# EUROPEAN PATENT APPLICATION

(11) **EP 4 043 469 A1**
(43) Date of publication of application: **17.08.2022**
(21) Application number: 22155118.7
(22) Date of filing: 04.02.2022
(51) Int. Cl.: C07F 15/00, C09K 11/00, H01L 51/50

(54) **ORGANOMETALLIC COMPOUND, ORGANIC LIGHT-EMITTING DEVICE INCLUDING ORGANOMETALLIC COMPOUND, AND ELECTRONIC APPARATUS INCLUDING ORGANIC LIGHT-EMITTING DEVICE**

(30) Priority: 10.02.2021 KR 20210019354
(71) Applicant: Samsung Electronics Co., Ltd., Gyeonggi-do, 16677 (KR)
(72) Inventor: LEE, Kum Hee, 16678 Suwon-si (KR); KANG, Byungjoon, 16678 Suwon-si (KR); KWAK, Seungyeon, 16678 Suwon-si (KR); KIM, Sangdong, 16678 Suwon-si (KR); KIM, Sungmin, 16678 Suwon-si (KR); LEE, Yong Joo, 16678 Suwon-si (KR); YI, Jeoungin, 16678 Suwon-si (KR); CHOI, Byoungki, 16678 Suwon-si (KR); HWANG, Kyuyoung, 16678 Suwon-si (KR)
(74) Representative: Elkington and Fife LLP

(57) **Abstract**

An organometallic compound represented by Formula 1, an organic light-emitting device including the organometallic compound, and an electronic apparatus including the organic light-emitting device:

Formula 1 M(L₁)ₙ₁(L₂)ₙ₂

wherein, in Formula 1,
M is a transition metal,
L₁ is a ligand represented by Formula 2-1,
L₂ is a ligand represented by Formula 2-2,
n1 and n2 are each independently 1 or 2, with the proviso that when n1 is 2, the L₁ ligands are identical to or different from each other, and when n2 is 2, the L₂ ligands are identical to or different from each other, and
L₁ is different from L₂.

## Description

### FIELD OF THE INVENTION

The present disclosure relates to an organometallic compound, an organic light-emitting device including the organometallic compound, and an electronic apparatus including the organic light-emitting device.

### BACKGROUND OF THE INVENTION

Organic light-emitting devices (OLEDs) are self-emissive devices which produce full-color images. In addition, OLEDs have wide viewing angles and exhibit excellent driving voltage and response speed characteristics.

OLEDs include an anode, a cathode, and an organic layer between the anode and the cathode and including an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. The excitons may transition from an excited state to a ground state, thus generating light.

### SUMMARY OF THE INVENTION

Provided are a novel organometallic compound, an organic light-emitting device including the organometallic compound, and an electronic apparatus including the organic light-emitting device.

Additional aspects will be set forth in part in the description which follows and, in part, will be apparent from the description, or may be learned by practice of the presented embodiments of the disclosure.

According to an aspect of an embodiment, an organometallic compound may be represented by Formula 1.

Formula 1 M(L₁)ₙ₁(L₂)ₙ₂

In Formula 1,
M may be a transition metal,
L₁ may be a ligand represented by Formula 2-1,
L₂ may be a ligand represented by Formula 2-2,
n1 and n2 may each independently be 1 or 2, with the proviso that when n1 is 2, the L₁ ligands may be identical to or different from each other, and when n2 is 2, the L₂ ligands may be identical to or different from each other, and
L₁ may be different from L₂.

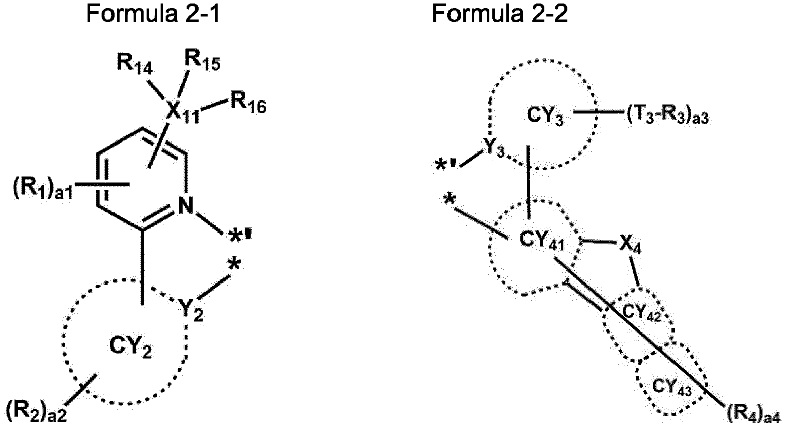

In Formulae 2-1 and 2-2,
Y₂ and Y₃ may each independently be C or N,
ring CY₂, ring CY₃, and ring CY₄₁ to ring CY₄₃ may each independently be a C₅-C₃₀ carbocyclic group or a C₁-C₃₀ heterocyclic group,
X₁₁ may be Si or Ge,
T₃ may be a single bond, a C₁-C₂₀ alkylene group unsubstituted or substituted with at least one R₁₀ₐ, a C₅-C₃₀ carbocyclic group unsubstituted or substituted with at least one R₁₀ₐ or a C₁-C₃₀ heterocyclic group unsubstituted or substituted with at least one R₁₀ₐ,
X4 may be O, S, Se, N(R48), C(R₄₈)(R₄₉), or Si(R₄₈)(R₄₉),
R₁ to R₄, R₁₄ to R₁₆, R₄₈, and R₄₉ may each independently be hydrogen, deuterium, -F, -Cl, -Br, -I, -SF₅, a hydroxyl group, a cyano group, a nitro group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉),
a1 may be an integer from 0 to 3,
a2 to a4 may each independently be an integer from 0 to 20,
when a1 is 2 or greater, at least two of the R₁ moieties may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
when a2 is 2 or greater, at least two of the R₂ moieties may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
when a3 is 2 or greater, at least two of the R₃ moieties may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
when a4 is 2 or greater, at least two of the R₄ moieties may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
at least two of R₁ to R₄ may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ has a same definition as R₂,
* and *' each indicate a binding site to M in Formula 1, and
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, or the substituted monovalent non-aromatic condensed heteropolycyclic group may be
deuterium, -F, -Cl, -Br, -I, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), - Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof,
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), - B(Q₂₆)(Q₂₇), -P(=O)(Q₂₈)(Q₂₉), P(Q₂₈)(Q₂₉), or any combination thereof,
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉), or
any combination thereof,
wherein Q₁ to Q₉, Q₁₁ to Q₁₉, Q₂₁ to Q₂₉, and Q₃₁ to Q₃₉ may each independently be hydrogen, deuterium, -F, -Cl, -Br, -I, a hydroxyl group, a cyano group, a nitro group, or a C₁-C₆₀ alkyl group, a C₂-C₆₀ alkenyl group, a C₂-C₆₀ alkynyl group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, a C₁-C₆₀ alkyl group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

According to an aspect of an embodiment, an organic light-emitting device may include a first electrode, a second electrode, and an organic layer between the first electrode and the second electrode, wherein the organic layer may include an emission layer and the organometallic compound.

The organometallic compound may be included in the emission layer, and the organometallic compound included in the emission layer may serve as a dopant.

According to an aspect of an embodiment, an electronic apparatus may include the organic light-emitting device.

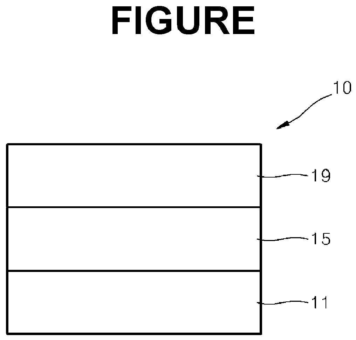

### BRIEF DESCRIPTION OF THE DRAWING

The above and other aspects, features, and advantages of certain embodiments of the disclosure will be more apparent from the following description taken in conjunction with the FIGURE which is a schematic cross-sectional view of an organic light-emitting device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

An organometallic compound may be represented by Formula 1:

Formula 1 M(L₁)ₙ₁(L₂)ₙ₂

wherein, in Formula 1, M may be a transition metal.

In some embodiments, M may be a first-row transition metal, a second-row transition metal, or a third-row transition metal.

In some embodiments, M may be iridium (Ir), platinum (Pt), osmium (Os), titanium (Ti), zirconium (Zr), hafnium (Hf), europium (Eu), terbium (Tb), thulium (Tm), or rhodium (Rh).

In an embodiment, M may be Ir, Pt, Os, or Rh.

L₁ in Formula 1 may be a ligand represented by Formula 2-1, and L₂ may be a ligand represented by Formula 2-2: 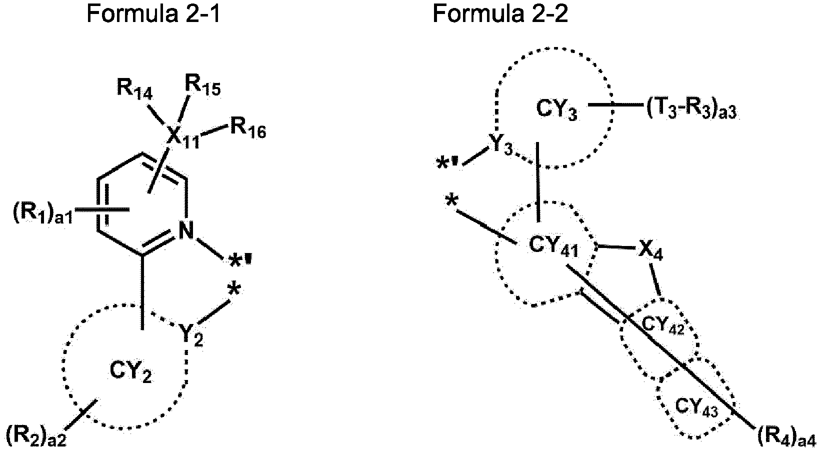
wherein, Formulae 2-1 and 2-2 may each be understood by referring to the descriptions of Formulae 2-1 and 2-2 provided herein.
n1 and n2 in Formula 1 may respectively indicate the number of L₁ ligands and L₂ ligands, and n1 and n2 may each independently be 1 or 2. When n1 is 2, two L₁ ligands may be identical to or different from each other, and when n2 is 2, two L₂ ligands may be identical to or different from each other.

For example, in Formula 1, i) n1 may be 2, and n2 may be 1, or ii) n1 may be 1, and n2 may be 2.

In an embodiment, in Formula 1, i) M may be Ir or Os, and a sum of n1 and n2 may be 3 or 4, or ii) M may be Pt, and a sum of n1 and n2 may be 2.

L₁ and L₂ in Formula 1 may be different from each other.

In Formulae 2-1 and 2-2, Y₂ and Y₃ may each independently be C or N.

In some embodiments, Y₂ in Formula 2-1 may be C, and Y₃ in Formula 2-2 may be N.

In Formulae 2-1 and 2-2, ring CY₂, ring CY₃, and ring CY₄₁ to ring CY₄₃ may each independently be a C₅-C₃₀ carbocyclic group or a C₁-C₃₀ heterocyclic group.

In some embodiments, ring CY₂, ring CY₃, and ring CY₄₁ to ring CY₄₃ may each independently be i) a first ring, ii) a second ring, iii) a condensed ring in which at least two first rings are condensed, iv) a condensed ring in which at least two second rings are condensed, or v) a condensed ring in which at least one first ring and at least one second ring are condensed,
the first ring may be a cyclopentane group, a cyclopentadiene group, a furan group, a thiophene group, a pyrrole group, a silole group, a germole group, a borole group, a selenophene group, a phosphole group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, an azaselenophene group, or an azaphosphole group, and
the second ring may be an adamantane group, a norbornane group (a bicyclo[2.2.1]heptane group), a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

In an embodiment, ring CY₂, ring CY₃, and ring CY₄₁ to ring CY₄₃ may each independently be a cyclopentane group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline, an adamantane group, a norbornane group, or a norbornene group.

In one or more embodiments, in Formula 2-1, ring CY₂ may be a benzene group, a naphthalene group, an anthracene group, a phenanthrene group, a 1,2,3,4-tetrahydronaphthalene group, a benzene group condensed with a norbornane group, a carbazole group, a fluorene group, a dibenzosilole group, a dibenzothiophene group, a dibenzofuran group, a dibenzoselenophene group, a pyridine group, a benzoxazole group, or a benzothiazole group.

In one or more embodiments, in Formula 2-2, ring CY₃ may be a pyridine group, a pyrimidine group, a triazine group, a quinoline group, an isoquinoline group, a quinoxaline group, a benzoquinoline group, a benzoisoquinoline group, a benzoquinoxaline group, a naphthoquinoline group, a naphthoisoquinoline group, a naphthoquinoxaline group, a pyridoquinoline group, a pyridoisoquinoline group, a pyridoquinoxaline group, a pyridine group condensed with a cyclohexane group, a pyridine group condensed with a norbornane group, an imidazole group, a benzimidazole group, a naphthoimidazole group, a phenanthrenoimidazole group, a pyridoimidazole group, an oxazole group, a benzoxazole group, a naphthooxazole group, a phenanthrenooxazole group, a pyridooxazole group, a thiazole group, a benzothiazole group, a naphthothiazole group, a phenanthrenothiazole group, or a pyridothiazole group.

In one or more embodiments, in Formula 2-2, ring CY₄₁ to ring CY₄₃ may each independently be i) A group, ii) a polycyclic group in which at least two A groups are condensed, or iii) a polycyclic group in which at least one A group and at least one B group are condensed,

wherein A group may be a benzene group, a pyridine group, a pyrimidine group, a pyridazine group, a pyrazine group, or a triazine group, and

B group may be a cyclohexane group, a norbornane group, a furan group, a thiophene group, a selenophene group, a pyrrole group, a cyclopentadiene group, or a silole group.

In one or more embodiments, in Formula 2-2, ring CY₄₁ and ring CY₄₂ may each independently be a benzene group, a naphthalene group, a benzene group condensed with a cyclohexane group, or a benzene group condensed with a norbornane group.

In one or more embodiments, in Formula 2-2, ring CY₄₃ may be:
a benzene group, a naphthalene group, a phenanthrene group, an anthracene group, or a chrysene group; or
a benzene group, a naphthalene group, a phenanthrene group, an anthracene group, or a chrysene group, each condensed with a cyclohexane group, a norbornane group, or any combination thereof.

In one or more embodiments, a carbon atom in ring CY₄₁ in Formula 2-2 may be bound to M in Formula 1 via a covalent bond.

X₁₁ in Formula 2-1 may be Si or Ge.

T₃ in Formula 2-2 may be a single bond, a C₁-C₂₀ alkylene group unsubstituted or substituted with at least one R₁₀ₐ, a C₅-C₃₀ carbocyclic group unsubstituted or substituted with at least one R₁₀ₐ, or a C₁-C₃₀ heterocyclic group unsubstituted or substituted with at least one R₁₀ₐ.

In some embodiments, T₃ in Formula 2-2 may be:
a single bond; or
a C₁-C₂₀ alkylene group, a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with at least one R₁₀ₐ.

In an embodiment, T₃ in Formula 2-2 may be:
a single bond; or
a benzene group unsubstituted or substituted with at least one R₁₀ₐ.

In one or more embodiments, T₃ in Formula 2-2 may be:
a single bond; or
a C₁-C₂₀ alkylene group, a benzene group, a naphthalene group, a dibenzofuran group, or a dibenzothiophene group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

In Formula 2-2, X₄ may be O, S, Se, N(R48), C(R₄₈)(R₄₉), or Si(R₄₈)(R₄₉).

In Formulae 2-1 and 2-2, R₁ to R₄, R₁₄ to R₁₆, R₄₈, and R₄₉ may each independently be hydrogen, deuterium, -F, -Cl, -Br, -I, -SF₅, a hydroxyl group, a cyano group, a nitro group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), - Ge(Q₃)(Q₄)(Q₅), -B(Q₆)(Q₇), -P(=O)(Q₈)(Q₉), or -P(Q₈)(Q₉). Q₁ to Q₉ may respectively be understood by referring to the descriptions of Q₁ to Q₉ provided herein.

In an embodiment, in Formulae 2-1 and 2-2, R₁ to R₄, R₁₄ to R₁₆, R₄₈, and R₄₉ may each independently be:
hydrogen, deuterium, -F, -Cl, -Br, -I, a hydroxyl group, a cyano group, a nitro group, -SF₅, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a deuterated C₁-C₂₀ alkyl group, a cyclopentyl group, a cyclohexyl group, a cycloheptyl group, a cyclooctyl group, an adamantanyl group, a norbornanyl group (a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, -CD₃, - CD₂H, -CDH₂, -CF₃, -CF₂H, -CFH₂, a hydroxyl group, a cyano group, a nitro group, a C₁-C₂₀ alkyl group, a deuterated C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a(C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a(C₁-C₂₀ alkyl)bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, -Si(Q₃₃)(Q₃₄)(Q₃₅), -Ge(Q₃₃)(Q₃₄)(Q₃₅), or any combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉),
wherein Q₁ to Q₉ and Q₃₃ to Q₃₅ may each independently be:
-CH₃, -CD₃, -CD₂H, -CDH₂, -CH2CH3, -CH2CD3, -CH2CD2H, -CH2CDH2, - CHDCH₃, -CHDCD₂H, -CHDCDH₂, -CHDCD₃, -CD₂CD₃, -CD₂CD₂H, or -CD₂CDH₂; or
an *n*-propyl group, an iso-propyl group, an n-butyl group, a sec-butyl group, an isobutyl group, a *tert*-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₂₀ alkyl group, a phenyl group, or any combination thereof.

In one or more embodiments, R₁ to R₄, R₄₈, and R₄₉ may each independently be:
hydrogen, deuterium, -F, or a cyano group; or
a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated a phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, -Si(Q₃₃)(Q₃₄)(Q₃₅), -Ge(Q₃₃)(Q₃₄)(Q₃₅), or any combination thereof.

In one or more embodiments, R₁₄ to R₁₆ may each independently be a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated a phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

In one or more embodiments, in Formula 2-1, R₁₄ to R₁₆ may each independently be -CH₃, -CH₂CH₃, -CD₃, -CD₂H, -CDH₂, -CH₂CD₃, or -CD₂CH₃.

In one or more embodiments, in Formula 2-1, R₁₄ to R₁₆ may be identical to or different from each other.

In one or more embodiments, in Formulae 2-1 and 2-2, R₁ to R₄, R₁₄ to R₁₆, R₄₈, and R₄₉ may each independently be hydrogen, deuterium, -F, a cyano group, a nitro group, -SF₅, -CH₃, -CD₃, -CD₂H, -CDH₂, -CF₃, -CF₂H, -CFH₂, -OCH₃, -OCDH₂, -OCD₂H, -OCD₃, -SCH₃, -SCDH₂, -SCD₂H, -SCD₃, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, a group represented by one of Formulae 10-201 to 10-354 in which at least one hydrogen is substituted with -F, -Si(Q₃)(Q₄)(Q₅), or -Ge(Q₃)(Q₄)(Q₅), wherein Q₃ to Q₅ may respectively be understood by referring to the descriptions of Q₃ to Q₅ provided herein.

In one or more embodiments, at least one of the R₁ moieties (the number a1 representing a count of the R₁ moieties) in Formula 2-1 (e.g., R₁₁ in Formula CY1-1) may be a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, or a group represented by one of Formulae 10-201 to 10-354 in which at least one hydrogen is substituted with -F:

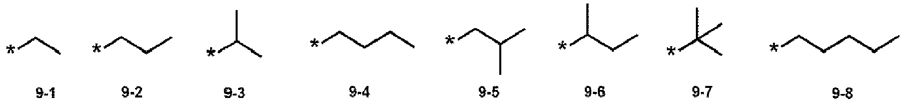

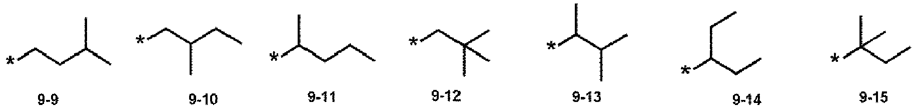

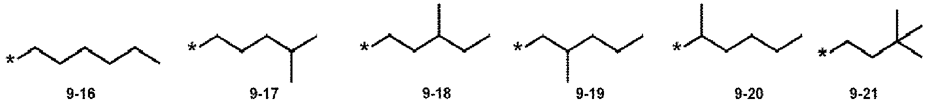

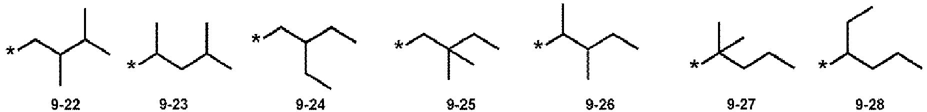

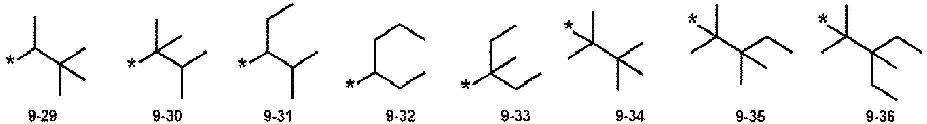

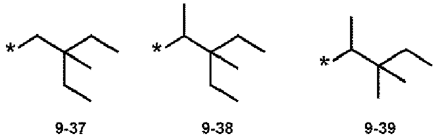

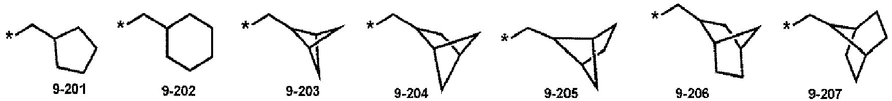

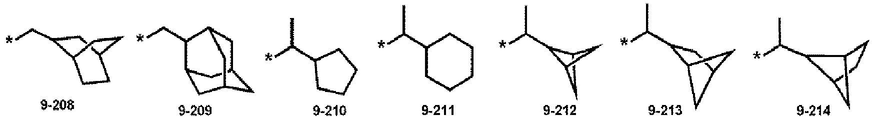

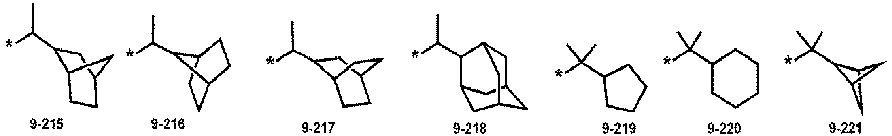

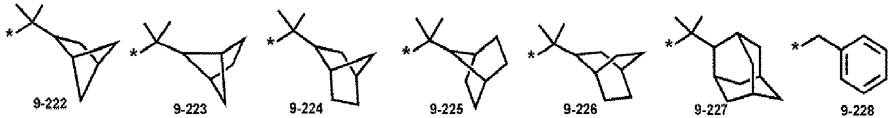

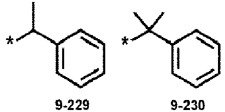

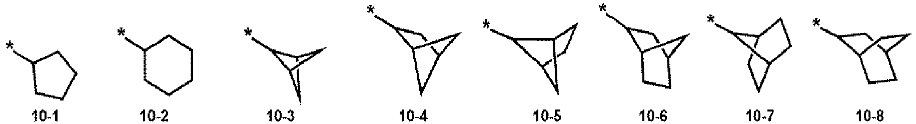

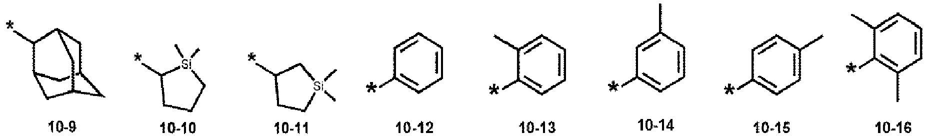

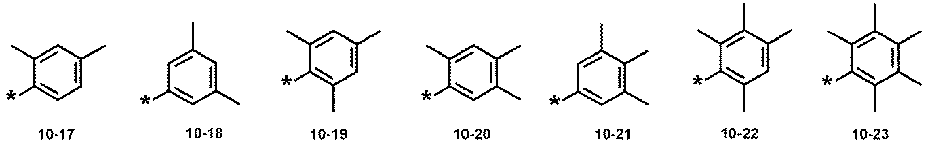

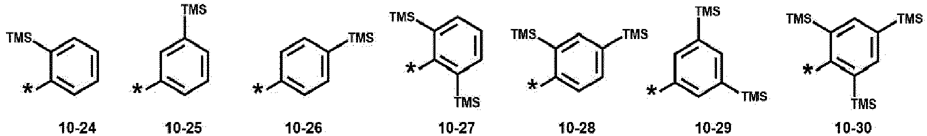

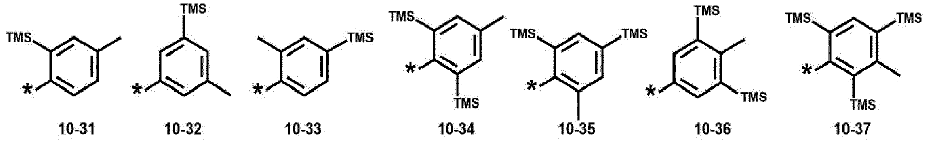

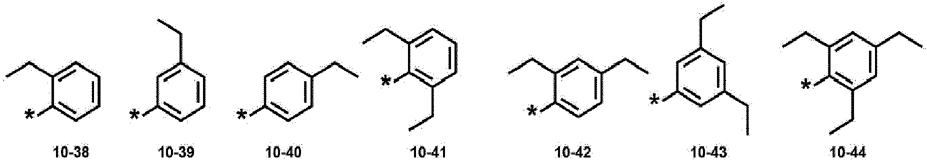

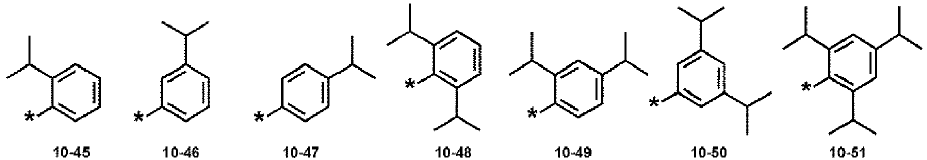

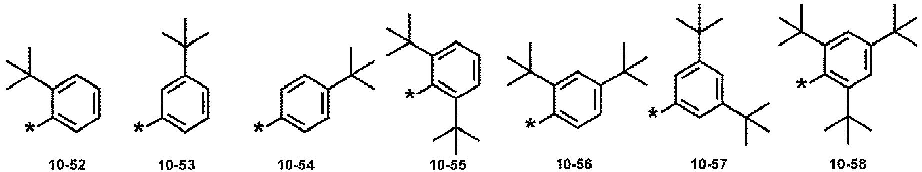

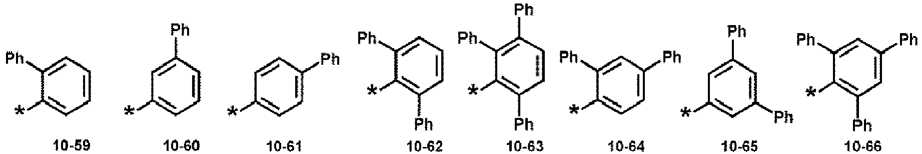

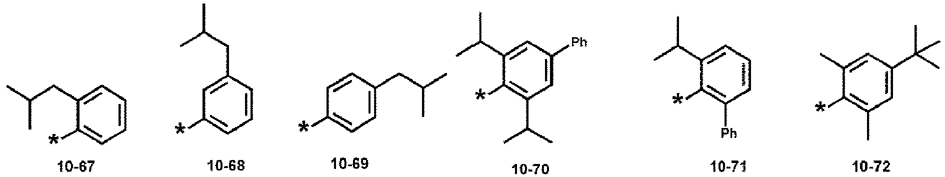

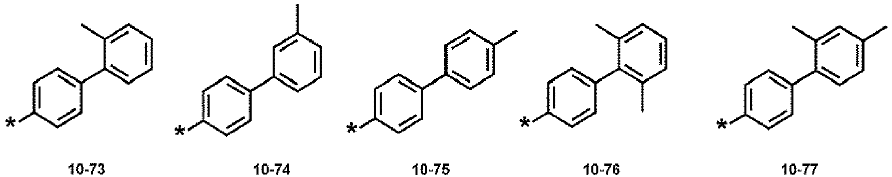

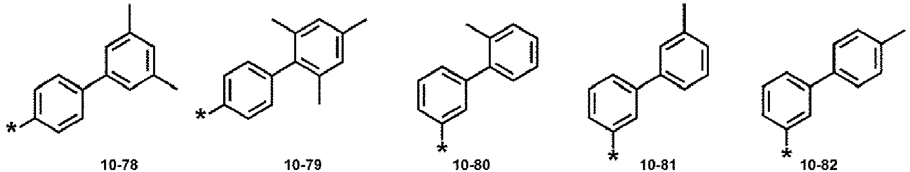

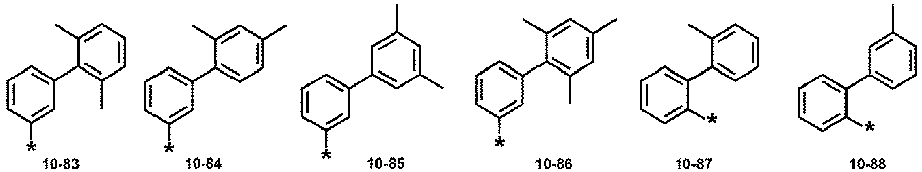

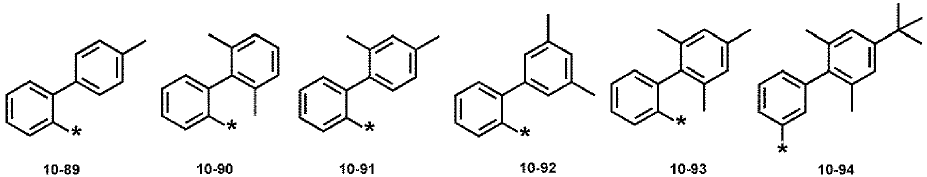

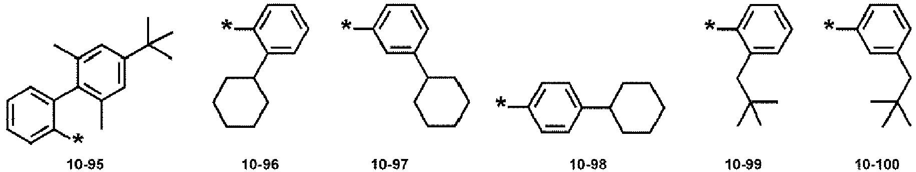

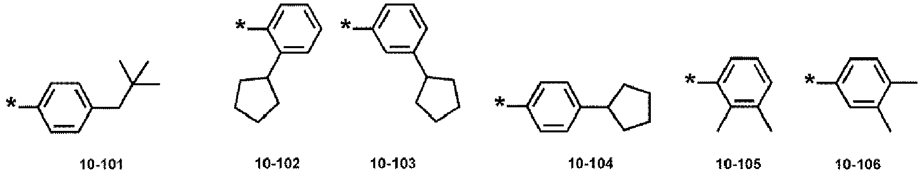

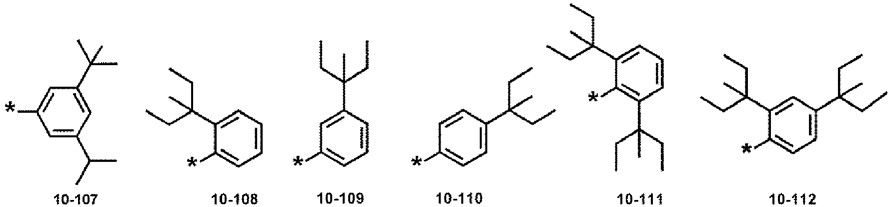

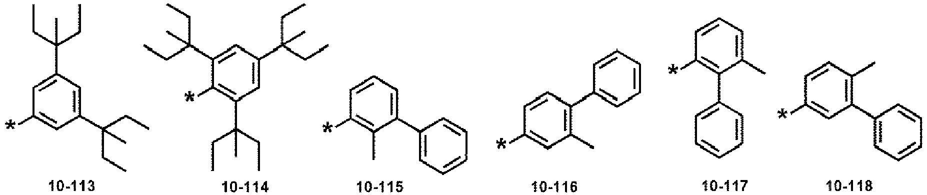

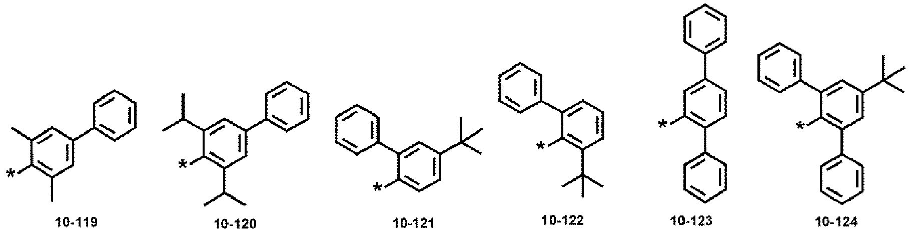

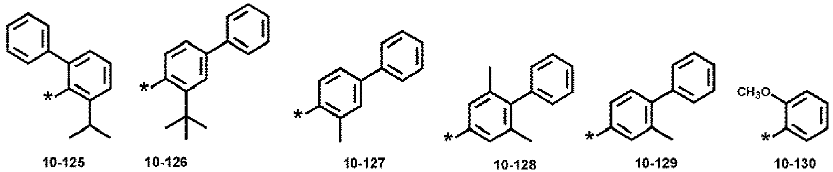

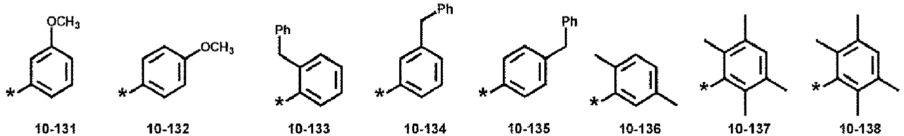

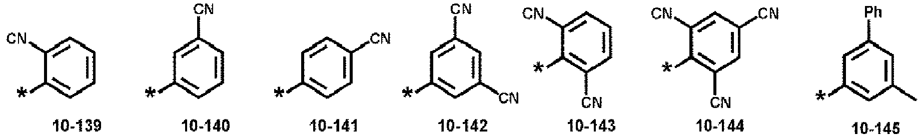

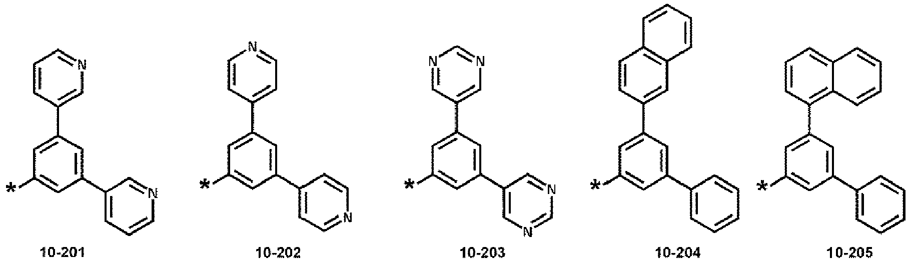

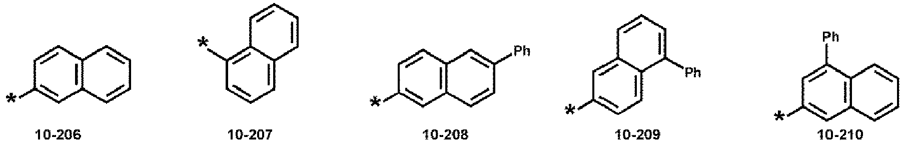

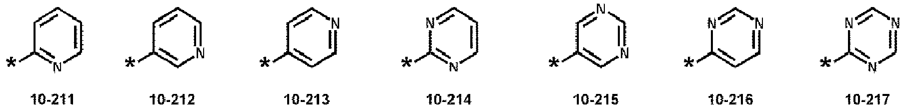

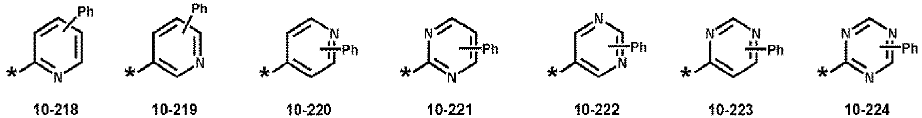

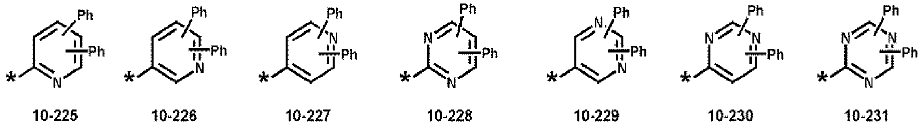

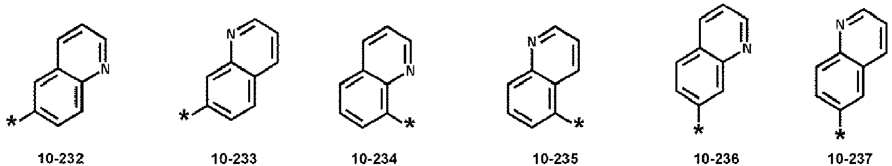

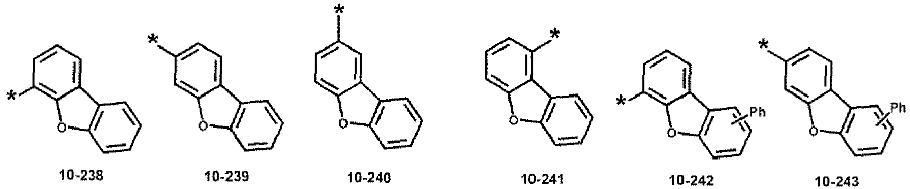

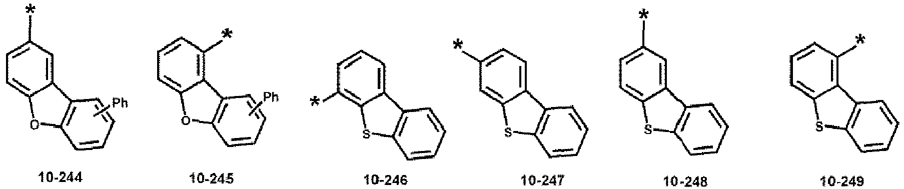

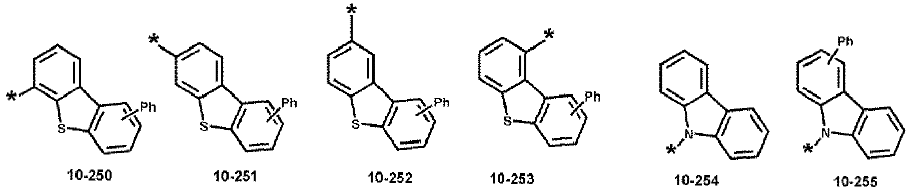

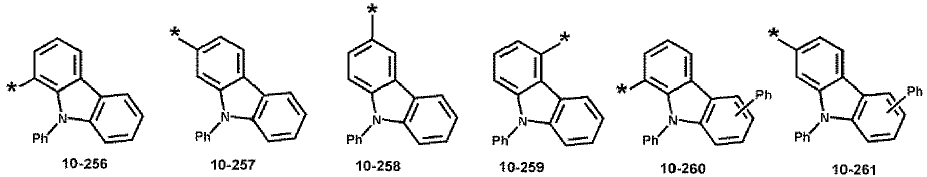

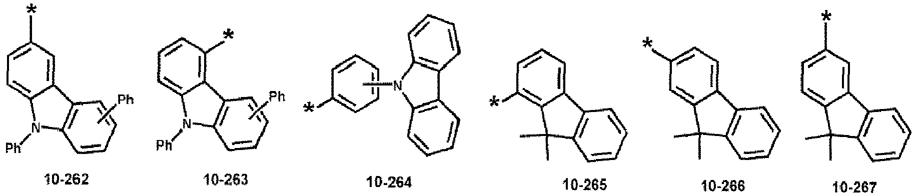

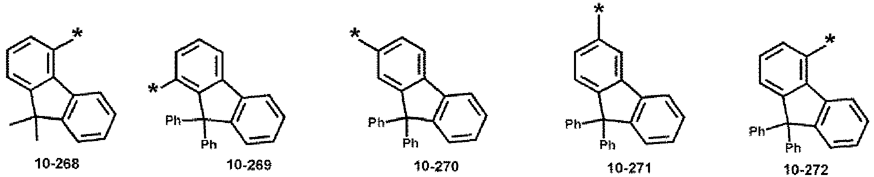

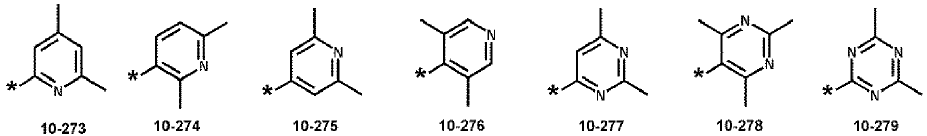

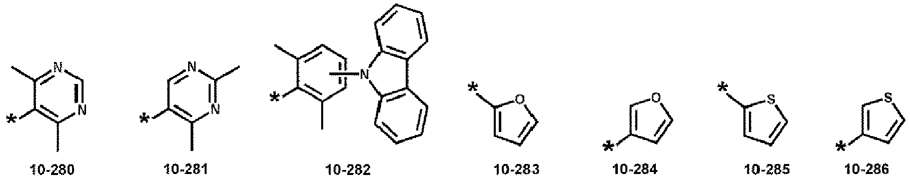

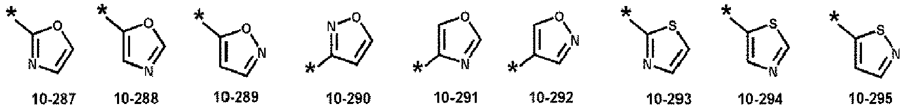

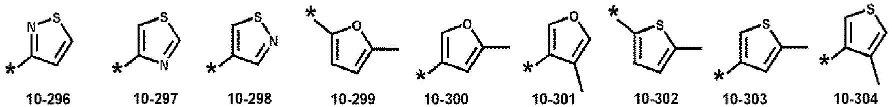

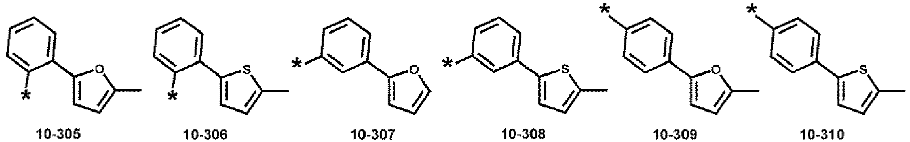

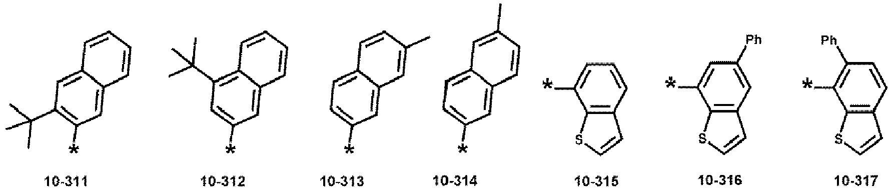

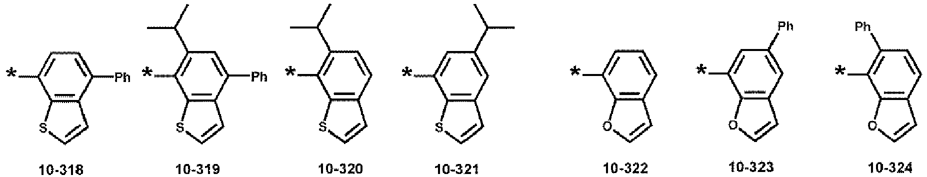

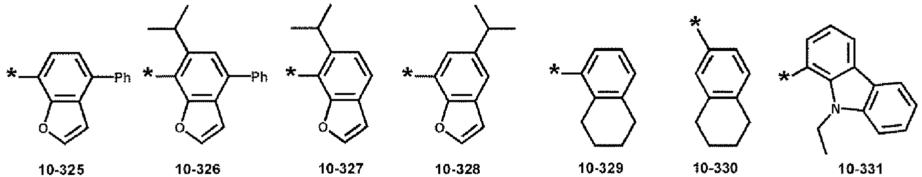

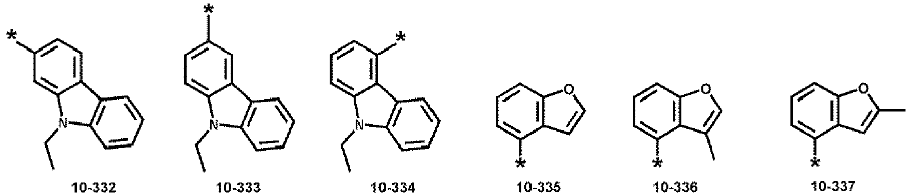

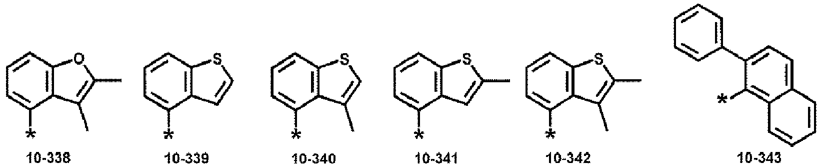

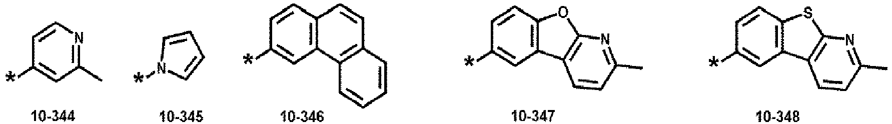

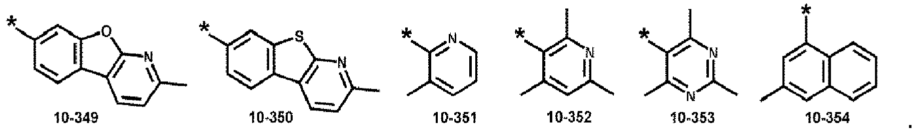

In Formulae 9-1 to 9-39, 9-201 to 9-230, 10-1 to 10-145, and 10-201 to 10-354, * indicates a binding site to an adjacent atom, "Ph" represents a phenyl group, "TMS" represents a trimethylsilyl group, "TMG" represents a trimethylgermyl group, and "OMe" represents a methoxy group.

The "group represented by one of Formulae 9-1 to 9-39 in which at least one hydrogen is substituted with deuterium" and the "group represented by one of Formulae 9-201 to 9-230 in which at least one hydrogen is substituted with deuterium" as used herein may each be, for example, a group represented by one of Formulae 9-501 to 9-514 and 9-601 to 9-637:

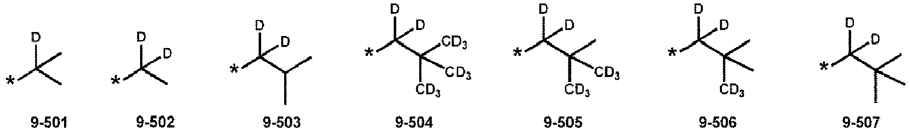

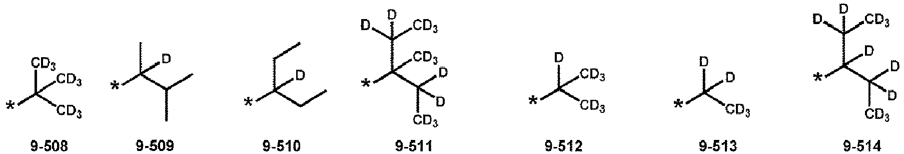

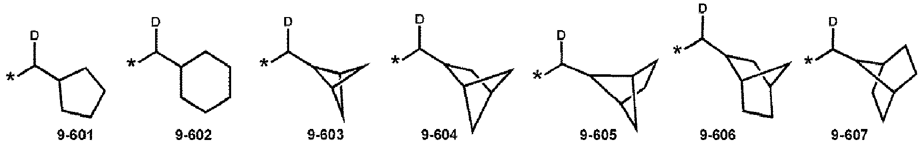

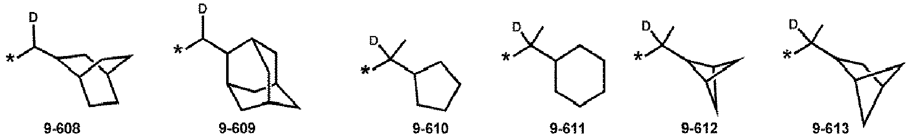

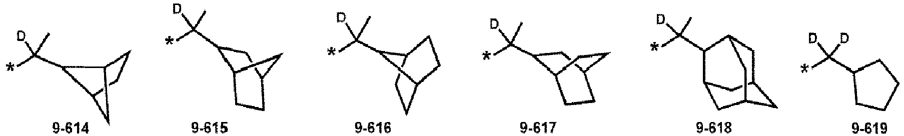

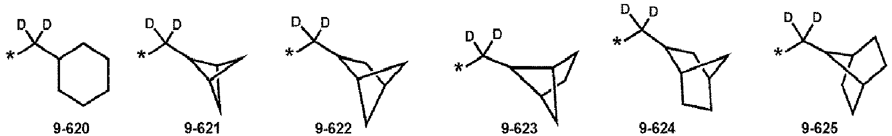

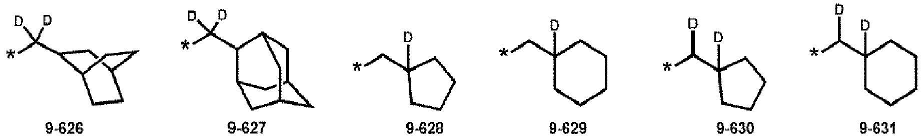

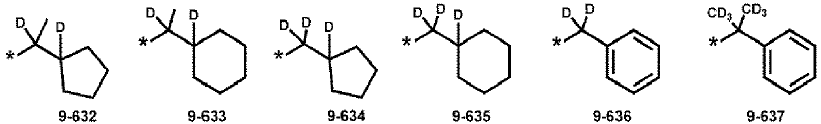

The "group represented by one of Formulae 9-1 to 9-39 in which at least one hydrogen is substituted with -F" and the "group represented by one of Formulae 9-201 to 9-230 in which at least one hydrogen is substituted with -F" as used herein may each be, for example, a group represented by one of Formulae 9-701 to 9-710:

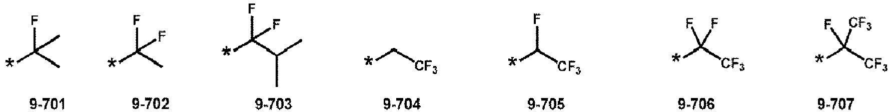

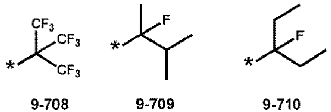

The "group represented by one of Formulae 10-1 to 10-145 in which at least one hydrogen is substituted with deuterium" and the "group represented by one of Formulae 10-201 to 10-354 in which at least one hydrogen is substituted with deuterium" as used herein may each be, for example, a group represented by one of Formulae 10-501 to 10-553:

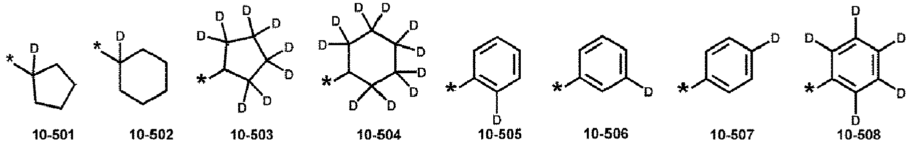

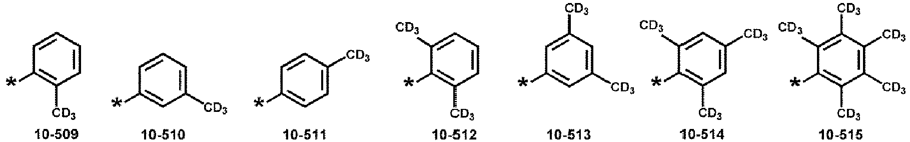

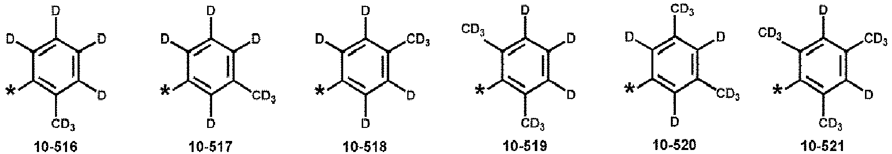

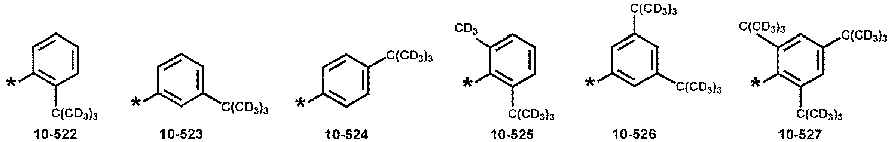

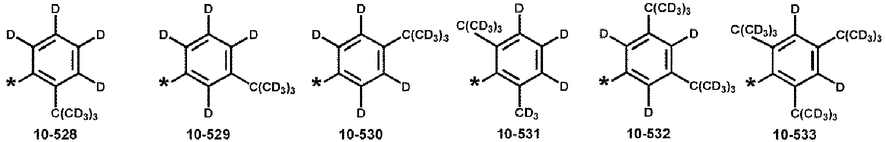

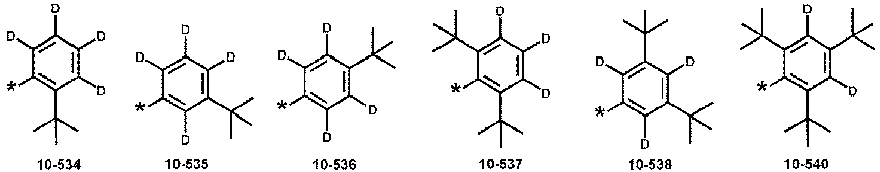

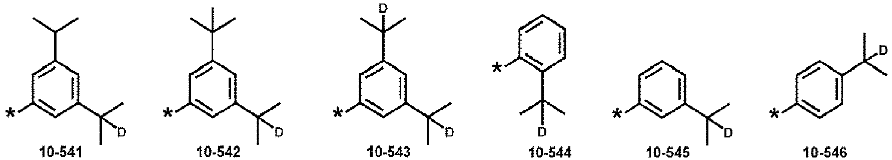

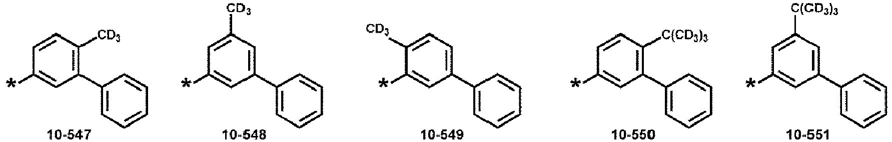

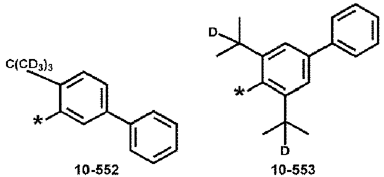

The "group represented by one of Formulae 10-1 to 10-145 in which at least one hydrogen is substituted with -F" and the "group represented by one of Formulae 10-201 to 10-354 in which at least one hydrogen is substituted with -F" as used herein may each be, for example, a group represented by one of Formulae 10-601 to 10-636:

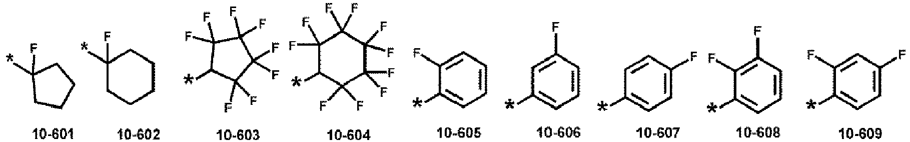

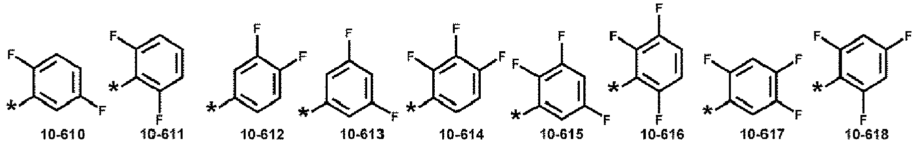

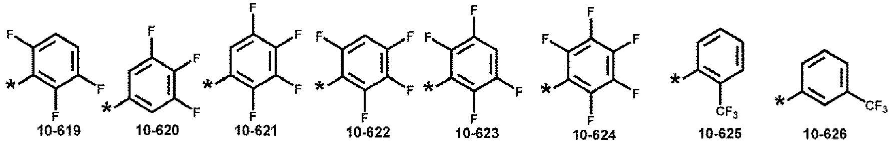

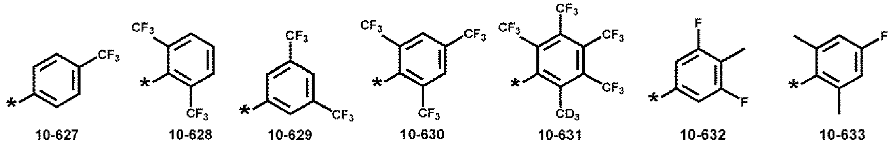

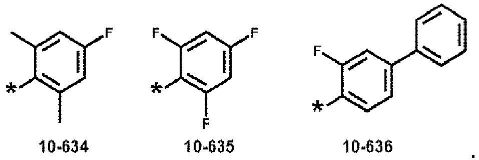

In Formulae 2-1 and 2-2, a1 to a4 may respectively indicate the number of R₁ moieties to R₄ moieties, a1 may be an integer from 0 to 3, and a2 to a4 may each independently be an integer from 0 to 20 (e.g., an integer from 0 to 10). When a1 is 2 or greater, at least two R₁ moieties may be identical to or different from each other, when a2 is 2 or greater, at least two R₂ moieties may be identical to or different from each other, when a3 is 2 is or greater, at least two R₃ moieties may be identical to or different from each other, and when a4 is 2 is or greater, at least two R₄moieties may be identical to or different from each other.

In one or more embodiments, the organometallic compound represented by Formula 1 may include deuterium, a fluoro group, or any combination thereof.

In one or more embodiments, the organometallic compound represented by Formula 1 may satisfy at least one of Conditions 1 to 8:
Condition 1
   at least one of the R₁ moieties (the number a1 representing a count of the R₁ moieties) may not be hydrogen and may include at least one deuterium,
Condition 2
   at least one of the R₂ moieties (the number a2 representing a count of the R₂ moieties) may not be hydrogen and may include at least one deuterium,
Condition 3
   at least one of the *-T₃-R₃ moieties (the number a3 representing a count of the *-T₃-R₃ moieties) may not be hydrogen and may include at least one deuterium,
Condition 4
   at least one of the R₄ moieties (the number a4 representing a count of the R₄ moieties) may not be hydrogen and may include at least one deuterium,
Condition 5
   at least one of the R₁ moieties (the number a1 representing a count of the R₁ moieties) may not be hydrogen and may include at least one fluoro group,
Condition 6
   at least one of the R₂ moieties (the number a2 representing a count of the R₂ moieties) may not be hydrogen and may include at least one fluoro group,
Condition 7
   at least one of the *-T₃-R₃ moieties (the number a3 representing a count of the *-T₃-R₃ moieties) may not be hydrogen and may include at least one fluoro group, and
Condition 8
   at least one of the R₄(moieties) (the number a4 representing a count of the R₄ moieties) may not be hydrogen and may include at least one fluoro group.

In Formulae 2-1 and 2-2, i) at least two R₁ moieties may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ, ii) at least two R₂ moieties may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ, iii) at least two R₃ moieties may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ, iv) at least two R₄ moieties may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ, and v) at least two of the R₁ moieties to R₄ moieties may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ.

R₁₀ₐ used herein may be understood by referring to the description of R₂ provided herein. For example, R₁₀ₐ may be understood by referring to the description of R₂ provided herein, and R₁₀ₐ may not be hydrogen.

In Formulae 2-1 to 2-2, *and *' each indicate a binding site to an adjacent atom.

In an embodiment, a group represented by 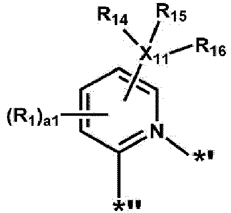 in Formula 2-1 may be represented by one of Formulae CY1-1 to CY1-3: 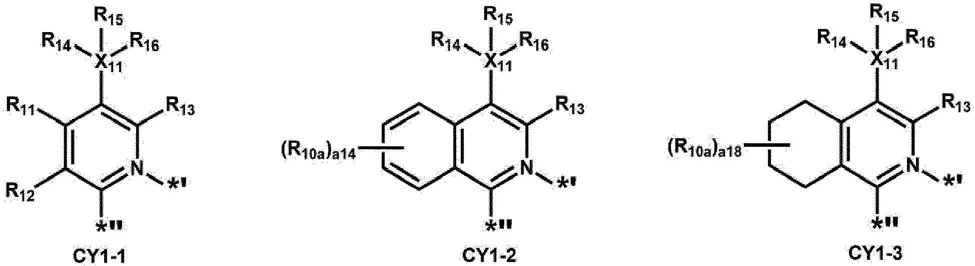
wherein, in Formulae CY1-1 to CY1-3,
X₁₁, R₁₄ to R₁₆, and R₁₀ₐ may respectively be understood by referring to the descriptions of X₁₁, R₁₄ to R₁₆, and R₁₀ₐ provided herein,
R₁₁ to R₁₃ may each be understood by referring to the description of R₁ provided herein,
a14 may be an integer from 0 to 4,
a18 may be an integer from 0 to 8,
*' indicates a binding site to M in Formula 1, and
*" indicates a binding site to an adjacent atom in Formula 2-1.

For example, in Formula CY1-1, R₁₁ may not be hydrogen.

In an embodiment, in Formula CY1-1, R₁₁ may not be hydrogen and a methyl group.

In one or more embodiments, in Formula CY1-1, R₁₁ may not be hydrogen, a methyl group, and a cyano group.

In one or more embodiments, in Formula CY1-1, R₁₁ may not be hydrogen, and R₁₂ and R₁₃ may each be hydrogen.

In one or more embodiments, in Formula CY1-1, R₁₁ may have at least two, three, or four carbon atoms.

In one or more embodiments, in Formula CY1-1, R₁₁ may be:
a methyl group substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated a phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof; or
a C₂-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ aikyi)C₃-C₁₀ cycloalkyl group, a phenyl group, a deuterated a phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

In one or more embodiments, a group represented by 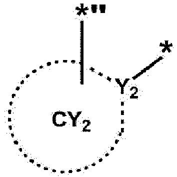 in Formula 2-1 may be represented by one of Formulae CY2-1 to CY2-33: 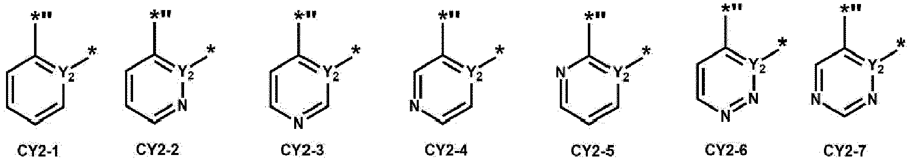 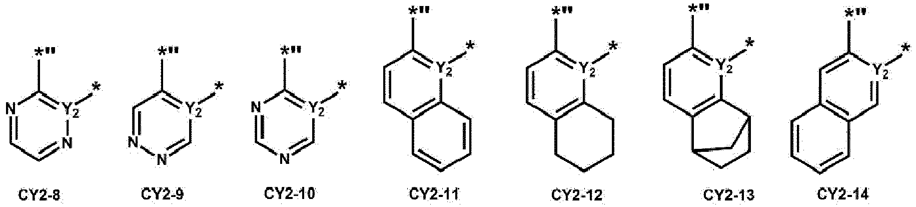 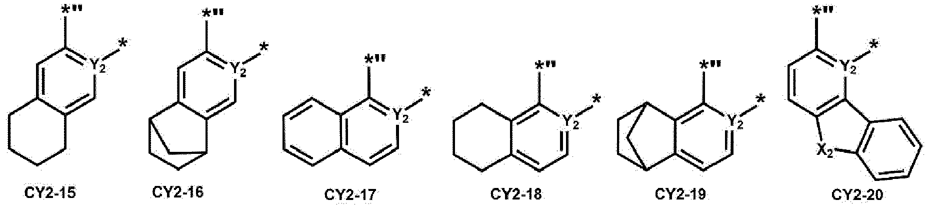 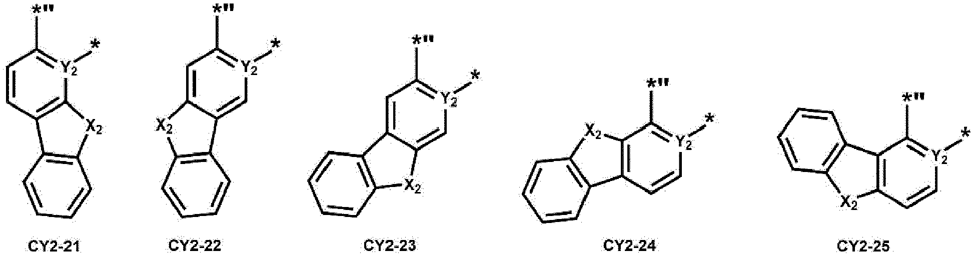 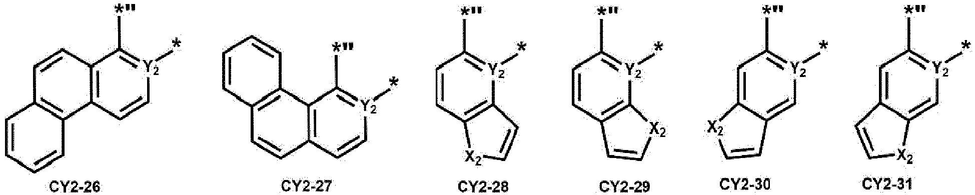 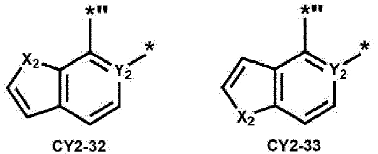
wherein, in Formulae CY2-1 to CY2-33,
Y₂ may be understood by referring to the description of Y₂ provided herein,
X2 may be O, S, Se, N(R₂₈), C(R₂₈)(R₂₉), or Si(R₂₈)(R₂₉),
R₂₈ and R₂₉ may each be understood by referring to the description of R₂ provided herein,
*" indicates a binding site to an adjacent atom in Formula 2-1, and
* in indicates a binding site to M in Formula 1.

In one or more embodiments, a group represented by 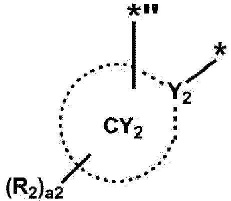 in Formula 2-1 may be represented by one of Formulae CY2(1) to CY2(56): 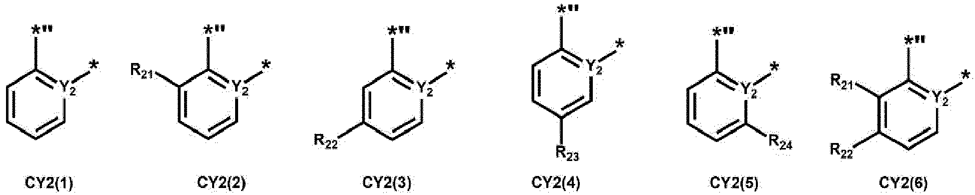 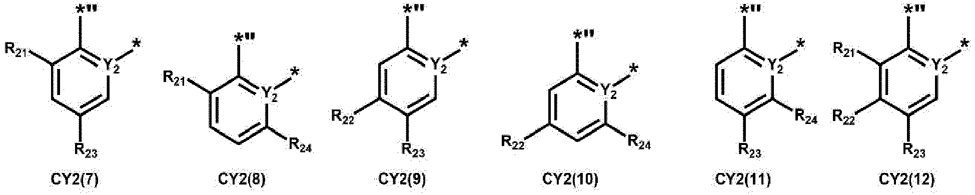 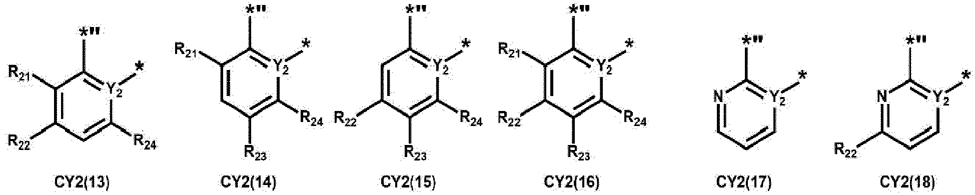 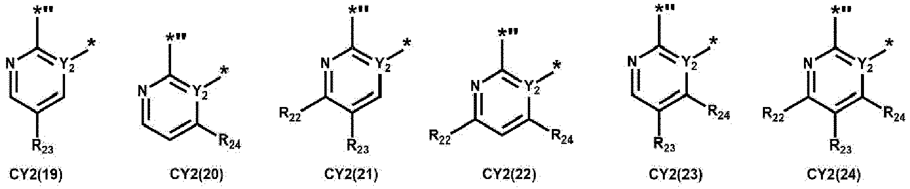 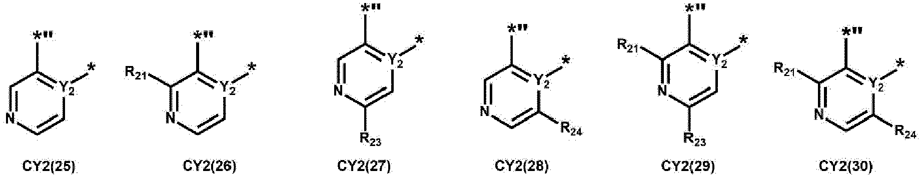 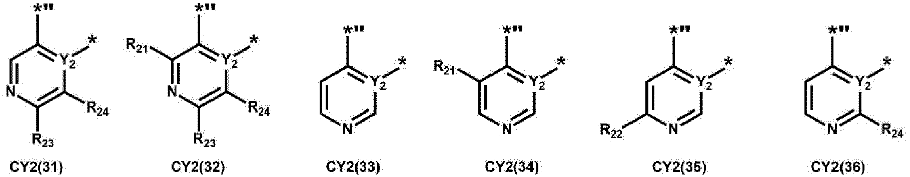 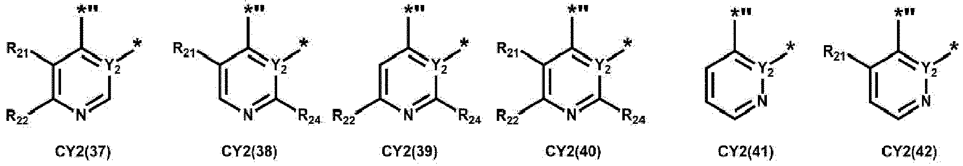 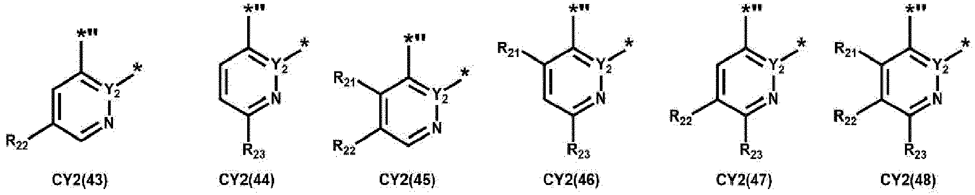 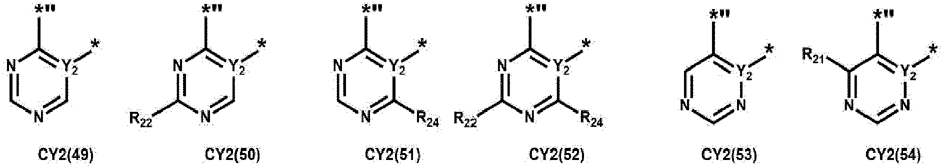 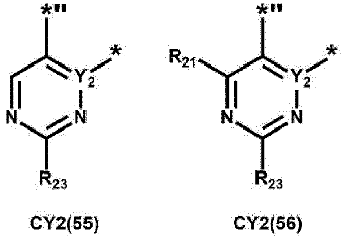 wherein, in Formulae CY2(1) to CY2(56),
Y₂ may be understood by referring to the description of Y₂ provided herein,
R₂₁ to R₂₄ may each be understood by referring to the description of R₂ provided herein, wherein R₂₁ to R₂₄ may not each be hydrogen,
*" indicates a binding site to an adjacent atom in Formula 2-1, and
* in indicates a binding site to M in Formula 1.

In one or more embodiments, a group represented by 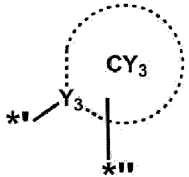 in Formula 2-2 may be represented by one of Formulae CY3-1 to CY3-48: 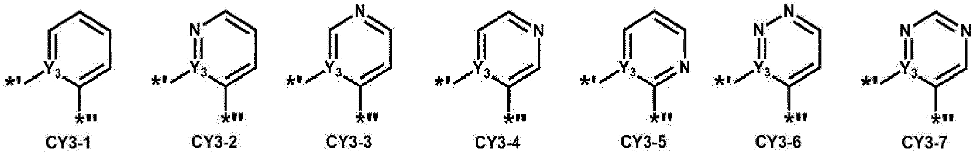 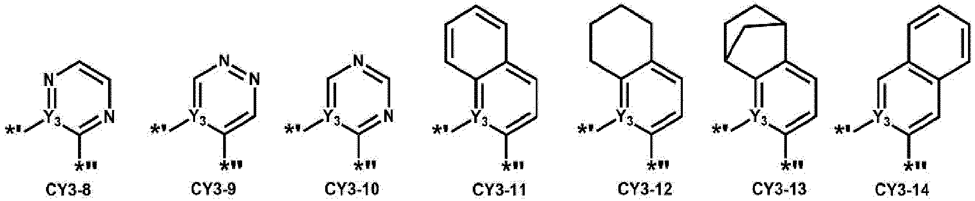 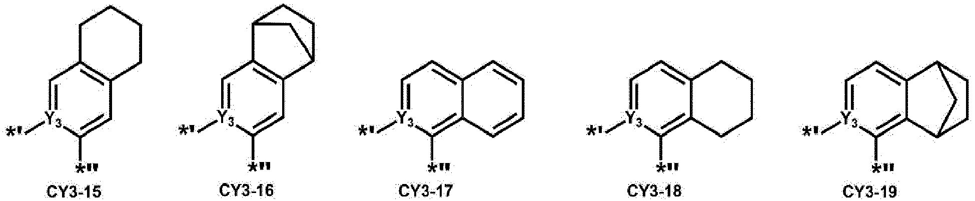 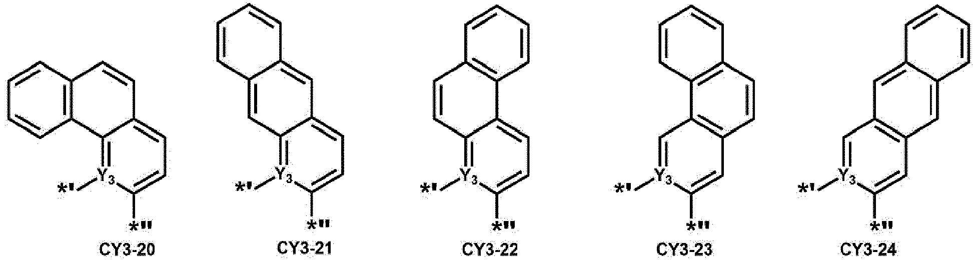 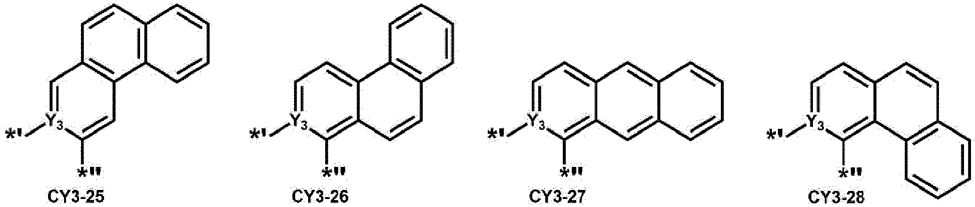 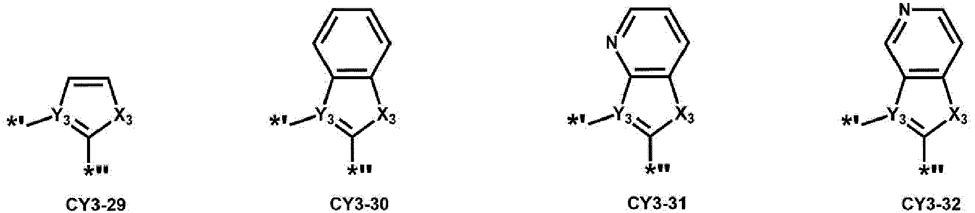 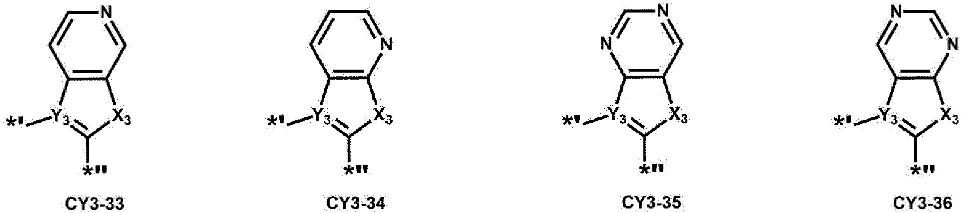 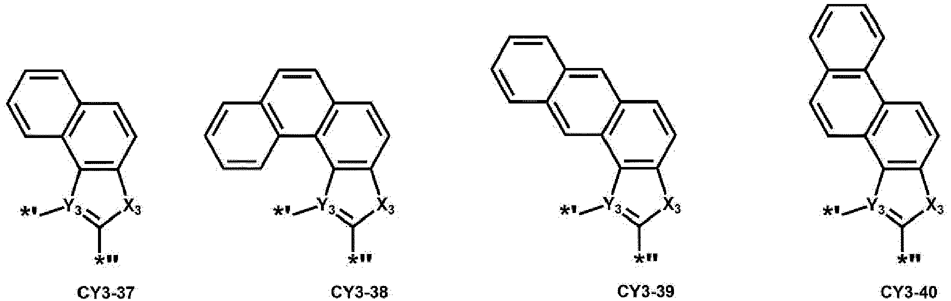 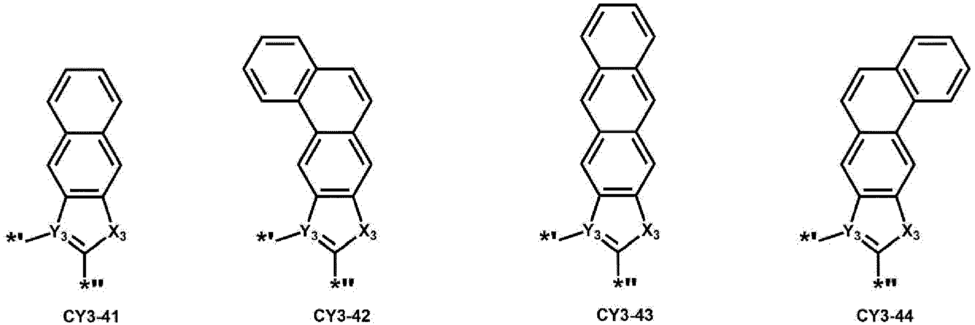 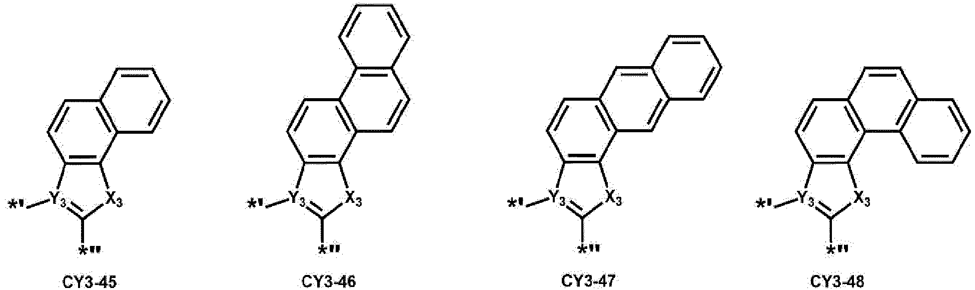 wherein, in Formulae CY3-1 to CY3-48,
X₃ may be O, S, or N(T₃-R₃),
Y₃, T₃, and R₃ may respectively be understood by referring to the descriptions of Y₃, T₃, and R₃ provided herein,
*' indicates a binding site to M in Formula 1, and
*" indicates a binding site to an adjacent atom in Formula 2-2.

In some embodiments, in Formulae CY3-29 to CY3-48, i) X₃ may be N(T₃-R₃), and ii) at least one of Condition A and Condition B may be satisfied:
Condition A
   T₃ may be a C₅-C₃₀ carbocyclic group unsubstituted or substituted with at least one R₁₀ₐ or a C₁-C₃₀ heterocyclic group unsubstituted or substituted with at least one R₁₀ₐ, and
Condition B
   R₃ may be a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, a group represented by 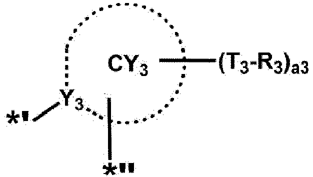 in Formula 2-2 may be represented by one of Formulae CY3(1) to CY3(16): 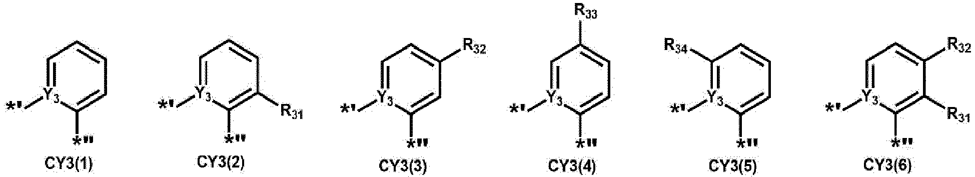 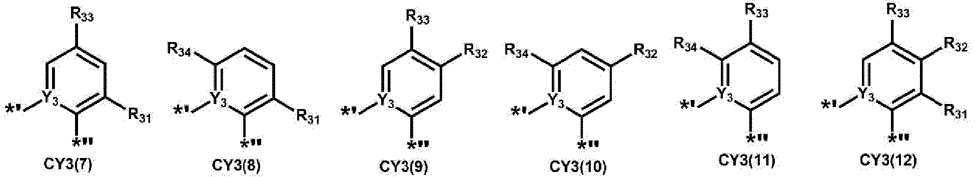 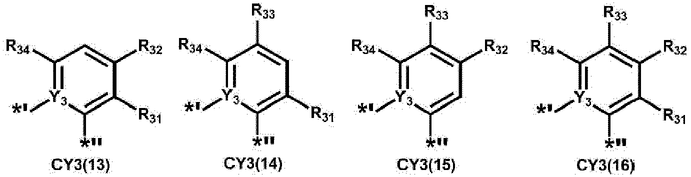 wherein, in Formulae CY3(1) to CY3(16),
Y₃ may be understood by referring to the description of Y₃ provided herein,
R₃₁ to R₃₄ may each be understood by referring to the description of R₃ provided herein, wherein R₃₁ to R₃₄ may not each be hydrogen,
*' indicates a binding site to M in Formula 1, and
*" indicates a binding site to an adjacent atom in Formula 2-2.

In one or more embodiments, a group represented by 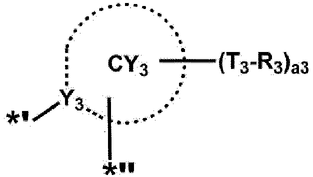 in Formula 2-2 may be represented by one of Formulae CY3-29 to CY3-48 (wherein X₃ may be N(T₃-R₃)).

In one or more embodiments, a group represented by 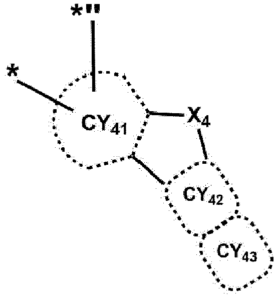 in Formula 2-2 may be represented by one of Formulae CY4-1 to CY4-6: 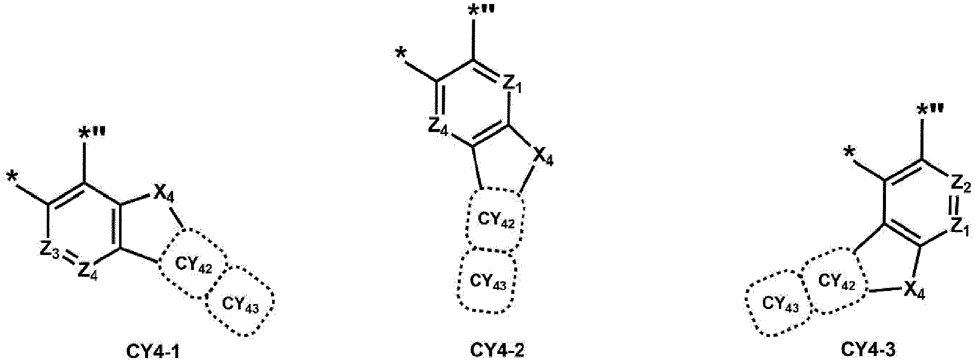 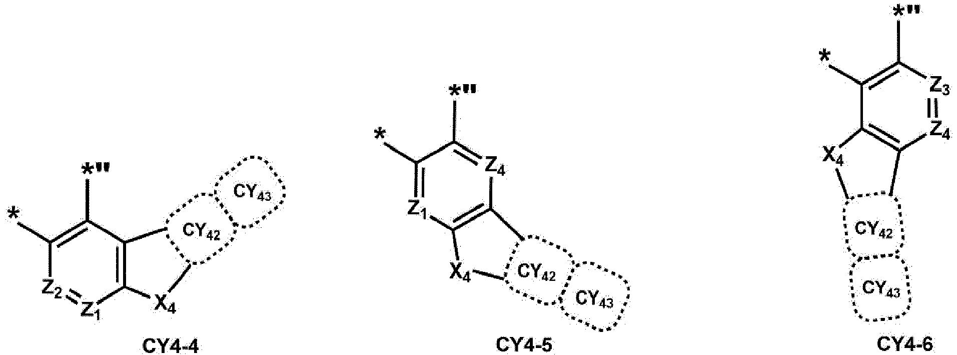 wherein, in Formulae CY4-1 to CY4-6,
X₄, ring CY₄₂, and ring CY₄₃ may respectively be understood by referring to the descriptions of X₄, ring CY₄₂, and ring CY₄₃ provided herein,
Z₁ to Z₄ may each independently be N or C,
* indicates a binding site to M in Formula 1, and
*" indicates a binding site to ring CY₃ in Formula 2-2.

In one or more embodiments, a group represented by 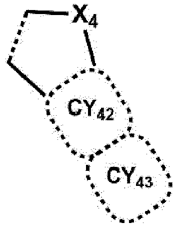 in 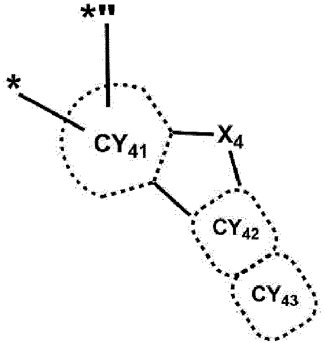 in Formula 2-2 may be represented by one of Formulae CY401 to CY412: 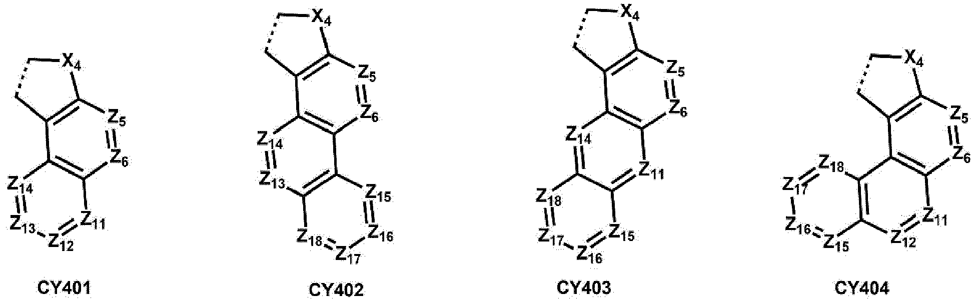 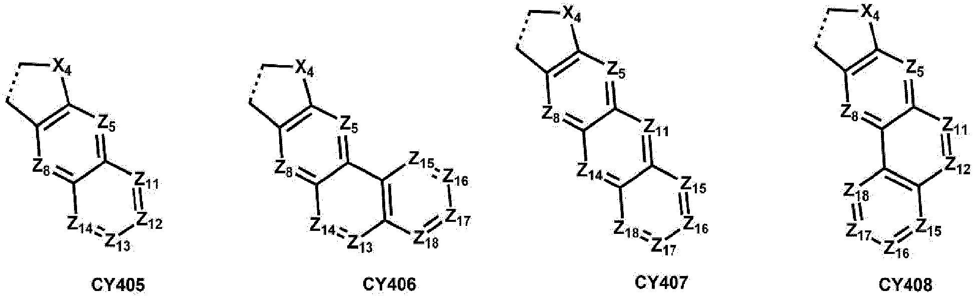 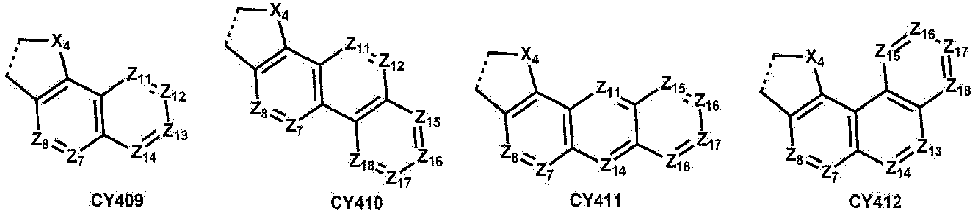 wherein, in Formulae CY401 to CY412,
X₄ may be understood by referring to the description of X₄ provided herein,
Z₅ to Z₈ and Z₁₁ to Z₁₈ may each independently be N or C, and
an X₄-containing 5-membered ring may be condensed to an adjacent ring CY41.

In one or more embodiments, the organometallic compound represented by Formula 1 may include deuterium, a fluoro group, or any combination thereof.

In one or more embodiments, the organometallic compound may emit red light or green light, e.g., red light or green light having a maximum emission wavelength of about 500 nanometers (nm) or greater, e.g., about 500 nm to about 850 nm. In some embodiments, the organometallic compound may emit green light. In some embodiments, the organometallic compound may emit a light (for example, a green light) having a maximum emission wavelength of about 515 nm to about 550 nm, or about 520 nm to about 540 nm.

In one or more embodiments, L₁ in Formula 1 may be a ligand represented by one of Formulae A1 to A310: 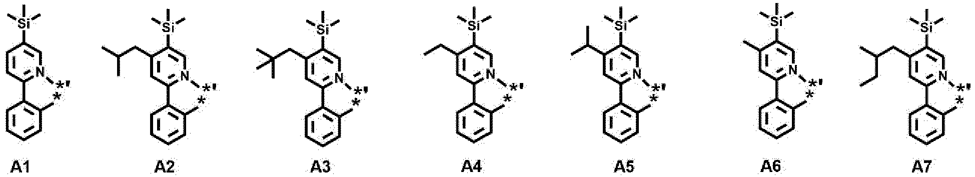 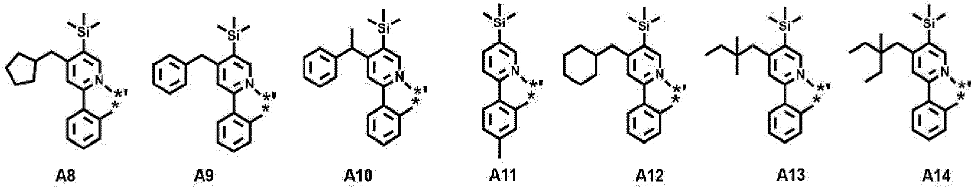 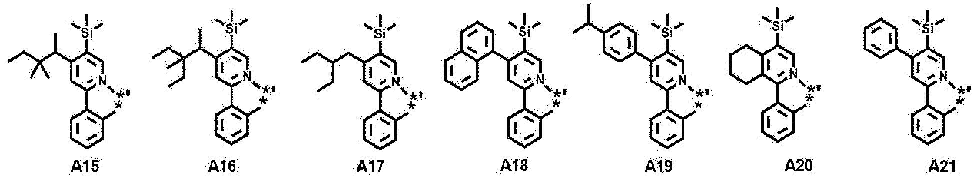 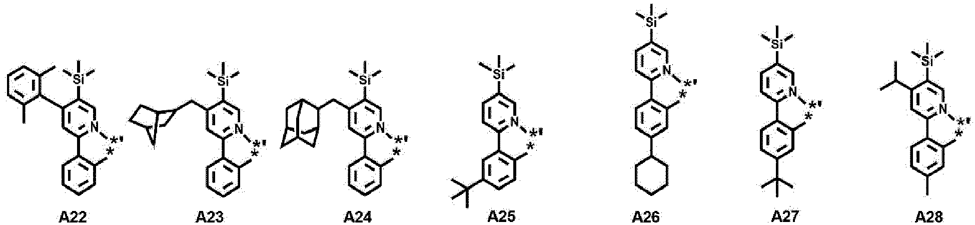 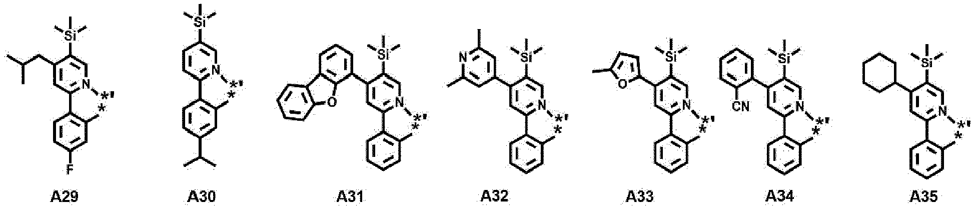 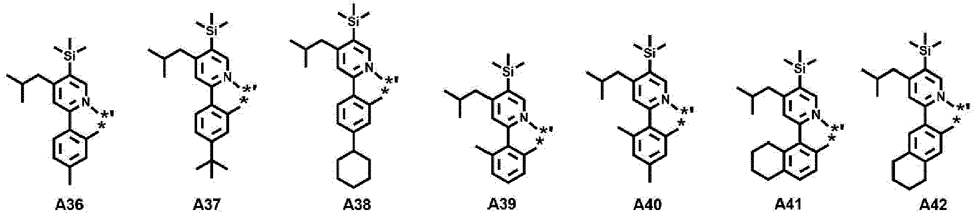 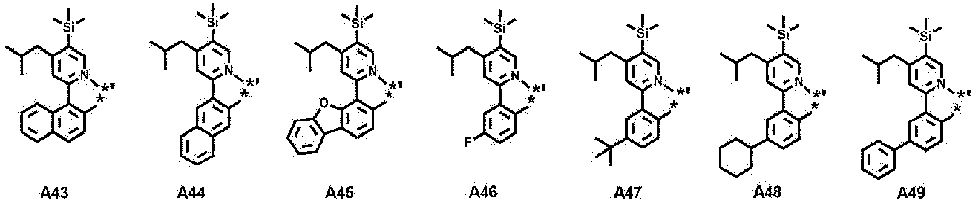 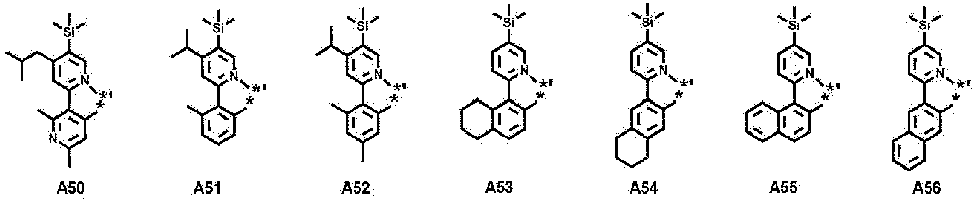 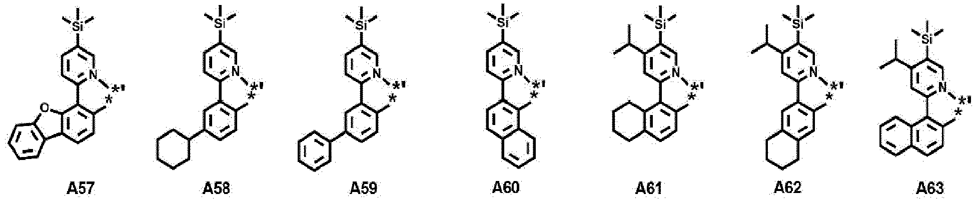 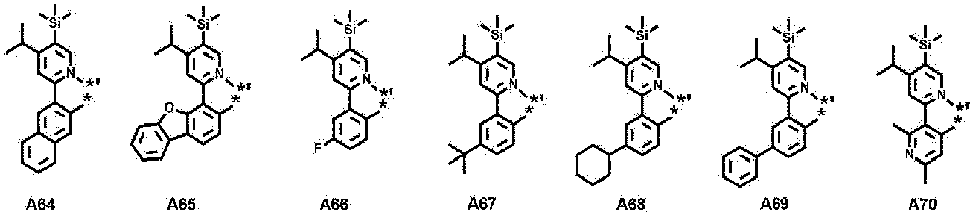 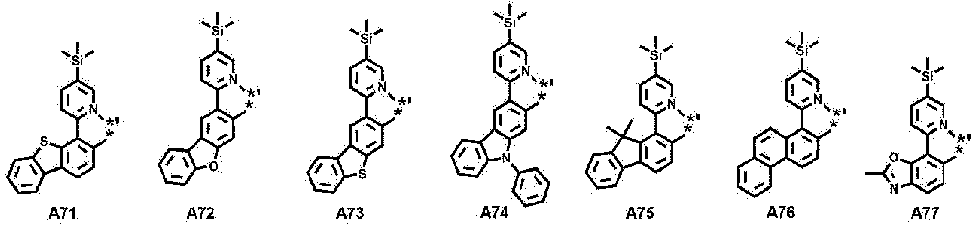 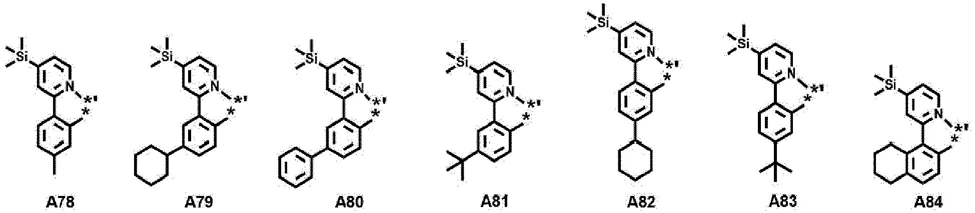 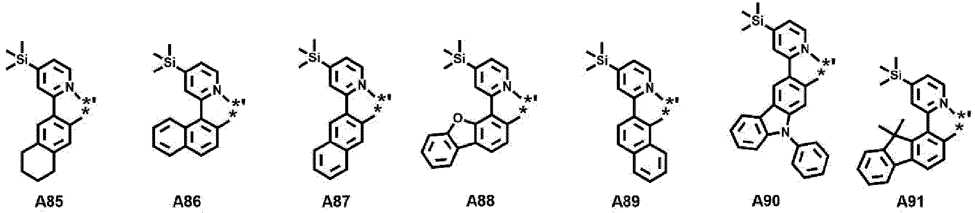 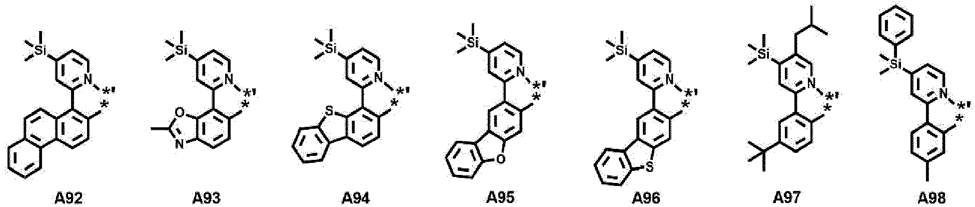 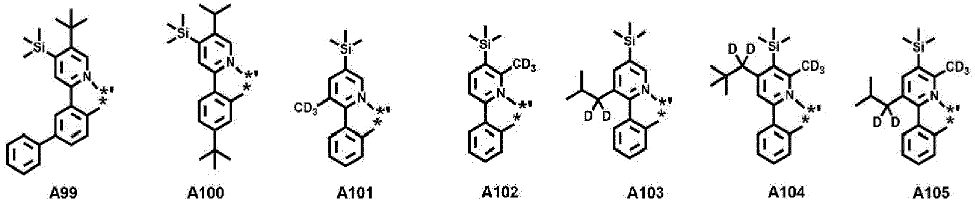 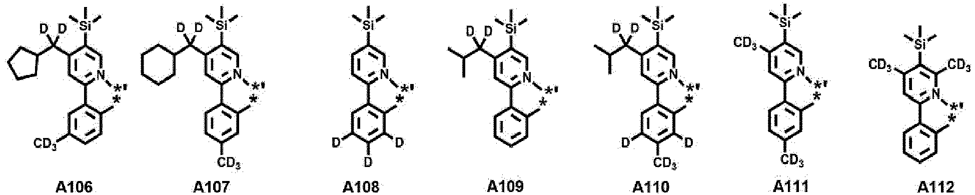 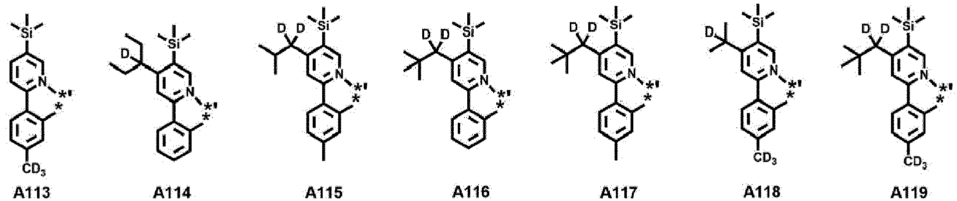 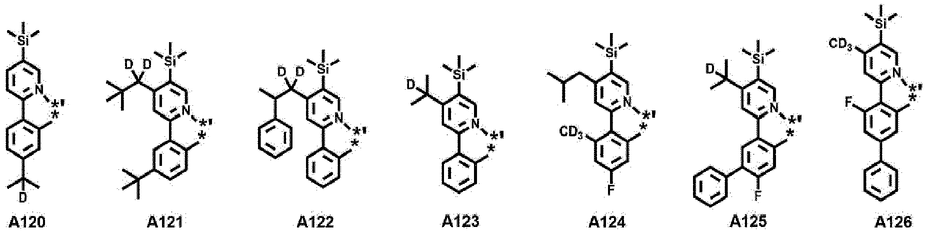 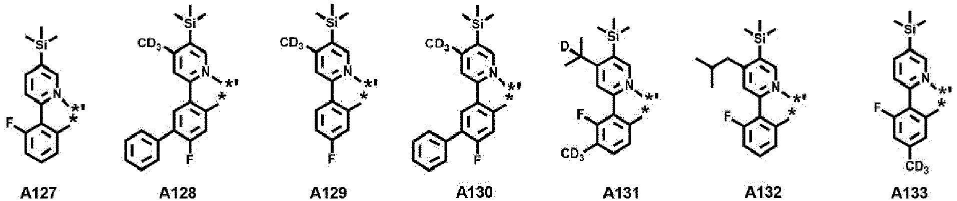 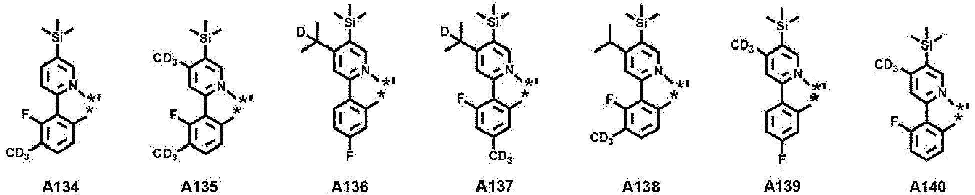 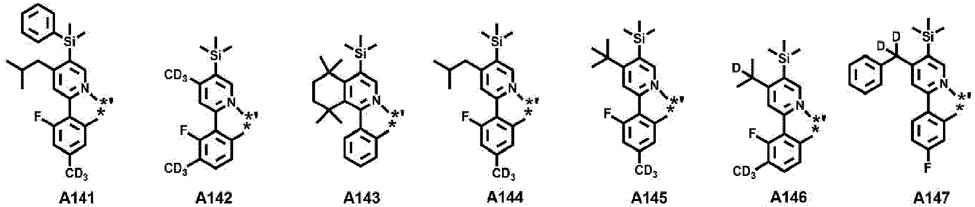 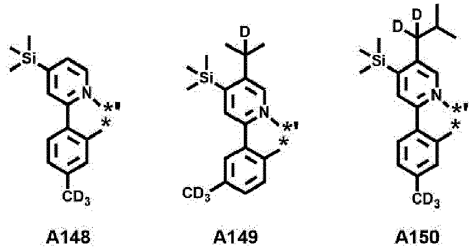 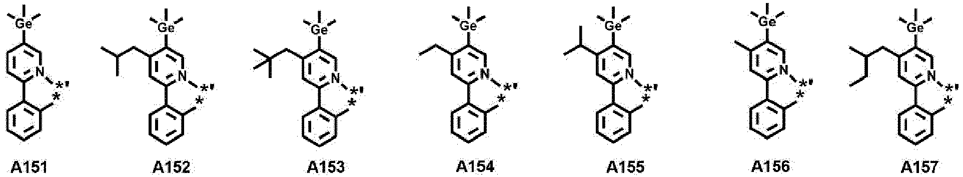 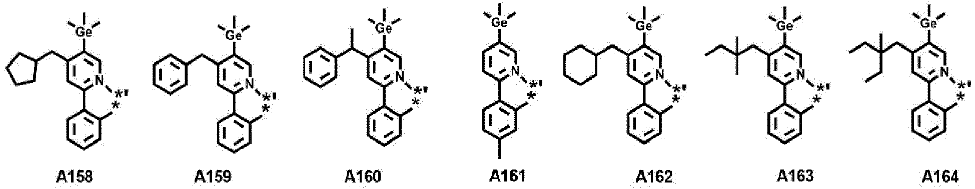 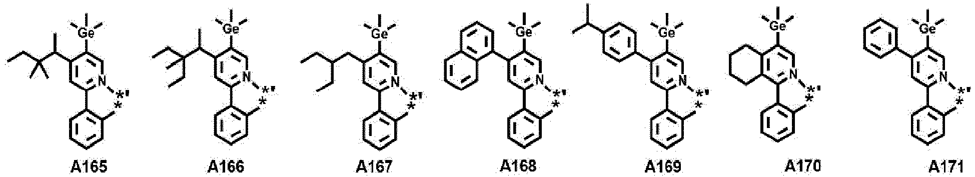 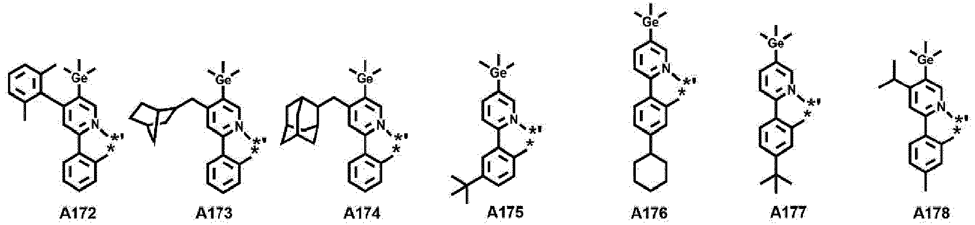 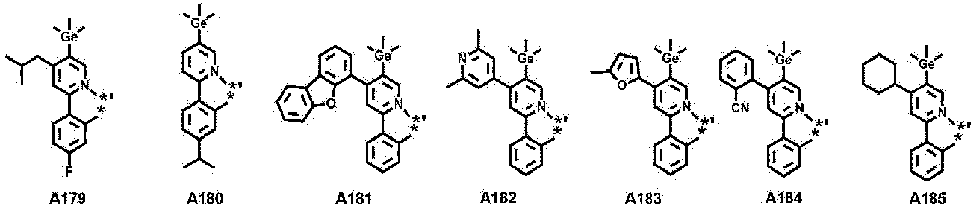 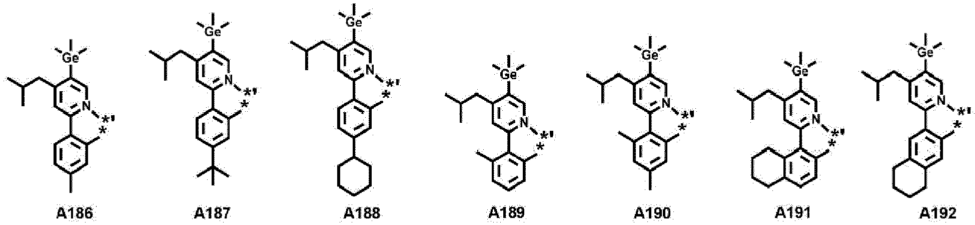 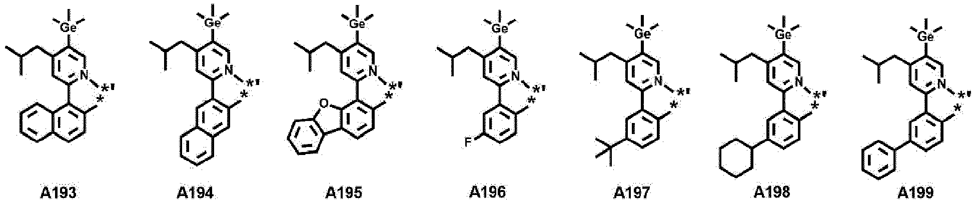 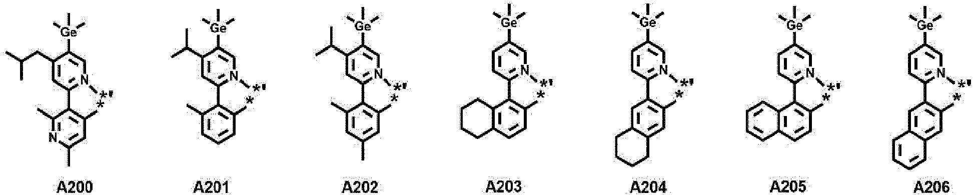 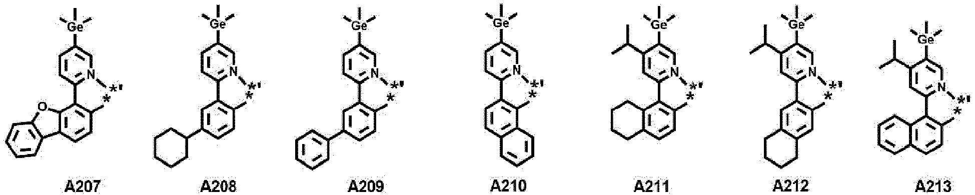 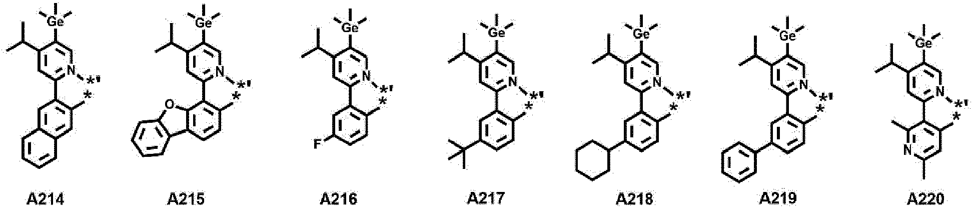 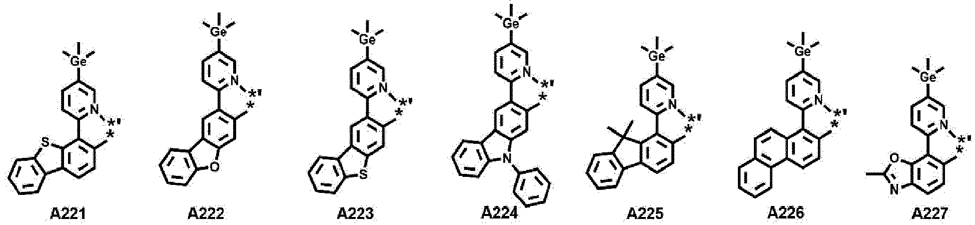 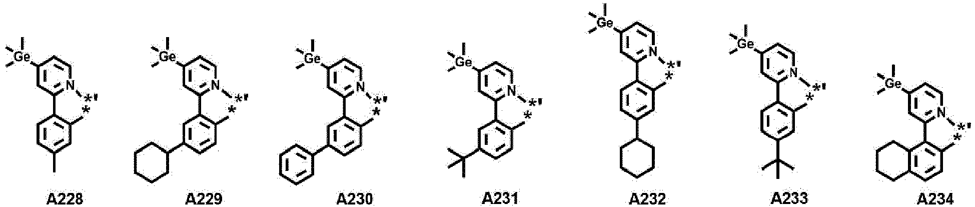 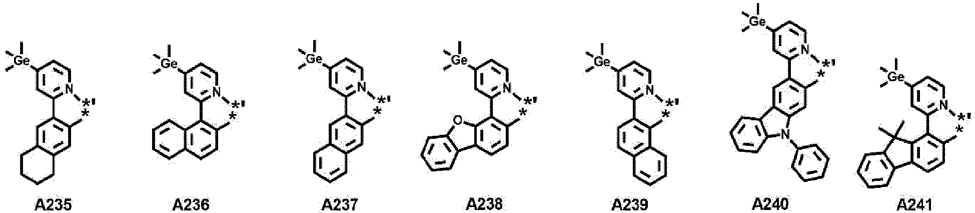 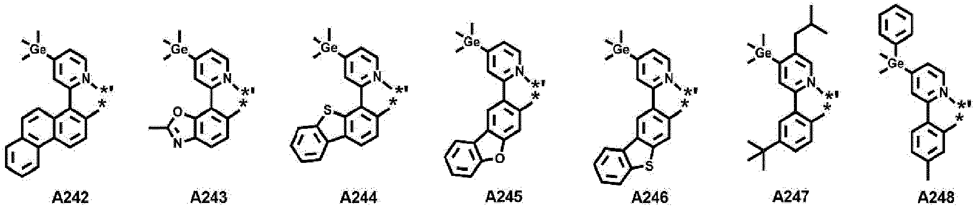 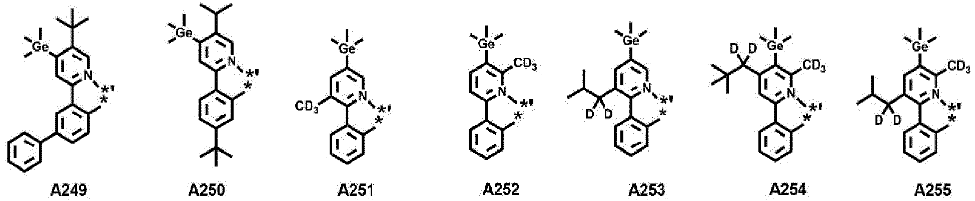 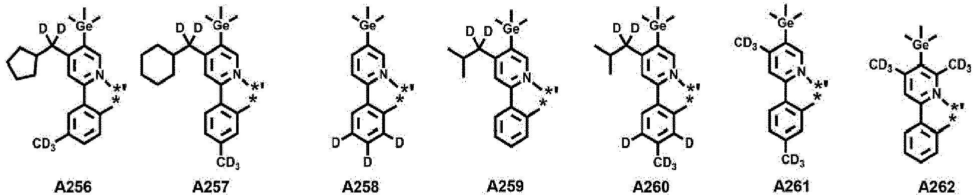 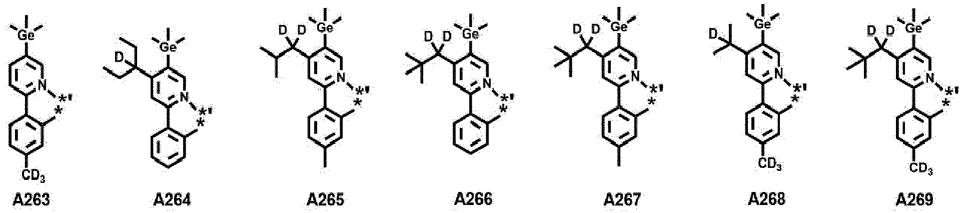 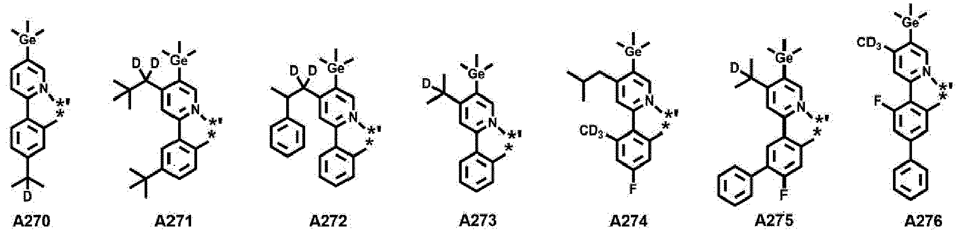 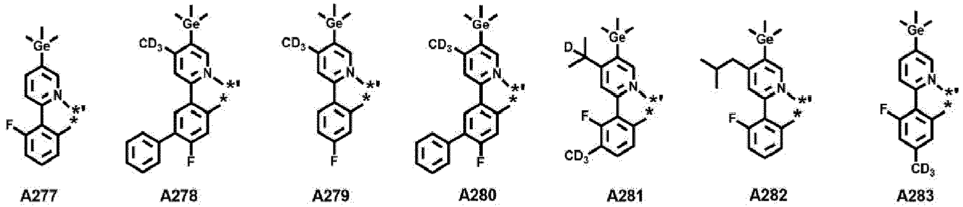 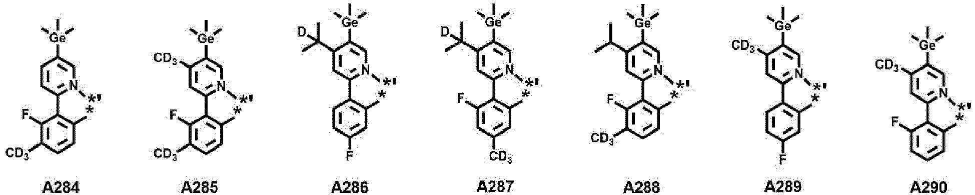 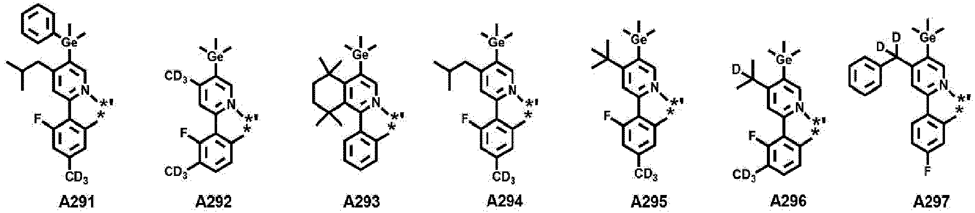 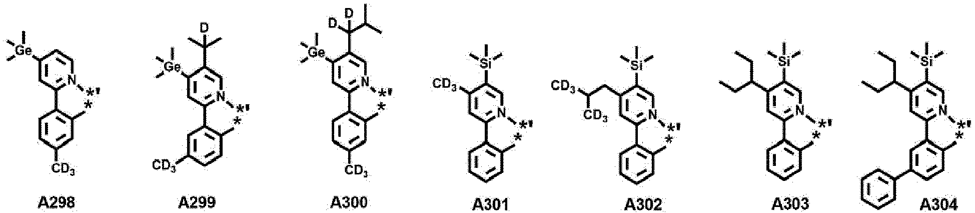 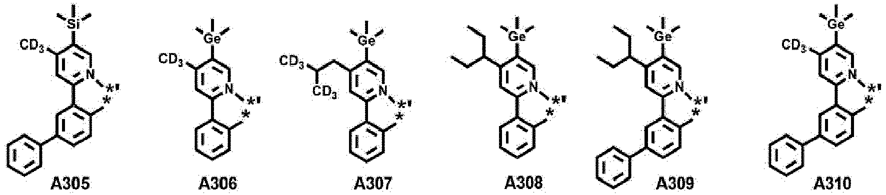 wherein, in Formulae A1 to A310, * and *' each indicate a binding site to M in Formula 1.

in one or more embodiments, L₂ in Formula 1 may be a ligand represented by one of Formulae B1 to B660: 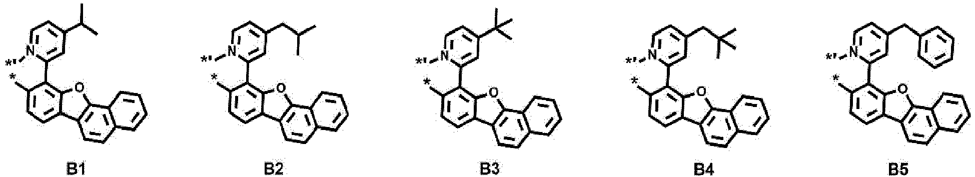 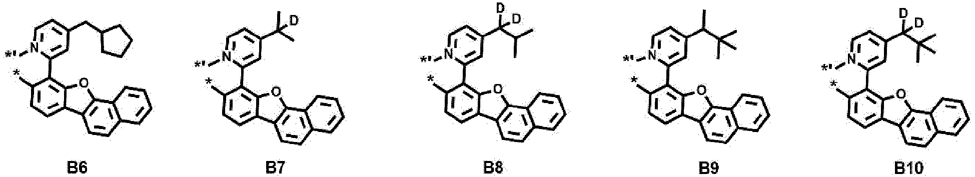 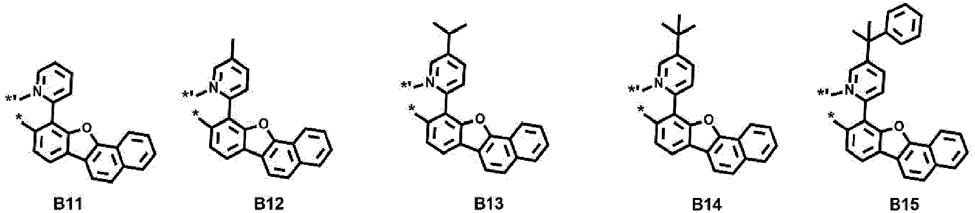 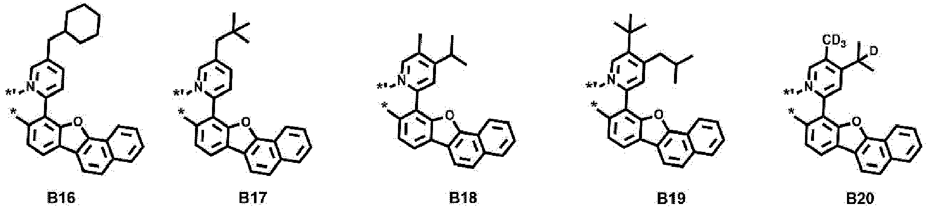 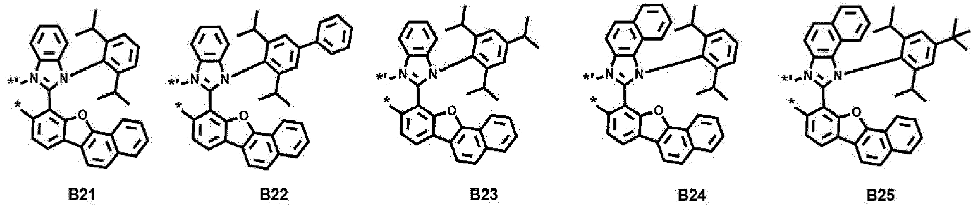 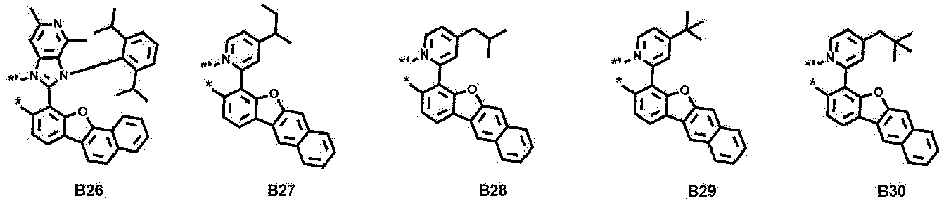 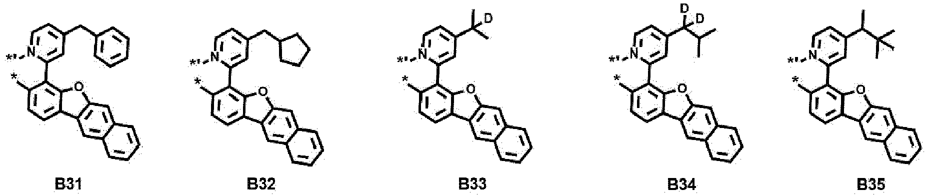 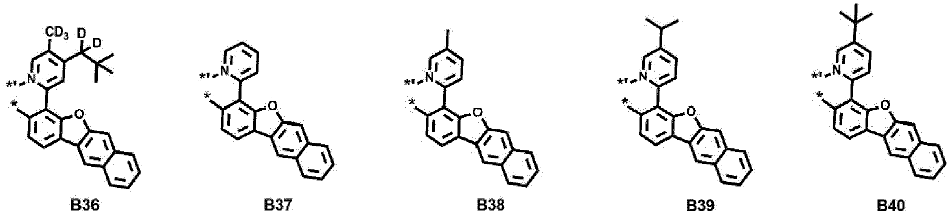 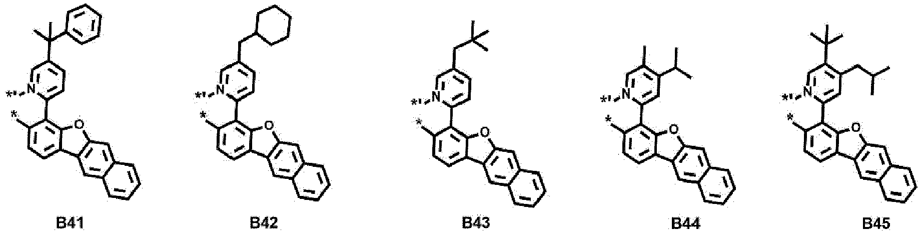 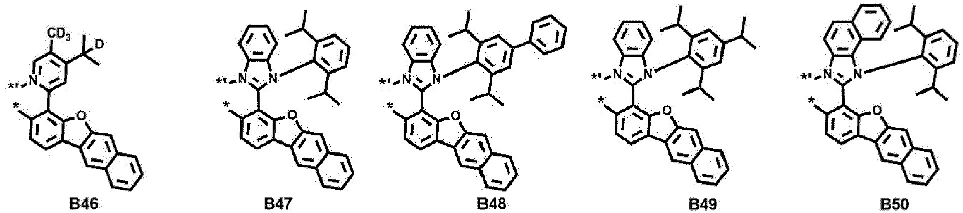 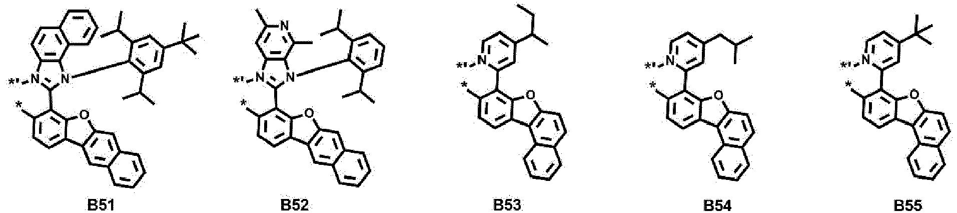 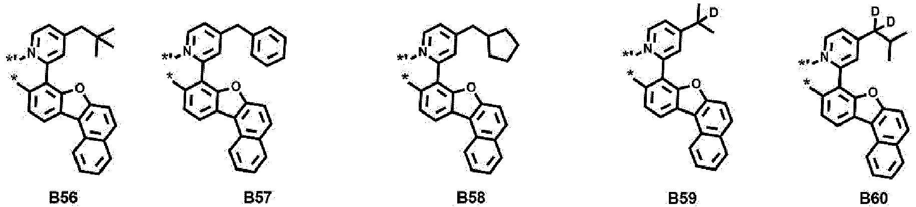 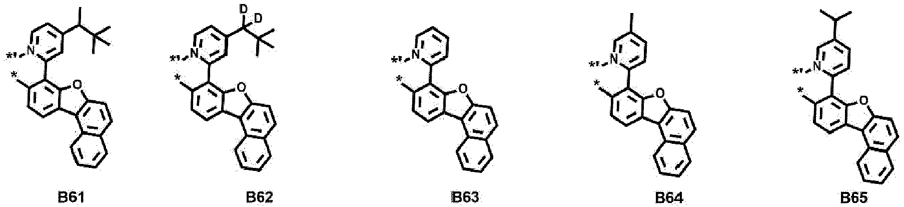 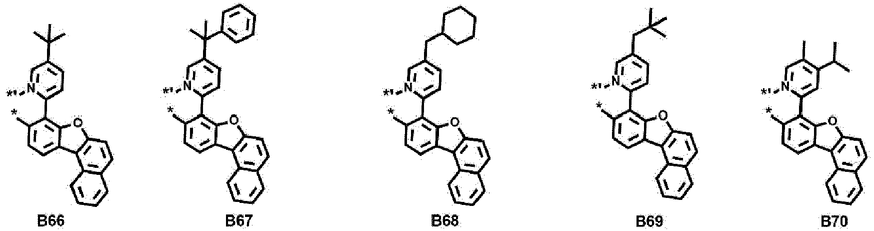 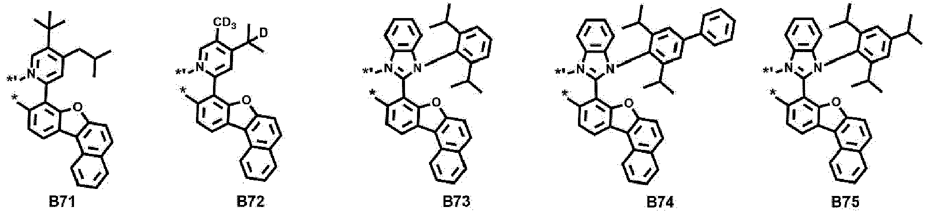 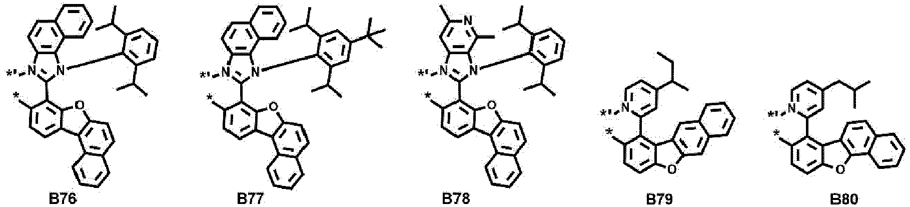 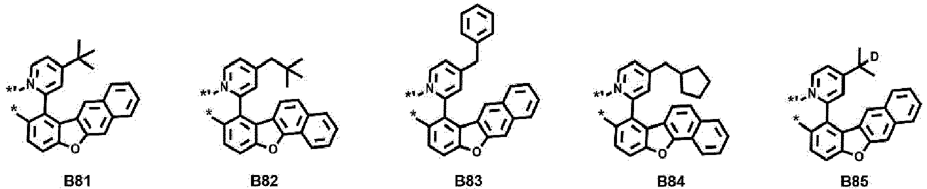 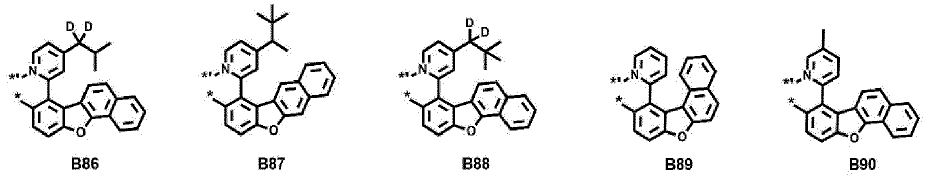 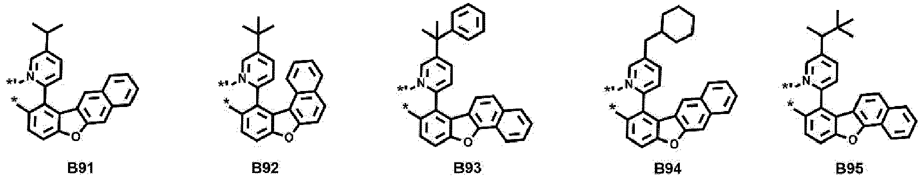 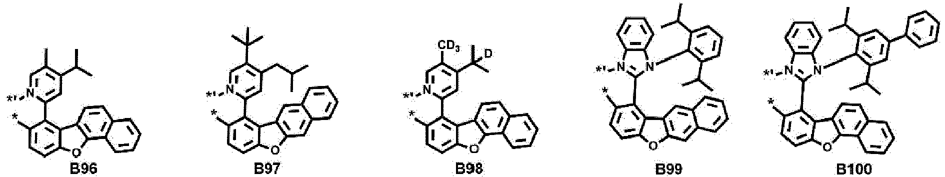 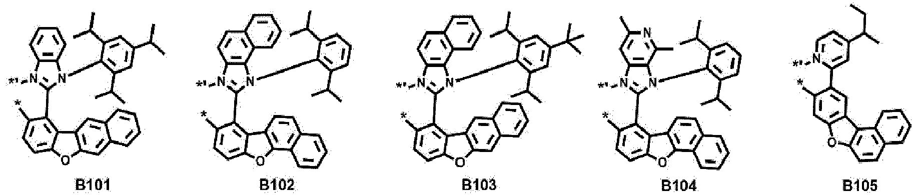 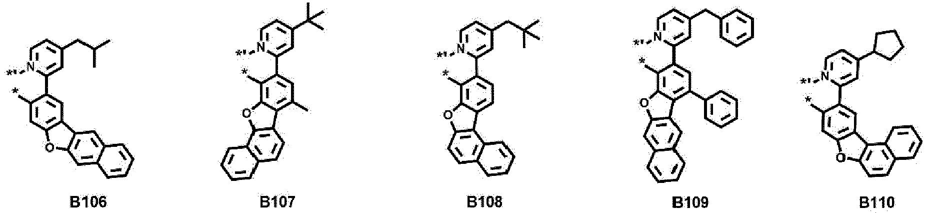 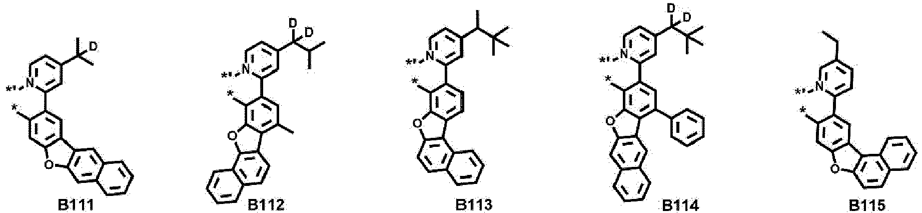 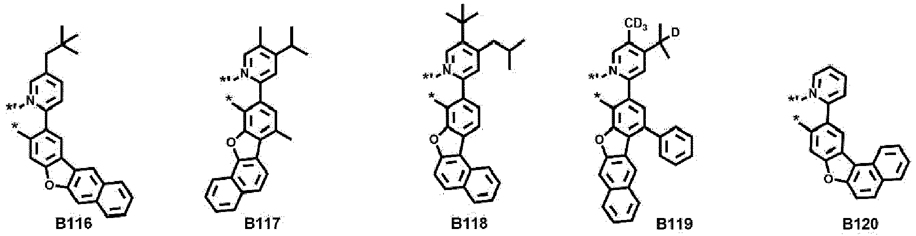 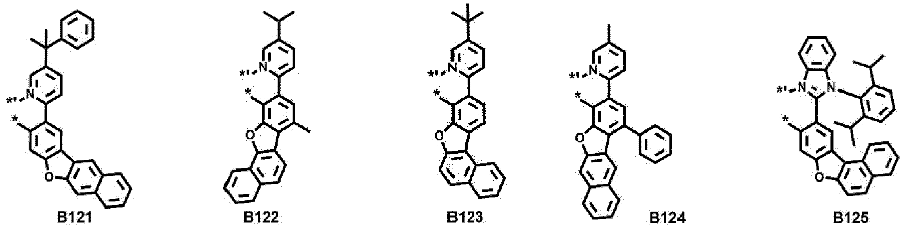 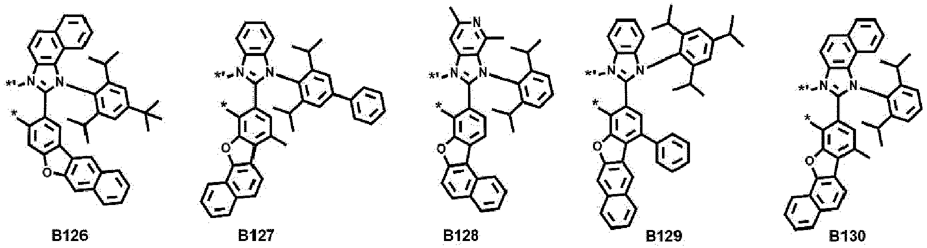 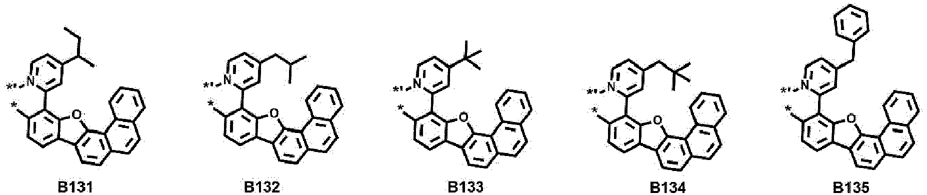 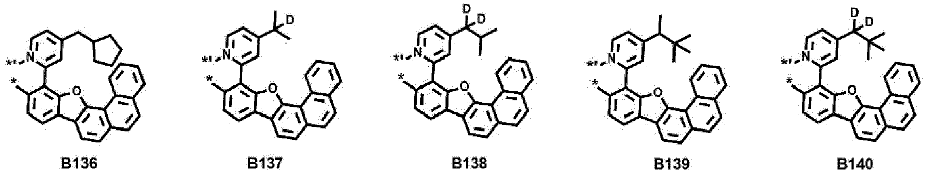 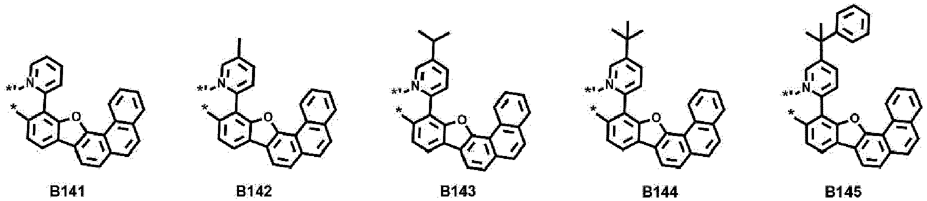 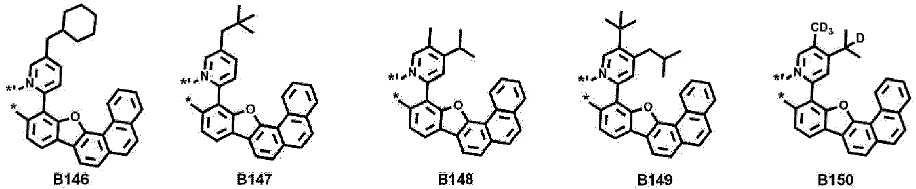 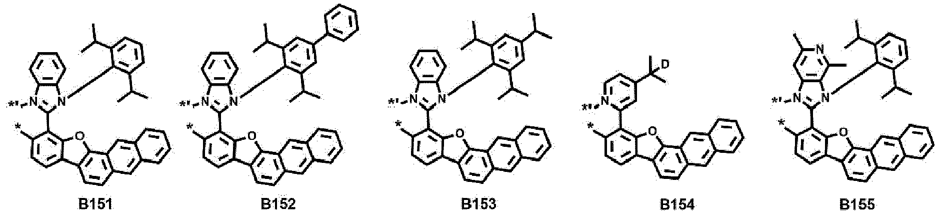 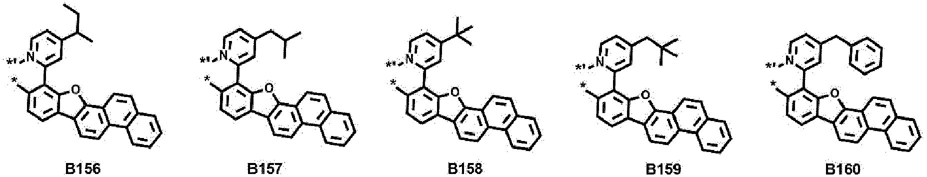 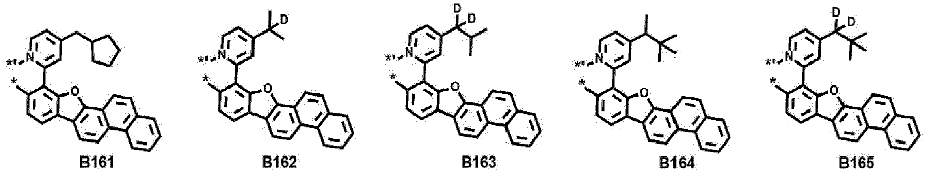 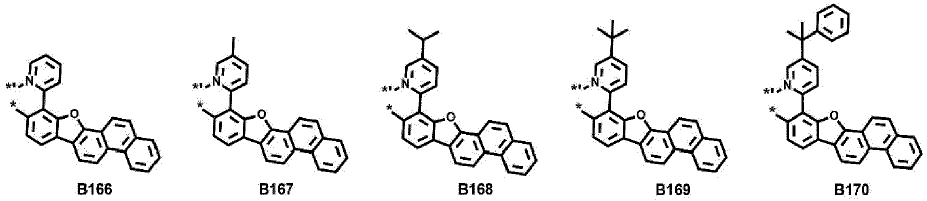 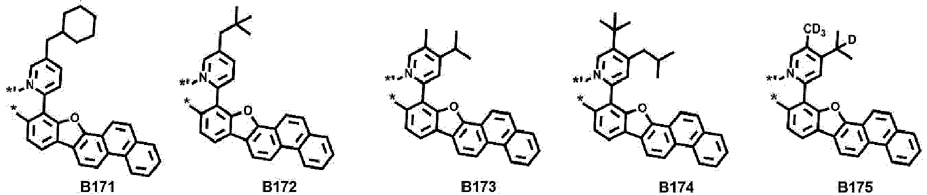 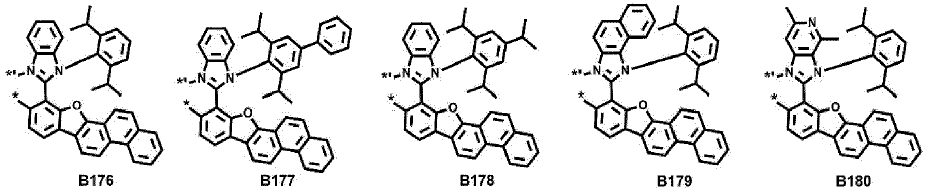 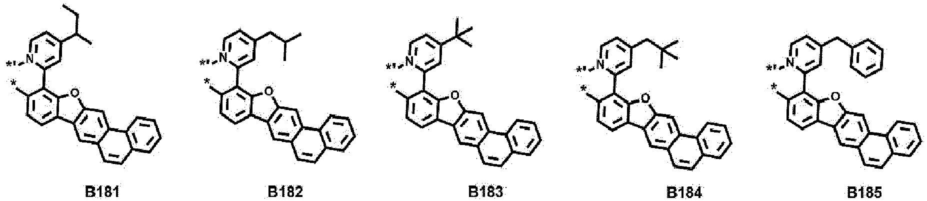 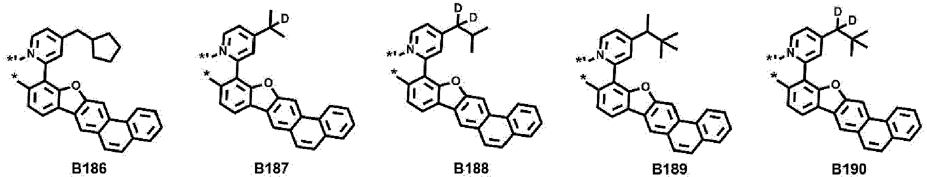 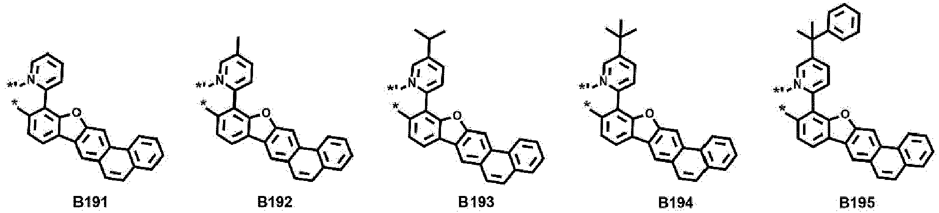 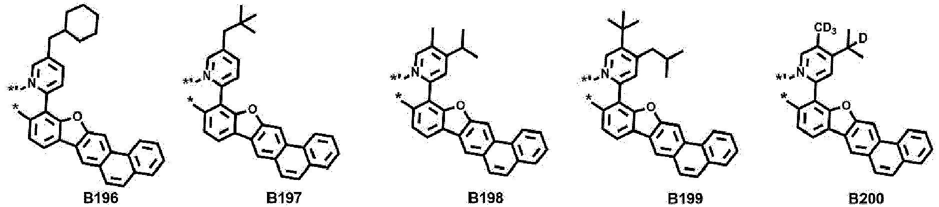 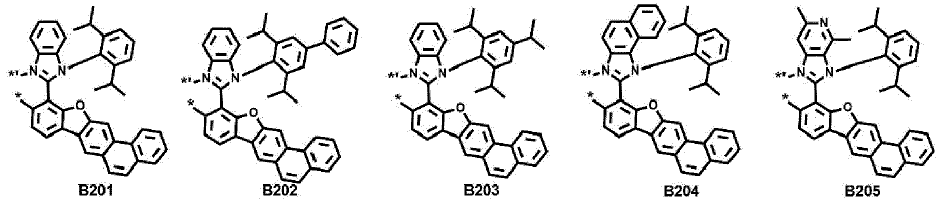 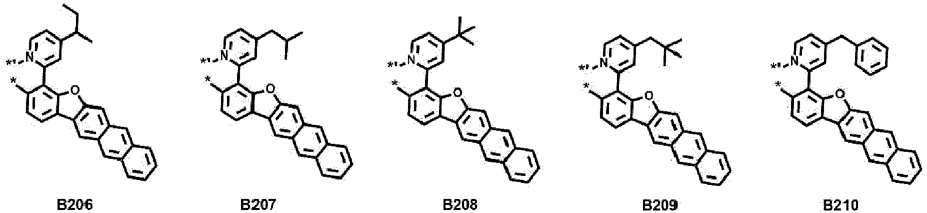 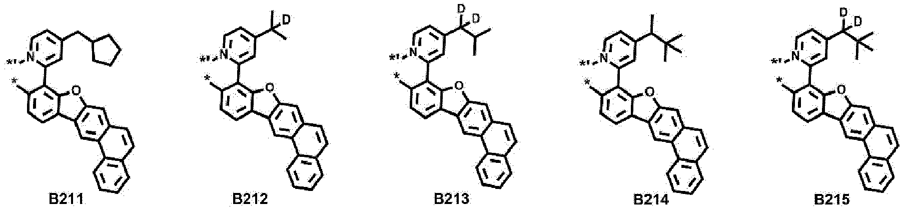 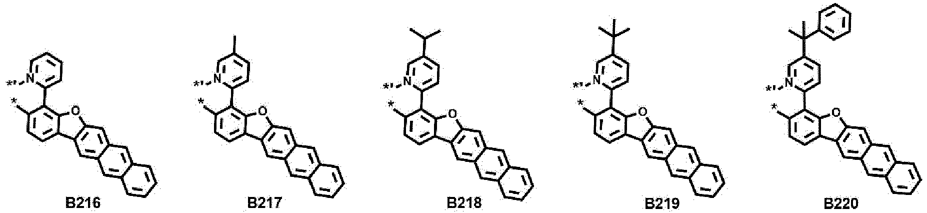 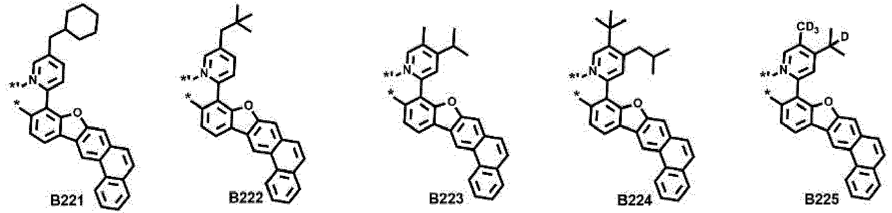 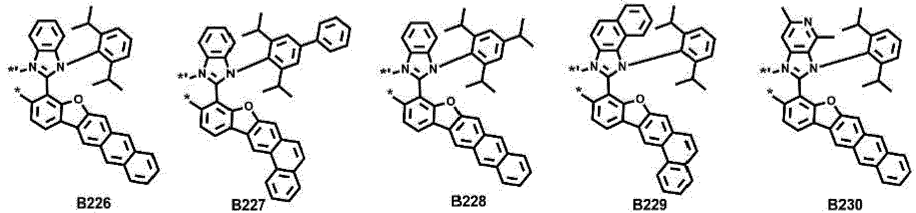 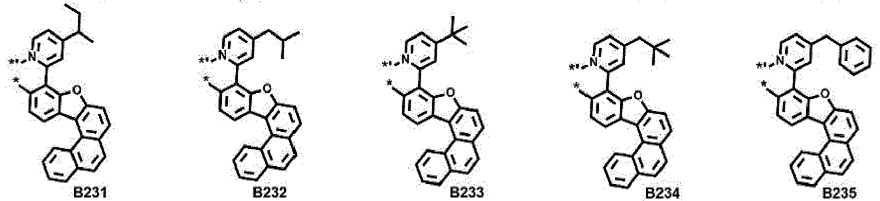 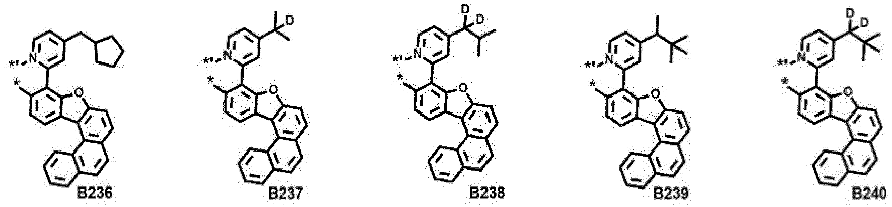 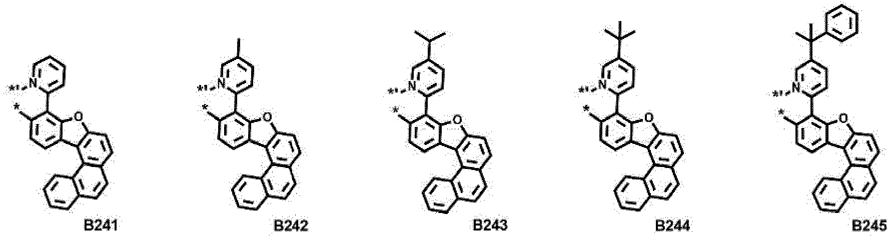 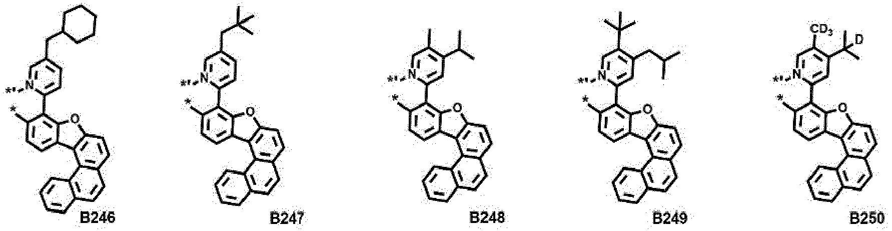 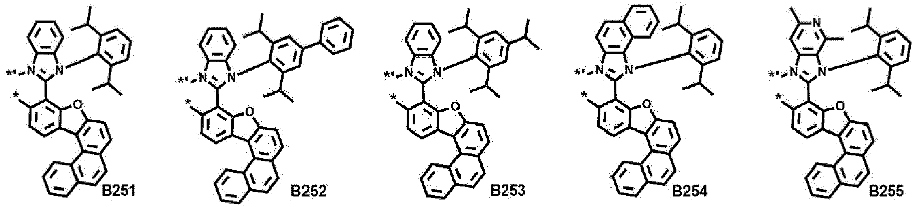 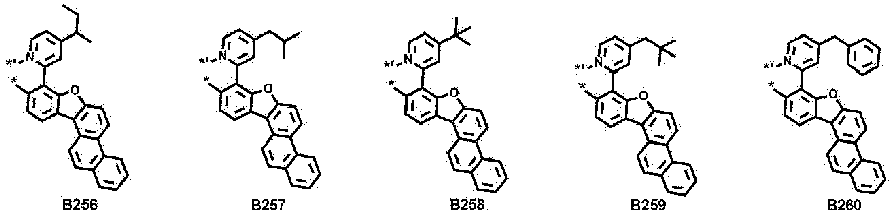 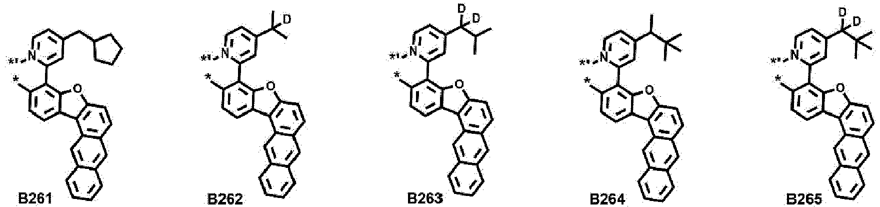 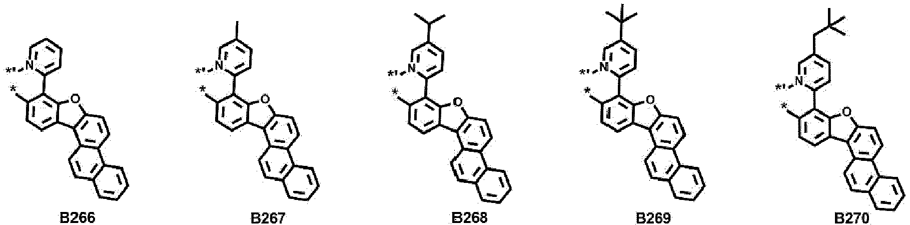 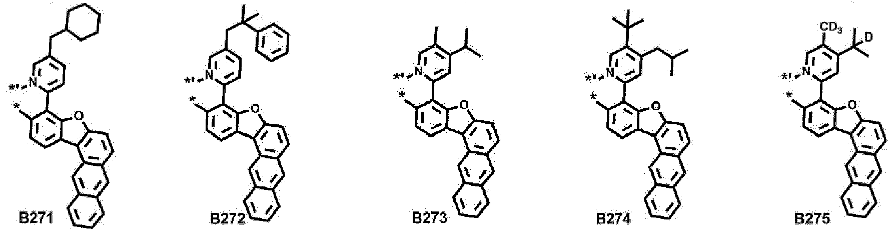 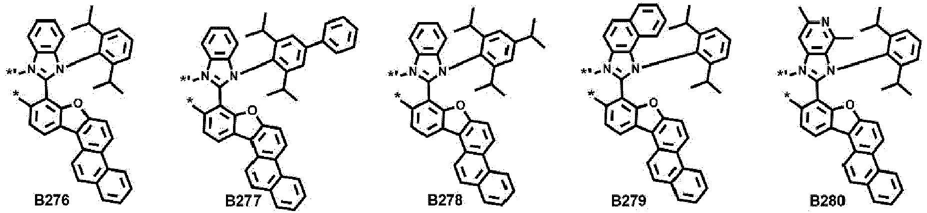 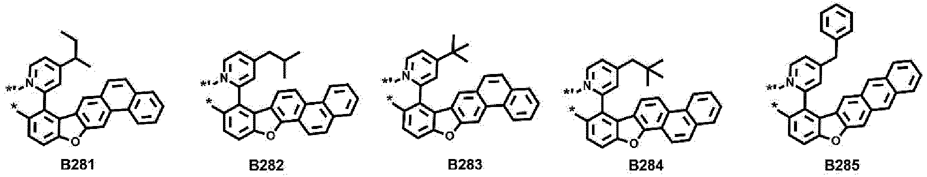 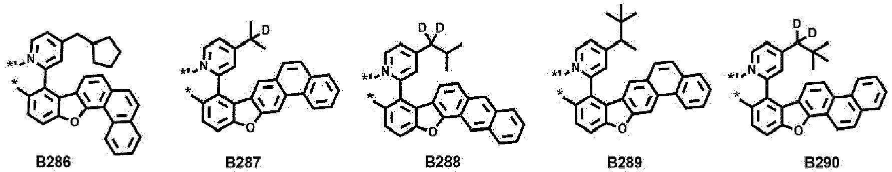 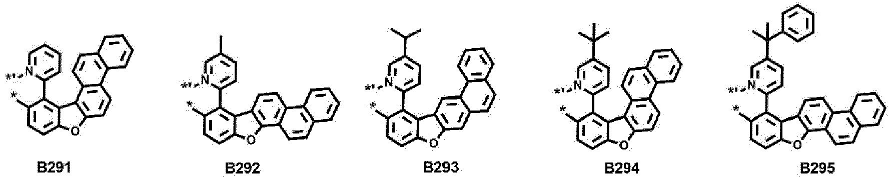 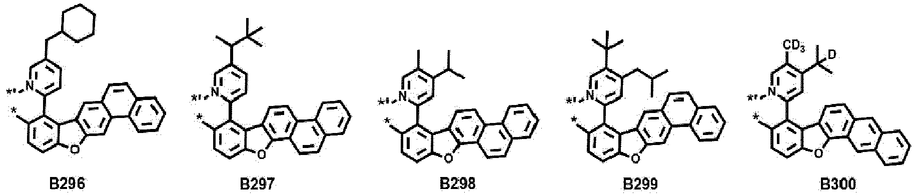 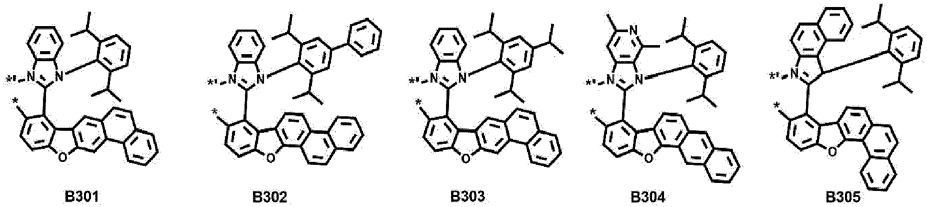 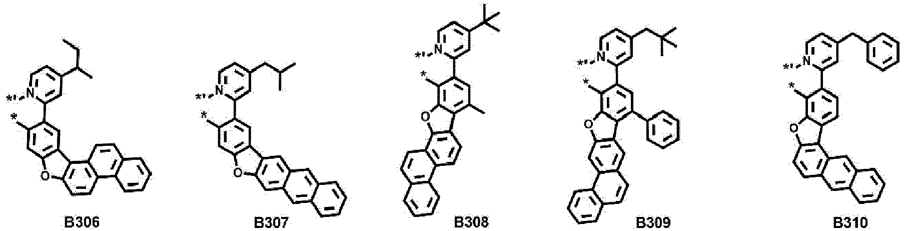 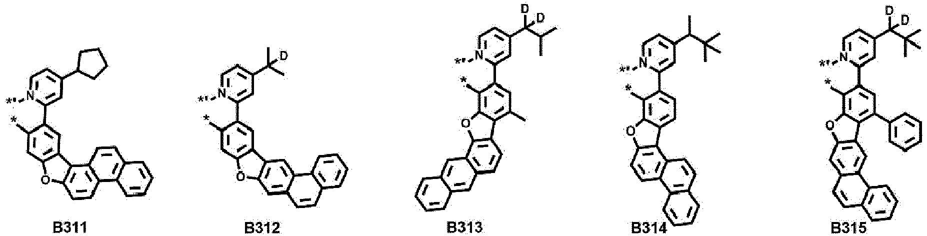 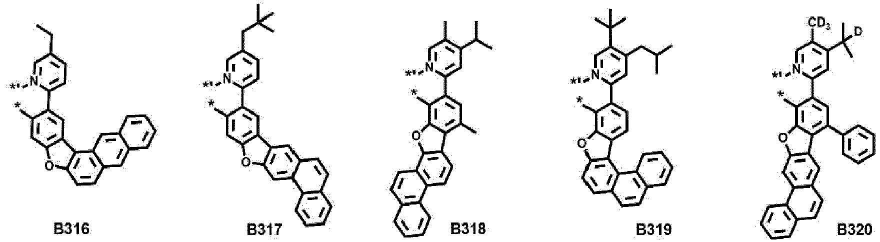 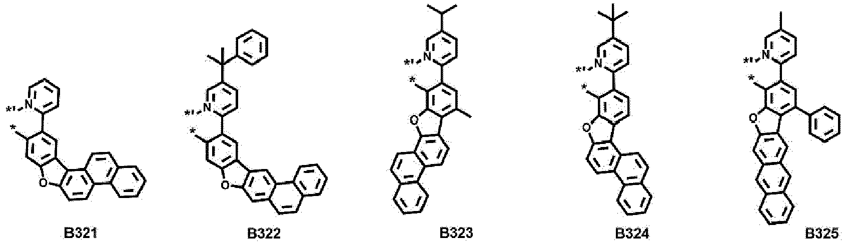 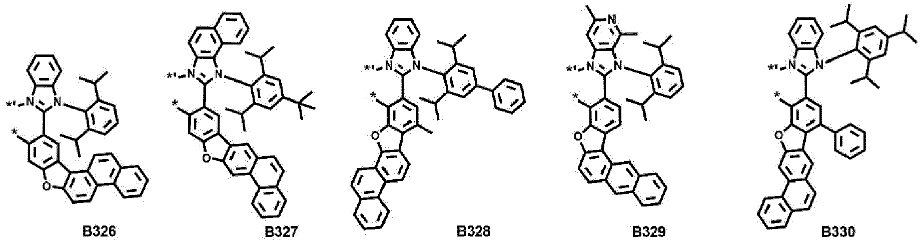 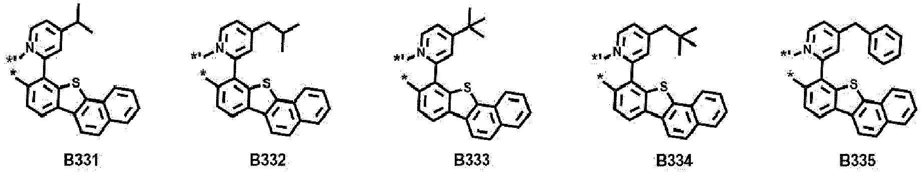 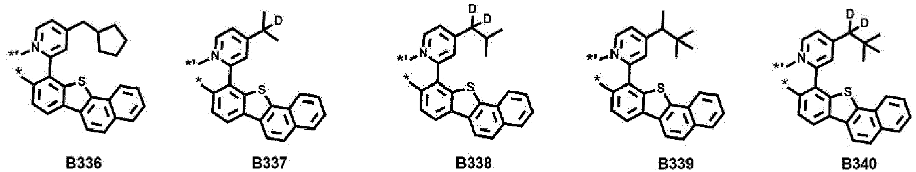 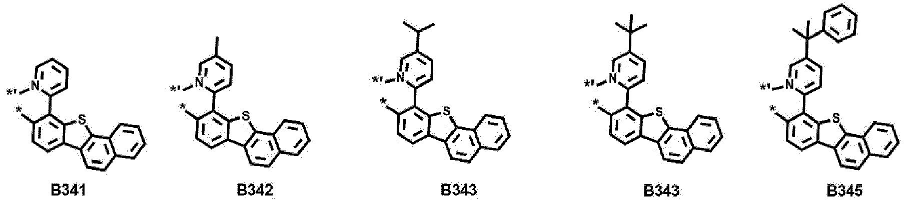 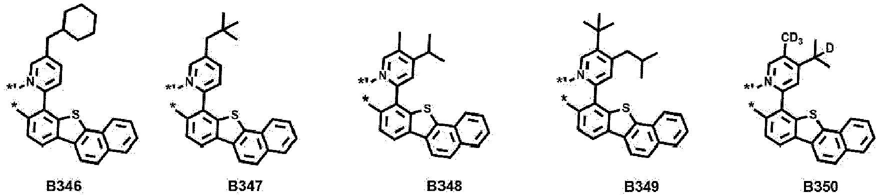 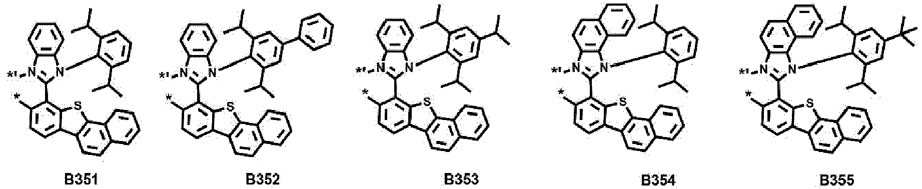 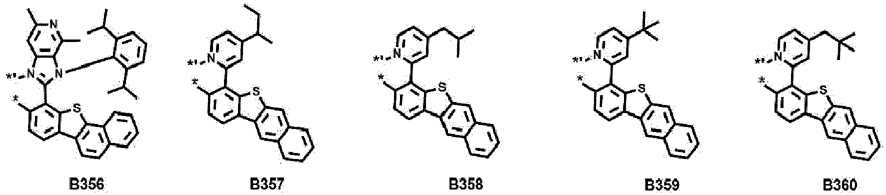 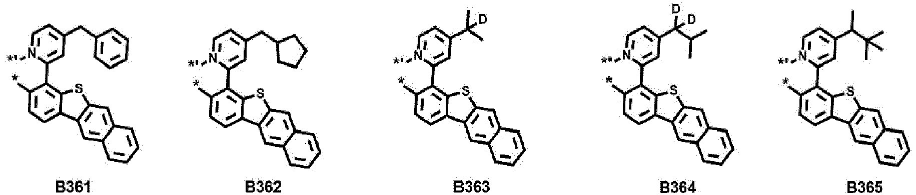 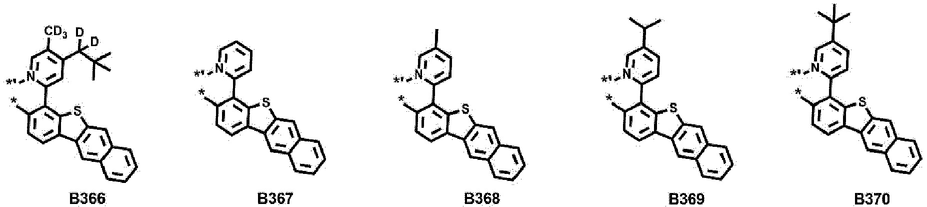 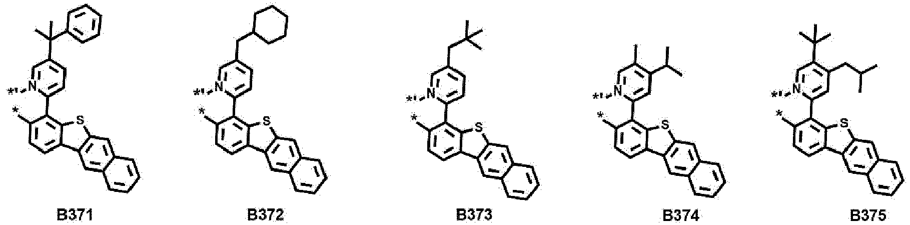 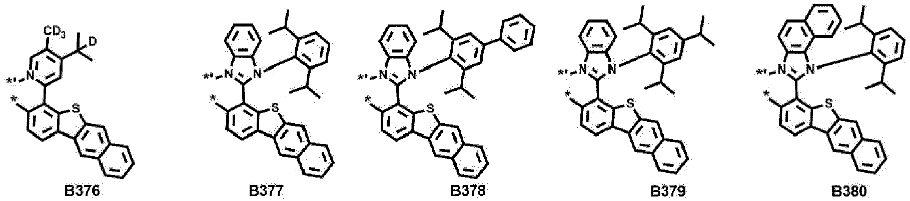 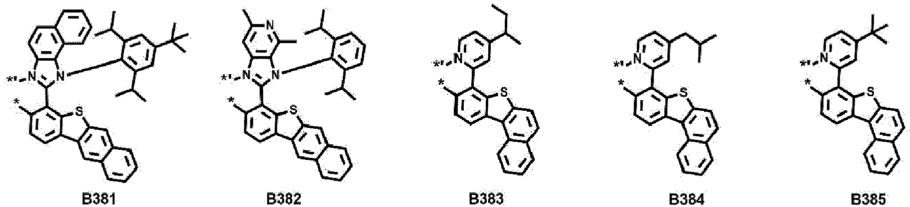 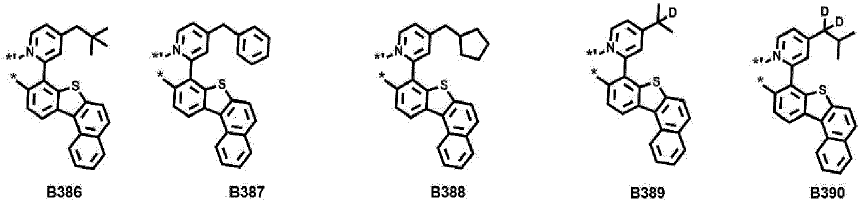 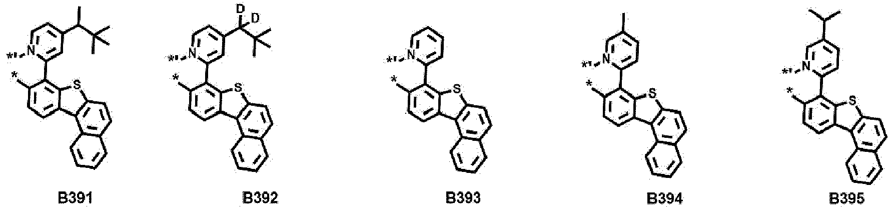 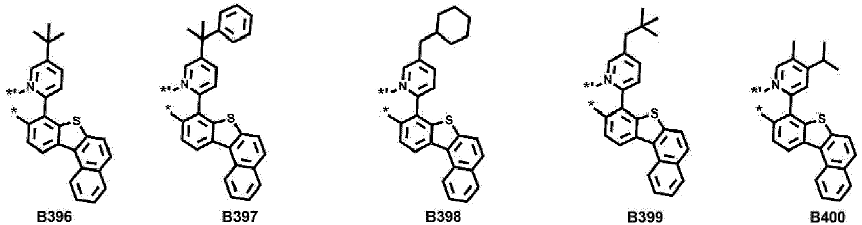 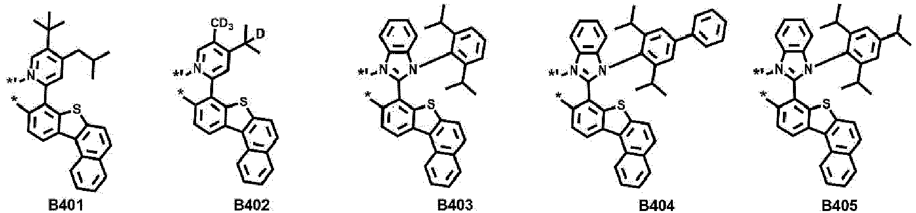 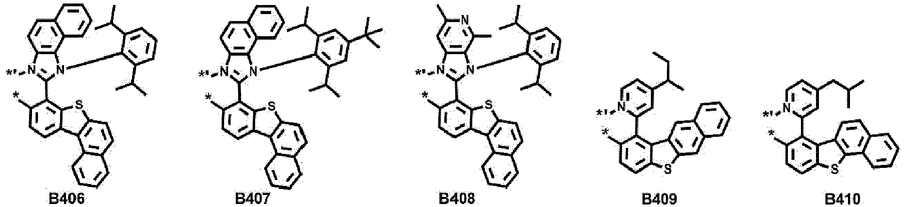 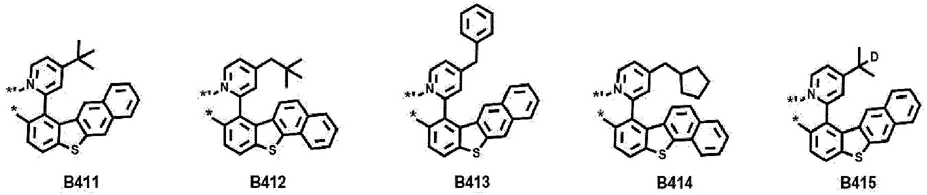 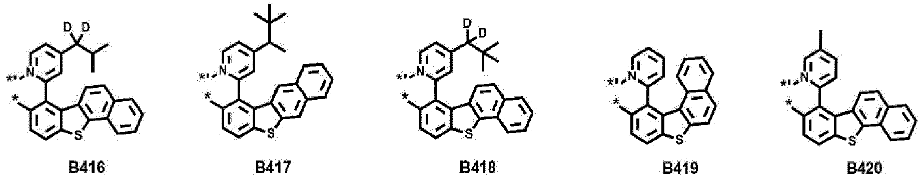 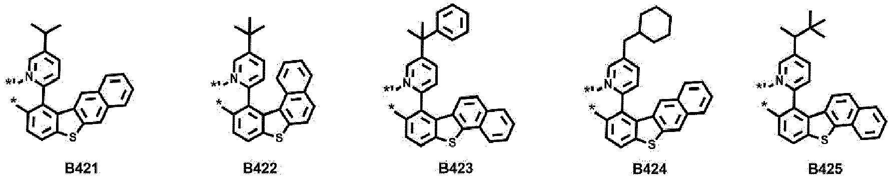 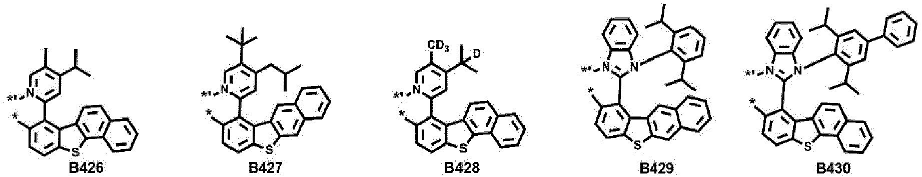 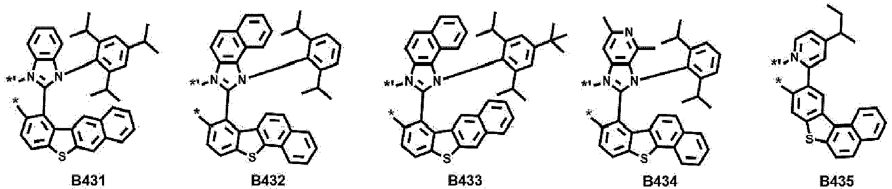 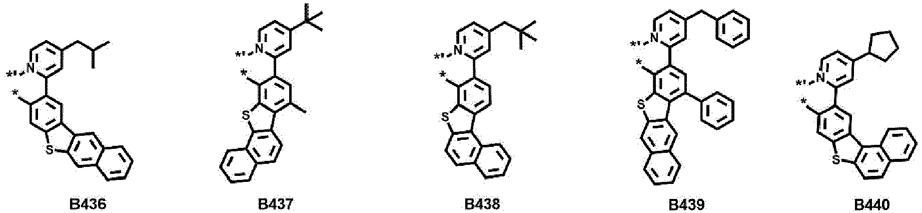 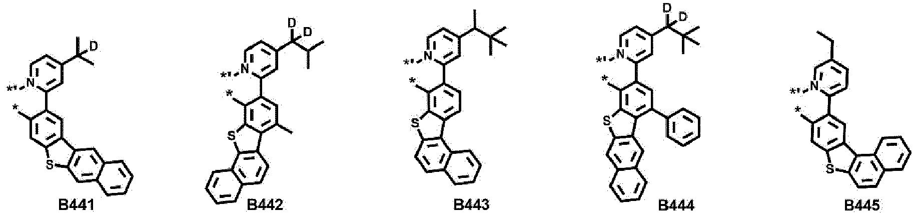 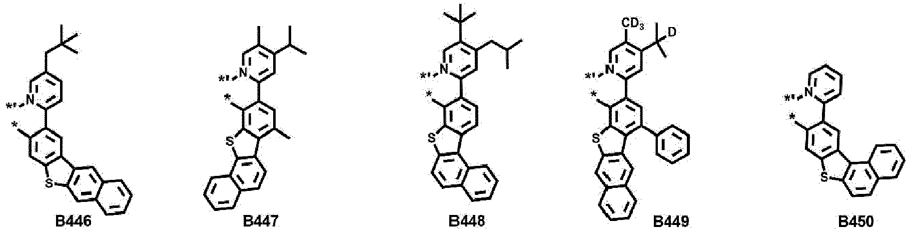 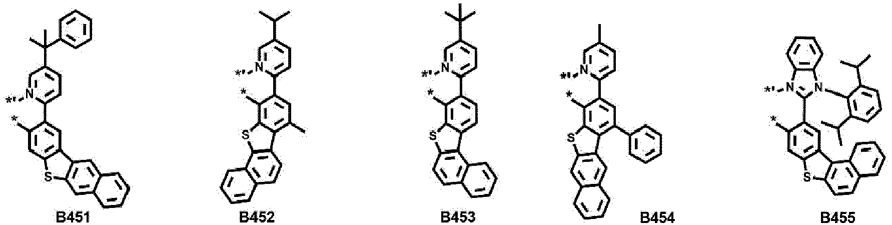 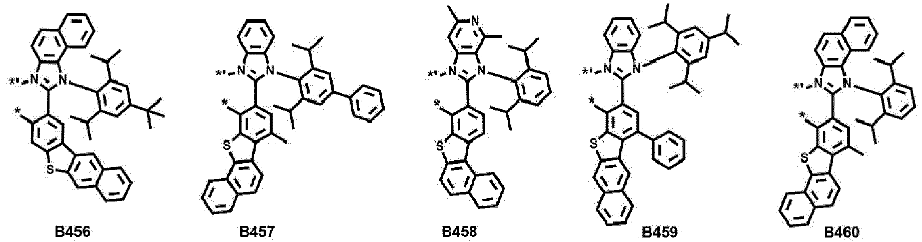 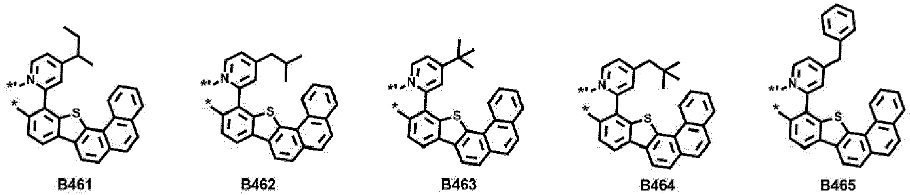 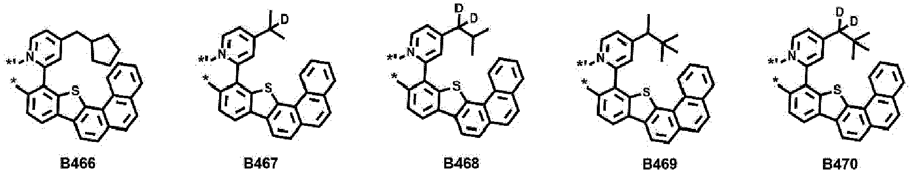 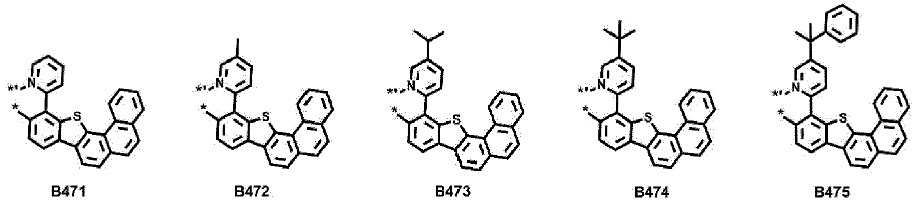 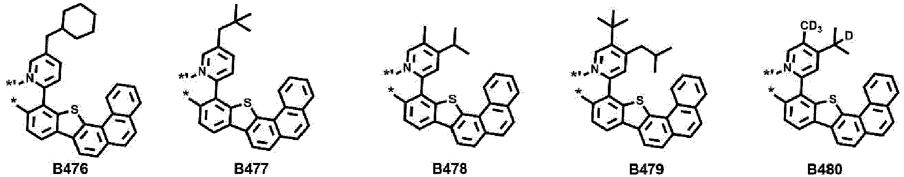 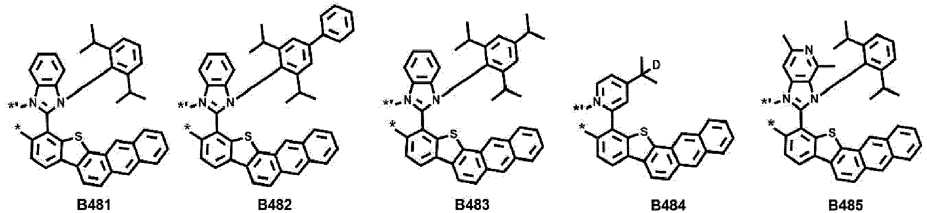 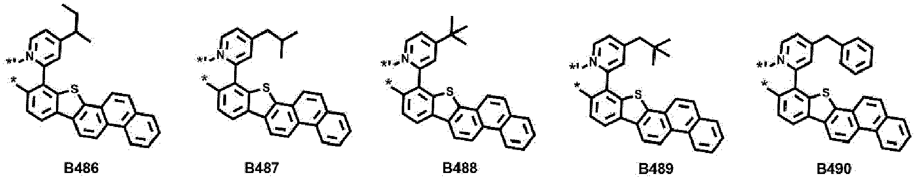 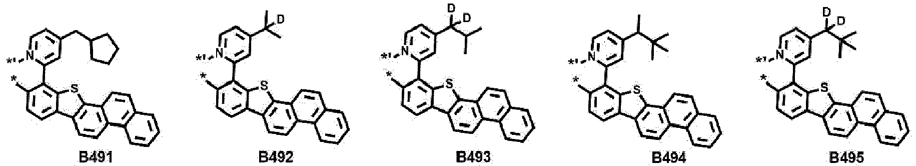 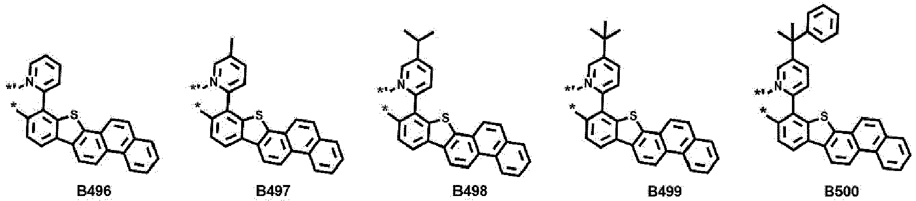 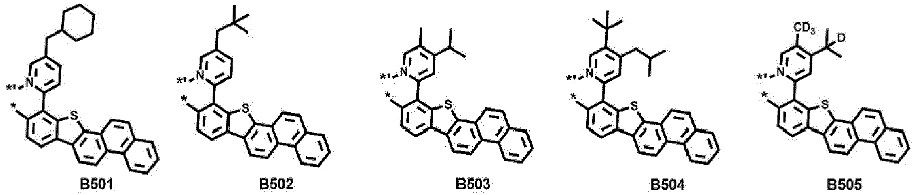 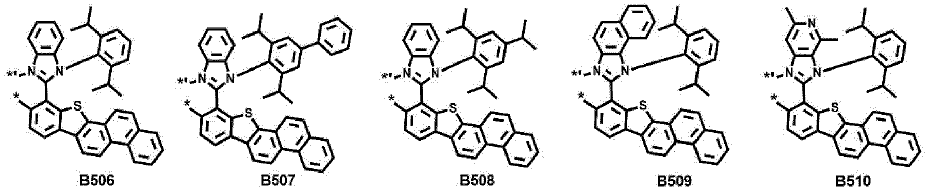 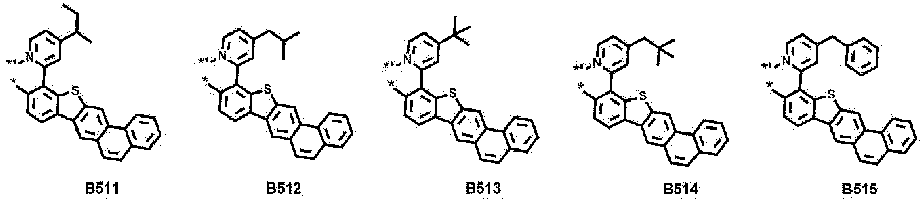 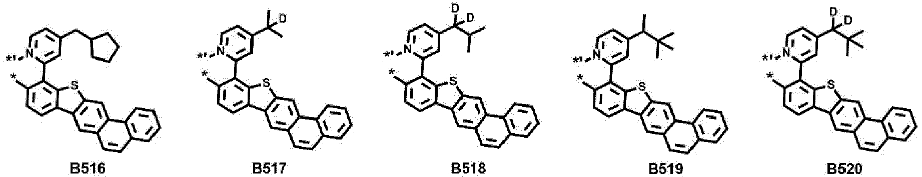 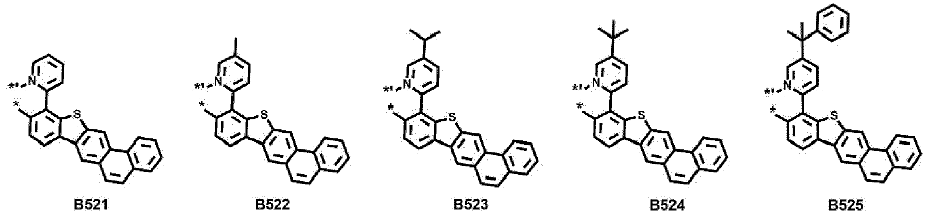 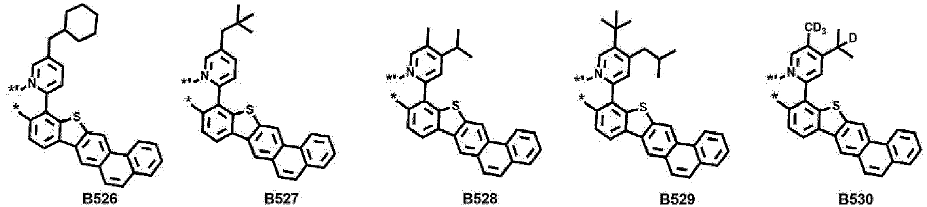 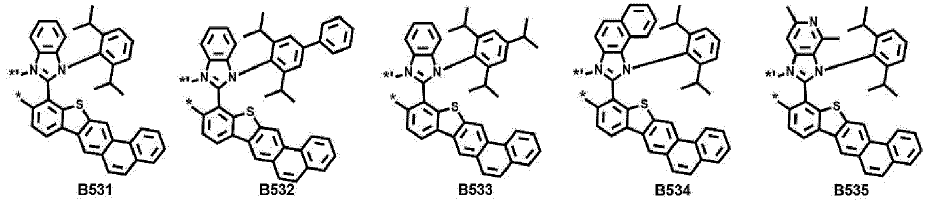 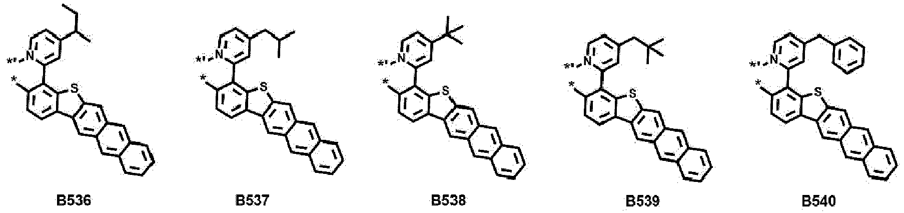 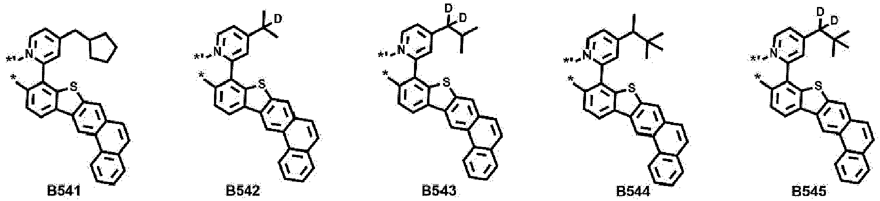 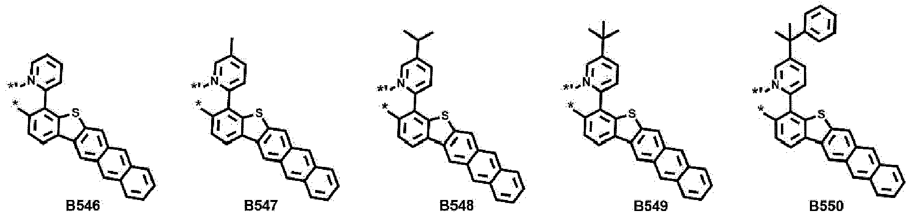 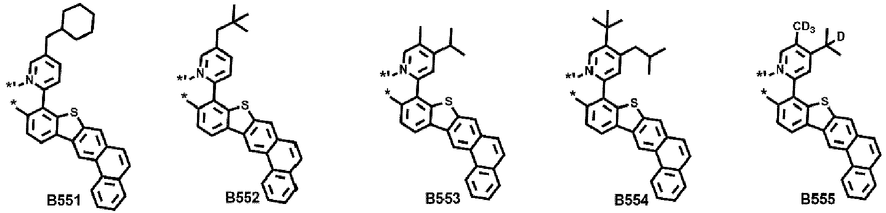 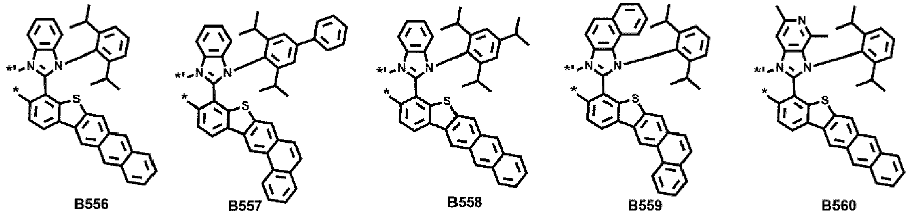 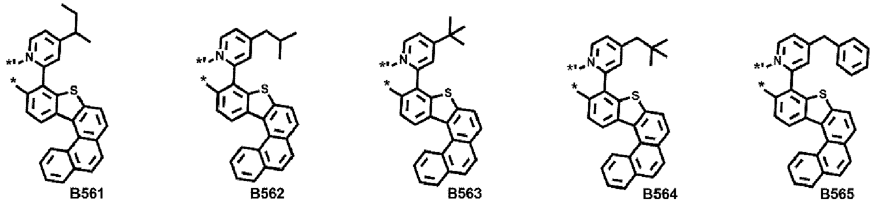 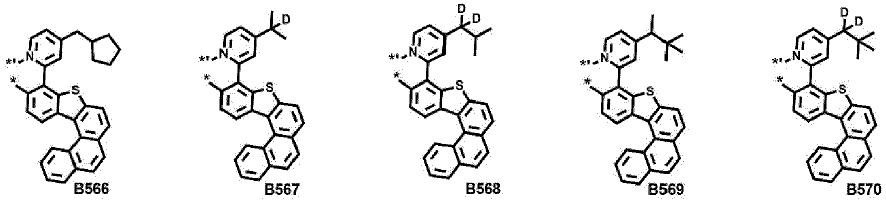 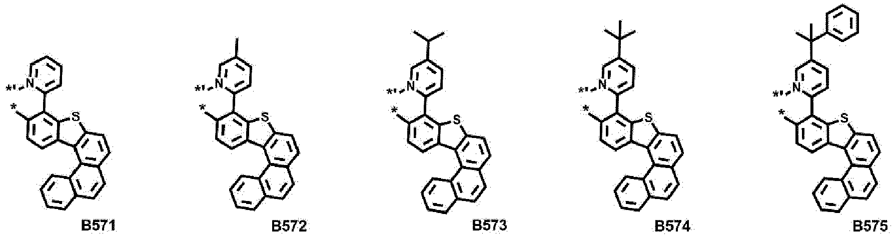 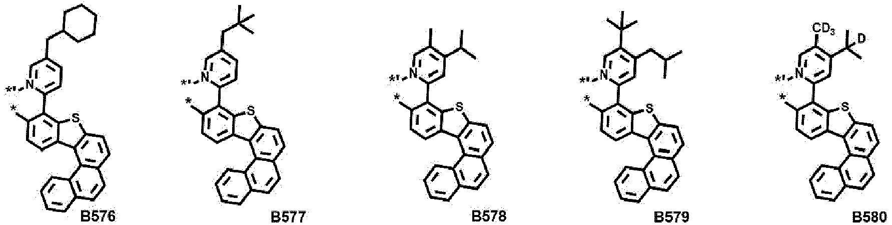 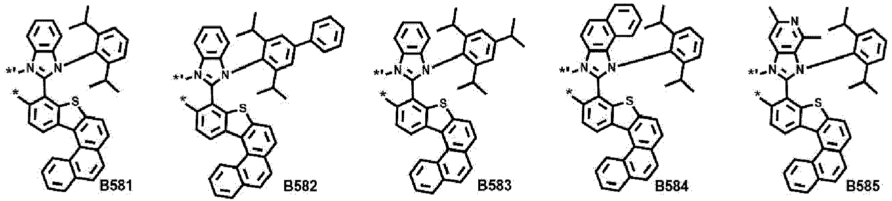 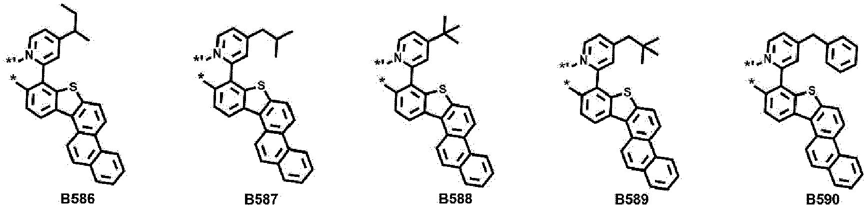 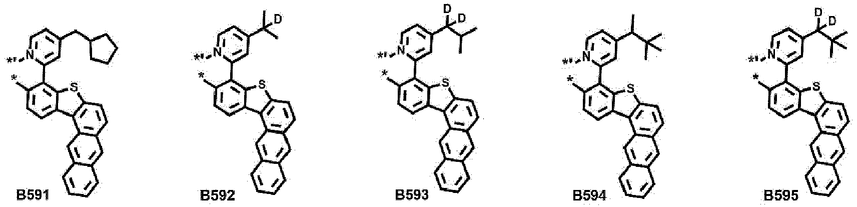 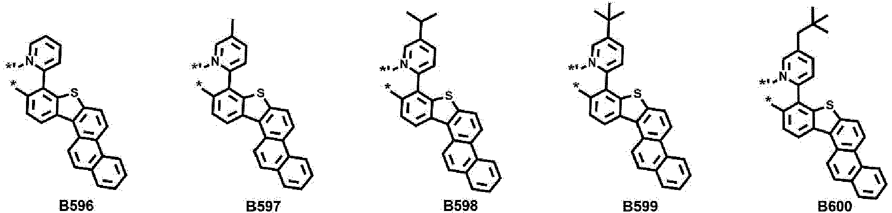 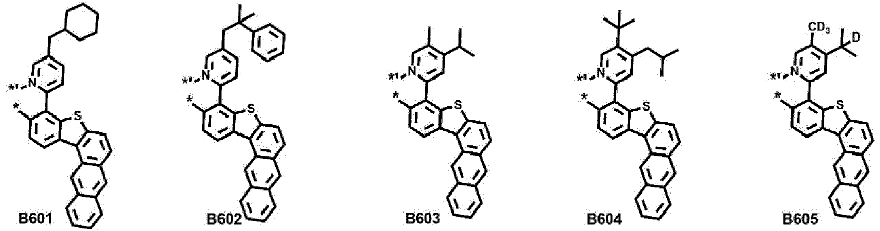 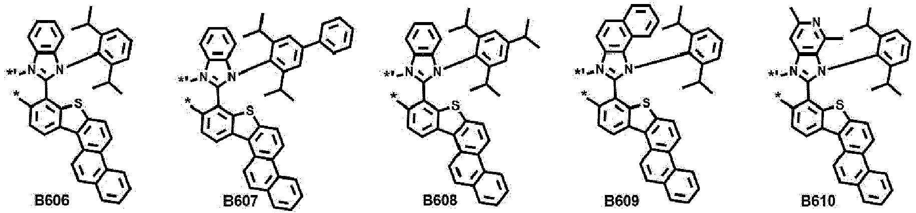 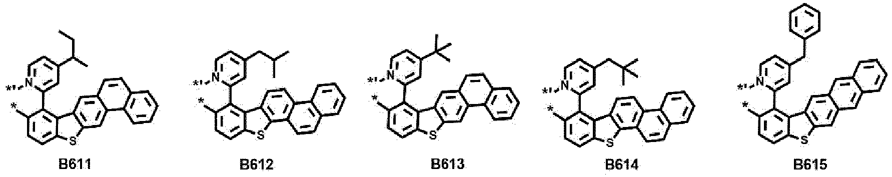 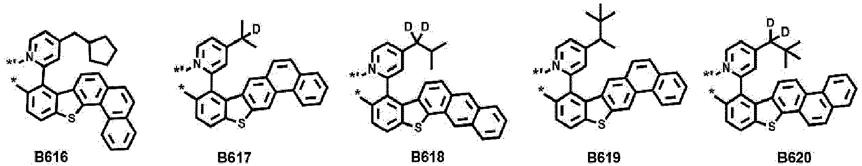 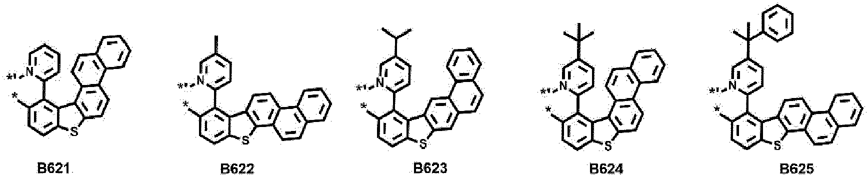 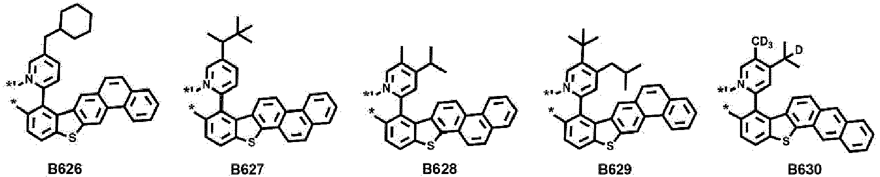 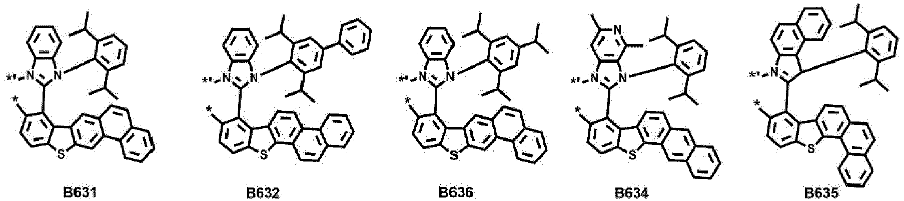 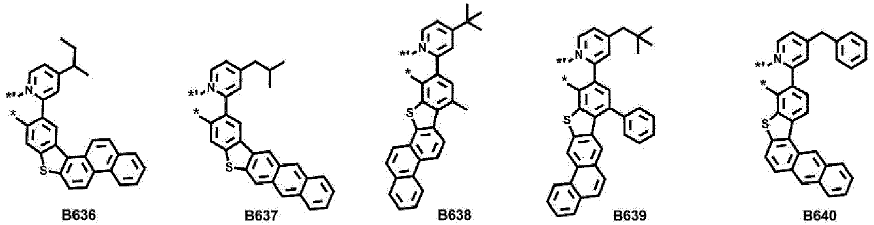 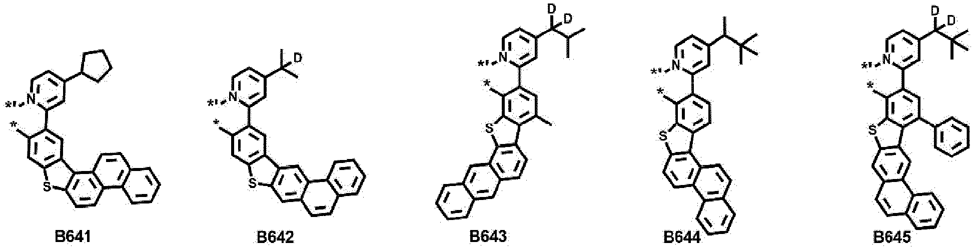 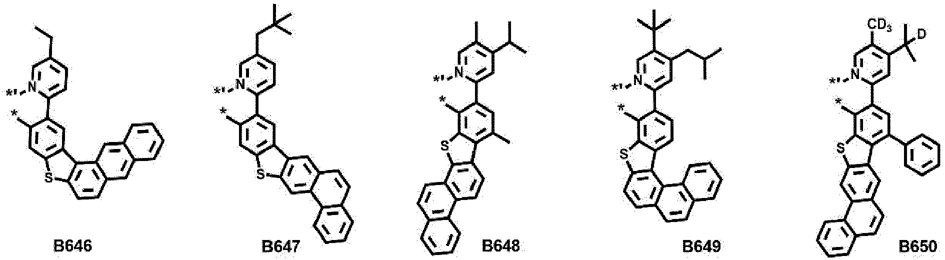 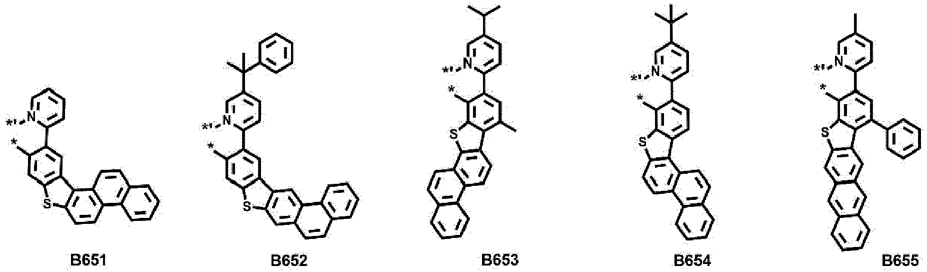 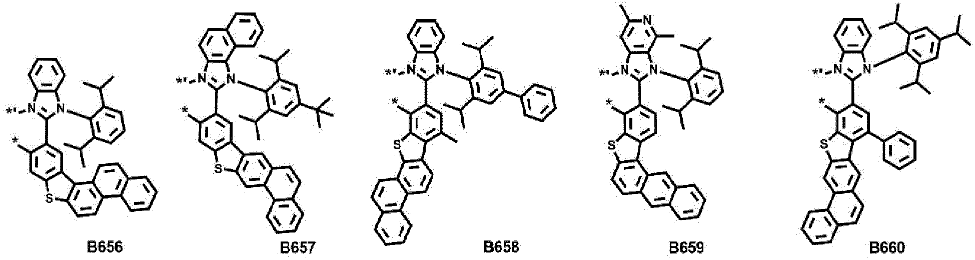 wherein, in Formulae B1 to B660, * and *' each indicate a binding site to M in Formula 1.

in one or more embodiments, the organometallic compound may be represented by Formula 1, wherein M in Formula 1 may be iridium, and L₁, L₂, n1, and n2 may each be as defined in Tables 1 to 96:

**Table 1**

| Compound No. | L₁ | L₂ | n1 | n2 |
|---|---|---|---|---|
| 1-1 or 1 | A1 | B1 | 2 | 1 |
| 1-2 | A1 | B2 | 2 | 1 |
| 1-3 | A1 | B3 | 2 | 1 |
| 1-4 | A1 | B4 | 2 | 1 |
| 1-5 | A1 | B5 | 2 | 1 |
| 1-6 | A1 | B6 | 2 | 1 |
| 1-7 | A1 | B7 | 2 | 1 |
| 1-8 | A1 | B8 | 2 | 1 |
| 1-9 | A1 | B9 | 2 | 1 |
| 1-10 | A1 | B10 | 2 | 1 |
| 1-11 | A1 | B11 | 2 | 1 |
| 1-12 | A1 | B12 | 2 | 1 |
| 1-13 | A1 | B13 | 2 | 1 |
| 1-14 | A1 | B14 | 2 | 1 |
| 1-15 | A1 | B15 | 2 | 1 |
| 1-16 | A1 | B16 | 2 | 1 |
| 1-17 | A1 | B17 | 2 | 1 |
| 1-18 | A1 | B18 | 2 | 1 |
| 1-19 | A1 | B19 | 2 | 1 |
| 1-20 | A1 | B20 | 2 | 1 |
| 1-21 | A1 | B21 | 2 | 1 |
| 1-22 | A1 | B22 | 2 | 1 |
| 1-23 | A1 | B23 | 2 | 1 |
| 1-24 | A1 | B24 | 2 | 1 |
| 1-25 | A1 | B25 | 2 | 1 |
| 1-26 | A1 | B26 | 2 | 1 |
| 1-27 | A1 | B27 | 2 | 1 |
| 1-28 | A1 | B28 | 2 | 1 |
| 1-29 | A1 | B29 | 2 | 1 |
| 1-30 | A1 | B30 | 2 | 1 |

**Table 2**

| Compound No. | L₁ | L₂ | n1 | n2 |
|---|---|---|---|---|
| 1-31 | A1 | B31 | 2 | 1 |
| 1-32 | A1 | B32 | 2 | 1 |
| 1-33 | A1 | B33 | 2 | 1 |
| 1-34 | A1 | B34 | 2 | 1 |
| 1-35 | A1 | B35 | 2 | 1 |
| 1-36 | A1 | B36 | 2 | 1 |
| 1-37 | A1 | B37 | 2 | 1 |
| 1-38 | A1 | B38 | 2 | 1 |
| 1-39 | A1 | B39 | 2 | 1 |
| 1-40 | A1 | B40 | 2 | 1 |
| 1-41 | A1 | B41 | 2 | 1 |
| 1-42 | A1 | B42 | 2 | 1 |
| 1-43 | A1 | B43 | 2 | 1 |
| 1-44 | A1 | B44 | 2 | 1 |
| 1-45 | A1 | B45 | 2 | 1 |
| 1-46 | A1 | B46 | 2 | 1 |
| 1-47 | A1 | B47 | 2 | 1 |
| 1-48 | A1 | B48 | 2 | 1 |
| 1-49 | A1 | B49 | 2 | 1 |
| 1-50 | A1 | B50 | 2 | 1 |
| 1-51 | A1 | B51 | 2 | 1 |
| 1-52 | A1 | B52 | 2 | 1 |
| 1-53 | A1 | B53 | 2 | 1 |
| 1-54 | A1 | B54 | 2 | 1 |
| 1-55 | A1 | B55 | 2 | 1 |
| 1-56 | A1 | B56 | 2 | 1 |
| 1-57 | A1 | B57 | 2 | 1 |
| 1-58 | A1 | B58 | 2 | 1 |
| 1-59 | A1 | B59 | 2 | 1 |
| 1-60 | A1 | B60 | 2 | 1 |

**Table 3**

| Compound No. | L₁ | L₂ | n1 | n2 |
|---|---|---|---|---|
| 1-61 | A1 | B61 | 2 | 1 |
| 1-62 | A1 | B62 | 2 | 1 |
| 1-63 | A1 | B63 | 2 | 1 |
| 1-64 | A1 | B64 | 2 | 1 |
| 1-65 | A1 | B65 | 2 | 1 |
| 1-66 | A1 | B66 | 2 | 1 |
| 1-67 | A1 | B67 | 2 | 1 |
| 1-68 | A1 | B68 | 2 | 1 |
| 1-69 | A1 | B69 | 2 | 1 |
| 1-70 | A1 | B70 | 2 | 1 |
| 1-71 | A1 | B71 | 2 | 1 |
| 1-72 | A1 | B72 | 2 | 1 |
| 1-73 | A1 | B73 | 2 | 1 |
| 1-74 | A1 | B74 | 2 | 1 |
| 1-75 | A1 | B75 | 2 | 1 |
| 1-76 | A1 | B76 | 2 | 1 |
| 1-77 | A1 | B77 | 2 | 1 |
| 1-78 | A1 | B78 | 2 | 1 |
| 1-79 | A1 | B79 | 2 | 1 |
| 1-80 | A1 | B80 | 2 | 1 |
| 1-81 | A1 | B81 | 2 | 1 |
| 1-82 | A1 | B82 | 2 | 1 |
| 1-83 | A1 | B83 | 2 | 1 |
| 1-84 | A1 | B84 | 2 | 1 |
| 1-85 | A1 | B85 | 2 | 1 |
| 1-86 | A1 | B86 | 2 | 1 |
| 1-87 | A1 | B87 | 2 | 1 |
| 1-88 | A1 | B88 | 2 | 1 |
| 1-89 | A1 | B89 | 2 | 1 |
| 1-90 | A1 | B90 | 2 | 1 |

**Table 4**

| Compound No. | L₁ | L₂ | n1 | n2 |
|---|---|---|---|---|
| 1-91 | A1 | B91 | 2 | 1 |
| 1-92 | A1 | B92 | 2 | 1 |
| 1-93 | A1 | B93 | 2 | 1 |
| 1-94 | A1 | B94 | 2 | 1 |
| 1-95 | A1 | B95 | 2 | 1 |
| 1-96 | A1 | B96 | 2 | 1 |
| 1-97 | A1 | B97 | 2 | 1 |
| 1-98 | A1 | B98 | 2 | 1 |
| 1-99 | A1 | B99 | 2 | 1 |
| 1-100 | A1 | B100 | 2 | 1 |
| 1-101 | A1 | B101 | 2 | 1 |
| 1-102 | A1 | B102 | 2 | 1 |
| 1-103 | A1 | B103 | 2 | 1 |
| 1-104 | A1 | B104 | 2 | 1 |
| 1-105 | A1 | B105 | 2 | 1 |
| 1-106 | A1 | B106 | 2 | 1 |
| 1-107 | A1 | B107 | 2 | 1 |
| 1-108 | A1 | B108 | 2 | 1 |
| 1-109 | A1 | B109 | 2 | 1 |
| 1-110 | A1 | B110 | 2 | 1 |
| 1-111 | A1 | B111 | 2 | 1 |
| 1-112 | A1 | B112 | 2 | 1 |
| 1-113 | A1 | B113 | 2 | 1 |
| 1-114 | A1 | B114 | 2 | 1 |
| 1-115 | A1 | B115 | 2 | 1 |
| 1-116 | A1 | B116 | 2 | 1 |
| 1-117 | A1 | B117 | 2 | 1 |
| 1-118 | A1 | B118 | 2 | 1 |
| 1-119 | A1 | B119 | 2 | 1 |
| 1-120 | A1 | B120 | 2 | 1 |

**Table 5**

| Compound No. | L₁ | L₂ | n1 | n2 |
|---|---|---|---|---|
| 1-121 | A1 | B121 | 2 | 1 |
| 1-122 | A1 | B122 | 2 | 1 |
| 1-123 | A1 | B123 | 2 | 1 |
| 1-124 | A1 | B124 | 2 | 1 |
| 1-125 | A1 | B125 | 2 | 1 |
| 1-126 | A1 | B126 | 2 | 1 |
| 1-127 | A1 | B127 | 2 | 1 |
| 1-128 | A1 | B128 | 2 | 1 |
| 1-129 | A1 | B129 | 2 | 1 |
| 1-130 | A1 | B130 | 2 | 1 |
| 1-131 | A1 | B131 | 2 | 1 |
| 1-132 | A1 | B132 | 2 | 1 |
| 1-133 | A1 | B133 | 2 | 1 |
| 1-134 | A1 | B134 | 2 | 1 |
| 1-135 | A1 | B135 | 2 | 1 |
| 1-136 | A1 | B136 | 2 | 1 |
| 1-137 | A1 | B137 | 2 | 1 |
| 1-138 | A1 | B138 | 2 | 1 |
| 1-139 | A1 | B139 | 2 | 1 |
| 1-140 | A1 | B140 | 2 | 1 |
| 1-141 | A1 | B141 | 2 | 1 |
| 1-142 | A1 | B142 | 2 | 1 |
| 1-143 | A1 | B143 | 2 | 1 |
| 1-144 | A1 | B144 | 2 | 1 |
| 1-145 | A1 | B145 | 2 | 1 |
| 1-146 | A1 | B146 | 2 | 1 |
| 1-147 | A1 | B147 | 2 | 1 |
| 1-148 | A1 | B148 | 2 | 1 |
| 1-149 | A1 | B149 | 2 | 1 |
| 1-150 | A1 | B150 | 2 | 1 |

**Table 6**

| Compound No. | L₁ | L₂ | n1 | n2 |
|---|---|---|---|---|
| 1-151 | A1 | B151 | 2 | 1 |
| 1-152 | A1 | B152 | 2 | 1 |
| 1-153 | A1 | B153 | 2 | 1 |
| 1-154 | A1 | B154 | 2 | 1 |
| 1-155 | A1 | B155 | 2 | 1 |
| 1-156 | A1 | B156 | 2 | 1 |
| 1-157 | A1 | B157 | 2 | 1 |
| 1-158 | A1 | B158 | 2 | 1 |
| 1-159 | A1 | B159 | 2 | 1 |
| 1-160 | A1 | B160 | 2 | 1 |
| 1-161 | A1 | B161 | 2 | 1 |
| 1-162 | A1 | B162 | 2 | 1 |
| 1-163 | A1 | B163 | 2 | 1 |
| 1-164 | A1 | B164 | 2 | 1 |
| 1-165 | A1 | B165 | 2 | 1 |
| 1-166 | A1 | B166 | 2 | 1 |
| 1-167 | A1 | B167 | 2 | 1 |
| 1-168 | A1 | B168 | 2 | 1 |
| 1-169 | A1 | B169 | 2 | 1 |
| 1-170 | A1 | B170 | 2 | 1 |
| 1-171 | A1 | B171 | 2 | 1 |
| 1-172 | A1 | B172 | 2 | 1 |
| 1-173 | A1 | B173 | 2 | 1 |
| 1-174 | A1 | B174 | 2 | 1 |
| 1-175 | A1 | B175 | 2 | 1 |
| 1-176 | A1 | B176 | 2 | 1 |
| 1-177 | A1 | B177 | 2 | 1 |
| 1-178 | A1 | B178 | 2 | 1 |
| 1-179 | A1 | B179 | 2 | 1 |
| 1-180 | A1 | B180 | 2 | 1 |

**Table 7**

| Compound No. | L₁ | L₂ | n1 | n2 |
|---|---|---|---|---|
| 1-181 | A1 | B181 | 2 | 1 |
| 1-182 | A1 | B182 | 2 | 1 |
| 1-183 | A1 | B183 | 2 | 1 |
| 1-184 | A1 | B184 | 2 | 1 |
| 1-185 | A1 | B185 | 2 | 1 |
| 1-186 | A1 | B186 | 2 | 1 |
| 1-187 | A1 | B187 | 2 | 1 |
| 1-188 | A1 | B188 | 2 | 1 |
| 1-189 | A1 | B189 | 2 | 1 |
| 1-190 | A1 | B190 | 2 | 1 |
| 1-191 | A1 | B191 | 2 | 1 |
| 1-192 | A1 | B192 | 2 | 1 |
| 1-193 | A1 | B193 | 2 | 1 |
| 1-194 | A1 | B194 | 2 | 1 |
| 1-195 | A1 | B195 | 2 | 1 |
| 1-196 | A1 | B196 | 2 | 1 |
| 1-197 | A1 | B197 | 2 | 1 |
| 1-198 | A1 | B198 | 2 | 1 |
| 1-199 | A1 | B199 | 2 | 1 |
| 1-200 | A1 | B200 | 2 | 1 |
| 1-201 | A1 | B201 | 2 | 1 |
| 1-202 | A1 | B202 | 2 | 1 |
| 1-203 | A1 | B203 | 2 | 1 |
| 1-204 | A1 | B204 | 2 | 1 |
| 1-205 | A1 | B205 | 2 | 1 |
| 1-206 | A1 | B206 | 2 | 1 |
| 1-207 | A1 | B207 | 2 | 1 |
| 1-208 | A1 | B208 | 2 | 1 |
| 1-209 | A1 | B209 | 2 | 1 |
| 1-210 | A1 | B210 | 2 | 1 |

**Table 8**

| Compound No. | L₁ | L₂ | n1 | n2 |
|---|---|---|---|---|
| 1-211 | A1 | B211 | 2 | 1 |
| 1-212 | A1 | B212 | 2 | 1 |
| 1-213 | A1 | B213 | 2 | 1 |
| 1-214 | A1 | B214 | 2 | 1 |
| 1-215 | A1 | B215 | 2 | 1 |
| 1-216 | A1 | B216 | 2 | 1 |
| 1-217 | A1 | B217 | 2 | 1 |
| 1-218 | A1 | B218 | 2 | 1 |
| 1-219 | A1 | B219 | 2 | 1 |
| 1-220 | A1 | B220 | 2 | 1 |
| 1-221 | A1 | B221 | 2 | 1 |
| 1-222 | A1 | B222 | 2 | 1 |
| 1-223 | A1 | B223 | 2 | 1 |
| 1-224 | A1 | B224 | 2 | 1 |
| 1-225 | A1 | B225 | 2 | 1 |
| 1-226 | A1 | B226 | 2 | 1 |
| 1-227 | A1 | B227 | 2 | 1 |
| 1-228 | A1 | B228 | 2 | 1 |
| 1-229 | A1 | B229 | 2 | 1 |
| 1-230 | A1 | B230 | 2 | 1 |
| 1-231 | A1 | B231 | 2 | 1 |
| 1-232 | A1 | B232 | 2 | 1 |
| 1-233 | A1 | B233 | 2 | 1 |
| 1-234 | A1 | B234 | 2 | 1 |
| 1-235 | A1 | B235 | 2 | 1 |
| 1-236 | A1 | B236 | 2 | 1 |
| 1-237 | A1 | B237 | 2 | 1 |
| 1-238 | A1 | B238 | 2 | 1 |
| 1-239 | A1 | B239 | 2 | 1 |
| 1-240 | A1 | B240 | 2 | 1 |

**Table 9**

| Compound No. | L₁ | L₂ | n1 | n2 |
|---|---|---|---|---|
| 1-241 | A1 | B241 | 2 | 1 |
| 1-242 | A1 | B242 | 2 | 1 |
| 1-243 | A1 | B243 | 2 | 1 |
| 1-244 | A1 | B244 | 2 | 1 |
| 1-245 | A1 | B245 | 2 | 1 |
| 1-246 | A1 | B246 | 2 | 1 |
| 1-247 | A1 | B247 | 2 | 1 |
| 1-248 | A1 | B248 | 2 | 1 |
| 1-249 | A1 | B249 | 2 | 1 |
| 1-250 | A1 | B250 | 2 | 1 |
| 1-251 | A1 | B251 | 2 | 1 |
| 1-252 | A1 | B252 | 2 | 1 |
| 1-253 | A1 | B253 | 2 | 1 |
| 1-254 | A1 | B254 | 2 | 1 |
| 1-255 | A1 | B255 | 2 | 1 |
| 1-256 | A1 | B256 | 2 | 1 |
| 1-257 | A1 | B257 | 2 | 1 |
| 1-258 | A1 | B258 | 2 | 1 |
| 1-259 | A1 | B259 | 2 | 1 |
| 1-260 | A1 | B260 | 2 | 1 |
| 1-261 | A1 | B261 | 2 | 1 |
| 1-262 | A1 | B262 | 2 | 1 |
| 1-263 | A1 | B263 | 2 | 1 |
| 1-264 | A1 | B264 | 2 | 1 |
| 1-265 | A1 | B265 | 2 | 1 |
| 1-266 | A1 | B266 | 2 | 1 |
| 1-267 | A1 | B267 | 2 | 1 |
| 1-268 | A1 | B268 | 2 | 1 |
| 1-269 | A1 | B269 | 2 | 1 |
| 1-270 | A1 | B270 | 2 | 1 |

**Table 10**

| Compound No. | L₁ | L₂ | n1 | n2 |
|---|---|---|---|---|
| 1-271 | A1 | B271 | 2 | 1 |
| 1-272 | A1 | B272 | 2 | 1 |
| 1-273 | A1 | B273 | 2 | 1 |
| 1-274 | A1 | B274 | 2 | 1 |
| 1-275 | A1 | B275 | 2 | 1 |
| 1-276 | A1 | B276 | 2 | 1 |
| 1-277 | A1 | B277 | 2 | 1 |
| 1-278 | A1 | B278 | 2 | 1 |
| 1-279 | A1 | B279 | 2 | 1 |
| 1-280 | A1 | B280 | 2 | 1 |
| 1-281 | A1 | B281 | 2 | 1 |
| 1-282 | A1 | B282 | 2 | 1 |
| 1-283 | A1 | B283 | 2 | 1 |
| 1-284 | A1 | B284 | 2 | 1 |
| 1-285 | A1 | B285 | 2 | 1 |
| 1-286 | A1 | B286 | 2 | 1 |
| 1-287 | A1 | B287 | 2 | 1 |
| 1-288 | A1 | B288 | 2 | 1 |
| 1-289 | A1 | B289 | 2 | 1 |
| 1-290 | A1 | B290 | 2 | 1 |
| 1-291 | A1 | B291 | 2 | 1 |
| 1-292 | A1 | B292 | 2 | 1 |
| 1-293 | A1 | B293 | 2 | 1 |
| 1-294 | A1 | B294 | 2 | 1 |
| 1-295 | A1 | B295 | 2 | 1 |
| 1-296 | A1 | B296 | 2 | 1 |
| 1-297 | A1 | B297 | 2 | 1 |
| 1-298 | A1 | B298 | 2 | 1 |
| 1-299 | A1 | B299 | 2 | 1 |
| 1-300 | A1 | B300 | 2 | 1 |

**Table 11**

| Compound No. | L₁ | L₂ | n1 | n2 |
|---|---|---|---|---|
| 1-301 | A1 | B301 | 2 | 1 |
| 1-302 | A1 | B302 | 2 | 1 |
| 1-303 | A1 | B303 | 2 | 1 |
| 1-304 | A1 | B304 | 2 | 1 |
| 1-305 | A1 | B305 | 2 | 1 |
| 1-306 | A1 | B306 | 2 | 1 |
| 1-307 | A1 | B307 | 2 | 1 |
| 1-308 | A1 | B308 | 2 | 1 |
| 1-309 | A1 | B309 | 2 | 1 |
| 1-310 | A1 | B310 | 2 | 1 |
| 1-311 | A1 | B311 | 2 | 1 |
| 1-312 | A1 | B312 | 2 | 1 |
| 1-313 | A1 | B313 | 2 | 1 |
| 1-314 | A1 | B314 | 2 | 1 |
| 1-315 | A1 | B315 | 2 | 1 |
| 1-316 | A1 | B316 | 2 | 1 |
| 1-317 | A1 | B317 | 2 | 1 |
| 1-318 | A1 | B318 | 2 | 1 |
| 1-319 | A1 | B319 | 2 | 1 |
| 1-320 | A1 | B320 | 2 | 1 |
| 1-321 | A1 | B321 | 2 | 1 |
| 1-322 | A1 | B322 | 2 | 1 |
| 1-323 | A1 | B323 | 2 | 1 |
| 1-324 | A1 | B324 | 2 | 1 |
| 1-325 | A1 | B325 | 2 | 1 |
| 1-326 | A1 | B326 | 2 | 1 |
| 1-327 | A1 | B327 | 2 | 1 |
| 1-328 | A1 | B328 | 2 | 1 |
| 1-329 | A1 | B329 | 2 | 1 |
| 1-330 | A1 | B330 | 2 | 1 |

**Table 12**

| Compound No. | L₁ | L₂ | n1 | n2 |
|---|---|---|---|---|
| 1-331 | A1 | B331 | 2 | 1 |
| 1-332 | A1 | B332 | 2 | 1 |
| 1-333 | A1 | B333 | 2 | 1 |
| 1-334 | A1 | B334 | 2 | 1 |
| 1-335 | A1 | B335 | 2 | 1 |
| 1-336 | A1 | B336 | 2 | 1 |
| 1-337 | A1 | B337 | 2 | 1 |
| 1-338 | A1 | B338 | 2 | 1 |
| 1-339 | A1 | B339 | 2 | 1 |
| 1-340 | A1 | B340 | 2 | 1 |
| 1-341 | A1 | B341 | 2 | 1 |
| 1-342 | A1 | B342 | 2 | 1 |
| 1-343 | A1 | B343 | 2 | 1 |
| 1-344 | A1 | B344 | 2 | 1 |
| 1-345 | A1 | B345 | 2 | 1 |
| 1-346 | A1 | B346 | 2 | 1 |
| 1-347 | A1 | B347 | 2 | 1 |
| 1-348 | A1 | B348 | 2 | 1 |
| 1-349 | A1 | B349 | 2 | 1 |
| 1-350 | A1 | B350 | 2 | 1 |
| 1-351 | A1 | B351 | 2 | 1 |
| 1-352 | A1 | B352 | 2 | 1 |
| 1-353 | A1 | B353 | 2 | 1 |
| 1-354 | A1 | B354 | 2 | 1 |
| 1-355 | A1 | B355 | 2 | 1 |
| 1-356 | A1 | B356 | 2 | 1 |
| 1-357 | A1 | B357 | 2 | 1 |
| 1-358 | A1 | B358 | 2 | 1 |
| 1-359 | A1 | B359 | 2 | 1 |
| 1-360 | A1 | B360 | 2 | 1 |

**Table 13**

| Compound No. | L₁ | L₂ | n1 | n2 |
|---|---|---|---|---|
| 1-361 | A1 | B361 | 2 | 1 |
| 1-362 | A1 | B362 | 2 | 1 |
| 1-363 | A1 | B363 | 2 | 1 |
| 1-364 | A1 | B364 | 2 | 1 |
| 1-365 | A1 | B365 | 2 | 1 |
| 1-366 | A1 | B366 | 2 | 1 |
| 1-367 | A1 | B367 | 2 | 1 |
| 1-368 | A1 | B368 | 2 | 1 |
| 1-369 | A1 | B369 | 2 | 1 |
| 1-370 | A1 | B370 | 2 | 1 |
| 1-371 | A1 | B371 | 2 | 1 |
| 1-372 | A1 | B372 | 2 | 1 |
| 1-373 | A1 | B373 | 2 | 1 |
| 1-374 | A1 | B374 | 2 | 1 |
| 1-375 | A1 | B375 | 2 | 1 |
| 1-376 | A1 | B376 | 2 | 1 |
| 1-377 | A1 | B377 | 2 | 1 |
| 1-378 | A1 | B378 | 2 | 1 |
| 1-379 | A1 | B379 | 2 | 1 |
| 1-380 | A1 | B380 | 2 | 1 |
| 1-381 | A1 | B381 | 2 | 1 |
| 1-382 | A1 | B382 | 2 | 1 |
| 1-383 | A1 | B383 | 2 | 1 |
| 1-384 | A1 | B384 | 2 | 1 |
| 1-385 | A1 | B385 | 2 | 1 |
| 1-386 | A1 | B386 | 2 | 1 |
| 1-387 | A1 | B387 | 2 | 1 |
| 1-388 | A1 | B388 | 2 | 1 |
| 1-389 | A1 | B389 | 2 | 1 |
| 1-390 | A1 | B390 | 2 | 1 |

**Table 14**

| Compound No. | L₁ | L₂ | n1 | n2 |
|---|---|---|---|---|
| 1-391 | A1 | B391 | 2 | 1 |
| 1-392 | A1 | B392 | 2 | 1 |
| 1-393 | A1 | B393 | 2 | 1 |
| 1-394 | A1 | B394 | 2 | 1 |
| 1-395 | A1 | B395 | 2 | 1 |
| 1-396 | A1 | B396 | 2 | 1 |
| 1-397 | A1 | B397 | 2 | 1 |
| 1-398 | A1 | B398 | 2 | 1 |
| 1-399 | A1 | B399 | 2 | 1 |
| 1-400 | A1 | B400 | 2 | 1 |
| 1-401 | A1 | B401 | 2 | 1 |
| 1-402 | A1 | B402 | 2 | 1 |
| 1-403 | A1 | B403 | 2 | 1 |
| 1-404 | A1 | B404 | 2 | 1 |
| 1-405 | A1 | B405 | 2 | 1 |
| 1-406 | A1 | B406 | 2 | 1 |
| 1-407 | A1 | B407 | 2 | 1 |
| 1-408 | A1 | B408 | 2 | 1 |
| 1-409 | A1 | B409 | 2 | 1 |
| 1-410 | A1 | B410 | 2 | 1 |
| 1-411 | A1 | B411 | 2 | 1 |
| 1-412 | A1 | B412 | 2 | 1 |
| 1-413 | A1 | B413 | 2 | 1 |
| 1-414 | A1 | B414 | 2 | 1 |
| 1-415 | A1 | B415 | 2 | 1 |
| 1-416 | A1 | B416 | 2 | 1 |
| 1-417 | A1 | B417 | 2 | 1 |
| 1-418 | A1 | B418 | 2 | 1 |
| 1-419 | A1 | B419 | 2 | 1 |
| 1-420 | A1 | B420 | 2 | 1 |

**Table 15**

| Compound No. | L₁ | L₂ | n1 | n2 |
|---|---|---|---|---|
| 1-421 | A1 | B421 | 2 | 1 |
| 1-422 | A1 | B422 | 2 | 1 |
| 1-423 | A1 | B423 | 2 | 1 |
| 1-424 | A1 | B424 | 2 | 1 |
| 1-425 | A1 | B425 | 2 | 1 |
| 1-426 | A1 | B426 | 2 | 1 |
| 1-427 | A1 | B427 | 2 | 1 |
| 1-428 | A1 | B428 | 2 | 1 |
| 1-429 | A1 | B429 | 2 | 1 |
| 1-430 | A1 | B430 | 2 | 1 |
| 1-431 | A1 | B431 | 2 | 1 |
| 1-432 | A1 | B432 | 2 | 1 |
| 1-433 | A1 | B433 | 2 | 1 |
| 1-434 | A1 | B434 | 2 | 1 |
| 1-435 | A1 | B435 | 2 | 1 |
| 1-436 | A1 | B436 | 2 | 1 |
| 1-437 | A1 | B437 | 2 | 1 |
| 1-438 | A1 | B438 | 2 | 1 |
| 1-439 | A1 | B439 | 2 | 1 |
| 1-440 | A1 | B440 | 2 | 1 |
| 1-441 | A1 | B441 | 2 | 1 |
| 1-442 | A1 | B442 | 2 | 1 |
| 1-443 | A1 | B443 | 2 | 1 |
| 1-444 | A1 | B444 | 2 | 1 |
| 1-445 | A1 | B445 | 2 | 1 |
| 1-446 | A1 | B446 | 2 | 1 |
| 1-447 | A1 | B447 | 2 | 1 |
| 1-448 | A1 | B448 | 2 | 1 |
| 1-449 | A1 | B449 | 2 | 1 |
| 1-450 | A1 | B450 | 2 | 1 |

**Table 16**

| Compound No. | L₁ | L₂ | n1 | n2 |
|---|---|---|---|---|
| 1-451 | A1 | B451 | 2 | 1 |
| 1-452 | A1 | B452 | 2 | 1 |
| 1-453 | A1 | B453 | 2 | 1 |
| 1-454 | A1 | B454 | 2 | 1 |
| 1-455 | A1 | B455 | 2 | 1 |
| 1-456 | A1 | B456 | 2 | 1 |
| 1-457 | A1 | B457 | 2 | 1 |
| 1-458 | A1 | B458 | 2 | 1 |
| 1-459 | A1 | B459 | 2 | 1 |
| 1-460 | A1 | B460 | 2 | 1 |
| 1-461 | A1 | B461 | 2 | 1 |
| 1-462 | A1 | B462 | 2 | 1 |
| 1-463 | A1 | B463 | 2 | 1 |
| 1-464 | A1 | B464 | 2 | 1 |
| 1-465 | A1 | B465 | 2 | 1 |
| 1-466 | A1 | B466 | 2 | 1 |
| 1-467 | A1 | B467 | 2 | 1 |
| 1-468 | A1 | B468 | 2 | 1 |
| 1-469 | A1 | B469 | 2 | 1 |
| 1-470 | A1 | B470 | 2 | 1 |
| 1-471 | A1 | B471 | 2 | 1 |
| 1-472 | A1 | B472 | 2 | 1 |
| 1-473 | A1 | B473 | 2 | 1 |
| 1-474 | A1 | B474 | 2 | 1 |
| 1-475 | A1 | B475 | 2 | 1 |
| 1-476 | A1 | B476 | 2 | 1 |
| 1-477 | A1 | B477 | 2 | 1 |
| 1-478 | A1 | B478 | 2 | 1 |
| 1-479 | A1 | B479 | 2 | 1 |
| 1-480 | A1 | B480 | 2 | 1 |

**Table 17**

| Compound No. | L₁ | L₂ | n1 | n2 |
|---|---|---|---|---|
| 1-481 | A1 | B481 | 2 | 1 |
| 1-482 | A1 | B482 | 2 | 1 |
| 1-483 | A1 | B483 | 2 | 1 |
| 1-484 | A1 | B484 | 2 | 1 |
| 1-485 | A1 | B485 | 2 | 1 |
| 1-486 | A1 | B486 | 2 | 1 |
| 1-487 | A1 | B487 | 2 | 1 |
| 1-488 | A1 | B488 | 2 | 1 |
| 1-489 | A1 | B489 | 2 | 1 |
| 1-490 | A1 | B490 | 2 | 1 |
| 1-491 | A1 | B491 | 2 | 1 |
| 1-492 | A1 | B492 | 2 | 1 |
| 1-493 | A1 | B493 | 2 | 1 |
| 1-494 | A1 | B494 | 2 | 1 |
| 1-495 | A1 | B495 | 2 | 1 |
| 1-496 | A1 | B496 | 2 | 1 |
| 1-497 | A1 | B497 | 2 | 1 |
| 1-498 | A1 | B498 | 2 | 1 |
| 1-499 | A1 | B499 | 2 | 1 |
| 1-500 | A1 | B500 | 2 | 1 |
| 1-501 | A1 | B501 | 2 | 1 |
| 1-502 | A1 | B502 | 2 | 1 |
| 1-503 | A1 | B503 | 2 | 1 |
| 1-504 | A1 | B504 | 2 | 1 |
| 1-505 | A1 | B505 | 2 | 1 |
| 1-506 | A1 | B506 | 2 | 1 |
| 1-507 | A1 | B507 | 2 | 1 |
| 1-508 | A1 | B508 | 2 | 1 |
| 1-509 | A1 | B509 | 2 | 1 |
| 1-510 | A1 | B510 | 2 | 1 |

**Table 18**

| Compound No. | L₁ | L₂ | n1 | n2 |
|---|---|---|---|---|
| 1-511 | A1 | B511 | 2 | 1 |
| 1-512 | A1 | B512 | 2 | 1 |
| 1-513 | A1 | B513 | 2 | 1 |
| 1-514 | A1 | B514 | 2 | 1 |
| 1-515 | A1 | B515 | 2 | 1 |
| 1-516 | A1 | B516 | 2 | 1 |
| 1-517 | A1 | B517 | 2 | 1 |
| 1-518 | A1 | B518 | 2 | 1 |
| 1-519 | A1 | B519 | 2 | 1 |
| 1-520 | A1 | B520 | 2 | 1 |
| 1-521 | A1 | B521 | 2 | 1 |
| 1-522 | A1 | B522 | 2 | 1 |
| 1-523 | A1 | B523 | 2 | 1 |
| 1-524 | A1 | B524 | 2 | 1 |
| 1-525 | A1 | B525 | 2 | 1 |
| 1-526 | A1 | B526 | 2 | 1 |
| 1-527 | A1 | B527 | 2 | 1 |
| 1-528 | A1 | B528 | 2 | 1 |
| 1-529 | A1 | B529 | 2 | 1 |
| 1-530 | A1 | B530 | 2 | 1 |
| 1-531 | A1 | B531 | 2 | 1 |
| 1-532 | A1 | B532 | 2 | 1 |
| 1-533 | A1 | B533 | 2 | 1 |
| 1-534 | A1 | B534 | 2 | 1 |
| 1-535 | A1 | B535 | 2 | 1 |
| 1-536 | A1 | B536 | 2 | 1 |
| 1-537 | A1 | B537 | 2 | 1 |
| 1-538 | A1 | B538 | 2 | 1 |
| 1-539 | A1 | B539 | 2 | 1 |
| 1-540 | A1 | B540 | 2 | 1 |

**Table 19**

| Compound No. | L₁ | L₂ | n1 | n2 |
|---|---|---|---|---|
| 1-541 | A1 | B541 | 2 | 1 |
| 1-542 | A1 | B542 | 2 | 1 |
| 1-543 | A1 | B543 | 2 | 1 |
| 1-544 | A1 | B544 | 2 | 1 |
| 1-545 | A1 | B545 | 2 | 1 |
| 1-546 | A1 | B546 | 2 | 1 |
| 1-547 | A1 | B547 | 2 | 1 |
| 1-548 | A1 | B548 | 2 | 1 |
| 1-549 | A1 | B549 | 2 | 1 |
| 1-550 | A1 | B550 | 2 | 1 |
| 1-551 | A1 | B551 | 2 | 1 |
| 1-552 | A1 | B552 | 2 | 1 |
| 1-553 | A1 | B553 | 2 | 1 |
| 1-554 | A1 | B554 | 2 | 1 |
| 1-555 | A1 | B555 | 2 | 1 |
| 1-556 | A1 | B556 | 2 | 1 |
| 1-557 | A1 | B557 | 2 | 1 |
| 1-558 | A1 | B558 | 2 | 1 |
| 1-559 | A1 | B559 | 2 | 1 |
| 1-560 | A1 | B560 | 2 | 1 |
| 1-561 | A1 | B561 | 2 | 1 |
| 1-562 | A1 | B562 | 2 | 1 |
| 1-563 | A1 | B563 | 2 | 1 |
| 1-564 | A1 | B564 | 2 | 1 |
| 1-565 | A1 | B565 | 2 | 1 |
| 1-566 | A1 | B566 | 2 | 1 |
| 1-567 | A1 | B567 | 2 | 1 |
| 1-568 | A1 | B568 | 2 | 1 |
| 1-569 | A1 | B569 | 2 | 1 |
| 1-570 | A1 | B570 | 2 | 1 |

**Table 20**

| Compound No. | L₁ | L₂ | n1 | n2 |
|---|---|---|---|---|
| 1-571 | A1 | B571 | 2 | 1 |
| 1-572 | A1 | B572 | 2 | 1 |
| 1-573 | A1 | B573 | 2 | 1 |
| 1-574 | A1 | B574 | 2 | 1 |
| 1-575 | A1 | B575 | 2 | 1 |
| 1-576 | A1 | B576 | 2 | 1 |
| 1-577 | A1 | B577 | 2 | 1 |
| 1-578 | A1 | B578 | 2 | 1 |
| 1-579 | A1 | B579 | 2 | 1 |
| 1-580 | A1 | B580 | 2 | 1 |
| 1-581 | A1 | B581 | 2 | 1 |
| 1-582 | A1 | B582 | 2 | 1 |
| 1-583 | A1 | B583 | 2 | 1 |
| 1-584 | A1 | B584 | 2 | 1 |
| 1-585 | A1 | B585 | 2 | 1 |
| 1-586 | A1 | B586 | 2 | 1 |
| 1-587 | A1 | B587 | 2 | 1 |
| 1-588 | A1 | B588 | 2 | 1 |
| 1-589 | A1 | B589 | 2 | 1 |
| 1-590 | A1 | B590 | 2 | 1 |
| 1-591 | A1 | B591 | 2 | 1 |
| 1-592 | A1 | B592 | 2 | 1 |
| 1-593 | A1 | B593 | 2 | 1 |
| 1-594 | A1 | B594 | 2 | 1 |
| 1-595 | A1 | B595 | 2 | 1 |
| 1-596 | A1 | B596 | 2 | 1 |
| 1-597 | A1 | B597 | 2 | 1 |
| 1-598 | A1 | B598 | 2 | 1 |
| 1-599 | A1 | B599 | 2 | 1 |
| 1-600 | A1 | B600 | 2 | 1 |

**Table 21**

| Compound No. | L₁ | L₂ | n1 | n2 |
|---|---|---|---|---|
| 1-601 | A1 | B601 | 2 | 1 |
| 1-602 | A1 | B602 | 2 | 1 |
| 1-603 | A1 | B603 | 2 | 1 |
| 1-604 | A1 | B604 | 2 | 1 |
| 1-605 | A1 | B605 | 2 | 1 |
| 1-606 | A1 | B606 | 2 | 1 |
| 1-607 | A1 | B607 | 2 | 1 |
| 1-608 | A1 | B608 | 2 | 1 |
| 1-609 | A1 | B609 | 2 | 1 |
| 1-610 | A1 | B610 | 2 | 1 |
| 1-611 | A1 | B611 | 2 | 1 |
| 1-612 | A1 | B612 | 2 | 1 |
| 1-613 | A1 | B613 | 2 | 1 |
| 1-614 | A1 | B614 | 2 | 1 |
| 1-615 | A1 | B615 | 2 | 1 |
| 1-616 | A1 | B616 | 2 | 1 |
| 1-617 | A1 | B617 | 2 | 1 |
| 1-618 | A1 | B618 | 2 | 1 |
| 1-619 | A1 | B619 | 2 | 1 |
| 1-620 | A1 | B620 | 2 | 1 |
| 1-621 | A1 | B621 | 2 | 1 |
| 1-622 | A1 | B622 | 2 | 1 |
| 1-623 | A1 | B623 | 2 | 1 |
| 1-624 | A1 | B624 | 2 | 1 |
| 1-625 | A1 | B625 | 2 | 1 |
| 1-626 | A1 | B626 | 2 | 1 |
| 1-627 | A1 | B627 | 2 | 1 |
| 1-628 | A1 | B628 | 2 | 1 |
| 1-629 | A1 | B629 | 2 | 1 |
| 1-630 | A1 | B630 | 2 | 1 |

**Table 22**

| Compound No. | L₁ | L₂ | n1 | n2 |
|---|---|---|---|---|
| 1-631 | A1 | B631 | 2 | 1 |
| 1-632 | A1 | B632 | 2 | 1 |
| 1-633 | A1 | B633 | 2 | 1 |
| 1-634 | A1 | B634 | 2 | 1 |
| 1-635 | A1 | B635 | 2 | 1 |
| 1-636 | A1 | B636 | 2 | 1 |
| 1-637 | A1 | B637 | 2 | 1 |
| 1-638 | A1 | B638 | 2 | 1 |
| 1-639 | A1 | B639 | 2 | 1 |
| 1-640 | A1 | B640 | 2 | 1 |
| 1-641 | A1 | B641 | 2 | 1 |
| 1-642 | A1 | B642 | 2 | 1 |
| 1-643 | A1 | B643 | 2 | 1 |
| 1-644 | A1 | B644 | 2 | 1 |
| 1-645 | A1 | B645 | 2 | 1 |
| 1-646 | A1 | B646 | 2 | 1 |
| 1-647 | A1 | B647 | 2 | 1 |
| 1-648 | A1 | B648 | 2 | 1 |
| 1-649 | A1 | B649 | 2 | 1 |
| 1-650 | A1 | B650 | 2 | 1 |
| 1-651 | A1 | B651 | 2 | 1 |
| 1-652 | A1 | B652 | 2 | 1 |
| 1-653 | A1 | B653 | 2 | 1 |
| 1-654 | A1 | B654 | 2 | 1 |
| 1-655 | A1 | B655 | 2 | 1 |
| 1-656 | A1 | B656 | 2 | 1 |
| 1-657 | A1 | B657 | 2 | 1 |
| 1-658 | A1 | B658 | 2 | 1 |
| 1-659 | A1 | B659 | 2 | 1 |
| 1-660 | A1 | B660 | 2 | 1 |

**Table 23**

| Compound No. | L₁ | L₂ | n1 | n2 |
|---|---|---|---|---|
| 2-1 | A2 | B1 | 2 | 1 |
| 4-1 | A4 | B1 | 2 | 1 |
| 6-1 | A6 | B1 | 2 | 1 |
| 8-1 | A8 | B1 | 2 | 1 |
| 10-1 | A10 | B1 | 2 | 1 |
| 12-1 | A12 | B1 | 2 | 1 |
| 14-1 | A14 | B1 | 2 | 1 |
| 16-1 | A16 | B1 | 2 | 1 |
| 18-1 | A18 | B1 | 2 | 1 |
| 20-1 | A20 | B1 | 2 | 1 |
| 22-1 | A22 | B1 | 2 | 1 |
| 24-1 | A24 | B1 | 2 | 1 |
| 26-1 | A26 | B1 | 2 | 1 |
| 28-1 | A28 | B1 | 2 | 1 |
| 30-1 | A30 | B1 | 2 | 1 |
| 32-1 | A32 | B1 | 2 | 1 |
| 34-1 | A34 | B1 | 2 | 1 |
| 36-1 | A36 | B1 | 2 | 1 |
| 38-1 | A38 | B1 | 2 | 1 |
| 40-1 | A40 | B1 | 2 | 1 |
| 42-1 | A42 | B1 | 2 | 1 |
| 44-1 | A44 | B1 | 2 | 1 |
| 46-1 | A46 | B1 | 2 | 1 |
| 48-1 | A48 | B1 | 2 | 1 |
| 50-1 | A50 | B1 | 2 | 1 |
| 52-1 | A52 | B1 | 2 | 1 |
| 54-1 | A54 | B1 | 2 | 1 |
| 56-1 | A56 | B1 | 2 | 1 |
| 58-1 | A58 | B1 | 2 | 1 |
| 60-1 | A60 | B1 | 2 | 1 |

**Table 24**

| Compound No. | L₁ | L₂ | n1 | n2 |
|---|---|---|---|---|
| 62-1 | A62 | B1 | 2 | 1 |
| 64-1 | A64 | B1 | 2 | 1 |
| 66-1 | A66 | B1 | 2 | 1 |
| 68-1 | A68 | B1 | 2 | 1 |
| 70-1 | A70 | B1 | 2 | 1 |
| 73-1 | A73 | B1 | 2 | 1 |
| 76-1 | A76 | B1 | 2 | 1 |
| 80-1 | A80 | B1 | 2 | 1 |
| 84-1 | A84 | B1 | 2 | 1 |
| 87-1 | A87 | B1 | 2 | 1 |
| 90-1 | A90 | B1 | 2 | 1 |
| 93-1 | A93 | B1 | 2 | 1 |
| 96-1 | A96 | B1 | 2 | 1 |
| 99-1 | A99 | B1 | 2 | 1 |
| 102-1 | A102 | B1 | 2 | 1 |
| 105-1 | A105 | B1 | 2 | 1 |
| 108-1 | A108 | B1 | 2 | 1 |
| 120-1 | A120 | B1 | 2 | 1 |
| 125-1 | A125 | B1 | 2 | 1 |
| 129-1 | A129 | B1 | 2 | 1 |
| 130-1 | A130 | B1 | 2 | 1 |
| 133-1 | A133 | B1 | 2 | 1 |
| 137-1 | A137 | B1 | 2 | 1 |
| 140-1 | A140 | B1 | 2 | 1 |
| 143-1 | A143 | B1 | 2 | 1 |
| 146-1 | A146 | B1 | 2 | 1 |
| 149-1 | A149 | B1 | 2 | 1 |
| 151-1 | A151 | B1 | 2 | 1 |
| 152-1 | A152 | B1 | 2 | 1 |
| 153-1 | A153 | B1 | 2 | 1 |

**Table 25**

| Compound No. | L₁ | L₂ | n1 | n2 |
|---|---|---|---|---|
| 154-1 | A154 | B1 | 2 | 1 |
| 155-1 | A155 | B1 | 2 | 1 |
| 156-1 | A156 | B1 | 2 | 1 |
| 157-1 | A157 | B1 | 2 | 1 |
| 158-1 | A158 | B1 | 2 | 1 |
| 159-1 | A159 | B1 | 2 | 1 |
| 160-1 | A160 | B1 | 2 | 1 |
| 161-1 | A161 | B1 | 2 | 1 |
| 162-1 | A162 | B1 | 2 | 1 |
| 163-1 | A163 | B1 | 2 | 1 |
| 164-1 | A164 | B1 | 2 | 1 |
| 165-1 | A165 | B1 | 2 | 1 |
| 166-1 | A166 | B1 | 2 | 1 |
| 167-1 | A167 | B1 | 2 | 1 |
| 168-1 | A168 | B1 | 2 | 1 |
| 169-1 | A169 | B1 | 2 | 1 |
| 170-1 | A170 | B1 | 2 | 1 |
| 171-1 | A171 | B1 | 2 | 1 |
| 172-1 | A172 | B1 | 2 | 1 |
| 173-1 | A173 | B1 | 2 | 1 |
| 174-1 | A174 | B1 | 2 | 1 |
| 175-1 | A175 | B1 | 2 | 1 |
| 176-1 | A176 | B1 | 2 | 1 |
| 177-1 | A177 | B1 | 2 | 1 |
| 178-1 | A178 | B1 | 2 | 1 |
| 179-1 | A179 | B1 | 2 | 1 |
| 180-1 | A180 | B1 | 2 | 1 |
| 181-1 | A181 | B1 | 2 | 1 |
| 182-1 | A182 | B1 | 2 | 1 |
| 183-1 | A183 | B1 | 2 | 1 |

**Table 26**

| Compound No. | L₁ | L₂ | n1 | n2 |
|---|---|---|---|---|
| 184-1 | A184 | B1 | 2 | 1 |
| 185-1 | A185 | B1 | 2 | 1 |
| 186-1 | A186 | B1 | 2 | 1 |
| 187-1 | A187 | B1 | 2 | 1 |
| 188-1 | A188 | B1 | 2 | 1 |
| 189-1 | A189 | B1 | 2 | 1 |
| 190-1 | A190 | B1 | 2 | 1 |
| 191-1 | A191 | B1 | 2 | 1 |
| 192-1 | A192 | B1 | 2 | 1 |
| 193-1 | A193 | B1 | 2 | 1 |
| 194-1 | A194 | B1 | 2 | 1 |
| 195-1 | A195 | B1 | 2 | 1 |
| 196-1 | A196 | B1 | 2 | 1 |
| 197-1 | A197 | B1 | 2 | 1 |
| 198-1 | A198 | B1 | 2 | 1 |
| 199-1 | A199 | B1 | 2 | 1 |
| 200-1 | A200 | B1 | 2 | 1 |
| 201-1 | A201 | B1 | 2 | 1 |
| 202-1 | A202 | B1 | 2 | 1 |
| 203-1 | A203 | B1 | 2 | 1 |
| 204-1 | A204 | B1 | 2 | 1 |
| 205-1 | A205 | B1 | 2 | 1 |
| 206-1 | A206 | B1 | 2 | 1 |
| 207-1 | A207 | B1 | 2 | 1 |
| 208-1 | A208 | B1 | 2 | 1 |
| 209-1 | A209 | B1 | 2 | 1 |
| 210-1 | A210 | B1 | 2 | 1 |
| 211-1 | A211 | B1 | 2 | 1 |
| 212-1 | A212 | B1 | 2 | 1 |
| 213-1 | A213 | B1 | 2 | 1 |

**Table 27**

| Compound No. | L₁ | L₂ | n1 | n2 |
|---|---|---|---|---|
| 214-1 | A214 | B1 | 2 | 1 |
| 215-1 | A215 | B1 | 2 | 1 |
| 216-1 | A216 | B1 | 2 | 1 |
| 217-1 | A217 | B1 | 2 | 1 |
| 218-1 | A218 | B1 | 2 | 1 |
| 219-1 | A219 | B1 | 2 | 1 |
| 220-1 | A220 | B1 | 2 | 1 |
| 221-1 | A221 | B1 | 2 | 1 |
| 222-1 | A222 | B1 | 2 | 1 |
| 223-1 | A223 | B1 | 2 | 1 |
| 224-1 | A224 | B1 | 2 | 1 |
| 225-1 | A225 | B1 | 2 | 1 |
| 226-1 | A226 | B1 | 2 | 1 |
| 227-1 | A227 | B1 | 2 | 1 |
| 228-1 | A228 | B1 | 2 | 1 |
| 229-1 | A229 | B1 | 2 | 1 |
| 230-1 | A230 | B1 | 2 | 1 |
| 231-1 | A231 | B1 | 2 | 1 |
| 232-1 | A232 | B1 | 2 | 1 |
| 233-1 | A233 | B1 | 2 | 1 |
| 234-1 | A234 | B1 | 2 | 1 |
| 235-1 | A235 | B1 | 2 | 1 |
| 236-1 | A236 | B1 | 2 | 1 |
| 237-1 | A237 | B1 | 2 | 1 |
| 238-1 | A238 | B1 | 2 | 1 |
| 239-1 | A239 | B1 | 2 | 1 |
| 240-1 | A240 | B1 | 2 | 1 |
| 241-1 | A241 | B1 | 2 | 1 |
| 242-1 | A242 | B1 | 2 | 1 |
| 243-1 | A243 | B1 | 2 | 1 |

**Table 28**

| Compound No. | L₁ | L₂ | n1 | n2 |
|---|---|---|---|---|
| 244-1 | A244 | B1 | 2 | 1 |
| 245-1 | A245 | B1 | 2 | 1 |
| 246-1 | A246 | B1 | 2 | 1 |
| 247-1 | A247 | B1 | 2 | 1 |
| 248-1 | A248 | B1 | 2 | 1 |
| 249-1 | A249 | B1 | 2 | 1 |
| 250-1 | A250 | B1 | 2 | 1 |
| 251-1 | A251 | B1 | 2 | 1 |
| 252-1 | A252 | B1 | 2 | 1 |
| 253-1 | A253 | B1 | 2 | 1 |
| 254-1 | A254 | B1 | 2 | 1 |
| 255-1 | A255 | B1 | 2 | 1 |
| 256-1 | A256 | B1 | 2 | 1 |
| 257-1 | A257 | B1 | 2 | 1 |
| 258-1 | A258 | B1 | 2 | 1 |
| 259-1 | A259 | B1 | 2 | 1 |
| 260-1 | A260 | B1 | 2 | 1 |
| 261-1 | A261 | B1 | 2 | 1 |
| 262-1 | A262 | B1 | 2 | 1 |
| 263-1 | A263 | B1 | 2 | 1 |
| 264-1 | A264 | B1 | 2 | 1 |
| 265-1 | A265 | B1 | 2 | 1 |
| 266-1 | A266 | B1 | 2 | 1 |
| 267-1 | A267 | B1 | 2 | 1 |
| 268-1 | A268 | B1 | 2 | 1 |
| 269-1 | A269 | B1 | 2 | 1 |
| 270-1 | A270 | B1 | 2 | 1 |
| 271-1 | A271 | B1 | 2 | 1 |
| 272-1 | A272 | B1 | 2 | 1 |
| 273-1 | A273 | B1 | 2 | 1 |

**Table 29**

| Compound No. | L₁ | L₂ | n1 | n2 |
|---|---|---|---|---|
| 274-1 | A274 | B1 | 2 | 1 |
| 275-1 | A275 | B1 | 2 | 1 |
| 276-1 | A276 | B1 | 2 | 1 |
| 277-1 | A277 | B1 | 2 | 1 |
| 278-1 | A278 | B1 | 2 | 1 |
| 279-1 | A279 | B1 | 2 | 1 |
| 280-1 | A280 | B1 | 2 | 1 |
| 281-1 | A281 | B1 | 2 | 1 |
| 282-1 | A282 | B1 | 2 | 1 |
| 283-1 | A283 | B1 | 2 | 1 |
| 284-1 | A284 | B1 | 2 | 1 |
| 285-1 | A285 | B1 | 2 | 1 |
| 286-1 | A286 | B1 | 2 | 1 |
| 287-1 | A287 | B1 | 2 | 1 |
| 288-1 | A288 | B1 | 2 | 1 |
| 289-1 | A289 | B1 | 2 | 1 |
| 290-1 | A290 | B1 | 2 | 1 |
| 291-1 | A291 | B1 | 2 | 1 |
| 292-1 | A292 | B1 | 2 | 1 |
| 293-1 | A293 | B1 | 2 | 1 |
| 294-1 | A294 | B1 | 2 | 1 |
| 295-1 | A295 | B1 | 2 | 1 |
| 296-1 | A296 | B1 | 2 | 1 |
| 297-1 | A297 | B1 | 2 | 1 |
| 298-1 | A298 | B1 | 2 | 1 |
| 299-1 | A299 | B1 | 2 | 1 |
| 300-1 | A300 | B1 | 2 | 1 |

**Table 30**

| Compound No. | L₁ | L₂ | n1 | n2 |
|---|---|---|---|---|
| 2-4 | A2 | B4 | 2 | 1 |
| 2-8 | A2 | B8 | 2 | 1 |
| 2-10 | A2 | B10 | 2 | 1 |
| 2-13 | A2 | B13 | 2 | 1 |
| 2-20 | A2 | B20 | 2 | 1 |
| 2-24 | A2 | B24 | 2 | 1 |
| 2-27 | A2 | B27 | 2 | 1 |
| 2-48 | A2 | B48 | 2 | 1 |
| 2-62 | A2 | B62 | 2 | 1 |
| 2-63 | A2 | B63 | 2 | 1 |
| 2-85 | A2 | B85 | 2 | 1 |
| 2-91 | A2 | B91 | 2 | 1 |
| 2-108 | A2 | B108 | 2 | 1 |
| 2-116 | A2 | B116 | 2 | 1 |
| 2-137 | A2 | B137 | 2 | 1 |
| 2-144 | A2 | B144 | 2 | 1 |
| 2-152 | A2 | B152 | 2 | 1 |
| 2-162 | A2 | B162 | 2 | 1 |
| 2-169 | A2 | B169 | 2 | 1 |
| 2-176 | A2 | B176 | 2 | 1 |
| 2-187 | A2 | B187 | 2 | 1 |
| 2-201 or 838 | A2 | B201 | 2 | 1 |
| 2-213 | A2 | B213 | 2 | 1 |
| 2-249 | A2 | B249 | 2 | 1 |
| 2-272 | A2 | B272 | 2 | 1 |
| 2-281 | A2 | B281 | 2 | 1 |
| 2-306 | A2 | B306 | 2 | 1 |
| 2-340 | A2 | B340 | 2 | 1 |
| 2-399 | A2 | B399 | 2 | 1 |
| 2-445 | A2 | B445 | 2 | 1 |

**Table 31**

| Compound No. | L₁ | L₂ | n1 | n2 |
|---|---|---|---|---|
| 3-4 | A3 | B4 | 2 | 1 |
| 4-8 | A4 | B8 | 2 | 1 |
| 5-10 | A5 | B10 | 2 | 1 |
| 6-13 | A6 | B13 | 2 | 1 |
| 7-20 | A7 | B20 | 2 | 1 |
| 8-24 | A8 | B24 | 2 | 1 |
| 9-27 | A9 | B27 | 2 | 1 |
| 10-48 | A10 | B48 | 2 | 1 |
| 11-366 or 855 | A11 | B366 | 2 | 1 |
| 12-63 | A12 | B63 | 2 | 1 |
| 13-85 | A13 | B85 | 2 | 1 |
| 14-91 | A14 | B91 | 2 | 1 |
| 15-108 | A15 | B108 | 2 | 1 |
| 16-116 | A16 | B116 | 2 | 1 |
| 17-137 | A17 | B137 | 2 | 1 |
| 18-144 | A18 | B144 | 2 | 1 |
| 19-152 | A19 | B152 | 2 | 1 |
| 20-162 | A20 | B162 | 2 | 1 |
| 21-169 | A21 | B169 | 2 | 1 |
| 22-176 | A22 | B176 | 2 | 1 |
| 23-187 | A23 | B187 | 2 | 1 |
| 24-201 | A24 | B201 | 2 | 1 |
| 25-202 | A25 | B202 | 2 | 1 |
| 26-213 | A26 | B213 | 2 | 1 |
| 27-249 | A27 | B249 | 2 | 1 |
| 28-272 | A28 | B272 | 2 | 1 |
| 29-281 | A29 | B281 | 2 | 1 |
| 30-306 | A30 | B306 | 2 | 1 |
| 31-62 | A31 | B62 | 2 | 1 |
| 32-399 | A32 | B399 | 2 | 1 |
| 33-445 | A33 | B445 | 2 | 1 |

**Table 32**

| Compound No. | L₁ | L₂ | n1 | n2 |
|---|---|---|---|---|
| 34-4 | A34 | B4 | 2 | 1 |
| 35-8 | A35 | B8 | 2 | 1 |
| 36-10 | A36 | B10 | 2 | 1 |
| 37-13 | A37 | B13 | 2 | 1 |
| 38-20 | A38 | B20 | 2 | 1 |
| 39-24 | A39 | B24 | 2 | 1 |
| 40-27 | A40 | B27 | 2 | 1 |
| 41-48 | A41 | B48 | 2 | 1 |
| 42-62 | A42 | B62 | 2 | 1 |
| 43-63 | A43 | B63 | 2 | 1 |
| 44-85 | A44 | B85 | 2 | 1 |
| 45-91 | A45 | B91 | 2 | 1 |
| 46-108 | A46 | B108 | 2 | 1 |
| 47-116 | A47 | B116 | 2 | 1 |
| 48-137 | A48 | B137 | 2 | 1 |
| 49-144 | A49 | B144 | 2 | 1 |
| 50-152 | A50 | B152 | 2 | 1 |
| 51-162 | A51 | B162 | 2 | 1 |
| 52-169 | A52 | B169 | 2 | 1 |
| 53-176 | A53 | B176 | 2 | 1 |
| 54-187 | A54 | B187 | 2 | 1 |
| 55-201 | A55 | B201 | 2 | 1 |
| 56-202 | A56 | B202 | 2 | 1 |
| 57-213 | A57 | B213 | 2 | 1 |
| 58-249 | A58 | B249 | 2 | 1 |
| 59-272 | A59 | B272 | 2 | 1 |
| 60-281 | A60 | B281 | 2 | 1 |
| 61-306 | A61 | B306 | 2 | 1 |
| 62-340 | A62 | B340 | 2 | 1 |
| 63-399 | A63 | B399 | 2 | 1 |
| 64-445 | A64 | B445 | 2 | 1 |

**Table 33**

| Compound No. | L₁ | L₂ | n1 | n2 |
|---|---|---|---|---|
| 65-4 | A65 | B4 | 2 | 1 |
| 66-8 | A66 | B8 | 2 | 1 |
| 67-10 | A67 | B10 | 2 | 1 |
| 68-13 | A68 | B13 | 2 | 1 |
| 69-20 | A69 | B20 | 2 | 1 |
| 70-24 | A70 | B24 | 2 | 1 |
| 71-27 | A71 | B27 | 2 | 1 |
| 72-48 | A72 | B48 | 2 | 1 |
| 73-62 | A73 | B62 | 2 | 1 |
| 74-63 | A74 | B63 | 2 | 1 |
| 75-85 | A75 | B85 | 2 | 1 |
| 76-91 | A76 | B91 | 2 | 1 |
| 77-108 | A77 | B108 | 2 | 1 |
| 78-116 | A78 | B116 | 2 | 1 |
| 79-137 | A79 | B137 | 2 | 1 |
| 80-144 | A80 | B144 | 2 | 1 |
| 81-152 | A81 | B152 | 2 | 1 |
| 82-162 | A82 | B162 | 2 | 1 |
| 83-169 | A83 | B169 | 2 | 1 |
| 84-176 | A84 | B176 | 2 | 1 |
| 85-187 | A85 | B187 | 2 | 1 |
| 86-201 | A86 | B201 | 2 | 1 |
| 87-202 | A87 | B202 | 2 | 1 |
| 88-213 | A88 | B213 | 2 | 1 |
| 89-249 | A89 | B249 | 2 | 1 |
| 90-272 | A90 | B272 | 2 | 1 |
| 91-281 | A91 | B281 | 2 | 1 |
| 92-306 | A92 | B306 | 2 | 1 |
| 93-340 | A93 | B340 | 2 | 1 |
| 94-399 | A94 | B399 | 2 | 1 |
| 95-445 | A95 | B445 | 2 | 1 |

**Table 34**

| Compound No. | L₁ | L₂ | n1 | n2 |
|---|---|---|---|---|
| 96-4 | A96 | B4 | 2 | 1 |
| 97-8 | A97 | B8 | 2 | 1 |
| 98-10 | A98 | B10 | 2 | 1 |
| 99-13 | A99 | B13 | 2 | 1 |
| 100-20 | A100 | B20 | 2 | 1 |
| 101-24 | A101 | B24 | 2 | 1 |
| 102-27 | A102 | B27 | 2 | 1 |
| 103-48 | A103 | B48 | 2 | 1 |
| 104-62 | A104 | B62 | 2 | 1 |
| 105-63 | A105 | B63 | 2 | 1 |
| 106-85 | A106 | B85 | 2 | 1 |
| 107-91 | A107 | B91 | 2 | 1 |
| 108-108 | A108 | B108 | 2 | 1 |
| 109-116 | A109 | B116 | 2 | 1 |
| 110-137 | A110 | B137 | 2 | 1 |
| 111-144 | A111 | B144 | 2 | 1 |
| 112-152 | A112 | B152 | 2 | 1 |
| 113-162 | A113 | B162 | 2 | 1 |
| 114-169 | A114 | B169 | 2 | 1 |
| 115-176 | A115 | B176 | 2 | 1 |
| 116-48 or 960 | A116 | B48 | 2 | 1 |
| 117-201 | A117 | B201 | 2 | 1 |
| 118-24 or 962 | A118 | B24 | 2 | 1 |
| 119-213 | A119 | B213 | 2 | 1 |
| 120-249 | A120 | B249 | 2 | 1 |
| 121-272 | A121 | B272 | 2 | 1 |
| 122-281 | A122 | B281 | 2 | 1 |
| 123-306 | A123 | B306 | 2 | 1 |
| 124-340 | A124 | B340 | 2 | 1 |
| 125-399 | A125 | B399 | 2 | 1 |
| 126-445 | A126 | B445 | 2 | 1 |

**Table 35**

| Compound No. | L₁ | L₂ | n1 | n2 |
|---|---|---|---|---|
| 127-4 | A127 | B4 | 2 | 1 |
| 128-8 | A128 | B8 | 2 | 1 |
| 129-10 | A129 | B10 | 2 | 1 |
| 130-13 | A130 | B13 | 2 | 1 |
| 131-20 | A131 | B20 | 2 | 1 |
| 132-24 | A132 | B24 | 2 | 1 |
| 133-27 | A133 | B27 | 2 | 1 |
| 134-48 | A134 | B48 | 2 | 1 |
| 135-62 | A135 | B62 | 2 | 1 |
| 136-309 or 980 | A136 | B309 | 2 | 1 |
| 137-85 | A137 | B85 | 2 | 1 |
| 138-91 | A138 | B91 | 2 | 1 |
| 139-108 | A139 | B108 | 2 | 1 |
| 140-116 | A140 | B116 | 2 | 1 |
| 141-137 | A141 | B137 | 2 | 1 |
| 142-144 | A142 | B144 | 2 | 1 |
| 143-152 | A143 | B152 | 2 | 1 |
| 144-162 | A144 | B162 | 2 | 1 |
| 145-169 | A145 | B169 | 2 | 1 |
| 146-176 | A146 | B176 | 2 | 1 |
| 147-187 | A147 | B187 | 2 | 1 |
| 148-201 | A148 | B201 | 2 | 1 |
| 149-202 | A149 | B202 | 2 | 1 |
| 150-213 | A150 | B213 | 2 | 1 |
| 209-249 | A209 | B249 | 2 | 1 |
| 152-272 | A152 | B272 | 2 | 1 |
| 153-281 | A153 | B281 | 2 | 1 |
| 154-306 | A154 | B306 | 2 | 1 |
| 155-340 | A155 | B340 | 2 | 1 |
| 156-399 | A156 | B399 | 2 | 1 |
| 157-445 | A157 | B445 | 2 | 1 |

**Table 36**

| Compound No. | L₁ | L₂ | n1 | n2 |
|---|---|---|---|---|
| 158-4 | A158 | B4 | 2 | 1 |
| 159-8 | A159 | B8 | 2 | 1 |
| 160-10 | A160 | B10 | 2 | 1 |
| 161-13 | A161 | B13 | 2 | 1 |
| 162-20 | A162 | B20 | 2 | 1 |
| 163-24 | A163 | B24 | 2 | 1 |
| 164-27 | A164 | B27 | 2 | 1 |
| 165-48 | A165 | B48 | 2 | 1 |
| 166-62 | A166 | B62 | 2 | 1 |
| 167-63 | A167 | B63 | 2 | 1 |
| 168-85 | A168 | B85 | 2 | 1 |
| 169-91 | A169 | B91 | 2 | 1 |
| 170-108 | A170 | B108 | 2 | 1 |
| 171-116 | A171 | B116 | 2 | 1 |
| 172-137 | A172 | B137 | 2 | 1 |
| 173-144 | A173 | B144 | 2 | 1 |
| 174-152 | A174 | B152 | 2 | 1 |
| 175-162 | A175 | B162 | 2 | 1 |
| 176-169 | A176 | B169 | 2 | 1 |
| 177-176 | A177 | B176 | 2 | 1 |
| 178-187 | A178 | B187 | 2 | 1 |
| 179-201 | A179 | B201 | 2 | 1 |
| 180-202 | A180 | B202 | 2 | 1 |
| 181-213 | A181 | B213 | 2 | 1 |
| 182-249 | A182 | B249 | 2 | 1 |
| 183-272 | A183 | B272 | 2 | 1 |
| 184-281 | A184 | B281 | 2 | 1 |
| 185-306 | A185 | B306 | 2 | 1 |
| 186-340 | A186 | B340 | 2 | 1 |
| 187-399 | A187 | B399 | 2 | 1 |
| 188-445 | A188 | B445 | 2 | 1 |

**Table 37**

| Compound No. | L₁ | L₂ | n1 | n2 |
|---|---|---|---|---|
| 189-4 | A189 | B4 | 2 | 1 |
| 190-8 | A190 | B8 | 2 | 1 |
| 191-10 | A191 | B10 | 2 | 1 |
| 192-13 | A192 | B13 | 2 | 1 |
| 193-20 | A193 | B20 | 2 | 1 |
| 194-24 | A194 | B24 | 2 | 1 |
| 195-27 | A195 | B27 | 2 | 1 |
| 196-48 | A196 | B48 | 2 | 1 |
| 197-62 | A197 | B62 | 2 | 1 |
| 198-63 | A198 | B63 | 2 | 1 |
| 199-85 | A199 | B85 | 2 | 1 |
| 200-91 | A200 | B91 | 2 | 1 |
| 201-108 | A201 | B108 | 2 | 1 |
| 202-116 | A202 | B116 | 2 | 1 |
| 203-137 | A203 | B137 | 2 | 1 |
| 204-144 | A204 | B144 | 2 | 1 |
| 205-152 | A205 | B152 | 2 | 1 |
| 206-162 | A206 | B162 | 2 | 1 |
| 207-169 | A207 | B169 | 2 | 1 |
| 208-176 | A208 | B176 | 2 | 1 |
| 210-187 | A210 | B187 | 2 | 1 |
| 211-201 | A211 | B201 | 2 | 1 |
| 212-202 | A212 | B202 | 2 | 1 |
| 213-213 | A213 | B213 | 2 | 1 |
| 214-249 | A214 | B249 | 2 | 1 |
| 215-272 | A215 | B272 | 2 | 1 |
| 216-281 | A216 | B281 | 2 | 1 |
| 217-306 | A217 | B306 | 2 | 1 |
| 218-340 | A218 | B340 | 2 | 1 |
| 219-399 | A219 | B399 | 2 | 1 |
| 220-445 | A220 | B445 | 2 | 1 |

**Table 38**

| Compound No. | L₁ | L₂ | n1 | n2 |
|---|---|---|---|---|
| 221-4 | A221 | B4 | 2 | 1 |
| 222-8 | A222 | B8 | 2 | 1 |
| 223-10 | A223 | B10 | 2 | 1 |
| 224-13 | A224 | B13 | 2 | 1 |
| 225-20 | A225 | B20 | 2 | 1 |
| 226-24 | A226 | B24 | 2 | 1 |
| 227-27 | A227 | B27 | 2 | 1 |
| 228-48 | A228 | B48 | 2 | 1 |
| 229-62 | A229 | B62 | 2 | 1 |
| 230-63 | A230 | B63 | 2 | 1 |
| 231-85 | A231 | B85 | 2 | 1 |
| 232-91 | A232 | B91 | 2 | 1 |
| 233-108 | A233 | B108 | 2 | 1 |
| 234-116 | A234 | B116 | 2 | 1 |
| 235-137 | A235 | B137 | 2 | 1 |
| 236-144 | A236 | B144 | 2 | 1 |
| 237-152 | A237 | B152 | 2 | 1 |
| 238-162 | A238 | B162 | 2 | 1 |
| 239-169 | A239 | B169 | 2 | 1 |
| 240-176 | A240 | B176 | 2 | 1 |
| 241-187 | A241 | B187 | 2 | 1 |
| 242-201 | A242 | B201 | 2 | 1 |
| 243-202 | A243 | B202 | 2 | 1 |
| 244-213 | A244 | B213 | 2 | 1 |
| 245-249 | A245 | B249 | 2 | 1 |
| 246-272 | A246 | B272 | 2 | 1 |
| 247-281 | A247 | B281 | 2 | 1 |
| 248-306 | A248 | B306 | 2 | 1 |
| 249-340 | A249 | B340 | 2 | 1 |
| 250-399 | A250 | B399 | 2 | 1 |
| 251-445 | A251 | B445 | 2 | 1 |

**Table 39**

| Compound No. | L₁ | L₂ | n1 | n2 |
|---|---|---|---|---|
| 252-4 | A252 | B4 | 2 | 1 |
| 253-8 | A253 | B8 | 2 | 1 |
| 254-10 | A254 | B10 | 2 | 1 |
| 255-13 | A255 | B13 | 2 | 1 |
| 256-20 | A256 | B20 | 2 | 1 |
| 257-24 | A257 | B24 | 2 | 1 |
| 258-27 | A258 | B27 | 2 | 1 |
| 259-48 | A259 | B48 | 2 | 1 |
| 260-62 | A260 | B62 | 2 | 1 |
| 261-63 | A261 | B63 | 2 | 1 |
| 262-85 | A262 | B85 | 2 | 1 |
| 263-91 | A263 | B91 | 2 | 1 |
| 264-108 | A264 | B108 | 2 | 1 |
| 265-116 | A265 | B116 | 2 | 1 |
| 266-137 | A266 | B137 | 2 | 1 |
| 267-144 | A267 | B144 | 2 | 1 |
| 268-152 | A268 | B152 | 2 | 1 |
| 269-162 | A269 | B162 | 2 | 1 |
| 270-169 | A270 | B169 | 2 | 1 |
| 271-176 | A271 | B176 | 2 | 1 |
| 272-187 | A272 | B187 | 2 | 1 |
| 274-201 | A274 | B201 | 2 | 1 |
| 275-202 | A275 | B202 | 2 | 1 |
| 276-213 | A276 | B213 | 2 | 1 |
| 277-249 | A277 | B249 | 2 | 1 |
| 278-272 | A278 | B272 | 2 | 1 |
| 279-281 | A279 | B281 | 2 | 1 |
| 280-306 | A280 | B306 | 2 | 1 |
| 281-340 | A281 | B340 | 2 | 1 |
| 282-399 | A282 | B399 | 2 | 1 |
| 283-445 | A283 | B445 | 2 | 1 |

**Table 40**

| Compound No. | L₁ | L₂ | n1 | n2 |
|---|---|---|---|---|
| 284-4 | A284 | B4 | 2 | 1 |
| 285-8 | A285 | B8 | 2 | 1 |
| 286-10 | A286 | B10 | 2 | 1 |
| 287-13 | A287 | B13 | 2 | 1 |
| 288-20 | A288 | B20 | 2 | 1 |
| 289-24 | A289 | B24 | 2 | 1 |
| 290-27 | A290 | B27 | 2 | 1 |
| 291-48 | A291 | B48 | 2 | 1 |
| 292-62 | A292 | B62 | 2 | 1 |
| 293-63 | A293 | B63 | 2 | 1 |
| 294-85 | A294 | B85 | 2 | 1 |
| 295-91 | A295 | B91 | 2 | 1 |
| 296-108 | A296 | B108 | 2 | 1 |
| 297-116 | A297 | B116 | 2 | 1 |
| 298-137 | A298 | B137 | 2 | 1 |
| 299-144 | A299 | B144 | 2 | 1 |
| 300-152 | A300 | B152 | 2 | 1 |

**Table 41**

| Compound No. | L₁ | L₂ | n1 | n2 |
|---|---|---|---|---|
| 151-1 | A151 | B1 | 2 | 1 |
| 151-2 | A151 | B2 | 2 | 1 |
| 151-3 | A151 | B3 | 2 | 1 |
| 151-4 | A151 | B4 | 2 | 1 |
| 151-5 | A151 | B5 | 2 | 1 |
| 151-6 | A151 | B6 | 2 | 1 |
| 151-7 | A151 | B7 | 2 | 1 |
| 151-8 | A151 | B8 | 2 | 1 |
| 151-9 | A151 | B9 | 2 | 1 |
| 151-10 | A151 | B10 | 2 | 1 |
| 151-11 | A151 | B11 | 2 | 1 |
| 151-12 | A151 | B12 | 2 | 1 |
| 151-13 | A151 | B13 | 2 | 1 |
| 151-14 | A151 | B14 | 2 | 1 |
| 151-15 | A151 | B15 | 2 | 1 |
| 151-16 | A151 | B16 | 2 | 1 |
| 151-17 | A151 | B17 | 2 | 1 |
| 151-18 | A151 | B18 | 2 | 1 |
| 151-19 | A151 | B19 | 2 | 1 |
| 151-20 | A151 | B20 | 2 | 1 |
| 151-21 | A151 | B21 | 2 | 1 |
| 151-22 | A151 | B22 | 2 | 1 |
| 151-23 | A151 | B23 | 2 | 1 |
| 151-24 | A151 | B24 | 2 | 1 |
| 151-25 | A151 | B25 | 2 | 1 |
| 151-26 | A151 | B26 | 2 | 1 |
| 151-27 | A151 | B27 | 2 | 1 |
| 151-28 | A151 | B28 | 2 | 1 |
| 151-29 | A151 | B29 | 2 | 1 |
| 151-30 | A151 | B30 | 2 | 1 |

**Table 42**

| Compound No. | L₁ | L₂ | n1 | n2 |
|---|---|---|---|---|
| 151-31 | A151 | B31 | 2 | 1 |
| 151-32 | A151 | B32 | 2 | 1 |
| 151-33 | A151 | B33 | 2 | 1 |
| 151-34 | A151 | B34 | 2 | 1 |
| 151-35 | A151 | B35 | 2 | 1 |
| 151-36 | A151 | B36 | 2 | 1 |
| 151-37 | A151 | B37 | 2 | 1 |
| 151-38 | A151 | B38 | 2 | 1 |
| 151-39 | A151 | B39 | 2 | 1 |
| 151-40 | A151 | B40 | 2 | 1 |
| 151-41 | A151 | B41 | 2 | 1 |
| 151-42 | A151 | B42 | 2 | 1 |
| 151-43 | A151 | B43 | 2 | 1 |
| 151-44 | A151 | B44 | 2 | 1 |
| 151-45 | A151 | B45 | 2 | 1 |
| 151-46 | A151 | B46 | 2 | 1 |
| 151-47 | A151 | B47 | 2 | 1 |
| 151-48 | A151 | B48 | 2 | 1 |
| 151-49 | A151 | B49 | 2 | 1 |
| 151-50 | A151 | B50 | 2 | 1 |
| 151-51 | A151 | B51 | 2 | 1 |
| 151-52 | A151 | B52 | 2 | 1 |
| 151-53 | A151 | B53 | 2 | 1 |
| 151-54 | A151 | B54 | 2 | 1 |
| 151-55 | A151 | B55 | 2 | 1 |
| 151-56 | A151 | B56 | 2 | 1 |
| 151-57 | A151 | B57 | 2 | 1 |
| 151-58 | A151 | B58 | 2 | 1 |
| 151-59 | A151 | B59 | 2 | 1 |
| 151-60 | A151 | B60 | 2 | 1 |

**Table 43**

| Compound No. | L₁ | L₂ | n1 | n2 |
|---|---|---|---|---|
| 151-61 | A151 | B61 | 2 | 1 |
| 151-62 | A151 | B62 | 2 | 1 |
| 151-63 | A151 | B63 | 2 | 1 |
| 151-64 | A151 | B64 | 2 | 1 |
| 151-65 | A151 | B65 | 2 | 1 |
| 151-66 | A151 | B66 | 2 | 1 |
| 151-67 | A151 | B67 | 2 | 1 |
| 151-68 | A151 | B68 | 2 | 1 |
| 151-69 | A151 | B69 | 2 | 1 |
| 151-70 | A151 | B70 | 2 | 1 |
| 151-71 | A151 | B71 | 2 | 1 |
| 151-72 | A151 | B72 | 2 | 1 |
| 151-73 | A151 | B73 | 2 | 1 |
| 151-74 | A151 | B74 | 2 | 1 |
| 151-75 | A151 | B75 | 2 | 1 |
| 151-76 | A151 | B76 | 2 | 1 |
| 151-77 | A151 | B77 | 2 | 1 |
| 151-78 | A151 | B78 | 2 | 1 |
| 151-79 | A151 | B79 | 2 | 1 |
| 151-80 | A151 | B80 | 2 | 1 |
| 151-81 | A151 | B81 | 2 | 1 |
| 151-82 | A151 | B82 | 2 | 1 |
| 151-83 | A151 | B83 | 2 | 1 |
| 151-84 | A151 | B84 | 2 | 1 |
| 151-85 | A151 | B85 | 2 | 1 |
| 151-86 | A151 | B86 | 2 | 1 |
| 151-87 | A151 | B87 | 2 | 1 |
| 151-88 | A151 | B88 | 2 | 1 |
| 151-89 | A151 | B89 | 2 | 1 |
| 151-90 | A151 | B90 | 2 | 1 |

**Table 44**

| Compound No. | L₁ | L₂ | n1 | n2 |
|---|---|---|---|---|
| 151-91 | A151 | B91 | 2 | 1 |
| 151-92 | A151 | B92 | 2 | 1 |
| 151-93 | A151 | B93 | 2 | 1 |
| 151-94 | A151 | B94 | 2 | 1 |
| 151-95 | A151 | B95 | 2 | 1 |
| 151-96 | A151 | B96 | 2 | 1 |
| 151-97 | A151 | B97 | 2 | 1 |
| 151-98 | A151 | B98 | 2 | 1 |
| 151-99 | A151 | B99 | 2 | 1 |
| 151-100 | A151 | B100 | 2 | 1 |
| 151-101 | A151 | B101 | 2 | 1 |
| 151-102 | A151 | B102 | 2 | 1 |
| 151-103 | A151 | B103 | 2 | 1 |
| 151-104 | A151 | B104 | 2 | 1 |
| 151-105 | A151 | B105 | 2 | 1 |
| 151-106 | A151 | B106 | 2 | 1 |
| 151-107 | A151 | B107 | 2 | 1 |
| 151-108 | A151 | B108 | 2 | 1 |
| 151-109 | A151 | B109 | 2 | 1 |
| 151-110 | A151 | B110 | 2 | 1 |
| 151-111 | A151 | B111 | 2 | 1 |
| 151-112 | A151 | B112 | 2 | 1 |
| 151-113 | A151 | B113 | 2 | 1 |
| 151-114 | A151 | B114 | 2 | 1 |
| 151-115 | A151 | B115 | 2 | 1 |
| 151-116 | A151 | B116 | 2 | 1 |
| 151-117 | A151 | B117 | 2 | 1 |
| 151-118 | A151 | B118 | 2 | 1 |
| 151-119 | A151 | B119 | 2 | 1 |
| 151-120 | A151 | B120 | 2 | 1 |

**Table 45**

| Compound No. | L₁ | L₂ | n1 | n2 |
|---|---|---|---|---|
| 151-121 | A151 | B121 | 2 | 1 |
| 151-122 | A151 | B122 | 2 | 1 |
| 151-123 | A151 | B123 | 2 | 1 |
| 151-124 | A151 | B124 | 2 | 1 |
| 151-125 | A151 | B125 | 2 | 1 |
| 151-126 | A151 | B126 | 2 | 1 |
| 151-127 | A151 | B127 | 2 | 1 |
| 151-128 | A151 | B128 | 2 | 1 |
| 151-129 | A151 | B129 | 2 | 1 |
| 151-130 | A151 | B130 | 2 | 1 |
| 151-131 | A151 | B131 | 2 | 1 |
| 151-132 | A151 | B132 | 2 | 1 |
| 151-133 | A151 | B133 | 2 | 1 |
| 151-134 | A151 | B134 | 2 | 1 |
| 151-135 | A151 | B135 | 2 | 1 |
| 151-136 | A151 | B136 | 2 | 1 |
| 151-137 or 1279 | A151 | B137 | 2 | 1 |
| 151-138 | A151 | B138 | 2 | 1 |
| 151-139 | A151 | B139 | 2 | 1 |
| 151-140 | A151 | B140 | 2 | 1 |
| 151-141 | A151 | B141 | 2 | 1 |
| 151-142 | A151 | B142 | 2 | 1 |
| 151-143 | A151 | B143 | 2 | 1 |
| 151-144 | A151 | B144 | 2 | 1 |
| 151-145 | A151 | B145 | 2 | 1 |
| 151-146 | A151 | B146 | 2 | 1 |
| 151-147 | A151 | B147 | 2 | 1 |
| 151-148 | A151 | B148 | 2 | 1 |
| 151-149 | A151 | B149 | 2 | 1 |
| 151-150 | A151 | B150 | 2 | 1 |

**Table 46**

| Compound No. | L₁ | L₂ | n1 | n2 |
|---|---|---|---|---|
| 151-151 | A151 | B151 | 2 | 1 |
| 151-152 | A151 | B152 | 2 | 1 |
| 151-153 | A151 | B153 | 2 | 1 |
| 151-154 | A151 | B154 | 2 | 1 |
| 151-155 | A151 | B155 | 2 | 1 |
| 151-156 | A151 | B156 | 2 | 1 |
| 151-157 | A151 | B157 | 2 | 1 |
| 151-158 | A151 | B158 | 2 | 1 |
| 151-159 | A151 | B159 | 2 | 1 |
| 151-160 | A151 | B160 | 2 | 1 |
| 151-161 | A151 | B161 | 2 | 1 |
| 151-162 | A151 | B162 | 2 | 1 |
| 151-163 | A151 | B163 | 2 | 1 |
| 151-164 | A151 | B164 | 2 | 1 |
| 151-165 | A151 | B165 | 2 | 1 |
| 151-166 | A151 | B166 | 2 | 1 |
| 151-167 | A151 | B167 | 2 | 1 |
| 151-168 | A151 | B168 | 2 | 1 |
| 151-169 | A151 | B169 | 2 | 1 |
| 151-170 | A151 | B170 | 2 | 1 |
| 151-171 | A151 | B171 | 2 | 1 |
| 151-172 | A151 | B172 | 2 | 1 |
| 151-173 | A151 | B173 | 2 | 1 |
| 151-174 | A151 | B174 | 2 | 1 |
| 151-175 | A151 | B175 | 2 | 1 |
| 151-176 | A151 | B176 | 2 | 1 |
| 151-177 | A151 | B177 | 2 | 1 |
| 151-178 | A151 | B178 | 2 | 1 |
| 151-179 | A151 | B179 | 2 | 1 |
| 151-180 | A151 | B180 | 2 | 1 |

**Table 47**

| Compound No. | L₁ | L₂ | n1 | n2 |
|---|---|---|---|---|
| 151-181 | A151 | B181 | 2 | 1 |
| 151-182 | A151 | B182 | 2 | 1 |
| 151-183 | A151 | B183 | 2 | 1 |
| 151-184 | A151 | B184 | 2 | 1 |
| 151-185 | A151 | B185 | 2 | 1 |
| 151-186 | A151 | B186 | 2 | 1 |
| 151-187 | A151 | B187 | 2 | 1 |
| 151-188 | A151 | B188 | 2 | 1 |
| 151-189 | A151 | B189 | 2 | 1 |
| 151-190 | A151 | B190 | 2 | 1 |
| 151-191 | A151 | B191 | 2 | 1 |
| 151-192 | A151 | B192 | 2 | 1 |
| 151-193 | A151 | B193 | 2 | 1 |
| 151-194 | A151 | B194 | 2 | 1 |
| 151-195 | A151 | B195 | 2 | 1 |
| 151-196 | A151 | B196 | 2 | 1 |
| 151-197 | A151 | B197 | 2 | 1 |
| 151-198 | A151 | B198 | 2 | 1 |
| 151-199 | A151 | B199 | 2 | 1 |
| 151-200 | A151 | B200 | 2 | 1 |
| 151-201 | A151 | B201 | 2 | 1 |
| 151-202 | A151 | B202 | 2 | 1 |
| 151-203 | A151 | B203 | 2 | 1 |
| 151-204 | A151 | B204 | 2 | 1 |
| 151-205 | A151 | B205 | 2 | 1 |
| 151-206 | A151 | B206 | 2 | 1 |
| 151-207 | A151 | B207 | 2 | 1 |
| 151-208 | A151 | B208 | 2 | 1 |
| 151-209 | A151 | B209 | 2 | 1 |
| 151-210 | A151 | B210 | 2 | 1 |

**Table 48**

| Compound No. | L₁ | L₂ | n1 | n2 |
|---|---|---|---|---|
| 151-211 | A151 | B211 | 2 | 1 |
| 151-212 | A151 | B212 | 2 | 1 |
| 151-213 | A151 | B213 | 2 | 1 |
| 151-214 | A151 | B214 | 2 | 1 |
| 151-215 | A151 | B215 | 2 | 1 |
| 151-216 | A151 | B216 | 2 | 1 |
| 151-217 | A151 | B217 | 2 | 1 |
| 151-218 | A151 | B218 | 2 | 1 |
| 151-219 | A151 | B219 | 2 | 1 |
| 151-220 | A151 | B220 | 2 | 1 |
| 151-221 | A151 | B221 | 2 | 1 |
| 151-222 | A151 | B222 | 2 | 1 |
| 151-223 | A151 | B223 | 2 | 1 |
| 151-224 | A151 | B224 | 2 | 1 |
| 151-225 | A151 | B225 | 2 | 1 |
| 151-226 | A151 | B226 | 2 | 1 |
| 151-227 | A151 | B227 | 2 | 1 |
| 151-228 | A151 | B228 | 2 | 1 |
| 151-229 | A151 | B229 | 2 | 1 |
| 151-230 | A151 | B230 | 2 | 1 |
| 151-231 | A151 | B231 | 2 | 1 |
| 151-232 | A151 | B232 | 2 | 1 |
| 151-233 | A151 | B233 | 2 | 1 |
| 151-234 | A151 | B234 | 2 | 1 |
| 151-235 | A151 | B235 | 2 | 1 |
| 151-236 | A151 | B236 | 2 | 1 |
| 151-237 | A151 | B237 | 2 | 1 |
| 151-238 | A151 | B238 | 2 | 1 |
| 151-239 | A151 | B239 | 2 | 1 |
| 151-240 | A151 | B240 | 2 | 1 |

**Table 49**

| Compound No. | L₁ | L₂ | n1 | n2 |
|---|---|---|---|---|
| 151-241 | A151 | B241 | 2 | 1 |
| 151-242 | A151 | B242 | 2 | 1 |
| 151-243 | A151 | B243 | 2 | 1 |
| 151-244 | A151 | B244 | 2 | 1 |
| 151-245 | A151 | B245 | 2 | 1 |
| 151-246 | A151 | B246 | 2 | 1 |
| 151-247 | A151 | B247 | 2 | 1 |
| 151-248 | A151 | B248 | 2 | 1 |
| 151-249 | A151 | B249 | 2 | 1 |
| 151-250 | A151 | B250 | 2 | 1 |
| 151-251 | A151 | B251 | 2 | 1 |
| 151-252 | A151 | B252 | 2 | 1 |
| 151-253 | A151 | B253 | 2 | 1 |
| 151-254 | A151 | B254 | 2 | 1 |
| 151-255 | A151 | B255 | 2 | 1 |
| 151-256 | A151 | B256 | 2 | 1 |
| 151-257 | A151 | B257 | 2 | 1 |
| 151-258 | A151 | B258 | 2 | 1 |
| 151-259 | A151 | B259 | 2 | 1 |
| 151-260 | A151 | B260 | 2 | 1 |
| 151-261 | A151 | B261 | 2 | 1 |
| 151-262 | A151 | B262 | 2 | 1 |
| 151-263 | A151 | B263 | 2 | 1 |
| 151-264 | A151 | B264 | 2 | 1 |
| 151-265 | A151 | B265 | 2 | 1 |
| 151-266 | A151 | B266 | 2 | 1 |
| 151-267 | A151 | B267 | 2 | 1 |
| 151-268 | A151 | B268 | 2 | 1 |
| 151-269 | A151 | B269 | 2 | 1 |
| 151-270 | A151 | B270 | 2 | 1 |

**Table 50**

| Compound No. | L₁ | L₂ | n1 | n2 |
|---|---|---|---|---|
| 151-271 | A151 | B271 | 2 | 1 |
| 151-272 | A151 | B272 | 2 | 1 |
| 151-273 | A151 | B273 | 2 | 1 |
| 151-274 | A151 | B274 | 2 | 1 |
| 151-275 | A151 | B275 | 2 | 1 |
| 151-276 | A151 | B276 | 2 | 1 |
| 151-277 | A151 | B277 | 2 | 1 |
| 151-278 | A151 | B278 | 2 | 1 |
| 151-279 | A151 | B279 | 2 | 1 |
| 151-280 | A151 | B280 | 2 | 1 |
| 151-281 | A151 | B281 | 2 | 1 |
| 151-282 | A151 | B282 | 2 | 1 |
| 151-283 | A151 | B283 | 2 | 1 |
| 151-284 | A151 | B284 | 2 | 1 |
| 151-285 | A151 | B285 | 2 | 1 |
| 151-286 | A151 | B286 | 2 | 1 |
| 151-287 | A151 | B287 | 2 | 1 |
| 151-288 | A151 | B288 | 2 | 1 |
| 151-289 | A151 | B289 | 2 | 1 |
| 151-290 | A151 | B290 | 2 | 1 |
| 151-291 | A151 | B291 | 2 | 1 |
| 151-292 | A151 | B292 | 2 | 1 |
| 151-293 | A151 | B293 | 2 | 1 |
| 151-294 | A151 | B294 | 2 | 1 |
| 151-295 | A151 | B295 | 2 | 1 |
| 151-296 | A151 | B296 | 2 | 1 |
| 151-297 | A151 | B297 | 2 | 1 |
| 151-298 | A151 | B298 | 2 | 1 |
| 151-299 | A151 | B299 | 2 | 1 |
| 151-300 | A151 | B300 | 2 | 1 |

**Table 51**

| Compound No. | L₁ | L₂ | n1 | n2 |
|---|---|---|---|---|
| 151-301 | A151 | B301 | 2 | 1 |
| 151-302 | A151 | B302 | 2 | 1 |
| 151-303 | A151 | B303 | 2 | 1 |
| 151-304 | A151 | B304 | 2 | 1 |
| 151-305 | A151 | B305 | 2 | 1 |
| 151-306 | A151 | B306 | 2 | 1 |
| 151-307 | A151 | B307 | 2 | 1 |
| 151-308 | A151 | B308 | 2 | 1 |
| 151-309 | A151 | B309 | 2 | 1 |
| 151-310 | A151 | B310 | 2 | 1 |
| 151-311 | A151 | B311 | 2 | 1 |
| 151-312 | A151 | B312 | 2 | 1 |
| 151-313 | A151 | B313 | 2 | 1 |
| 151-314 | A151 | B314 | 2 | 1 |
| 151-315 | A151 | B315 | 2 | 1 |
| 151-316 | A151 | B316 | 2 | 1 |
| 151-317 | A151 | B317 | 2 | 1 |
| 151-318 | A151 | B318 | 2 | 1 |
| 151-319 | A151 | B319 | 2 | 1 |
| 151-320 | A151 | B320 | 2 | 1 |
| 151-321 | A151 | B321 | 2 | 1 |
| 151-322 | A151 | B322 | 2 | 1 |
| 151-323 | A151 | B323 | 2 | 1 |
| 151-324 | A151 | B324 | 2 | 1 |
| 151-325 | A151 | B325 | 2 | 1 |
| 151-326 | A151 | B326 | 2 | 1 |
| 151-327 | A151 | B327 | 2 | 1 |
| 151-328 | A151 | B328 | 2 | 1 |
| 151-329 | A151 | B329 | 2 | 1 |
| 151-330 | A151 | B330 | 2 | 1 |

**Table 52**

| Compound No. | L₁ | L₂ | n1 | n2 |
|---|---|---|---|---|
| 151-331 | A151 | B331 | 2 | 1 |
| 151-332 | A151 | B332 | 2 | 1 |
| 151-333 | A151 | B333 | 2 | 1 |
| 151-334 | A151 | B334 | 2 | 1 |
| 151-335 | A151 | B335 | 2 | 1 |
| 151-336 | A151 | B336 | 2 | 1 |
| 151-337 | A151 | B337 | 2 | 1 |
| 151-338 | A151 | B338 | 2 | 1 |
| 151-339 | A151 | B339 | 2 | 1 |
| 151-340 | A151 | B340 | 2 | 1 |
| 151-341 | A151 | B341 | 2 | 1 |
| 151-342 | A151 | B342 | 2 | 1 |
| 151-343 | A151 | B343 | 2 | 1 |
| 151-344 | A151 | B344 | 2 | 1 |
| 151-345 | A151 | B345 | 2 | 1 |
| 151-346 | A151 | B346 | 2 | 1 |
| 151-347 | A151 | B347 | 2 | 1 |
| 151-348 | A151 | B348 | 2 | 1 |
| 151-349 | A151 | B349 | 2 | 1 |
| 151-350 | A151 | B350 | 2 | 1 |
| 151-351 | A151 | B351 | 2 | 1 |
| 151-352 | A151 | B352 | 2 | 1 |
| 151-353 | A151 | B353 | 2 | 1 |
| 151-354 | A151 | B354 | 2 | 1 |
| 151-355 | A151 | B355 | 2 | 1 |
| 151-356 | A151 | B356 | 2 | 1 |
| 151-357 | A151 | B357 | 2 | 1 |
| 151-358 | A151 | B358 | 2 | 1 |
| 151-359 | A151 | B359 | 2 | 1 |
| 151-360 | A151 | B360 | 2 | 1 |

**Table 53**

| Compound No. | L₁ | L₂ | n1 | n2 |
|---|---|---|---|---|
| 151-361 | A151 | B361 | 2 | 1 |
| 151-362 | A151 | B362 | 2 | 1 |
| 151-363 | A151 | B363 | 2 | 1 |
| 151-364 | A151 | B364 | 2 | 1 |
| 151-365 | A151 | B365 | 2 | 1 |
| 151-366 | A151 | B366 | 2 | 1 |
| 151-367 | A151 | B367 | 2 | 1 |
| 151-368 | A151 | B368 | 2 | 1 |
| 151-369 | A151 | B369 | 2 | 1 |
| 151-370 | A151 | B370 | 2 | 1 |
| 151-371 | A151 | B371 | 2 | 1 |
| 151-372 | A151 | B372 | 2 | 1 |
| 151-373 | A151 | B373 | 2 | 1 |
| 151-374 | A151 | B374 | 2 | 1 |
| 151-375 | A151 | B375 | 2 | 1 |
| 151-376 | A151 | B376 | 2 | 1 |
| 151-377 | A151 | B377 | 2 | 1 |
| 151-378 | A151 | B378 | 2 | 1 |
| 151-379 | A151 | B379 | 2 | 1 |
| 151-380 | A151 | B380 | 2 | 1 |
| 151-381 | A151 | B381 | 2 | 1 |
| 151-382 | A151 | B382 | 2 | 1 |
| 151-383 | A151 | B383 | 2 | 1 |
| 151-384 | A151 | B384 | 2 | 1 |
| 151-385 | A151 | B385 | 2 | 1 |
| 151-386 | A151 | B386 | 2 | 1 |
| 151-387 | A151 | B387 | 2 | 1 |
| 151-388 | A151 | B388 | 2 | 1 |
| 151-389 | A151 | B389 | 2 | 1 |
| 151-390 | A151 | B390 | 2 | 1 |

**Table 54**

| Compound No. | L₁ | L₂ | n1 | n2 |
|---|---|---|---|---|
| 151-391 | A151 | B391 | 2 | 1 |
| 151-392 | A151 | B392 | 2 | 1 |
| 151-393 | A151 | B393 | 2 | 1 |
| 151-394 | A151 | B394 | 2 | 1 |
| 151-395 | A151 | B395 | 2 | 1 |
| 151-396 | A151 | B396 | 2 | 1 |
| 151-397 | A151 | B397 | 2 | 1 |
| 151-398 | A151 | B398 | 2 | 1 |
| 151-399 | A151 | B399 | 2 | 1 |
| 151-400 | A151 | B400 | 2 | 1 |
| 151-401 | A151 | B401 | 2 | 1 |
| 151-402 | A151 | B402 | 2 | 1 |
| 151-403 | A151 | B403 | 2 | 1 |
| 151-404 | A151 | B404 | 2 | 1 |
| 151-405 | A151 | B405 | 2 | 1 |
| 151-406 | A151 | B406 | 2 | 1 |
| 151-407 | A151 | B407 | 2 | 1 |
| 151-408 | A151 | B408 | 2 | 1 |
| 151-409 | A151 | B409 | 2 | 1 |
| 151-410 | A151 | B410 | 2 | 1 |
| 151-411 | A151 | B411 | 2 | 1 |
| 151-412 | A151 | B412 | 2 | 1 |
| 151-413 | A151 | B413 | 2 | 1 |
| 151-414 | A151 | B414 | 2 | 1 |
| 151-415 | A151 | B415 | 2 | 1 |
| 151-416 | A151 | B416 | 2 | 1 |
| 151-417 | A151 | B417 | 2 | 1 |
| 151-418 | A151 | B418 | 2 | 1 |
| 151-419 | A151 | B419 | 2 | 1 |
| 151-420 | A151 | B420 | 2 | 1 |

**Table 55**

| Compound No. | L₁ | L₂ | n1 | n2 |
|---|---|---|---|---|
| 151-421 | A151 | B421 | 2 | 1 |
| 151-422 | A151 | B422 | 2 | 1 |
| 151-423 | A151 | B423 | 2 | 1 |
| 151-424 | A151 | B424 | 2 | 1 |
| 151-425 | A151 | B425 | 2 | 1 |
| 151-426 | A151 | B426 | 2 | 1 |
| 151-427 | A151 | B427 | 2 | 1 |
| 151-428 | A151 | B428 | 2 | 1 |
| 151-429 | A151 | B429 | 2 | 1 |
| 151-430 | A151 | B430 | 2 | 1 |
| 115-431 | A151 | B431 | 2 | 1 |
| 151-432 | A151 | B432 | 2 | 1 |
| 151-433 | A151 | B433 | 2 | 1 |
| 151-434 | A151 | B434 | 2 | 1 |
| 151-435 | A151 | B435 | 2 | 1 |
| 151-436 | A151 | B436 | 2 | 1 |
| 151-437 | A151 | B437 | 2 | 1 |
| 151-438 | A151 | B438 | 2 | 1 |
| 151-439 | A151 | B439 | 2 | 1 |
| 151-440 | A151 | B440 | 2 | 1 |
| 151-441 | A151 | B441 | 2 | 1 |
| 151-442 | A151 | B442 | 2 | 1 |
| 151-443 | A151 | B443 | 2 | 1 |
| 151-444 | A151 | B444 | 2 | 1 |
| 151-445 | A151 | B445 | 2 | 1 |
| 151-446 | A151 | B446 | 2 | 1 |
| 151-447 | A151 | B447 | 2 | 1 |
| 151-448 | A151 | B448 | 2 | 1 |
| 151-449 | A151 | B449 | 2 | 1 |
| 151-450 | A151 | B450 | 2 | 1 |

**Table 56**

| Compound No. | L₁ | L₂ | n1 | n2 |
|---|---|---|---|---|
| 151-451 | A151 | B451 | 2 | 1 |
| 151-452 | A151 | B452 | 2 | 1 |
| 151-453 | A151 | B453 | 2 | 1 |
| 151-454 | A151 | B454 | 2 | 1 |
| 151-455 | A151 | B455 | 2 | 1 |
| 151-456 | A151 | B456 | 2 | 1 |
| 151-457 | A151 | B457 | 2 | 1 |
| 151-458 | A151 | B458 | 2 | 1 |
| 151-459 | A151 | B459 | 2 | 1 |
| 151-460 | A151 | B460 | 2 | 1 |
| 151-461 | A151 | B461 | 2 | 1 |
| 151-462 | A151 | B462 | 2 | 1 |
| 151-463 | A151 | B463 | 2 | 1 |
| 151-464 | A151 | B464 | 2 | 1 |
| 151-465 | A151 | B465 | 2 | 1 |
| 151-466 | A151 | B466 | 2 | 1 |
| 151-467 | A151 | B467 | 2 | 1 |
| 151-468 | A151 | B468 | 2 | 1 |
| 151-469 | A151 | B469 | 2 | 1 |
| 151-470 | A151 | B470 | 2 | 1 |
| 151-471 | A151 | B471 | 2 | 1 |
| 151-472 | A151 | B472 | 2 | 1 |
| 151-473 | A151 | B473 | 2 | 1 |
| 151-474 | A151 | B474 | 2 | 1 |
| 151-475 | A151 | B475 | 2 | 1 |
| 151-476 | A151 | B476 | 2 | 1 |
| 151-477 | A151 | B477 | 2 | 1 |
| 151-478 | A151 | B478 | 2 | 1 |
| 151-479 | A151 | B479 | 2 | 1 |
| 151-480 | A151 | B480 | 2 | 1 |

**Table 57**

| Compound No. | L₁ | L₂ | n1 | n2 |
|---|---|---|---|---|
| 151-481 | A151 | B481 | 2 | 1 |
| 151-482 | A151 | B482 | 2 | 1 |
| 151-483 | A151 | B483 | 2 | 1 |
| 151-484 | A151 | B484 | 2 | 1 |
| 151-485 | A151 | B485 | 2 | 1 |
| 151-486 | A151 | B486 | 2 | 1 |
| 151-487 | A151 | B487 | 2 | 1 |
| 151-488 | A151 | B488 | 2 | 1 |
| 151-489 | A151 | B489 | 2 | 1 |
| 151-490 | A151 | B490 | 2 | 1 |
| 151-491 | A151 | B491 | 2 | 1 |
| 151-492 | A151 | B492 | 2 | 1 |
| 151-493 | A151 | B493 | 2 | 1 |
| 151-494 | A151 | B494 | 2 | 1 |
| 151-495 | A151 | B495 | 2 | 1 |
| 151-496 | A151 | B496 | 2 | 1 |
| 151-497 | A151 | B497 | 2 | 1 |
| 151-498 | A151 | B498 | 2 | 1 |
| 151-499 | A151 | B499 | 2 | 1 |
| 151-500 | A151 | B500 | 2 | 1 |
| 151-501 | A151 | B501 | 2 | 1 |
| 151-502 | A151 | B502 | 2 | 1 |
| 151-503 | A151 | B503 | 2 | 1 |
| 151-504 | A151 | B504 | 2 | 1 |
| 151-505 | A151 | B505 | 2 | 1 |
| 151-506 | A151 | B506 | 2 | 1 |
| 151-507 | A151 | B507 | 2 | 1 |
| 151-508 | A151 | B508 | 2 | 1 |
| 151-509 | A151 | B509 | 2 | 1 |
| 151-510 | A151 | B510 | 2 | 1 |

**Table 58**

| Compound No. | L₁ | L₂ | n1 | n2 |
|---|---|---|---|---|
| 151-511 | A151 | B511 | 2 | 1 |
| 151-512 | A151 | B512 | 2 | 1 |
| 151-513 | A151 | B513 | 2 | 1 |
| 151-514 | A151 | B514 | 2 | 1 |
| 151-515 | A151 | B515 | 2 | 1 |
| 151-516 | A151 | B516 | 2 | 1 |
| 151-517 | A151 | B517 | 2 | 1 |
| 151-518 | A151 | B518 | 2 | 1 |
| 151-519 | A151 | B519 | 2 | 1 |
| 151-520 | A151 | B520 | 2 | 1 |
| 151-521 | A151 | B521 | 2 | 1 |
| 151-522 | A151 | B522 | 2 | 1 |
| 151-523 | A151 | B523 | 2 | 1 |
| 151-524 | A151 | B524 | 2 | 1 |
| 151-525 | A151 | B525 | 2 | 1 |
| 151-526 | A151 | B526 | 2 | 1 |
| 151-527 | A151 | B527 | 2 | 1 |
| 151-528 | A151 | B528 | 2 | 1 |
| 151-529 | A151 | B529 | 2 | 1 |
| 151-530 | A151 | B530 | 2 | 1 |
| 151-531 | A151 | B531 | 2 | 1 |
| 151-532 | A151 | B532 | 2 | 1 |
| 151-533 | A151 | B533 | 2 | 1 |
| 151-534 | A151 | B534 | 2 | 1 |
| 151-535 | A151 | B535 | 2 | 1 |
| 151-536 | A151 | B536 | 2 | 1 |
| 151-537 | A151 | B537 | 2 | 1 |
| 151-538 | A151 | B538 | 2 | 1 |
| 151-539 | A151 | B539 | 2 | 1 |
| 151-540 | A151 | B540 | 2 | 1 |

**Table 59**

| Compound No. | L₁ | L₂ | n1 | n2 |
|---|---|---|---|---|
| 151-541 | A151 | B541 | 2 | 1 |
| 151-542 | A151 | B542 | 2 | 1 |
| 151-543 | A151 | B543 | 2 | 1 |
| 151-544 | A151 | B544 | 2 | 1 |
| 151-545 | A151 | B545 | 2 | 1 |
| 151-546 | A151 | B546 | 2 | 1 |
| 151-547 | A151 | B547 | 2 | 1 |
| 151-548 | A151 | B548 | 2 | 1 |
| 151-549 | A151 | B549 | 2 | 1 |
| 151-550 | A151 | B550 | 2 | 1 |
| 151-551 | A151 | B551 | 2 | 1 |
| 151-552 | A151 | B552 | 2 | 1 |
| 151-553 | A151 | B553 | 2 | 1 |
| 151-554 | A151 | B554 | 2 | 1 |
| 151-555 | A151 | B555 | 2 | 1 |
| 151-556 | A151 | B556 | 2 | 1 |
| 151-557 | A151 | B557 | 2 | 1 |
| 151-558 | A151 | B558 | 2 | 1 |
| 151-559 | A151 | B559 | 2 | 1 |
| 151-560 | A151 | B560 | 2 | 1 |
| 151-561 | A151 | B561 | 2 | 1 |
| 151-562 | A151 | B562 | 2 | 1 |
| 151-563 | A151 | B563 | 2 | 1 |
| 151-564 | A151 | B564 | 2 | 1 |
| 151-565 | A151 | B565 | 2 | 1 |
| 151-566 | A151 | B566 | 2 | 1 |
| 151-567 | A151 | B567 | 2 | 1 |
| 151-568 | A151 | B568 | 2 | 1 |
| 151-569 | A151 | B569 | 2 | 1 |
| 151-570 | A151 | B570 | 2 | 1 |

**Table 60**

| Compound No. | L₁ | L₂ | n1 | n2 |
|---|---|---|---|---|
| 151-571 | A151 | B571 | 2 | 1 |
| 151-572 | A151 | B572 | 2 | 1 |
| 151-573 | A151 | B573 | 2 | 1 |
| 115-574 | A151 | B574 | 2 | 1 |
| 151-575 | A151 | B575 | 2 | 1 |
| 151-576 | A151 | B576 | 2 | 1 |
| 151-577 | A151 | B577 | 2 | 1 |
| 151-578 | A151 | B578 | 2 | 1 |
| 151-579 | A151 | B579 | 2 | 1 |
| 151-580 | A151 | B580 | 2 | 1 |
| 151-581 | A151 | B581 | 2 | 1 |
| 151-582 | A151 | B582 | 2 | 1 |
| 151-583 | A151 | B583 | 2 | 1 |
| 151-584 | A151 | B584 | 2 | 1 |
| 151-585 | A151 | B585 | 2 | 1 |
| 151-586 | A151 | B586 | 2 | 1 |
| 151-587 | A151 | B587 | 2 | 1 |
| 151-588 | A151 | B588 | 2 | 1 |
| 151-589 | A151 | B589 | 2 | 1 |
| 151-590 | A151 | B590 | 2 | 1 |
| 151-591 | A151 | B591 | 2 | 1 |
| 151-592 | A151 | B592 | 2 | 1 |
| 151-593 | A151 | B593 | 2 | 1 |
| 151-594 | A151 | B594 | 2 | 1 |
| 151-595 | A151 | B595 | 2 | 1 |
| 151-596 | A151 | B596 | 2 | 1 |
| 151-597 | A151 | B597 | 2 | 1 |
| 151-598 | A151 | B598 | 2 | 1 |
| 151-599 | A151 | B599 | 2 | 1 |
| 151-600 | A151 | B600 | 2 | 1 |

**Table 61**

| Compound No. | L₁ | L₂ | n1 | n2 |
|---|---|---|---|---|
| 151-601 | A151 | B601 | 2 | 1 |
| 151-602 | A151 | B602 | 2 | 1 |
| 151-603 | A151 | B603 | 2 | 1 |
| 151-604 | A151 | B604 | 2 | 1 |
| 151-605 | A151 | B605 | 2 | 1 |
| 151-606 | A151 | B606 | 2 | 1 |
| 151-607 | A151 | B607 | 2 | 1 |
| 151-608 | A151 | B608 | 2 | 1 |
| 151-609 | A151 | B609 | 2 | 1 |
| 151-610 | A151 | B610 | 2 | 1 |
| 151-611 | A151 | B611 | 2 | 1 |
| 151-612 | A151 | B612 | 2 | 1 |
| 151-613 | A151 | B613 | 2 | 1 |
| 151-614 | A151 | B614 | 2 | 1 |
| 151-615 | A151 | B615 | 2 | 1 |
| 151-616 | A151 | B616 | 2 | 1 |
| 151-617 | A151 | B617 | 2 | 1 |
| 151-618 | A151 | B618 | 2 | 1 |
| 151-619 | A151 | B619 | 2 | 1 |
| 151-620 | A151 | B620 | 2 | 1 |
| 151-621 | A151 | B621 | 2 | 1 |
| 151-622 | A151 | B622 | 2 | 1 |
| 151-623 | A151 | B623 | 2 | 1 |
| 151-624 | A151 | B624 | 2 | 1 |
| 151-625 | A151 | B625 | 2 | 1 |
| 151-626 | A151 | B626 | 2 | 1 |
| 151-627 | A151 | B627 | 2 | 1 |
| 151-628 | A151 | B628 | 2 | 1 |
| 151-629 | A151 | B629 | 2 | 1 |
| 151-630 | A151 | B630 | 2 | 1 |

**Table 62**

| Compound No. | L₁ | L₂ | n1 | n2 |
|---|---|---|---|---|
| 151-631 | A151 | B631 | 2 | 1 |
| 151-632 | A151 | B632 | 2 | 1 |
| 151-633 | A151 | B633 | 2 | 1 |
| 151-634 | A151 | B634 | 2 | 1 |
| 151-635 | A151 | B635 | 2 | 1 |
| 151-636 | A151 | B636 | 2 | 1 |
| 151-637 | A151 | B637 | 2 | 1 |
| 151-638 | A151 | B638 | 2 | 1 |
| 151-639 | A151 | B639 | 2 | 1 |
| 151-640 | A151 | B640 | 2 | 1 |
| 151-641 | A151 | B641 | 2 | 1 |
| 151-642 | A151 | B642 | 2 | 1 |
| 151-643 | A151 | B643 | 2 | 1 |
| 151-644 | A151 | B644 | 2 | 1 |
| 151-645 | A151 | B645 | 2 | 1 |
| 151-646 | A151 | B646 | 2 | 1 |
| 151-647 | A151 | B647 | 2 | 1 |
| 151-648 | A151 | B648 | 2 | 1 |
| 151-649 | A151 | B649 | 2 | 1 |
| 151-650 | A151 | B650 | 2 | 1 |
| 151-651 | A151 | B651 | 2 | 1 |
| 151-1652 | A151 | B652 | 2 | 1 |
| 151-653 | A151 | B653 | 2 | 1 |
| 151-654 | A151 | B654 | 2 | 1 |
| 151-655 | A151 | B655 | 2 | 1 |
| 151-656 | A151 | B656 | 2 | 1 |
| 151-657 | A151 | B657 | 2 | 1 |
| 151-658 | A151 | B658 | 2 | 1 |
| 151-659 | A151 | B659 | 2 | 1 |
| 151-660 | A151 | B660 | 2 | 1 |

**Table 63**

| Compound No. | L₁ | L₂ | n1 | n2 |
|---|---|---|---|---|
| 152-4 | A152 | B4 | 2 | 1 |
| 152-8 | A152 | B8 | 2 | 1 |
| 152-10 | A152 | B10 | 2 | 1 |
| 152-13 | A152 | B13 | 2 | 1 |
| 152-20 | A152 | B20 | 2 | 1 |
| 152-24 | A152 | B24 | 2 | 1 |
| 152-27 | A152 | B27 | 2 | 1 |
| 152-48 | A152 | B48 | 2 | 1 |
| 152-62 | A152 | B62 | 2 | 1 |
| 152-63 | A152 | B63 | 2 | 1 |
| 152-85 | A152 | B85 | 2 | 1 |
| 152-91 | A152 | B91 | 2 | 1 |
| 152-108 | A152 | B108 | 2 | 1 |
| 152-116 | A152 | B116 | 2 | 1 |
| 152-137 | A152 | B137 | 2 | 1 |
| 152-144 | A152 | B144 | 2 | 1 |
| 152-152 | A152 | B152 | 2 | 1 |
| 152-162 | A152 | B162 | 2 | 1 |
| 152-169 | A152 | B169 | 2 | 1 |
| 152-176 | A152 | B176 | 2 | 1 |
| 152-187 | A152 | B187 | 2 | 1 |
| 152-201 | A152 | B201 | 2 | 1 |
| 152-202 | A152 | B202 | 2 | 1 |
| 152-213 | A152 | B213 | 2 | 1 |
| 152-249 | A152 | B249 | 2 | 1 |
| 152-272 | A152 | B272 | 2 | 1 |
| 152-281 | A152 | B281 | 2 | 1 |
| 152-306 | A152 | B306 | 2 | 1 |
| 152-340 | A152 | B340 | 2 | 1 |
| 152-399 | A152 | B399 | 2 | 1 |
| 152-445 | A152 | B445 | 2 | 1 |

**Table 64**

| Compound No. | L₁ | L₂ | n1 | n2 |
|---|---|---|---|---|
| 153-7 | A153 | B7 | 2 | 1 |
| 153-9 | A153 | B9 | 2 | 1 |
| 153-10 | A153 | B10 | 2 | 1 |
| 153-13 | A153 | B13 | 2 | 1 |
| 153-22 | A153 | B22 | 2 | 1 |
| 153-26 | A153 | B26 | 2 | 1 |
| 153-29 | A153 | B29 | 2 | 1 |
| 153-50 | A153 | B50 | 2 | 1 |
| 153-64 | A153 | B64 | 2 | 1 |
| 153-65 | A153 | B65 | 2 | 1 |
| 153-87 | A153 | B87 | 2 | 1 |
| 153-93 | A153 | B93 | 2 | 1 |
| 153-110 | A153 | B110 | 2 | 1 |
| 153-118 | A153 | B118 | 2 | 1 |
| 153-139 | A153 | B139 | 2 | 1 |
| 153-146 | A153 | B146 | 2 | 1 |
| 153-154 | A153 | B154 | 2 | 1 |
| 153-163 | A153 | B163 | 2 | 1 |
| 153-167 | A153 | B167 | 2 | 1 |
| 154-178 | A154 | B178 | 2 | 1 |
| 154-189 | A154 | B189 | 2 | 1 |
| 154-203 | A154 | B203 | 2 | 1 |
| 154-205 | A154 | B205 | 2 | 1 |
| 154-215 | A154 | B215 | 2 | 1 |
| 154-251 | A154 | B251 | 2 | 1 |
| 154-274 | A154 | B274 | 2 | 1 |
| 154-283 | A154 | B283 | 2 | 1 |
| 154-308 | A154 | B308 | 2 | 1 |
| 154-341 | A154 | B341 | 2 | 1 |
| 154-397 | A154 | B397 | 2 | 1 |
| 154-447 | A154 | B447 | 2 | 1 |

**Table 65**

| Compound No. | L₁ | L₂ | n1 | n2 |
|---|---|---|---|---|
| 155-7 | A155 | B7 | 2 | 1 |
| 155-9 | A155 | B9 | 2 | 1 |
| 155-10 | A155 | B10 | 2 | 1 |
| 155-13 | A155 | B13 | 2 | 1 |
| 155-22 | A155 | B22 | 2 | 1 |
| 155-26 | A155 | B26 | 2 | 1 |
| 155-29 | A155 | B29 | 2 | 1 |
| 155-50 | A155 | B50 | 2 | 1 |
| 155-64 | A155 | B64 | 2 | 1 |
| 155-65 | A155 | B65 | 2 | 1 |
| 155-87 | A155 | B87 | 2 | 1 |
| 155-93 | A155 | B93 | 2 | 1 |
| 155-110 | A155 | B110 | 2 | 1 |
| 155-118 | A155 | B118 | 2 | 1 |
| 155-139 | A155 | B139 | 2 | 1 |
| 155-146 | A155 | B146 | 2 | 1 |
| 155-154 | A155 | B154 | 2 | 1 |
| 155-163 | A155 | B163 | 2 | 1 |
| 155-167 | A155 | B167 | 2 | 1 |
| 155-178 | A155 | B178 | 2 | 1 |
| 155-189 | A155 | B189 | 2 | 1 |
| 155-203 | A155 | B203 | 2 | 1 |
| 155-205 | A155 | B205 | 2 | 1 |
| 155-215 | A155 | B215 | 2 | 1 |
| 155-251 | A155 | B251 | 2 | 1 |
| 155-274 | A155 | B274 | 2 | 1 |
| 155-283 | A155 | B283 | 2 | 1 |
| 155-308 | A155 | B308 | 2 | 1 |
| 155-341 | A155 | B341 | 2 | 1 |
| 155-397 | A155 | B397 | 2 | 1 |
| 155-447 | A155 | B447 | 2 | 1 |

**Table 66**

| Compound No. | L₁ | L₂ | n1 | n2 |
|---|---|---|---|---|
| 156-7 | A156 | B7 | 2 | 1 |
| 157-9 | A157 | B9 | 2 | 1 |
| 158-10 | A158 | B10 | 2 | 1 |
| 159-13 | A159 | B13 | 2 | 1 |
| 160-22 | A160 | B22 | 2 | 1 |

**Table 67**

| Compound No. | L₁ | L₂ | n1 | n2 |
|---|---|---|---|---|
| 161-4 | A161 | B4 | 2 | 1 |
| 161-8 | A161 | B8 | 2 | 1 |
| 161-10 | A161 | B10 | 2 | 1 |
| 161-13 | A161 | B13 | 2 | 1 |
| 161-20 | A161 | B20 | 2 | 1 |
| 161-24 | A161 | B24 | 2 | 1 |
| 161-27 | A161 | B27 | 2 | 1 |
| 161-48 | A161 | B48 | 2 | 1 |
| 161-62 | A161 | B62 | 2 | 1 |
| 161-63 | A161 | B63 | 2 | 1 |
| 161-85 | A161 | B85 | 2 | 1 |
| 161-91 | A161 | B91 | 2 | 1 |
| 161-108 | A161 | B108 | 2 | 1 |
| 161-116 | A161 | B116 | 2 | 1 |
| 161-137 | A161 | B137 | 2 | 1 |
| 161-144 | A161 | B144 | 2 | 1 |
| 161-152 | A161 | B152 | 2 | 1 |
| 161-162 | A161 | B162 | 2 | 1 |
| 161-169 | A161 | B169 | 2 | 1 |
| 161-176 | A161 | B176 | 2 | 1 |
| 161-187 | A161 | B187 | 2 | 1 |
| 161-201 | A161 | B201 | 2 | 1 |
| 161-202 | A161 | B202 | 2 | 1 |
| 161-213 | A161 | B213 | 2 | 1 |
| 161-249 | A161 | B249 | 2 | 1 |
| 161-272 | A161 | B272 | 2 | 1 |
| 161-281 | A161 | B281 | 2 | 1 |
| 161-306 | A161 | B306 | 2 | 1 |
| 161-340 | A161 | B340 | 2 | 1 |
| 161-399 | A161 | B399 | 2 | 1 |
| 161-445 | A161 | B445 | 2 | 1 |

**Table 68**

| Compound No. | L₁ | L₂ | n1 | n2 |
|---|---|---|---|---|
| 162-4 | A162 | B4 | 2 | 1 |
| 163-8 | A163 | B8 | 2 | 1 |
| 164-10 | A164 | B10 | 2 | 1 |
| 165-13 | A165 | B13 | 2 | 1 |
| 166-20 | A166 | B20 | 2 | 1 |
| 167-24 | A167 | B24 | 2 | 1 |
| 168-27 | A168 | B27 | 2 | 1 |
| 169-48 | A169 | B48 | 2 | 1 |
| 170-62 | A170 | B62 | 2 | 1 |
| 171-63 | A171 | B63 | 2 | 1 |
| 171-85 | A171 | B85 | 2 | 1 |
| 171-91 | A171 | B91 | 2 | 1 |
| 171-108 | A171 | B108 | 2 | 1 |
| 171-116 | A171 | B116 | 2 | 1 |
| 171-137 | A171 | B137 | 2 | 1 |
| 171-144 | A171 | B144 | 2 | 1 |
| 171-152 | A171 | B152 | 2 | 1 |
| 171-162 | A171 | B162 | 2 | 1 |
| 171-169 | A171 | B169 | 2 | 1 |
| 171-176 | A171 | B176 | 2 | 1 |
| 171-187 | A171 | B187 | 2 | 1 |
| 171-201 | A171 | B201 | 2 | 1 |
| 171-202 | A171 | B202 | 2 | 1 |
| 171-213 | A171 | B213 | 2 | 1 |
| 171-249 | A171 | B249 | 2 | 1 |
| 171-272 | A171 | B272 | 2 | 1 |
| 171-281 | A171 | B281 | 2 | 1 |
| 171-306 | A171 | B306 | 2 | 1 |
| 171-340 | A171 | B340 | 2 | 1 |
| 171-399 | A171 | B399 | 2 | 1 |
| 171-445 | A171 | B445 | 2 | 1 |

**Table 69**

| Compound No. | L₁ | L₂ | n1 | n2 |
|---|---|---|---|---|
| 171-7 | A171 | B7 | 2 | 1 |
| 171-9 | A171 | B9 | 2 | 1 |
| 171-10 | A171 | B10 | 2 | 1 |
| 171-13 | A171 | B13 | 2 | 1 |
| 171-22 | A171 | B22 | 2 | 1 |
| 171-26 | A171 | B26 | 2 | 1 |
| 171-29 | A171 | B29 | 2 | 1 |
| 171-50 | A171 | B50 | 2 | 1 |
| 171-64 | A171 | B64 | 2 | 1 |
| 171-65 | A171 | B65 | 2 | 1 |
| 172-87 | A172 | B87 | 2 | 1 |
| 173-93 | A173 | B93 | 2 | 1 |
| 174-110 | A174 | B110 | 2 | 1 |
| 175-118 | A175 | B118 | 2 | 1 |
| 176-139 | A176 | B139 | 2 | 1 |
| 177-146 | A177 | B146 | 2 | 1 |
| 178-154 | A178 | B154 | 2 | 1 |
| 178-163 | A178 | B163 | 2 | 1 |
| 178-167 | A178 | B167 | 2 | 1 |
| 178-178 | A178 | B178 | 2 | 1 |
| 178-189 | A178 | B189 | 2 | 1 |
| 178-203 | A178 | B203 | 2 | 1 |
| 178-205 | A178 | B205 | 2 | 1 |
| 178-215 | A178 | B215 | 2 | 1 |
| 178-251 | A178 | B251 | 2 | 1 |
| 178-274 | A178 | B274 | 2 | 1 |
| 178-283 | A178 | B283 | 2 | 1 |
| 178-308 | A178 | B308 | 2 | 1 |
| 178-341 | A178 | B341 | 2 | 1 |
| 178-397 | A178 | B397 | 2 | 1 |
| 178-447 | A178 | B447 | 2 | 1 |

**Table 70**

| Compound No. | L₁ | L₂ | n1 | n2 |
|---|---|---|---|---|
| 178-4 | A178 | B4 | 2 | 1 |
| 178-8 | A178 | B8 | 2 | 1 |
| 178-10 | A178 | B10 | 2 | 1 |
| 178-13 | A178 | B13 | 2 | 1 |
| 178-20 | A178 | B20 | 2 | 1 |
| 178-24 | A178 | B24 | 2 | 1 |
| 178-27 | A178 | B27 | 2 | 1 |
| 178-48 | A178 | B48 | 2 | 1 |
| 178-62 | A178 | B62 | 2 | 1 |
| 178-63 | A178 | B63 | 2 | 1 |
| 178-85 | A178 | B85 | 2 | 1 |
| 178-91 | A178 | B91 | 2 | 1 |
| 178-108 | A178 | B108 | 2 | 1 |
| 178-116 | A178 | B116 | 2 | 1 |
| 178-137 | A178 | B137 | 2 | 1 |
| 178-144 | A178 | B144 | 2 | 1 |
| 178-152 | A178 | B152 | 2 | 1 |
| 179-162 | A179 | B162 | 2 | 1 |
| 180-169 | A180 | B169 | 2 | 1 |
| 181-176 | A181 | B176 | 2 | 1 |
| 182-187 | A182 | B187 | 2 | 1 |
| 183-201 | A183 | B201 | 2 | 1 |
| 184-202 | A184 | B202 | 2 | 1 |
| 185-213 | A185 | B213 | 2 | 1 |
| 186-249 | A186 | B249 | 2 | 1 |
| 187-272 | A187 | B272 | 2 | 1 |
| 188-281 | A188 | B281 | 2 | 1 |
| 189-306 | A189 | B306 | 2 | 1 |
| 190-340 | A190 | B340 | 2 | 1 |
| 191-399 | A191 | B399 | 2 | 1 |
| 192-445 | A192 | B445 | 2 | 1 |

**Table 71**

| Compound No. | L₁ | L₂ | n1 | n2 |
|---|---|---|---|---|
| 193-4 | A193 | B4 | 2 | 1 |
| 194-8 | A194 | B8 | 2 | 1 |
| 195-10 | A195 | B10 | 2 | 1 |
| 196-13 | A196 | B13 | 2 | 1 |
| 197-20 | A197 | B20 | 2 | 1 |
| 198-24 | A198 | B24 | 2 | 1 |
| 199-27 | A199 | B27 | 2 | 1 |
| 200-48 | A200 | B48 | 2 | 1 |
| 201-62 | A201 | B62 | 2 | 1 |
| 202-63 | A202 | B63 | 2 | 1 |
| 203-85 | A203 | B85 | 2 | 1 |
| 204-91 | A204 | B91 | 2 | 1 |
| 205-108 | A205 | B108 | 2 | 1 |
| 206-116 | A206 | B116 | 2 | 1 |
| 207-137 | A207 | B137 | 2 | 1 |
| 208-144 | A208 | B144 | 2 | 1 |
| 209-152 | A209 | B152 | 2 | 1 |
| 210-162 | A210 | B162 | 2 | 1 |
| 211-169 | A211 | B169 | 2 | 1 |
| 212-176 | A212 | B176 | 2 | 1 |
| 213-187 | A213 | B187 | 2 | 1 |
| 214-201 | A214 | B201 | 2 | 1 |
| 215-202 | A215 | B202 | 2 | 1 |
| 216-213 | A216 | B213 | 2 | 1 |
| 217-249 | A217 | B249 | 2 | 1 |
| 218-272 | A218 | B272 | 2 | 1 |
| 219-281 | A219 | B281 | 2 | 1 |
| 220-306 | A220 | B306 | 2 | 1 |
| 221-340 | A221 | B340 | 2 | 1 |
| 222-399 | A222 | B399 | 2 | 1 |

**Table 72**

| Compound No. | L₁ | L₂ | n1 | n2 |
|---|---|---|---|---|
| 223-4 | A223 | B4 | 2 | 1 |
| 224-8 | A224 | B8 | 2 | 1 |
| 225-10 | A225 | B10 | 2 | 1 |
| 226-13 | A226 | B13 | 2 | 1 |
| 227-20 | A227 | B20 | 2 | 1 |
| 228-24 | A228 | B24 | 2 | 1 |
| 229-27 | A229 | B27 | 2 | 1 |
| 230-48 | A230 | B48 | 2 | 1 |
| 231-62 | A231 | B62 | 2 | 1 |
| 232-63 | A232 | B63 | 2 | 1 |
| 233-85 | A233 | B85 | 2 | 1 |
| 234-91 | A234 | B91 | 2 | 1 |
| 235-108 | A235 | B108 | 2 | 1 |
| 236-116 | A236 | B116 | 2 | 1 |
| 237-137 | A237 | B137 | 2 | 1 |
| 238-144 | A238 | B144 | 2 | 1 |
| 239-152 | A239 | B152 | 2 | 1 |
| 240-162 | A240 | B162 | 2 | 1 |
| 241-169 | A241 | B169 | 2 | 1 |
| 242-176 | A242 | B176 | 2 | 1 |
| 243-187 | A243 | B187 | 2 | 1 |
| 244-201 | A244 | B201 | 2 | 1 |
| 245-202 | A245 | B202 | 2 | 1 |
| 246-213 | A246 | B213 | 2 | 1 |
| 247-249 | A247 | B249 | 2 | 1 |
| 248-272 | A248 | B272 | 2 | 1 |
| 249-281 | A249 | B281 | 2 | 1 |
| 250-306 | A250 | B306 | 2 | 1 |
| 251-340 | A251 | B340 | 2 | 1 |
| 252-399 | A252 | B399 | 2 | 1 |

**Table 73**

| Compound No. | L₁ | L₂ | n1 | n2 |
|---|---|---|---|---|
| 253-1 | A253 | B1 | 2 | 1 |
| 253-2 | A253 | B2 | 2 | 1 |
| 253-3 | A253 | B3 | 2 | 1 |
| 253-4 | A253 | B4 | 2 | 1 |
| 253-5 | A253 | B5 | 2 | 1 |
| 253-6 | A253 | B6 | 2 | 1 |
| 253-7 | A253 | B7 | 2 | 1 |
| 253-8 | A253 | B8 | 2 | 1 |
| 253-9 | A253 | B9 | 2 | 1 |
| 253-10 | A253 | B10 | 2 | 1 |
| 253-11 | A253 | B11 | 2 | 1 |
| 253-12 | A253 | B12 | 2 | 1 |
| 253-13 | A253 | B13 | 2 | 1 |
| 253-14 | A253 | B14 | 2 | 1 |
| 253-15 | A253 | B15 | 2 | 1 |
| 253-16 | A253 | B16 | 2 | 1 |
| 253-17 | A253 | B17 | 2 | 1 |
| 253-18 | A253 | B18 | 2 | 1 |
| 253-19 | A253 | B19 | 2 | 1 |
| 253-20 | A253 | B20 | 2 | 1 |
| 253-21 | A253 | B21 | 2 | 1 |
| 253-22 | A253 | B22 | 2 | 1 |
| 253-23 | A253 | B23 | 2 | 1 |
| 253-24 | A253 | B24 | 2 | 1 |
| 253-25 | A253 | B25 | 2 | 1 |
| 253-26 | A253 | B26 | 2 | 1 |
| 253-27 | A253 | B27 | 2 | 1 |
| 253-28 | A253 | B28 | 2 | 1 |
| 253-29 | A253 | B29 | 2 | 1 |
| 253-30 | A253 | B30 | 2 | 1 |

**Table 74**

| Compound No. | L₁ | L₂ | n1 | n2 |
|---|---|---|---|---|
| 253-31 | A253 | B31 | 2 | 1 |
| 253-32 | A253 | B32 | 2 | 1 |
| 253-33 | A253 | B33 | 2 | 1 |
| 253-34 | A253 | B34 | 2 | 1 |
| 253-35 | A253 | B35 | 2 | 1 |
| 253-36 | A253 | B36 | 2 | 1 |
| 253-37 | A253 | B37 | 2 | 1 |
| 253-38 | A253 | B38 | 2 | 1 |
| 253-39 | A253 | B39 | 2 | 1 |
| 253-40 | A253 | B40 | 2 | 1 |
| 253-41 | A253 | B41 | 2 | 1 |
| 253-42 | A253 | B42 | 2 | 1 |
| 253-43 | A253 | B43 | 2 | 1 |
| 253-44 | A253 | B44 | 2 | 1 |
| 253-45 | A253 | B45 | 2 | 1 |
| 253-46 | A253 | B46 | 2 | 1 |
| 253-47 | A253 | B47 | 2 | 1 |
| 253-48 | A253 | B48 | 2 | 1 |
| 253-49 | A253 | B49 | 2 | 1 |
| 253-50 | A253 | B50 | 2 | 1 |
| 253-51 | A253 | B51 | 2 | 1 |
| 253-52 | A253 | B52 | 2 | 1 |
| 253-53 | A253 | B53 | 2 | 1 |
| 253-74 | A253 | B74 | 2 | 1 |
| 253-136 | A253 | B136 | 2 | 1 |
| 253-137 | A253 | B137 | 2 | 1 |
| 253-138 | A253 | B138 | 2 | 1 |
| 253-139 | A253 | B139 | 2 | 1 |
| 253-140 | A253 | B140 | 2 | 1 |
| 253-141 | A253 | B141 | 2 | 1 |

**Table 75**

| Compound No. | L₁ | L₂ | n1 | n2 |
|---|---|---|---|---|
| 253-156 | A253 | B156 | 2 | 1 |
| 253-157 | A253 | B157 | 2 | 1 |
| 253-158 | A253 | B158 | 2 | 1 |
| 253-159 | A253 | B159 | 2 | 1 |
| 253-160 | A253 | B160 | 2 | 1 |
| 253-161 | A253 | B161 | 2 | 1 |
| 253-162 | A253 | B162 | 2 | 1 |
| 253-163 | A253 | B163 | 2 | 1 |
| 253-164 | A253 | B164 | 2 | 1 |
| 253-165 | A253 | B165 | 2 | 1 |
| 253-166 | A253 | B166 | 2 | 1 |
| 253-167 | A253 | B167 | 2 | 1 |
| 253-168 | A253 | B168 | 2 | 1 |
| 253-169 | A253 | B169 | 2 | 1 |
| 253-170 | A253 | B170 | 2 | 1 |
| 253-171 | A253 | B171 | 2 | 1 |
| 253-172 | A253 | B172 | 2 | 1 |
| 253-173 | A253 | B173 | 2 | 1 |
| 253-174 | A253 | B174 | 2 | 1 |
| 253-175 | A253 | B175 | 2 | 1 |
| 253-176 | A253 | B176 | 2 | 1 |
| 253-177 | A253 | B177 | 2 | 1 |
| 257-178 | A257 | B178 | 2 | 1 |
| 258-179 | A258 | B179 | 2 | 1 |
| 259-180 | A259 | B180 | 2 | 1 |
| 260-181 | A260 | B181 | 2 | 1 |
| 261-182 | A261 | B182 | 2 | 1 |
| 262-183 | A262 | B183 | 2 | 1 |
| 263-184 | A263 | B184 | 2 | 1 |
| 264-185 | A264 | B185 | 2 | 1 |

**Table 76**

| Compound No. | L₁ | L₂ | n1 | n2 |
|---|---|---|---|---|
| 265-186 | A265 | B186 | 2 | 1 |
| 266-187 | A266 | B187 | 2 | 1 |
| 266-188 | A266 | B188 | 2 | 1 |
| 267-189 | A267 | B189 | 2 | 1 |
| 267-190 | A267 | B190 | 2 | 1 |
| 268-191 | A268 | B191 | 2 | 1 |
| 269-192 | A269 | B192 | 2 | 1 |
| 270-193 | A270 | B193 | 2 | 1 |
| 271-194 | A271 | B194 | 2 | 1 |
| 272-195 | A272 | B195 | 2 | 1 |
| 274-196 | A274 | B196 | 2 | 1 |
| 275-197 | A275 | B197 | 2 | 1 |
| 276-198 | A276 | B198 | 2 | 1 |
| 277-199 | A277 | B199 | 2 | 1 |
| 278-200 | A278 | B200 | 2 | 1 |
| 279-201 | A279 | B201 | 2 | 1 |
| 280-202 | A280 | B202 | 2 | 1 |
| 281-203 | A281 | B203 | 2 | 1 |
| 282-204 | A282 | B204 | 2 | 1 |
| 283-205 | A283 | B205 | 2 | 1 |
| 284-209 | A284 | B209 | 2 | 1 |
| 285-231 | A285 | B231 | 2 | 1 |
| 286-340 | A286 | B340 | 2 | 1 |
| 287-399 | A287 | B399 | 2 | 1 |
| 288-445 | A288 | B445 | 2 | 1 |

**Table 77**

| Compound No. | L₁ | L₂ | n1 | n2 |
|---|---|---|---|---|
| 273-1 | A273 | B1 | 2 | 1 |
| 273-2 | A273 | B2 | 2 | 1 |
| 273-3 | A273 | B3 | 2 | 1 |
| 273-4 | A273 | B4 | 2 | 1 |
| 273-5 | A273 | B5 | 2 | 1 |
| 273-6 | A273 | B6 | 2 | 1 |
| 273-7 | A273 | B7 | 2 | 1 |
| 273-8 | A273 | B8 | 2 | 1 |
| 273-9 | A273 | B9 | 2 | 1 |
| 273-10 | A273 | B10 | 2 | 1 |
| 273-11 | A273 | B11 | 2 | 1 |
| 273-12 | A273 | B12 | 2 | 1 |
| 273-13 | A273 | B13 | 2 | 1 |
| 273-14 | A273 | B14 | 2 | 1 |
| 273-15 | A273 | B15 | 2 | 1 |
| 273-16 | A273 | B16 | 2 | 1 |
| 273-17 | A273 | B17 | 2 | 1 |
| 273-18 | A273 | B18 | 2 | 1 |
| 273-19 | A273 | B19 | 2 | 1 |
| 273-20 | A273 | B20 | 2 | 1 |
| 273-21 | A273 | B21 | 2 | 1 |
| 273-22 | A273 | B22 | 2 | 1 |
| 273-23 | A273 | B23 | 2 | 1 |
| 273-24 | A273 | B24 | 2 | 1 |
| 273-25 | A273 | B25 | 2 | 1 |
| 273-26 | A273 | B26 | 2 | 1 |
| 273-27 | A273 | B27 | 2 | 1 |
| 273-28 | A273 | B28 | 2 | 1 |
| 273-29 | A273 | B29 | 2 | 1 |
| 273-30 | A273 | B30 | 2 | 1 |

**Table 78**

| Compound No. | L₁ | L₂ | n1 | n2 |
|---|---|---|---|---|
| 273-31 | A273 | B31 | 2 | 1 |
| 273-32 | A273 | B32 | 2 | 1 |
| 273-33 | A273 | B33 | 2 | 1 |
| 273-34 | A273 | B34 | 2 | 1 |
| 273-35 | A273 | B35 | 2 | 1 |
| 273-36 | A273 | B36 | 2 | 1 |
| 273-37 | A273 | B37 | 2 | 1 |
| 273-38 | A273 | B38 | 2 | 1 |
| 273-39 | A273 | B39 | 2 | 1 |
| 273-40 | A273 | B40 | 2 | 1 |
| 273-41 | A273 | B41 | 2 | 1 |
| 273-42 | A273 | B42 | 2 | 1 |
| 273-43 | A273 | B43 | 2 | 1 |
| 273-44 | A273 | B44 | 2 | 1 |
| 273-45 | A273 | B45 | 2 | 1 |
| 273-46 | A273 | B46 | 2 | 1 |
| 273-47 | A273 | B47 | 2 | 1 |
| 273-48 | A273 | B48 | 2 | 1 |
| 273-49 | A273 | B49 | 2 | 1 |
| 273-50 | A273 | B50 | 2 | 1 |
| 273-51 | A273 | B51 | 2 | 1 |
| 273-52 | A273 | B52 | 2 | 1 |
| 273-53 | A273 | B53 | 2 | 1 |
| 273-74 | A273 | B74 | 2 | 1 |
| 257-136 | A273 | B136 | 2 | 1 |
| 257-137 | A273 | B137 | 2 | 1 |
| 257-138 | A273 | B138 | 2 | 1 |
| 257-139 | A273 | B139 | 2 | 1 |
| 257-140 | A273 | B140 | 2 | 1 |
| 257-141 | A273 | B141 | 2 | 1 |

**Table 79**

| Compound No. | L₁ | L₂ | n1 | n2 |
|---|---|---|---|---|
| 273-156 | A273 | B156 | 2 | 1 |
| 273-157 | A273 | B157 | 2 | 1 |
| 273-158 | A273 | B158 | 2 | 1 |
| 273-159 | A273 | B159 | 2 | 1 |
| 273-160 | A273 | B160 | 2 | 1 |
| 273-161 | A273 | B161 | 2 | 1 |
| 273-162 or 2206 | A273 | B162 | 2 | 1 |
| 273-163 | A273 | B163 | 2 | 1 |
| 273-164 | A273 | B164 | 2 | 1 |
| 273-165 | A273 | B165 | 2 | 1 |
| 273-166 | A273 | B166 | 2 | 1 |
| 273-167 | A273 | B167 | 2 | 1 |
| 273-168 | A273 | B168 | 2 | 1 |
| 273-169 | A273 | B169 | 2 | 1 |
| 273-170 | A273 | B170 | 2 | 1 |
| 273-171 | A273 | B171 | 2 | 1 |
| 273-172 | A273 | B172 | 2 | 1 |
| 273-173 | A273 | B173 | 2 | 1 |
| 273-174 | A273 | B174 | 2 | 1 |
| 273-175 | A273 | B175 | 2 | 1 |
| 273-176 | A273 | B176 | 2 | 1 |
| 273-177 | A273 | B177 | 2 | 1 |
| 273-178 | A273 | B178 | 2 | 1 |
| 273-179 | A273 | B179 | 2 | 1 |
| 273-180 | A273 | B180 | 2 | 1 |
| 273-181 | A273 | B181 | 2 | 1 |
| 273-182 | A273 | B182 | 2 | 1 |
| 273-183 | A273 | B183 | 2 | 1 |
| 273-184 | A273 | B184 | 2 | 1 |
| 273-185 | A273 | B185 | 2 | 1 |

**Table 80**

| Compound No. | L₁ | L₂ | n1 | n2 |
|---|---|---|---|---|
| 273-186 | A273 | B186 | 2 | 1 |
| 273-187 | A273 | B187 | 2 | 1 |
| 273-188 | A273 | B188 | 2 | 1 |
| 273-189 | A273 | B189 | 2 | 1 |
| 273-190 | A273 | B190 | 2 | 1 |
| 273-191 | A273 | B191 | 2 | 1 |
| 273-192 | A273 | B192 | 2 | 1 |
| 273-193 | A273 | B193 | 2 | 1 |
| 273-194 | A273 | B194 | 2 | 1 |
| 273-195 | A273 | B195 | 2 | 1 |
| 273-196 | A273 | B196 | 2 | 1 |
| 273-197 | A273 | B197 | 2 | 1 |
| 273-198 | A273 | B198 | 2 | 1 |
| 273-199 | A273 | B199 | 2 | 1 |
| 273-200 | A273 | B200 | 2 | 1 |
| 273-201 | A273 | B201 | 2 | 1 |
| 273-202 | A273 | B202 | 2 | 1 |
| 273-203 | A273 | B203 | 2 | 1 |
| 273-204 | A273 | B204 | 2 | 1 |
| 273-205 | A273 | B205 | 2 | 1 |
| 273-209 | A273 | B209 | 2 | 1 |
| 273-231 | A273 | B231 | 2 | 1 |
| 273-340 | A273 | B340 | 2 | 1 |

**Table 81**

| Compound No. | L₁ | L₂ | n1 | n2 |
|---|---|---|---|---|
| 277-1 | A277 | B1 | 2 | 1 |
| 278-4 | A278 | B4 | 2 | 1 |
| 279-8 | A279 | B8 | 2 | 1 |
| 280-10 | A280 | B10 | 2 | 1 |
| 281-13 | A281 | B13 | 2 | 1 |
| 282-20 | A282 | B20 | 2 | 1 |
| 283-24 | A283 | B24 | 2 | 1 |
| 284-27 | A284 | B27 | 2 | 1 |
| 285-48 | A285 | B48 | 2 | 1 |
| 286-62 | A286 | B62 | 2 | 1 |
| 287-63 | A287 | B63 | 2 | 1 |
| 288-85 | A288 | B85 | 2 | 1 |
| 289-1 | A289 | B1 | 2 | 1 |
| 290-4 | A290 | B4 | 2 | 1 |
| 291-8 | A291 | B8 | 2 | 1 |
| 292-10 | A292 | B10 | 2 | 1 |
| 293-13 | A293 | B13 | 2 | 1 |
| 294-20 | A294 | B20 | 2 | 1 |
| 295-24 | A295 | B24 | 2 | 1 |
| 296-27 | A296 | B27 | 2 | 1 |
| 297-48 | A297 | B48 | 2 | 1 |
| 298-62 | A298 | B62 | 2 | 1 |
| 299-63 | A299 | B63 | 2 | 1 |
| 300-85 | A300 | B85 | 2 | 1 |

**Table 82**

| Compound No. | L₁ | L₂ | n1 | n2 |
|---|---|---|---|---|
| 2-156 | A2 | B156 | 2 | 1 |
| 69-156 | A69 | B156 | 2 | 1 |
| 109-156 | A109 | B156 | 2 | 1 |
| 114-156 | A114 | B156 | 2 | 1 |
| 118-156 | A118 | B156 | 2 | 1 |
| 123-156 | A123 | B156 | 2 | 1 |
| 152-156 | A152 | B156 | 2 | 1 |
| 219-156 | A219 | B156 | 2 | 1 |
| 259-156 | A259 | B156 | 2 | 1 |
| 264-156 | A264 | B156 | 2 | 1 |
| 268-156 | A268 | B156 | 2 | 1 |
| 2-157 | A2 | B157 | 2 | 1 |
| 69-157 | A69 | B157 | 2 | 1 |
| 109-157 | A109 | B157 | 2 | 1 |
| 114-157 | A114 | B157 | 2 | 1 |
| 118-157 | A118 | B157 | 2 | 1 |
| 123-157 | A123 | B157 | 2 | 1 |
| 152-157 | A152 | B157 | 2 | 1 |
| 219-157 | A219 | B157 | 2 | 1 |
| 259-157 | A259 | B157 | 2 | 1 |
| 264-157 | A264 | B157 | 2 | 1 |
| 268-157 | A268 | B157 | 2 | 1 |
| 2-158 | A2 | B158 | 2 | 1 |
| 69-158 | A69 | B158 | 2 | 1 |
| 109-158 | A109 | B158 | 2 | 1 |
| 114-158 | A114 | B158 | 2 | 1 |
| 118-158 | A118 | B158 | 2 | 1 |
| 123-158 | A123 | B158 | 2 | 1 |
| 152-158 | A152 | B158 | 2 | 1 |
| 219-158 | A219 | B158 | 2 | 1 |
| 259-158 | A259 | B158 | 2 | 1 |

**Table 83**

| Compound No. | L₁ | L₂ | n1 | n2 |
|---|---|---|---|---|
| 264-158 | A264 | B158 | 2 | 1 |
| 268-158 | A268 | B158 | 2 | 1 |
| 2-159 | A2 | B159 | 2 | 1 |
| 69-159 | A69 | B159 | 2 | 1 |
| 109-159 | A109 | B159 | 2 | 1 |
| 114-159 | A114 | B159 | 2 | 1 |
| 118-159 | A118 | B159 | 2 | 1 |
| 123-159 | A123 | B159 | 2 | 1 |
| 152-159 | A152 | B159 | 2 | 1 |
| 219-159 | A219 | B159 | 2 | 1 |
| 259-159 | A259 | B159 | 2 | 1 |
| 264-159 | A264 | B159 | 2 | 1 |
| 268-159 | A268 | B159 | 2 | 1 |
| 2-160 | A2 | B160 | 2 | 1 |
| 69-160 | A69 | B160 | 2 | 1 |
| 109-160 | A109 | B160 | 2 | 1 |
| 114-160 | A114 | B160 | 2 | 1 |
| 118-160 | A118 | B160 | 2 | 1 |
| 123-160 | A123 | B160 | 2 | 1 |
| 152-160 | A152 | B160 | 2 | 1 |
| 219-160 | A219 | B160 | 2 | 1 |
| 259-160 | A259 | B160 | 2 | 1 |
| 264-160 | A264 | B160 | 2 | 1 |
| 268-160 | A268 | B160 | 2 | 1 |
| 2-161 | A2 | B161 | 2 | 1 |
| 69-161 | A69 | B161 | 2 | 1 |
| 109-161 | A109 | B161 | 2 | 1 |
| 114-161 | A114 | B161 | 2 | 1 |
| 118-161 | A118 | B161 | 2 | 1 |
| 123-161 | A123 | B161 | 2 | 1 |
| 152-161 | A152 | B161 | 2 | 1 |

**Table 84**

| Compound No. | L₁ | L₂ | n1 | n2 |
|---|---|---|---|---|
| 219-161 | A219 | B161 | 2 | 1 |
| 259-161 | A259 | B161 | 2 | 1 |
| 264-161 | A264 | B161 | 2 | 1 |
| 268-161 | A268 | B161 | 2 | 1 |
| 69-162 | A69 | B162 | 2 | 1 |
| 109-162 | A109 | B162 | 2 | 1 |
| 114-162 | A114 | B162 | 2 | 1 |
| 118-162 | A118 | B162 | 2 | 1 |
| 123-162 | A123 | B162 | 2 | 1 |
| 219-162 | A219 | B162 | 2 | 1 |
| 259-162 | A259 | B162 | 2 | 1 |
| 264-162 | A264 | B162 | 2 | 1 |
| 268-162 | A268 | B162 | 2 | 1 |
| 2-163 | A2 | B163 | 2 | 1 |
| 69-163 | A69 | B163 | 2 | 1 |
| 109-163 | A109 | B163 | 2 | 1 |
| 114-163 | A114 | B163 | 2 | 1 |
| 118-160 | A118 | B163 | 2 | 1 |
| 123-160 | A123 | B163 | 2 | 1 |
| 152-160 | A152 | B163 | 2 | 1 |
| 219-160 | A219 | B163 | 2 | 1 |
| 259-160 | A259 | B163 | 2 | 1 |
| 264-160 | A264 | B163 | 2 | 1 |
| 268-160 | A268 | B163 | 2 | 1 |
| 2-164 | A2 | B164 | 2 | 1 |
| 69-164 | A69 | B164 | 2 | 1 |
| 109-164 | A109 | B164 | 2 | 1 |
| 114-164 | A114 | B164 | 2 | 1 |
| 118-164 | A118 | B164 | 2 | 1 |
| 123-164 | A123 | B164 | 2 | 1 |
| 152-164 | A152 | B164 | 2 | 1 |

**Table 85**

| Compound No. | L₁ | L₂ | n1 | n2 |
|---|---|---|---|---|
| 219-164 | A219 | B164 | 2 | 1 |
| 259-164 | A259 | B164 | 2 | 1 |
| 264-164 | A264 | B164 | 2 | 1 |
| 268-164 | A268 | B164 | 2 | 1 |
| 2-165 | A2 | B165 | 2 | 1 |
| 69-165 | A69 | B165 | 2 | 1 |
| 109-165 | A109 | B165 | 2 | 1 |
| 114-165 | A114 | B165 | 2 | 1 |
| 118-165 | A118 | B165 | 2 | 1 |
| 123-165 | A123 | B165 | 2 | 1 |
| 152-165 | A152 | B165 | 2 | 1 |
| 219-165 | A219 | B165 | 2 | 1 |
| 259-165 | A259 | B165 | 2 | 1 |
| 264-165 | A264 | B165 | 2 | 1 |
| 268-165 | A268 | B165 | 2 | 1 |
| 2-166 | A2 | B165 | 2 | 1 |
| 69-166 | A69 | B165 | 2 | 1 |
| 109-166 | A109 | B165 | 2 | 1 |
| 114-166 | A114 | B165 | 2 | 1 |
| 118-166 | A118 | B165 | 2 | 1 |
| 123-166 | A123 | B165 | 2 | 1 |
| 152-166 | A152 | B165 | 2 | 1 |
| 219-166 | A219 | B165 | 2 | 1 |
| 259-166 | A259 | B165 | 2 | 1 |
| 264-166 | A264 | B165 | 2 | 1 |
| 268-166 | A268 | B165 | 2 | 1 |
| 2-173 | A2 | B173 | 2 | 1 |
| 69-173 | A69 | B173 | 2 | 1 |
| 109-173 | A109 | B173 | 2 | 1 |
| 114-173 | A114 | B173 | 2 | 1 |
| 118-173 | A118 | B173 | 2 | 1 |

**Table 86**

| Compound No. | L₁ | L₂ | n1 | n2 |
|---|---|---|---|---|
| 123-173 | A123 | B173 | 2 | 1 |
| 152-173 | A152 | B173 | 2 | 1 |
| 219-173 | A219 | B173 | 2 | 1 |
| 259-173 | A259 | B173 | 2 | 1 |
| 264-173 | A264 | B173 | 2 | 1 |
| 268-173 | A268 | B173 | 2 | 1 |
| 69-176 | A69 | B176 | 2 | 1 |
| 109-176 | A109 | B176 | 2 | 1 |
| 114-176 | A114 | B176 | 2 | 1 |
| 118-176 | A118 | B176 | 2 | 1 |
| 123-176 | A123 | B176 | 2 | 1 |
| 219-176 | A219 | B176 | 2 | 1 |
| 259-176 | A259 | B176 | 2 | 1 |
| 264-176 | A264 | B176 | 2 | 1 |
| 268-176 | A268 | B176 | 2 | 1 |
| 2-177 | A2 | B177 | 2 | 1 |
| 69-177 | A69 | B177 | 2 | 1 |
| 109-177 | A109 | B177 | 2 | 1 |
| 114-177 | A114 | B177 | 2 | 1 |
| 118-177 | A118 | B177 | 2 | 1 |
| 123-177 | A123 | B177 | 2 | 1 |
| 152-177 | A152 | B177 | 2 | 1 |
| 219-177 | A219 | B177 | 2 | 1 |
| 259-177 | A259 | B177 | 2 | 1 |
| 264-177 | A264 | B177 | 2 | 1 |
| 268-177 | A268 | B177 | 2 | 1 |
| 2-180 | A2 | B180 | 2 | 1 |
| 152-180 | A69 | B180 | 2 | 1 |
| 219-180 | A109 | B180 | 2 | 1 |
| 259-180 | A114 | B180 | 2 | 1 |
| 264-180 | A118 | B180 | 2 | 1 |

**Table 87**

| Compound No. | L₁ | L₂ | n1 | n2 |
|---|---|---|---|---|
| 2-181 | A2 | B181 | 2 | 1 |
| 69-181 | A69 | B181 | 2 | 1 |
| 109-181 | A109 | B181 | 2 | 1 |
| 114-181 | A114 | B181 | 2 | 1 |
| 118-181 | A118 | B181 | 2 | 1 |
| 123-181 | A123 | B181 | 2 | 1 |
| 152-181 | A152 | B181 | 2 | 1 |
| 219-181 | A219 | B181 | 2 | 1 |
| 259-181 | A259 | B181 | 2 | 1 |
| 264-181 | A264 | B181 | 2 | 1 |
| 268-181 | A268 | B181 | 2 | 1 |
| 2-182 | A2 | B182 | 2 | 1 |
| 69-182 | A69 | B182 | 2 | 1 |
| 109-182 | A109 | B182 | 2 | 1 |
| 114-182 | A114 | B182 | 2 | 1 |
| 118-182 | A118 | B182 | 2 | 1 |
| 123-182 | A123 | B182 | 2 | 1 |
| 152-182 | A152 | B182 | 2 | 1 |
| 219-182 | A219 | B182 | 2 | 1 |
| 259-182 | A259 | B182 | 2 | 1 |
| 264-182 | A264 | B182 | 2 | 1 |
| 268-182 | A268 | B182 | 2 | 1 |
| 2-183 | A2 | B183 | 2 | 1 |
| 69-183 | A69 | B183 | 2 | 1 |
| 109-183 | A109 | B183 | 2 | 1 |
| 114-183 | A114 | B183 | 2 | 1 |
| 118-183 | A118 | B183 | 2 | 1 |
| 123-183 | A123 | B183 | 2 | 1 |
| 152-183 | A152 | B183 | 2 | 1 |
| 219-183 | A219 | B183 | 2 | 1 |
| 259-183 | A259 | B183 | 2 | 1 |

**Table 88**

| Compound No. | L₁ | L₂ | n1 | n2 |
|---|---|---|---|---|
| 264-183 | A264 | B183 | 2 | 1 |
| 268-183 | A268 | B183 | 2 | 1 |
| 2-184 | A2 | B184 | 2 | 1 |
| 69-184 | A69 | B184 | 2 | 1 |
| 109-184 | A109 | B184 | 2 | 1 |
| 114-184 | A114 | B184 | 2 | 1 |
| 118-184 | A118 | B184 | 2 | 1 |
| 123-184 | A123 | B184 | 2 | 1 |
| 152-184 | A152 | B184 | 2 | 1 |
| 219-184 | A219 | B184 | 2 | 1 |
| 259-184 | A259 | B184 | 2 | 1 |
| 264-184 | A264 | B184 | 2 | 1 |
| 268-184 | A268 | B184 | 2 | 1 |
| 2-185 | A2 | B185 | 2 | 1 |
| 69-185 | A69 | B185 | 2 | 1 |
| 109-185 | A109 | B185 | 2 | 1 |
| 114-185 | A114 | B185 | 2 | 1 |
| 118-185 | A118 | B185 | 2 | 1 |
| 123-185 | A123 | B185 | 2 | 1 |
| 152-185 | A152 | B185 | 2 | 1 |
| 219-185 | A219 | B185 | 2 | 1 |
| 259-185 | A259 | B185 | 2 | 1 |
| 268-185 | A268 | B185 | 2 | 1 |
| 2-186 | A2 | B186 | 2 | 1 |
| 69-186 | A69 | B186 | 2 | 1 |
| 109-186 | A109 | B186 | 2 | 1 |
| 114-186 | A114 | B186 | 2 | 1 |
| 118-186 | A118 | B186 | 2 | 1 |
| 123-186 | A123 | B186 | 2 | 1 |
| 152-186 | A152 | B186 | 2 | 1 |

**Table 89**

| Compound No. | L₁ | L₂ | n1 | n2 |
|---|---|---|---|---|
| 219-186 | A219 | B186 | 2 | 1 |
| 259-186 | A259 | B186 | 2 | 1 |
| 264-186 | A264 | B186 | 2 | 1 |
| 268-186 | A268 | B186 | 2 | 1 |
| 69-187 | A69 | B187 | 2 | 1 |
| 109-187 | A109 | B187 | 2 | 1 |
| 114-187 | A114 | B187 | 2 | 1 |
| 118-187 | A118 | B187 | 2 | 1 |
| 123-187 | A123 | B187 | 2 | 1 |
| 219-187 | A219 | B187 | 2 | 1 |
| 259-187 | A259 | B187 | 2 | 1 |
| 264-187 | A264 | B187 | 2 | 1 |
| 268-187 | A268 | B187 | 2 | 1 |
| 2-188 | A2 | B188 | 2 | 1 |
| 69-188 | A69 | B188 | 2 | 1 |
| 109-188 | A109 | B188 | 2 | 1 |
| 114-188 | A114 | B188 | 2 | 1 |
| 118-188 | A118 | B188 | 2 | 1 |
| 123-188 | A123 | B188 | 2 | 1 |
| 152-188 | A152 | B188 | 2 | 1 |
| 219-188 | A219 | B188 | 2 | 1 |
| 259-188 | A259 | B188 | 2 | 1 |
| 264-188 | A264 | B188 | 2 | 1 |
| 268-188 | A268 | B188 | 2 | 1 |
| 2-189 | A2 | B189 | 2 | 1 |
| 69-189 | A69 | B189 | 2 | 1 |
| 109-189 | A109 | B189 | 2 | 1 |
| 114-189 | A114 | B189 | 2 | 1 |
| 118-189 | A118 | B189 | 2 | 1 |
| 123-189 | A123 | B189 | 2 | 1 |
| 152-189 | A152 | B189 | 2 | 1 |

**Table 90**

| Compound No. | L₁ | L₂ | n1 | n2 |
|---|---|---|---|---|
| 219-189 | A219 | B189 | 2 | 1 |
| 259-189 | A259 | B189 | 2 | 1 |
| 264-189 | A264 | B189 | 2 | 1 |
| 268-189 | A268 | B189 | 2 | 1 |
| 2-190 | A2 | B190 | 2 | 1 |
| 69-190 | A69 | B190 | 2 | 1 |
| 109-190 | A109 | B190 | 2 | 1 |
| 114-190 | A114 | B190 | 2 | 1 |
| 118-190 | A118 | B190 | 2 | 1 |
| 123-190 | A123 | B190 | 2 | 1 |
| 152-190 | A152 | B190 | 2 | 1 |
| 219-190 | A219 | B190 | 2 | 1 |
| 259-190 | A259 | B190 | 2 | 1 |
| 264-190 | A264 | B190 | 2 | 1 |
| 268-190 | A268 | B190 | 2 | 1 |
| 2-191 | A2 | B191 | 2 | 1 |
| 69-191 | A69 | B191 | 2 | 1 |
| 109-191 | A109 | B191 | 2 | 1 |
| 114-191 | A114 | B191 | 2 | 1 |
| 118-191 | A118 | B191 | 2 | 1 |
| 123-191 | A123 | B191 | 2 | 1 |
| 152-191 | A152 | B191 | 2 | 1 |
| 219-191 | A219 | B191 | 2 | 1 |
| 259-191 | A259 | B191 | 2 | 1 |
| 264-191 | A264 | B191 | 2 | 1 |
| 2-198 | A2 | B198 | 2 | 1 |
| 69-198 | A69 | B198 | 2 | 1 |
| 109-198 | A109 | B198 | 2 | 1 |
| 114-198 | A114 | B198 | 2 | 1 |
| 118-198 | A118 | B198 | 2 | 1 |

**Table 91**

| Compound No. | L₁ | L₂ | n1 | n2 |
|---|---|---|---|---|
| 123-198 | A123 | B173 | 2 | 1 |
| 152-198 | A152 | B173 | 2 | 1 |
| 219-198 | A219 | B173 | 2 | 1 |
| 259-198 | A259 | B173 | 2 | 1 |
| 264-198 | A264 | B173 | 2 | 1 |
| 268-198 | A268 | B173 | 2 | 1 |
| 69-201 | A69 | B201 | 2 | 1 |
| 109-201 | A109 | B201 | 2 | 1 |
| 114-201 | A114 | B201 | 2 | 1 |
| 118-201 | A118 | B201 | 2 | 1 |
| 123-201 | A123 | B201 | 2 | 1 |
| 219-201 | A219 | B201 | 2 | 1 |
| 259-201 | A259 | B201 | 2 | 1 |
| 264-201 | A264 | B201 | 12 | 1 |
| 268-201 | A268 | B201 | 2 | 1 |
| 2-202 | A2 | B202 | 2 | 1 |
| 69-202 | A69 | B202 | 2 | 1 |
| 109-202 | A109 | B202 | 2 | 1 |
| 114-202 | A114 | B202 | 2 | 1 |
| 118-202 | A118 | B202 | 2 | 1 |
| 123-202 | A123 | B202 | 2 | 1 |
| 219-202 | A219 | B202 | 2 | 1 |
| 259-202 | A259 | B202 | 2 | 1 |
| 264-202 | A264 | B202 | 2 | 1 |
| 268-202 | A268 | B202 | 2 | 1 |
| 2-205 | A2 | B205 | 2 | 1 |
| 152-205 | A69 | B205 | 2 | 1 |
| 219-205 | A109 | B205 | 2 | 1 |
| 259-205 | A114 | B205 | 2 | 1 |
| 264-205 | A118 | B205 | 2 | 1 |
| 268-205 | A268 | B205 | 2 | 1 |

**Table 92**

| Compound No. | L₁ | L₂ | n1 | n2 |
|---|---|---|---|---|
| 301-1 | A301 | B1 | 2 | 1 |
| 302-1 | A302 | B1 | 2 | 1 |
| 303-1 | A303 | B1 | 2 | 1 |
| 304-1 | A304 | B1 | 2 | 1 |
| 305-1 | A305 | B1 | 2 | 1 |
| 306-1 | A306 | B1 | 2 | 1 |
| 307-1 | A307 | B1 | 2 | 1 |
| 308-1 | A308 | B1 | 2 | 1 |
| 309-1 | A309 | B1 | 2 | 1 |
| 310-1 | A310 | B1 | 2 | 1 |
| 306-181 | A306 | B181 | 2 | 1 |
| 306-182 | A306 | B182 | 2 | 1 |
| 306-183 or 2543 | A306 | B183 | 2 | 1 |
| 306-184 | A306 | B184 | 12 | 1 |
| 306-185 | A306 | B185 | 2 | 1 |
| 306-186 | A306 | B186 | 2 | 1 |
| 306-187 | A306 | B187 | 2 | 1 |
| 306-188 | A306 | B188 | 2 | 1 |
| 306-189 | A306 | B189 | 2 | 1 |
| 306-190 | A306 | B190 | 2 | 1 |
| 306-191 | A306 | B191 | 2 | 1 |
| 306-192 | A306 | B192 | 2 | 1 |
| 306-193 | A306 | B193 | 2 | 1 |
| 306-194 | A306 | B194 | 2 | 1 |
| 306-195 | A306 | B195 | 2 | 1 |
| 306-197 | A306 | B197 | 2 | 1 |
| 306-198 | A306 | B198 | 2 | 1 |
| 306-199 | A306 | B199 | 2 | 1 |
| 306-200 | A306 | B200 | 2 | 1 |
| 306-201 | A306 | B201 | 2 | 1 |
| 306-202 | A306 | B202 | 2 | 1 |

**Table 93**

| Compound No. | L₁ | L₂ | n1 | n2 |
|---|---|---|---|---|
| 301-4 | A301 | B4 | 2 | 1 |
| 302-8 | A302 | B8 | 2 | 1 |
| 303-10 | A303 | B10 | 2 | 1 |
| 304-13 | A304 | B13 | 2 | 1 |
| 305-20 | A305 | B20 | 2 | 1 |
| 306-24 | A306 | B24 | 2 | 1 |
| 307-27 | A307 | B27 | 2 | 1 |
| 308-48 | A308 | B48 | 2 | 1 |
| 309-62 | A309 | B62 | 2 | 1 |
| 310-63 | A310 | B63 | 2 | 1 |
| 301-85 | A301 | B85 | 2 | 1 |
| 302-91 | A302 | B91 | 2 | 1 |
| 303-108 | A303 | B108 | 2 | 1 |
| 304-116 | A304 | B116 | 2 | 1 |
| 305-137 | A305 | B137 | 2 | 1 |
| 306-144 | A306 | B144 | 2 | 1 |
| 307-152 | A307 | B152 | 2 | 1 |
| 308-162 | A308 | B162 | 2 | 1 |
| 309-169 | A309 | B169 | 2 | 1 |
| 310-176 | A310 | B176 | 2 | 1 |
| 301-187 | A301 | B187 | 2 | 1 |
| 302-201 | A302 | B201 | 2 | 1 |
| 303-202 | A303 | B202 | 2 | 1 |
| 304-213 | A304 | B213 | 2 | 1 |
| 305-249 | A305 | B249 | 2 | 1 |
| 306-272 | A306 | B272 | 2 | 1 |
| 307-281 | A307 | B281 | 2 | 1 |
| 308-306 | A308 | B306 | 2 | 1 |
| 309-340 | A309 | B340 | 2 | 1 |
| 310-399 | A310 | B399 | 2 | 1 |
| 301-445 | A301 | B445 | 2 | 1 |

**Table 94**

| Compound No. | L₁ | L₂ | n1 | n2 |
|---|---|---|---|---|
| 1-1N | A1 | B1 | 1 | 2 |
| 2-2N | A2 | B2 | 1 | 2 |
| 5-7N | A5 | B7 | 1 | 2 |
| 11-9N | A11 | B9 | 1 | 2 |
| 13-11N | A15 | B11 | 1 | 2 |
| 27-20N | A27 | B20 | 1 | 2 |
| 28-22N | A28 | B22 | 1 | 2 |
| 66-24N | A66 | B24 | 1 | 2 |
| 109-29N | A109 | B29 | 1 | 2 |
| 113-35N | A113 | B35 | 1 | 2 |
| 116-47N | A116 | B47 | 1 | 2 |
| 118-49N | A118 | B49 | 1 | 2 |
| 136-137N | A136 | B137 | 1 | 2 |
| 137-162N | A137 | B162 | 1 | 2 |
| 1-184N or 2588 | A1 | B184 | 1 | 2 |
| 1-187N | A1 | B187 | 1 | 2 |
| 2-200N | A2 | B200 | 1 | 2 |
| 5-201N | A5 | B201 | 1 | 2 |
| 11-202N | A11 | B202 | 1 | 2 |
| 15-1N | A15 | B1 | 1 | 2 |
| 27-22N | A27 | B2 | 1 | 2 |
| 28-7N | A28 | B7 | 1 | 2 |
| 66-9N | A66 | B9 | 1 | 2 |
| 109-11N | A109 | B11 | 1 | 2 |
| 113-20N | A113 | B20 | 1 | 2 |
| 116-22N | A116 | B22 | 1 | 2 |
| 118-24N | A118 | B24 | 1 | 2 |
| 136-29N | A136 | B29 | 1 | 2 |
| 137-35N | A137 | B35 | 1 | 2 |

**Table 95**

| Compound No. | L₁ | L₂ | n1 | n2 |
|---|---|---|---|---|
| 1-47N | A1 | B47 | 1 | 2 |
| 2-49N | A2 | B49 | 1 | 2 |
| 5-137N | A5 | B137 | 1 | 2 |
| 11-162N | A11 | B162 | 1 | 2 |
| 15-187N | A15 | B187 | 1 | 2 |
| 27-200N | A27 | B200 | 1 | 2 |
| 151-201N | A151 | B201 | 1 | 2 |
| 152-202N | A152 | B202 | 1 | 2 |
| 155-1 N | A155 | B1 | 1 | 2 |
| 180-2N | A180 | B2 | 1 | 2 |
| 201-7N | A201 | B7 | 1 | 2 |
| 202-9N | A202 | B9 | 1 | 2 |
| 228-11N | A228 | B11 | 1 | 2 |
| 258-20N | A258 | B20 | 1 | 2 |
| 263-22N | A263 | B22 | 1 | 2 |
| 264-24N | A264 | B24 | 1 | 2 |
| 265-29N | A265 | B29 | 1 | 2 |
| 266-35N | A266 | B35 | 1 | 2 |
| 267-47N | A267 | B47 | 1 | 2 |
| 268-49N | A268 | B49 | 1 | 2 |
| 269-137N | A269 | B137 | 1 | 2 |
| 270-162N | A270 | B162 | 1 | 2 |
| 271-187N | A271 | B187 | 1 | 2 |
| 273-200N | A273 | B200 | 1 | 2 |
| 174-201N | A274 | B201 | 1 | 2 |
| 282-202N | A282 | B202 | 1 | 2 |

**Table 96**

| Compound No. | L₁ | L₂ | n1 | n2 |
|---|---|---|---|---|
| 283-1N | A283 | B1 | 1 | 2 |
| 151-2N | A151 | B2 | 1 | 2 |
| 152-7N | A152 | B7 | 1 | 2 |
| 155-9N | A155 | B9 | 1 | 2 |
| 180-11N | A180 | B11 | 1 | 2 |
| 201-20N | A201 | B20 | 1 | 2 |
| 202-22N | A202 | B22 | 1 | 2 |
| 228-24N | A228 | B24 | 1 | 2 |
| 258-29N | A258 | B29 | 1 | 2 |
| 263-35N | A263 | B35 | 1 | 2 |
| 264-47N | A264 | B47 | 1 | 2 |
| 265-49N | A265 | B49 | 1 | 2 |
| 266-137N | A266 | B137 | 1 | 2 |
| 267-162N | A267 | B162 | 1 | 2 |

L₁ and L₂ in the organometallic compound represented by Formula 1 may respectively be ligands represented by Formulae 2-1 and 2-2. n1 and n2, which may respectively be the number of L₁ ligands and L₂ ligands, may each independently be 1 or 2. That is, the organometallic compound may include L₁ (Formula 2-1) including a group represented by *-X₁₁(R₁₄)(R₁₅)(R₁₆) as a substituent and L2 (Formula 2-2) having a structure in which ring CY₄₃ is condensed to ring CY₄₂. Accordingly, the organometallic compound represented by Formula 1 may have significantly improved molecular orientation and molecular rigidity. Thus, an electronic device, e.g., an organic light-emitting device, including the organometallic compound may have an improved external quantum yield and improved lifespan.

The highest occupied molecular orbital (HOMO) energy level, lowest unoccupied molecular orbital (LUMO) energy level, and T₁ energy level of some of the organometallic compounds represented by Formula 1 were evaluated by using Gaussian 09 program that performs molecular structure optimizations according to density functional theory (DFT) at a level of B3LYP. The results thereof are shown in Table 97.

**Table 97**

| Compound No. | HOMO (electronvolts (eV)) | LUMO (eV) | T1 (eV) |
|---|---|---|---|
| Compound 1 | -4.769 | -1.244 | 2.492 |
| Compound 838 | -4.742 | -1.221 | 2.452 |
| Compound 855 | -4.733 | -1.222 | 2.316 |
| Compound 960 | -4.724 | -1.223 | 2.400 |
| Compound 962 | -4.669 | -1.240 | 2.442 |
| Compound 980 | -4.871 | -1.448 | 2.415 |
| Compound 1279 | -4.742 | -1.243 | 2.407 |
| Compound 2206 | -4.671 | -1.141 | 2.466 |
| Compound 2543 | -4.741 | -1.187 | 2.444 |
| Compound 2588 | -4.870 | -1.351 | 2.459 |

Referring to the results of Table 97, the organometallic compound represented by Formula 1 was found to have suitable electrical characteristics for use as a dopant in an electronic device, e.g., an organic light-emitting device.

A method of synthesizing the organometallic compound represented by Formula 1 may be apparent to one of ordinary skill in the art by referring to Synthesis Examples provided herein.

The organometallic compound represented by Formula 1 may be suitable for use in an organic layer of an organic light-emitting device, for example, as a dopant in an emission layer of the organic layer. Thus, according to another aspect, there is provided an organic light-emitting device that may include a first electrode; a second electrode; and an organic layer between the first electrode and the second electrode, the organic layer including an emission layer and at least one organometallic compound represented by Formula 1.

Since the organic light-emitting device has an organic layer including the organometallic compound represented by Formula 1, the organic light-emitting device may have an improved external quantum yield and improved lifespan characteristics.

The organometallic compound represented by Formula 1 may be used in a pair of electrodes of an organic light-emitting device. For example, the organometallic compound represented by Formula 1 may be included in the emission layer. In this embodiment, the organometallic compound may serve as a dopant and the emission layer may further include a host (that is, an amount of the organometallic compound represented by Formula 1 may be smaller than that of the host). The emission layer may emit red light or green light, e.g., red light or green light having a maximum emission wavelength of about 500 nanometers (nm) or longer, e.g., about 500 nm to about 850 nm. In some embodiments, the organometallic compound may emit green light. In some embodiments, the emission layer (or, the organic light-emitting device) may emit a light (for example, a green light) having a maximum emission wavelength of about 515 nm to about 550 nm, or about 520 nm to about 540 nm.

As used herein, the expression the "(organic layer) includes at least one organometallic compound" may be construed as meaning the "(organic layer) may include one organometallic compound of Formula 1 or two for more different organometallic compounds of Formula 1".

For example, only Compound 1 may be included in the organic layer as an organometallic compound. In this embodiment, Compound 1 may be included in the emission layer of the organic light-emitting device. In some embodiments, Compounds 1 and 2 may be included in the organic layer as organometallic compounds. In this embodiment, Compounds 1 and 2 may both be included in the same layer (for example, both Compounds 1 and 2 may be included in the emission layer).

The first electrode may be an anode, which is a hole injection electrode, and the second electrode may be a cathode, which is an electron injection electrode. In some embodiments, the first electrode may be a cathode, which is an electron injection electrode, and the second electrode may be an anode, which is a hole injection electrode.

For example, in the organic light-emitting device, the first electrode may be an anode, the second electrode may be a cathode, and the organic layer may further include a hole transport region between the first electrode and the emission layer and an electron transport region between the emission layer and the second electrode, wherein the hole transport region may include a hole injection layer, a hole transport layer, an electron blocking layer, a buffer layer, or any combination thereof, and the electron transport region may include a hole blocking layer, an electron transport layer, an electron injection layer, or any combination thereof.

The term "organic layer" as used herein refers to a single and/or a plurality of layers between the first electrode and the second electrode in an organic light-emitting device. The "organic layer" may include not only organic compounds but also organometallic complexes including metals.

The FIGURE illustrates a schematic cross-sectional view of an organic light-emitting device 10 according to an embodiment. Hereinafter, a structure of an organic light-emitting device according to one or more embodiments and a method of manufacturing the organic light-emitting device will be described with reference to the FIGURE. The organic light-emitting device 10 may include a first electrode 11, an organic layer 15, and a second electrode 19, which may be sequentially layered in this stated order.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and water repellency.

The first electrode 11 may be formed by depositing or sputtering, onto the substrate, a material for forming the first electrode 11. The first electrode 11 may be an anode. The material for forming the first electrode 11 may include a material with a high work function for easy hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In some embodiments, the material for forming the first electrode 11 may be a metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. In some embodiments, the first electrode 11 may have a triple-layered structure of ITO/Ag/ITO.

The organic layer 15 may be on the first electrode 11.

The organic layer 15 may include a hole transport region, an emission layer, and an electron transport region.

The hole transport region may be between the first electrode 11 and the emission layer.

The hole transport region may include a hole injection layer, a hole transport layer, an electron blocking layer, a buffer layer, or any combination thereof.

The hole transport region may include a hole injection layer only or a hole transport layer only. In some embodiments, the hole transport region may include a hole injection layer and a hole transport layer which are sequentially stacked on the first electrode 11. In some embodiments, the hole transport region may include a hole injection layer, a hole transport layer, and an electron blocking layer, which are sequentially stacked on the first electrode 11.

When the hole transport region includes a hole injection layer, the hole injection layer may be formed on the first electrode 11 by using one or more suitable methods, such as vacuum deposition, spin coating, casting, and Langmuir-Blodgett (LB) deposition.

When a hole injection layer is formed by vacuum-deposition, for example, the vacuum deposition may be performed at a temperature in a range of about 100°C to about 500°C, at a vacuum degree in a range of about 10⁻⁸ torr to about 10⁻³ torr, and at a rate in a range of about 0.01 Angstroms per second (Å/sec) to about 100 Å/sec, though the conditions may vary depending on a compound used as a hole injection material and a structure and thermal properties of a desired hole injection layer.

When a hole injection layer is formed by spin coating, the spin coating may be performed at a coating rate in a range of about 2,000 revolutions per minute (rpm) to about 5,000 rpm, and at a temperature in a range of about 80 °C to 200 °C, to facilitate removal of a solvent after the spin coating, though the conditions may vary depending on a compound that is used as a hole injection material and a structure and thermal properties of a desired hole injection layer.

The conditions for forming a hole transport layer and an electron blocking layer may be inferred from the conditions for forming the hole injection layer.

The hole transport region may include m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor-sulfonic acid (PANI/CSA), polyaniline/poly(4-styrene sulfonate) (PANI/PSS), a compound represented by Formula 201, a compound represented by Formula 202, or any combination thereof: 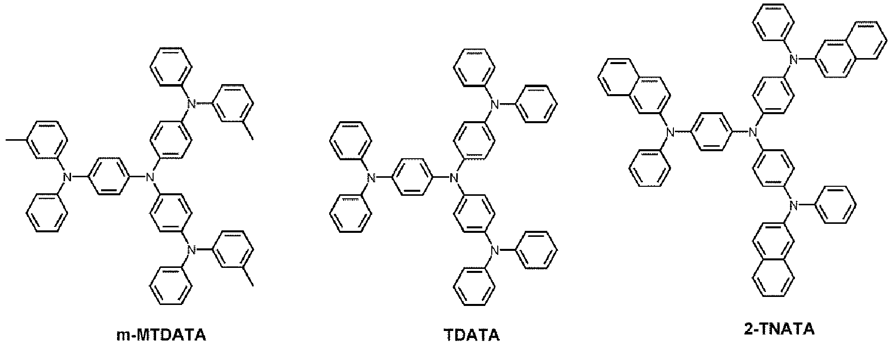 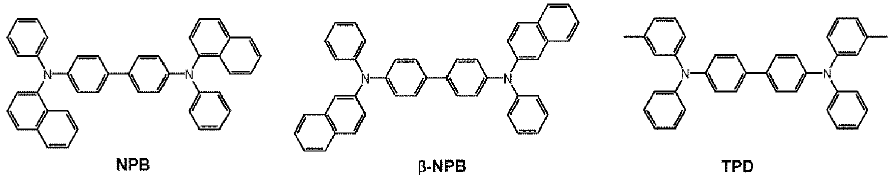 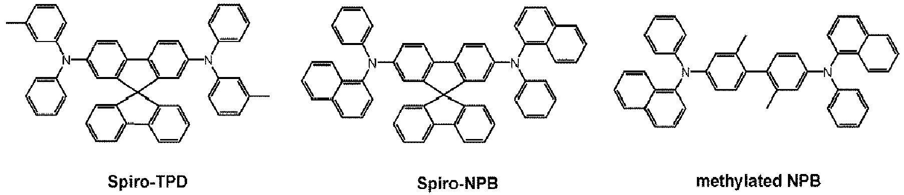 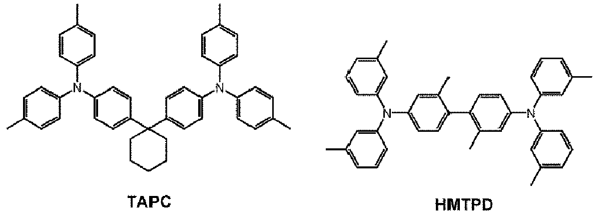 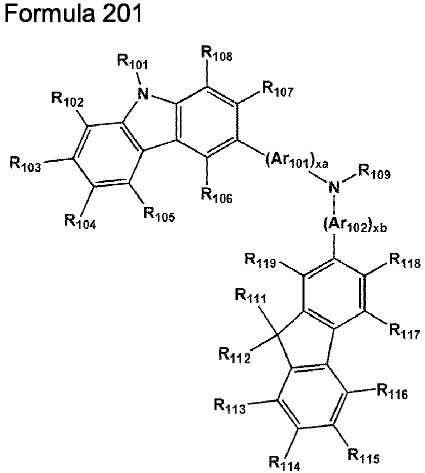 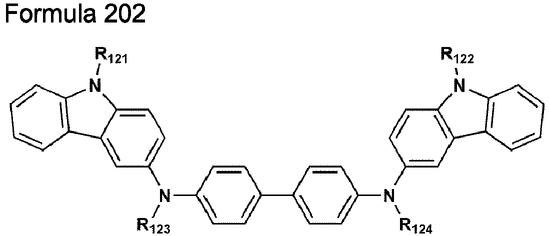 wherein, in Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

In Formula 201, xa and xb may each independently be an integer from 0 to 5. In some embodiments, xa and xb may each independently be 0, 1, or 2. In some embodiments, xa may be 1, and xb may be 0.

In Formulae 201 and 202, R₁₀₁ to R₁₀₈, R₁₁₁ to R₁₁₉, and R₁₂₁ to R₁₂₄ may each independently be:
hydrogen, deuterium, -F, -Cl, -Br, -I, a hydroxyl group, a cyano group, a nitro group, a C₁-C₁₀ alkyl group (e.g., a methyl group, an ethyl group, a propyl group, a butyl group, a pentyl group, or a hexyl group), or a C₁-C₁₀ alkoxy group (e.g., a methoxy group, an ethoxy group, a propoxy group, a butoxy group, or a pentoxy group);
a C₁-C₁₀ alkyl group or a C₁-C₁₀ alkoxy group, each substituted with deuterium, -F, -Cl, -Br, -I, a hydroxyl group, a cyano group, a nitro group, or any combination thereof; or
a phenyl group, a naphthyl group, an anthracenyl group, a fluorenyl group, or a pyrenyl group, each unsubstituted or substituted with deuterium, -F, -Cl, -Br, -I, a hydroxyl group, a cyano group, a nitro group, a C₁-C₁₀ alkyl group, a C₁-C₁₀ alkoxy group, or any combination thereof.

In Formula 201, R₁₀₉ may be a phenyl group, a naphthyl group, an anthracenyl group, or a pyridinyl group, each unsubstituted or substituted with deuterium, -F, -Cl, -Br, -I, a hydroxyl group, a cyano group, a nitro group, a C₁-C₂₀ alkyl group, a C₁-C₂₀ alkoxy group, a phenyl group, a naphthyl group, an anthracenyl group, a pyridinyl group, or any combination thereof.

In some embodiments, the compound represented by Formula 201 may be represented by Formula 201A: 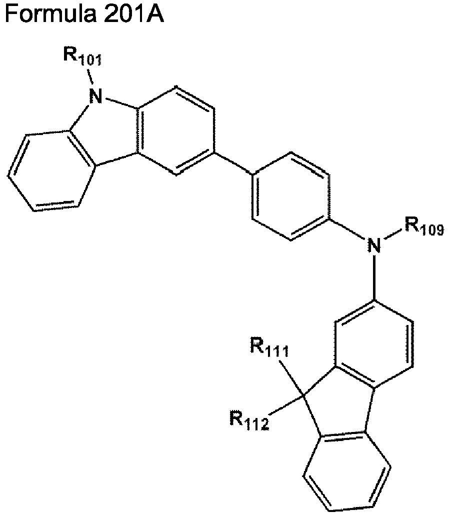 wherein, in Formula 201A, R₁₀₁, R₁₁₁, R₁₁₂, and R₁₀₉ may respectively be understood by referring to the descriptions of R₁₀₁, R₁₁₁, R112, and R₁₀₉ provided herein.

In some embodiments, the compounds represented by Formulae 201 and 202 may include Compounds HT1 to HT20:

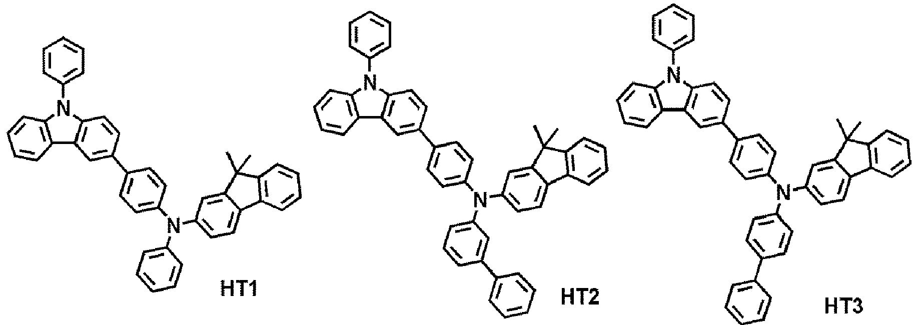

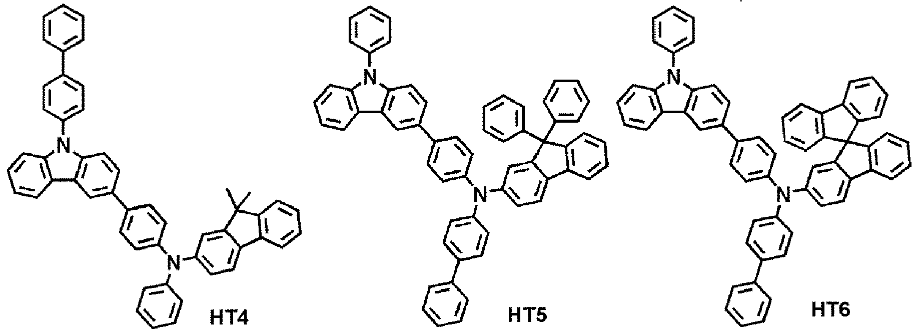

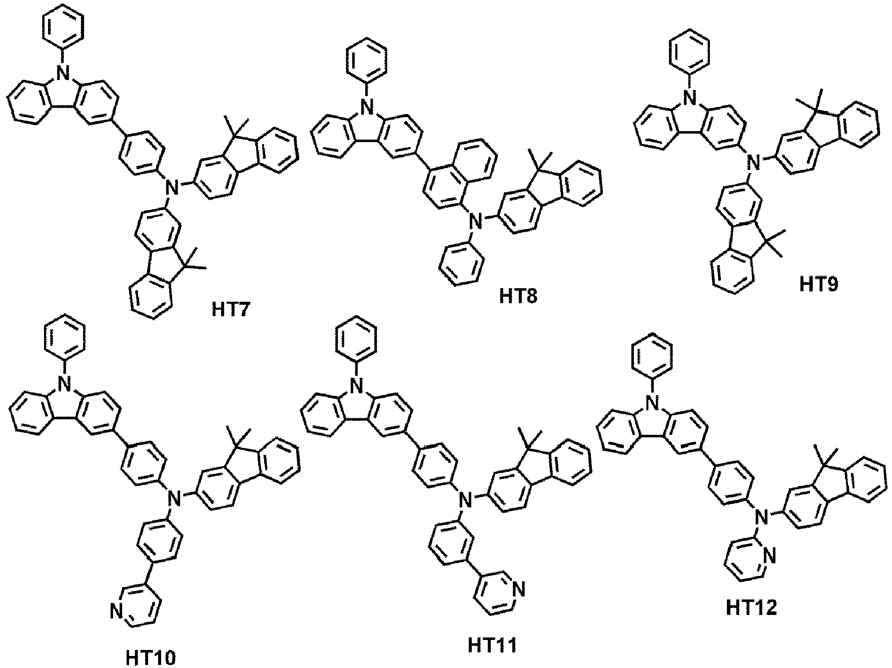

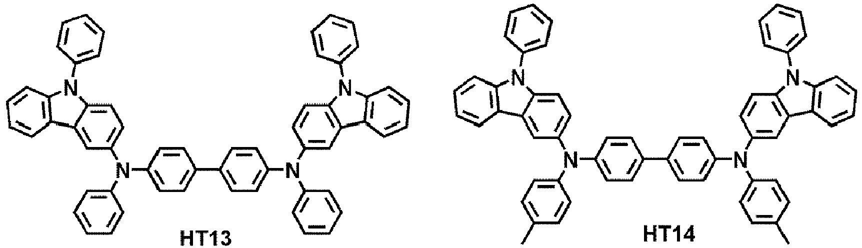

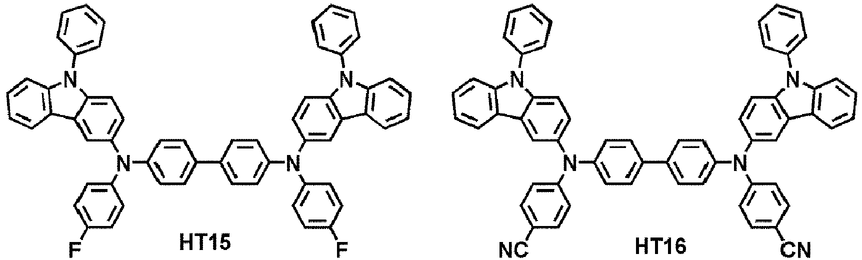

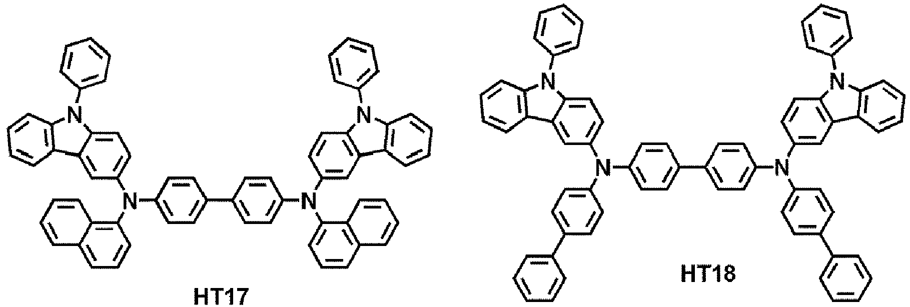

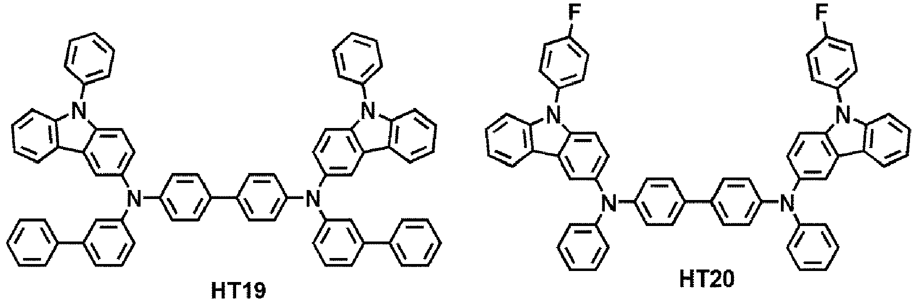

The thickness of the hole transport region may be in a range of about 100 Angstroms (Å) to about 10,000 Å, for example, about 100 Å to about 1,000 Å. When the hole transport region includes at least one of a hole injection layer and a hole transport layer, the thickness of the hole injection layer may be in a range of about 100 Å to about 10,000 Å, for example, about 100 Å to about 1,000 Å, the thickness of the hole transport layer may be in a range of about 50 Å to about 2,000 Å, for example, about 100 Å to about 1,500 Å. When the thicknesses of the hole transport region, the hole injection layer, and the hole transport layer are within any of these ranges, excellent hole transport characteristics may be obtained without a substantial increase in driving voltage.

The hole transport region may include a charge generating material as well as the aforementioned materials, to improve conductive properties of the hole transport region. The charge generating material may be substantially homogeneously or non-homogeneously dispersed in the hole transport region.

The charge generating material may include, for example, a p-dopant. The p-dopant may include one of a quinone derivative, a metal oxide, and a compound containing a cyano group. For example, non-limiting examples of the p-dopant include a quinone derivative, such as tetracyanoquinodimethane (TCNQ), 2,3,5,6-tetrafluoro-tetracyano-1,4-benzoquinonedimethane (F4-TCNQ), or F6-TCNNQ; a metal oxide, such as a tungsten oxide or a molybdenum oxide; and a compound containing a cyano group, such as Compound HT-D1:

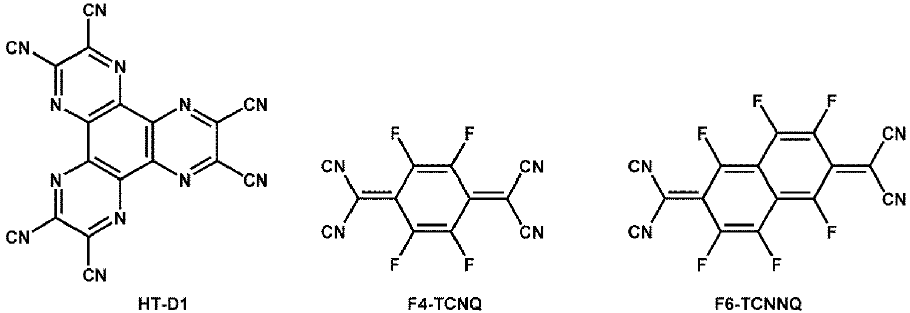

The hole transport region may further include a buffer layer.

The buffer layer may compensate for an optical resonance distance depending on a wavelength of light emitted from the emission layer to improve the efficiency of an organic light-emitting device.

When the hole transport region includes an electron blocking layer, a material for forming the electron blocking layer may include the material for forming a hole transport region, the host material described herein or any combination thereof. In some embodiments, when the hole transport region includes an electron blocking layer, mCP described herein, H-H1, or the like may be used for forming the electron blocking layer.

An emission layer may be formed on the hole transport region by using one or more suitable methods, such as vacuum deposition, spin coating, casting, or LB deposition. When the emission layer is formed by vacuum deposition or spin coating, vacuum deposition and coating conditions for forming the emission layer may be generally similar to those conditions for forming a hole injection layer, though the conditions may vary depending on a compound that is used.

The emission layer may include a host and a dopant, and the dopant may include the organometallic compound represented by Formula 1.

The host may include TPBi, TBADN, ADN (also known as "DNA"), CBP, CDBP, TCP, mCP, Compound H50, Compound H51, Compound H52, Compound H-H1, Compound H-E43, or any combination thereof:

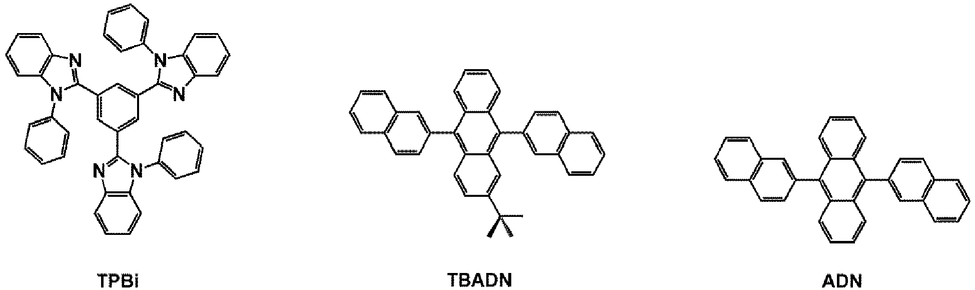

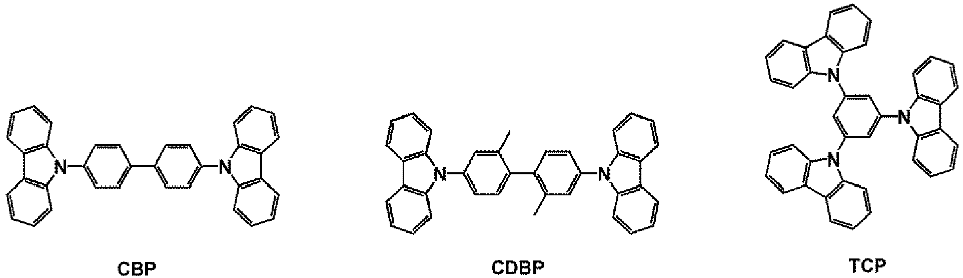

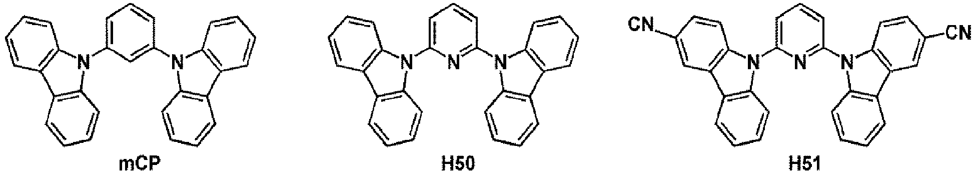

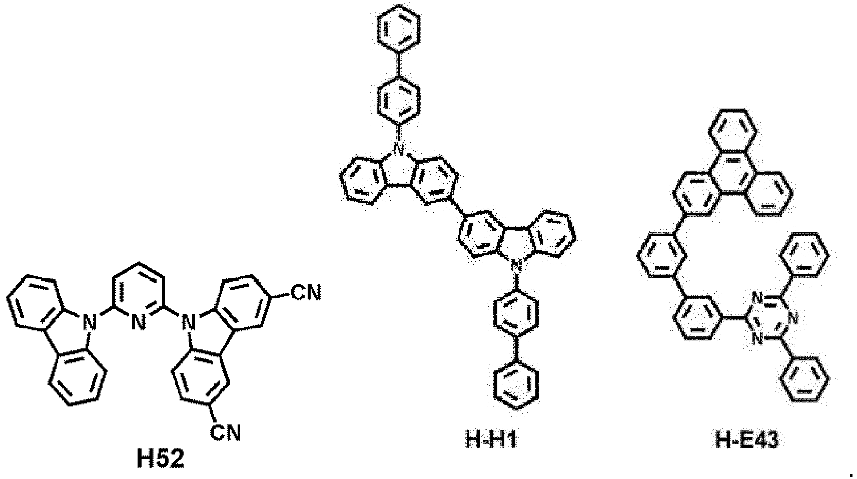

When the organic light-emitting device 10 is a full-color organic light-emitting device, the emission layer may be patterned into a red emission layer, a green emission layer, and/or a blue emission layer. In some embodiments, the emission layer may have a structure in which the red emission layer, the green emission layer, and/or the blue emission layer are layered to emit white light. In some embodiments, the structure of the emission layer may vary.

When the emission layer includes the host and the dopant, an amount (e.g., a content) of the dopant may be present in a range of about 0.01 parts to about 15 parts by weight based on about 100 parts by weight of the host.

The thickness of the emission layer may be in a range of about 100 Å to about 1,000 Å, and in some embodiments, about 200 Å to about 600 Å. When the thickness of the emission layer is within any of these ranges, improved luminescence characteristics may be obtained without a substantial increase in driving voltage.

An electron transport region may be over the emission layer.

The electron transport region may include a hole blocking layer, an electron transport layer, an electron injection layer, or any combination thereof.

In some embodiments, the electron transport region may have a hole blocking layer/an electron transport layer/an electron injection layer structure or an electron transport layer/an electron injection layer structure. The electron transport layer may have a single-layered structure or a multi-layered structure including two or more different materials.

The conditions for forming a hole blocking layer, an electron transport layer, and an electron injection layer may be inferred based on the conditions for forming the hole injection layer.

When the electron transport region includes a hole blocking layer, the hole blocking layer may include, for example, BCP, Bphen, BAIq, or any combination thereof:

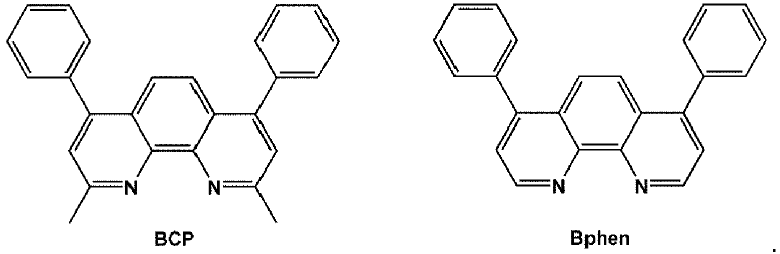

The thickness of the hole blocking layer may be in a range of about 20 Å to about 1,000 Å, for example, about 30 Å to about 300 Å. When the thickness of the hole blocking layer is within any of these ranges, excellent hole blocking characteristics may be obtained without a substantial increase in driving voltage.

The electron transport layer may include BCP, Bphen, Alq₃, BAIq, TAZ, NTAZ, or any combination thereof:

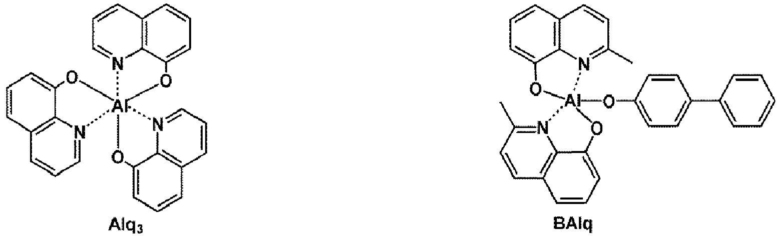

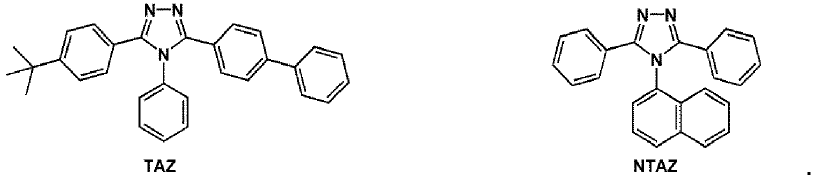

In some embodiments, the electron transport layer may include one of Compounds ET1 to ET25 or any combination thereof:

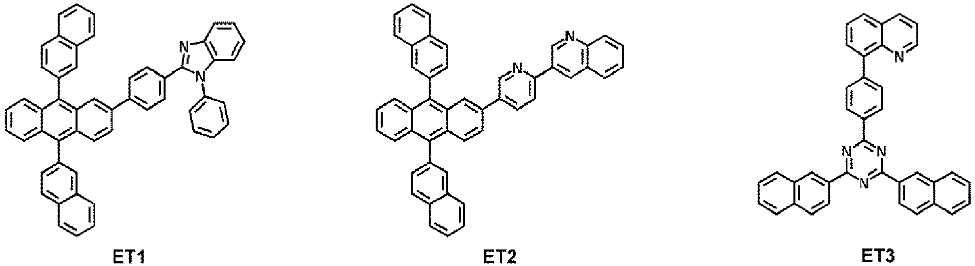

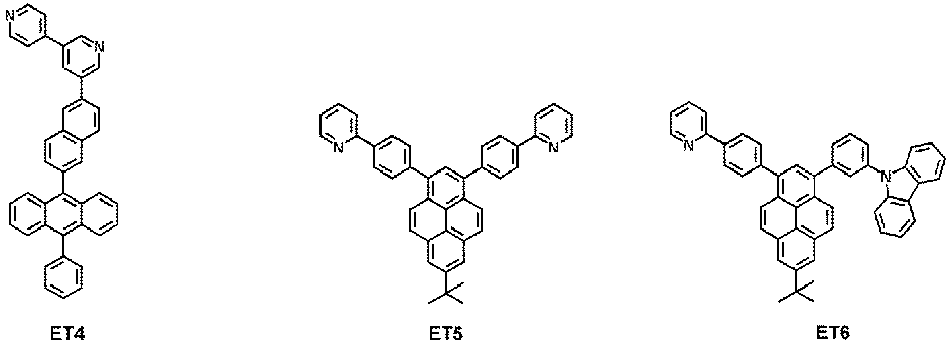

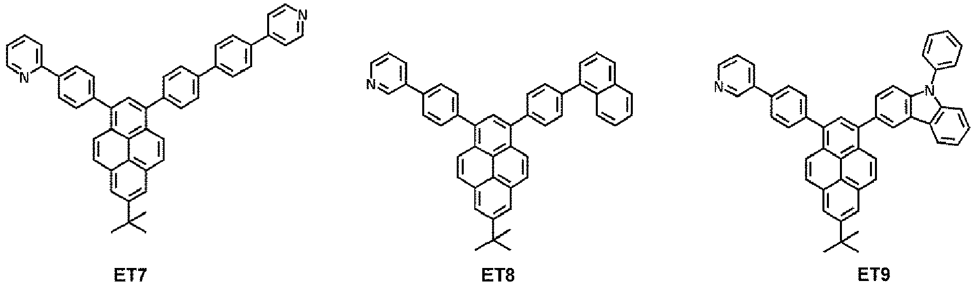

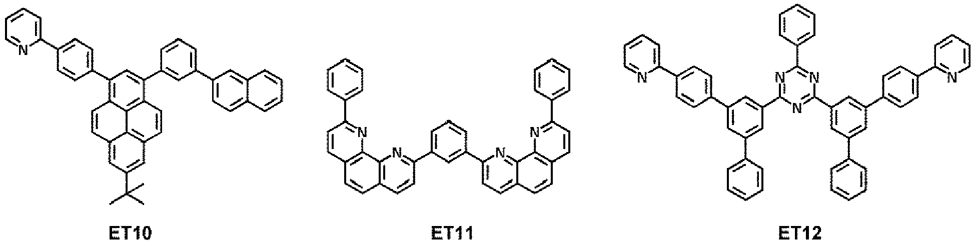

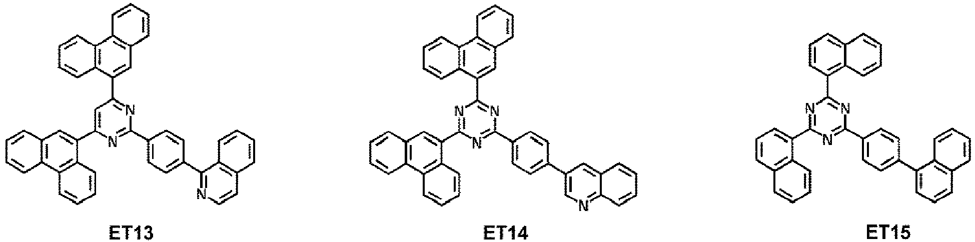

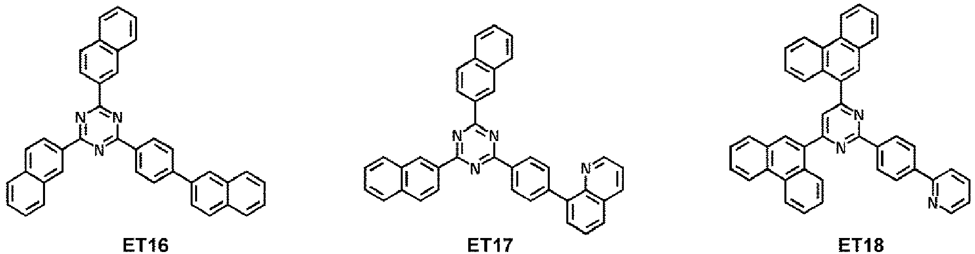

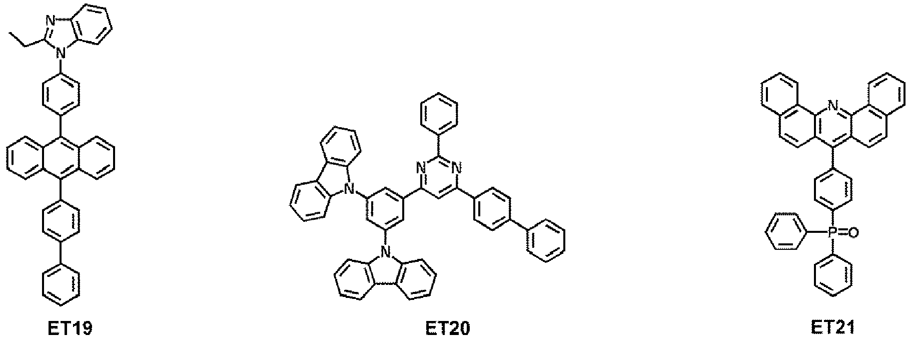

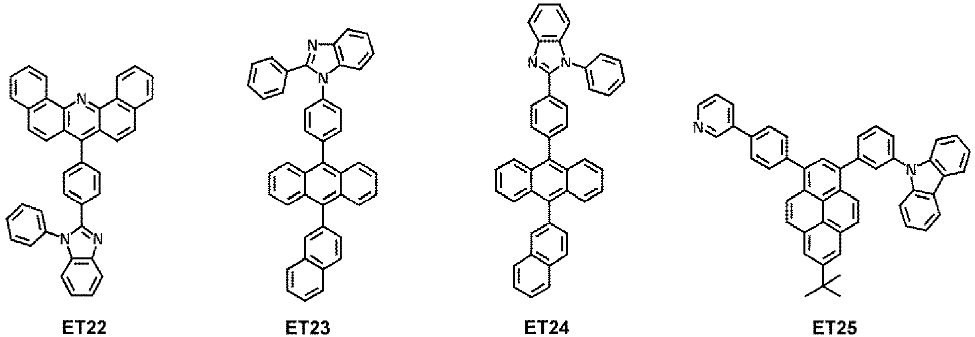

The thickness of the electron transport layer may be in a range of about 100 Å to about 1,000 Å, and in some embodiments, about 150 Å to about 500 Å. When the thickness of the electron transport layer is within any of these ranges, excellent electron transport characteristics may be obtained without a substantial increase in driving voltage.

The electron transport layer may further include a material containing metal, in addition to the materials described above.

The material containing metal may include a Li complex. The Li complex may include, e.g., Compound ET-D1 (LiQ) or Compound ET-D2:

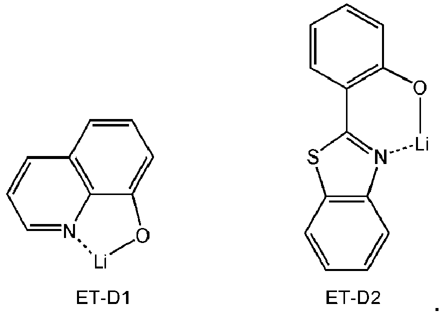

The electron transport region may include an electron injection layer that facilitates electron injection from the second electrode 19.

The electron injection layer may include LiF, NaCl, CsF, Li₂O, BaO, or any combination thereof.

The thickness of the electron injection layer may be in a range of about 1 Å to about 100 Å, and in some embodiments, about 3 Å to about 90 Å. When the thickness of the electron injection layer is within any of these ranges, excellent electron injection characteristics may be obtained without a substantial increase in driving voltage.

The second electrode 19 may be on the organic layer 15. The second electrode 19 may be a cathode. A material for forming the second electrode 19 may be a material with a relatively low work function, such as a metal, an alloy, an electrically conductive compound, or any combination thereof. Examples of the material for forming the second electrode 19 may include lithium (Li), silver (Ag), magnesium (Mg), aluminum (Al), aluminum-lithium (Al-Li), calcium (Ca), magnesium-indium (Mg-In), and magnesium-silver (Mg-Ag). In some embodiments, ITO or IZO may be used to form a transmissive second electrode 19 to manufacture a top emission light-emitting device. In some embodiments, the material for forming the second electrode 19 may vary.

Hereinbefore the organic light-emitting device 10 has been described with reference to the FIGURE, but embodiments are not limited thereto.

According to an aspect of an embodiment, an electronic apparatus may include the organic light-emitting device. Thus, an electronic apparatus including the organic light-emitting device may be provided. The electronic apparatus may include, for example, a display, lighting, a sensor, or the like.

According to an aspect of still an embodiment, a diagnostic composition may include at least one organometallic compound represented by Formula 1.

Since the organometallic compound represented by Formula 1 provides high luminescence efficiency, the diagnostic efficiency of the diagnostic composition that includes the organometallic compound represented by Formula 1 may be excellent.

The diagnostic composition may be applied in various ways, such as in a diagnostic kit, a diagnostic reagent, a biosensor, or a biomarker.

The term "C₁-C₆₀ alkyl group" as used herein refers to a linear or branched saturated aliphatic hydrocarbon monovalent group having 1 to 60 carbon atoms, and the term "C₁-C₆₀ alkylene group" as used herein refers to a divalent group having the same structure as the C₁-C₆₀ alkyl group.

Examples of the C₁-C₆₀ alkyl group, the C₁-C₂₀ alkyl group, and/or the C₁-C₁₀ alkyl group as used herein may include a methyl group, an ethyl group, an *n*-propyl group, an iso-propyl group, an *n*-butyl group, a *sec*-butyl group, an isobutyl group, a *tert*-butyl group, an *n*-pentyl group, a *tert*-pentyl group, a neopentyl group, an isopentyl group, a sec-pentyl group, a 3-pentyl group, a *sec*-isopentyl group, an *n*-hexyl group, an iso-hexyl group, a *sec*-hexyl group, a *tert*-hexyl group, an *n*-heptyl group, an iso-heptyl group, a sec-heptyl group, a *tert*-heptyl group, an *n*-octyl group, an iso-octyl group, a *sec*-octyl group, a *tert-*octyl group, an *n*-nonyl group, an iso-nonyl group, a *sec*-nonyl group, a *tert*-nonyl group, an *n*-decyl group, an iso-decyl group, a *sec*-decyl group, or a *tert*-decyl group, each unsubstituted or substituted with a methyl group, an ethyl group, an *n*-propyl group, an iso-propyl group, an *n*-butyl group, a *sec*-butyl group, an isobutyl group, a *tert*-butyl group, an *n*-pentyl group, a *tert*-pentyl group, a neopentyl group, an isopentyl group, a sec-pentyl group, a 3-pentyl group, a *sec*-isopentyl group, an *n*-hexyl group, an iso-hexyl group, a *sec*-hexyl group, a *tert*-hexyl group, an *n*-heptyl group, an iso-heptyl group, a sec-heptyl group, a *tert*-heptyl group, an *n*-octyl group, an iso-octyl group, a *sec*-octyl group, a *tert-*octyl group, an *n*-nonyl group, an iso-nonyl group, a *sec*-nonyl group, a *tert*-nonyl group, an *n*-decyl group, an iso-decyl group, a *sec*-decyl group, a *tert*-decyl group, or any combination thereof. In some embodiments, Formula 9-33 may be a branched C₆ alkyl group. Formula 9-33 may be a *tert*-butyl group substituted with two methyl groups.

The term "C₁-C₆₀ alkoxy group" as used herein refers to a monovalent group represented by -OA₁₀₁ (wherein A₁₀₁ is a C₁-C₆₀ alkyl group). Examples thereof include a methoxy group, an ethoxy group, a propoxy group, a butoxy group, and a pentoxy group.

The term "C₁-C₆₀ alkylthio group" as used herein refers to a monovalent group represented by -SA₁₀₁ (wherein A₁₀₁ is a C₁-C₆₀ alkyl group).

The term "C₂-C₆₀ alkenyl group" as used herein refers to a group formed by placing at least one carbon-carbon double bond in the middle or at the terminus of the C₂-C₈₀ alkyl group. Examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a group formed by placing at least one carbon-carbon triple bond in the middle or at the terminus of the C₂-C₆₀ alkyl group. Examples thereof include an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms. The term "C₃-C₁₀ cycloalkylene group" as used herein refers to a divalent group having the same structure as the C₃-C₁₀ cycloalkyl group.

Examples of the C₃-C₁₀ cycloalkyl group as used herein include a cyclopropyl group, a cyclobutyl group, a cyclopentyl group, a cyclohexyl group, a cycloheptyl group, a cyclooctyl group, an adamantanyl group, a norbornanyl (bicyclo[2.2.1]heptyl) group, a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a monovalent cyclic group having 1 to 10 carbon atoms and at least one heteroatom of N, O, P, Si, S, Se, Ge, and B as a ring-forming atom. The term "C₁-C₁₀ heterocycloalkylene group" as used herein refers to a divalent group having the same structure as the C₁-C₁₀ heterocycloalkyl group.

Examples of the C₁-C₁₀ heterocycloalkyl group as used herein may include a silolanyl group, a silinanyl group, a tetrahydrofuranyl group, a tetrahydro-2H-pyranyl group, or a tetrahydrothiophenyl group.

The term "C₃-C₁₀ cycloalkenyl group" as used herein refers to a monovalent cyclic group that has 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group including at least one heteroatom of N, O, P, Si, S, Se, Ge, and B as a ring-forming atom, 1 to 10 carbon atoms, and at least one double bond in its ring, wherein the molecular structure as a whole is non-aromatic. Examples of the C₁-C₁₀ heterocycloalkenyl group include a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms. The term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include a plurality of rings, the plurality of rings may be fused to each other.

The term "C₇-C₆₀ alkyl aryl group" as used herein refers to a C₆-C₆₀ aryl group substituted with at least one C₁-C₆₀ alkyl group.

The term "C₁-C₆₀ heteroaryl group" as used herein refers to a monovalent group having a heterocyclic aromatic system having at least one heteroatom of N, O, P, Si, S, Se, Ge, and B as a ring-forming atom and 1 to 60 carbon atoms. The term "C₁-C₆₀ heteroarylene group" as used herein refers to a divalent group having a heterocyclic aromatic system having at least one heteroatom of N, O, P, Si, S, Se, Ge and B as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include a plurality of rings, the plurality of rings may be fused to each other.

The term "C₂-C₆₀ alkyl heteroaryl group" as used herein refers to a C₁-C₆₀ heteroaryl group substituted with at least one C₁-C₆₀ alkyl group.

The term "C₆-C₆₀ aryloxy group" as used herein is represented by -OA₁₀₂ (wherein A₁₀₂ is the C₆-C₆₀ aryl group). The term "C₆-C₆₀ arylthio group" as used herein is represented by -SA₁₀₃ (wherein A₁₀₃ is the C₆-C₆₀ aryl group). The term "C₁-C₆₀ alkylthio group" as used herein is represented by -SA₁₀₄ (wherein A₁₀₄ is the C₁-C₆₀ alkyl group).

The term "monovalent non-aromatic condensed polycyclic group" as used herein refers to a monovalent group that has two or more condensed rings and only carbon atoms (e.g., the number of carbon atoms may be in a range of 8 to 60) as ring-forming atoms, wherein the molecular structure as a whole is non-aromatic. Examples of the monovalent non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and at least one heteroatom that may be N, O, P, Si, S, Se, Ge, B, or a combination thereof and carbon atoms (e.g., the number of carbon atoms may be in a range of 1 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

The term "C₅-C₃₀ carbocyclic group" as used herein refers to a saturated or unsaturated cyclic group including 5 to 30 carbon atoms only as ring-forming atoms. The C₅-C₃₀ carbocyclic group may be a monocyclic group or a polycyclic group. Examples of the "C₅-C₃₀ carbocyclic group (unsubstituted or substituted with at least one R₁₀ₐ)" may include an adamantane group, a norbornene group, a bicyclo[1.1.1]pentane group, a bicyclo[2.1.1]hexane group, a bicyclo[2.2.1]heptane group (a norbornane group), a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, or a fluorene group, (each unsubstituted or substituted with at least one R₁₀ₐ).

The term "C₁-C₃₀ heterocyclic group" as used herein refers to saturated or unsaturated cyclic group including 1 to 30 carbon atoms and at least one heteroatom that may be N, O, P, Si, S, Se, Ge, B, or a combination thereof as ring-forming atoms. The C₁-C₃₀ heterocyclic group may be a monocyclic group or a polycyclic group. Examples of the "C₁-C₃₀ heterocyclic group (unsubstituted or substituted with at least one R₁₀ₐ)" may include a thiophene group, a furan group, a pyrrole group, a silole group, a borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, (each unsubstituted or substituted with at least one R₁₀ₐ).

Examples of the "C₅-C₃₀ carbocyclic group" and the "C₁-C₃₀ heterocyclic group" as used herein include i) a first ring, ii) a second ring, iii) a condensed ring in which at least two first rings are condensed, iv) a condensed ring in which at least two second rings are condensed, or v) a condensed ring in which at least one first ring and at least one second ring are condensed,
the first ring may be a cyclopentane group, a cyclopentene group, a furan group, a thiophene group, a pyrrole group, a silole group, a borole group, a phosphole group, a germole group, a selenophene group, an oxazole group, an isoxazole group, an oxadiazole group, an oxatriazole group, a thiazole group, an isothiazole group, a thiadiazole group, a thiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The "fluorinated C₁-C₆₀ alkyl group (or fluorinated C₁-C₂₀ alkyl group or the like)", "fluorinated C₃-C₁₀ cycloalkyl group", "fluorinated C₁-C₁₀ heterocycloalkyl group", and "fluorinated phenyl group" as used herein may respectively be a C₁-C₆₀ alkyl group (or C₁-C₂₀ alkyl group or the like), a C₃-C₁₀ cycloalkyl group, a C₁-C₁₀ heterocycloalkyl group, and a phenyl group, each substituted with at least one fluoro group (-F). Examples of the "fluorinated C₁ alkyl group (i.e., a fluorinated methyl group)" may include -CF₃, -CF₂H, and -CFH₂. The "fluorinated C₁-C₆₀ alkyl group (or fluorinated C₁-C₂₀ alkyl group or the like)", "fluorinated C₃-C₁₀ cycloalkyl group", "fluorinated C₁-C₁₀ heterocycloalkyl group", or "fluorinated phenyl group" as used herein may respectively be: i) a fully fluorinated C₁-C₆₀ alkyl group (or fully fluorinated C₁-C₂₀ alkyl group or the like), fully fluorinated C₃-C₁₀ cycloalkyl group, fully fluorinated C₁-C₁₀ heterocycloalkyl group, or fully fluorinated phenyl group, in which all hydrogen atoms are substituted with fluoro groups; or ii) a partially fluorinated C₁-C₆₀ alkyl group (or partially fluorinated C₁-C₂₀ alkyl group or the like), partially fluorinated C₃-C₁₀ cycloalkyl group, partially fluorinated C₁-C₁₀ heterocycloalkyl group, or partially fluorinated phenyl group, in which some of hydrogen atoms are substituted with fluoro groups.

The "deuterated C₁-C₆₀ alkyl group (or deuterated C₁-C₂₀ alkyl group or the like)", "deuterated C₃-C₁₀ cycloalkyl group", "deuterated C₁-C₁₀ heterocycloalkyl group", and "deuterated phenyl group" as used herein may respectively be a C₁-C₆₀ alkyl group (or C₁-C₂₀ alkyl group or the like), a C₃-C₁₀ cycloalkyl group, a C₁-C₁₀ heterocycloalkyl group, and a phenyl group, each substituted with at least one deuterium. Examples of the "deuterated C₁ alkyl group (i.e., a deuterated methyl group)" may include -CD₃, -CD₂H, and -CDH₂. Examples of the "deuterated C₃-C₁₀ cycloalkyl group" may include Formula 10-501. The "deuterated C₁-C₆₀ alkyl group (or deuterated C₁-C₂₀ alkyl group or the like)", "deuterated C₃-C₁₀ cycloalkyl group", "deuterated C₁-C₁₀ heterocycloalkyl group", or deuterated phenyl group as used herein may respectively be: i) a fully deuterated C₁-C₆₀ alkyl group (or fully deuterated C₁-C₂₀ alkyl group or the like), fully deuterated C₃-C₁₀ cycloalkyl group, fully deuterated C₁-C₁₀ heterocycloalkyl group, or fully deuterated phenyl group, in which all hydrogen atoms are substituted with deuterium atoms; or ii) a partially deuterated C₁-C₆₀ alkyl group (or partially deuterated C₁-C₂₀ alkyl group or the like), partially deuterated C₃-C₁₀ cycloalkyl group, partially deuterated C₁-C₁₀ heterocycloalkyl group, or partially deuterated phenyl group, in which some of hydrogen atoms are substituted with deuterium atoms.

The "(C₁-C₂₀ alkyl)'X' group" as used herein refers to a 'X' group substituted with at least one C₁-C₂₀ alkyl group. For example, the "(C₁-C₂₀ alkyl)C₃-C₁₀ cycloalkyl group" as used herein refers to a C₃-C₁₀ cycloalkyl group substituted with at least one C₁-C₂₀ alkyl group, and the "(C₁-C₂₀ alkyl)phenyl group" as used herein refers to a phenyl group substituted with at least one C₁-C₂₀ alkyl group. Examples of the (C₁ alkyl)phenyl group may include a toluyl group.

In the present specification, "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" each refer to a hetero ring in which at least one ring-forming carbon atom is substituted with nitrogen atom and respectively having an identical backbone as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, and a dibenzothiophene 5,5-dioxide group".

A substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, or the substituted monovalent non-aromatic condensed heteropolycyclic group may be:
deuterium, -F, -Cl, -Br, -I, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, - F, -Cl, -Br, -I, -CD₃, -CD₂H, -CDH₂, -CF₃, -CF₂H, -CFH₂, a hydroxyl group, a cyano group, a nitro group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅),-Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q23)(Q24)(Q25), - Ge(Q23)(Q24)(Q25), -B(Q₂₆)(Q₂₇), -P(=O)(Q₂₈)(Q₂₉), P(Q28)(Q29), or any combination thereof;
-N(Q₃₁)(Q₃₂), -Si(Q33)(Q34)(Q35), -Ge(Q33)(Q34)(Q35), -B(Q₃₆)(Q₃₇),-P(=O)(Q₃₈)(Q₃₉), or -P(Q38)(Q39); or
any combination thereof.

In the present specification, Q₁ to Q₉, Q₁₁ to Q₁₉, Q₂₁ to Q₂₉, and Q₃₁ to Q₃₉ may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, a C₁-C₆₀ alkyl group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

For example, Q₁ to Q₉, Q₁₁ to Q₁₉, Q₂₁ to Q₂₉, and Q₃₁ to Q₃₉ may each independently be:
-CH₃, -CD₃, -CD₂H, -CDH₂, -CH2CH3, -CH2CD3, -CH₂CD₂H, -CH₂CDH₂,-CHDCH₃, -CHDCD₂H, -CHDCDH₂, -CHDCD₃, -CD₂CD₃, -CD₂CD₂H, or-CD₂CDH₂; or
an *n*-propyl group, an iso-propyl group, an *n*-butyl group, a *sec*-butyl group, an isobutyl group, a *tert*-butyl group, an *n*-pentyl group, a *tert*-pentyl group, a neopentyl group, an isopentyl group, a *sec*-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

Hereinafter, a compound and an organic light-emitting device according to an embodiment will be described in detail with reference to Synthesis Examples and Examples, however, the present disclosure is not limited thereto. The wording "B was used instead of A" used in describing Synthesis Examples means that an amount of B used was identical to an amount of A used based on molar equivalence.

### Examples

### Synthesis Example 1 (Compound 1 or Compound 1-1)

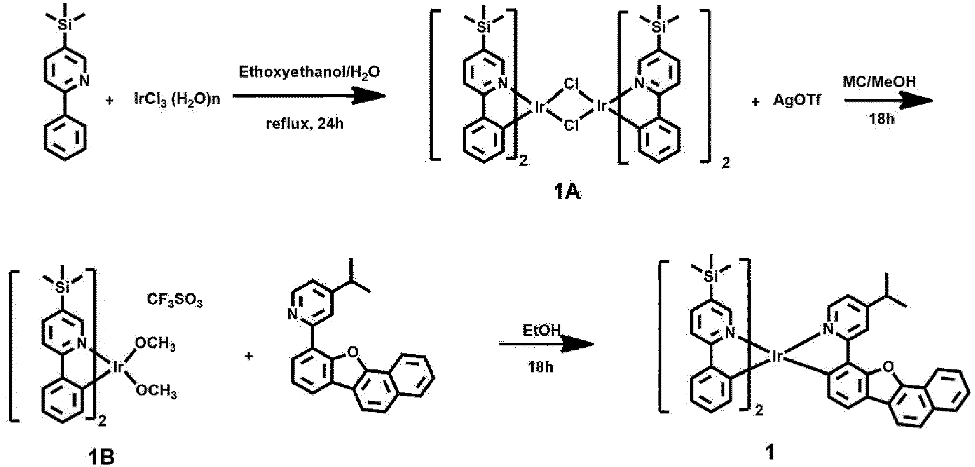

### Synthesis of Compound 1A

An amount of 7.5 grams (g) (33.1 mmol) of 2-phenyl-5-(trimethylsilyl)pyridine and 5.2 g (14.7 mmol) of iridium chloride hydrate (IrCl₃(H₂O)ₙ) were mixed with 120 milliliters (mL) of ethoxyethanol and 40 mL of distilled water. Then, the mixture was stirred under reflux for 24 hours, and then the temperature was dropped to room temperature. A solid formed therefrom was separated by filtration. The solid was washed sufficiently with water, methanol, and hexane in the stated order and dried in a vacuum oven to thereby obtain 8.2 g of Compound 1A (yield: 82 %).

### Synthesis of Compound 1B

An amount of 1.60 g (1.18 mmol) of Compound 1A was mixed with 45 mL of methylene chloride (MC), and a solution, in which 0.61 g (2.35 mmol) of silver trifluoromethanesulfonate (AgOTf) was dissolved in 15 mL of methanol (MeOH), was added thereto. Then, the mixture was stirred for 18 hours at room temperature while blocking light using aluminum foil. The resultant mixture was celite-filtered to remove a solid formed therefrom and filtered under reduced pressure to thereby obtain a solid (Compound 1B). The solid was used in the following reaction without any further purification.

### Synthesis of Compound 1

An amount of 1.61 g (1.94 mmol) of Compound 1B and 0.65 g (1.94 mmol) of 4-isopropyl-2-(naphtho[1,2-b]benzofuran-10-yl)pyridine were mixed with 30 mL of ethanol (EtOH) and stirred under reflux for 18 hours at a temperature of 90 °C, followed by lowering the temperature. The resulting solid product was filtered and separated, followed by performing column chromatography using ethyl acetate (EA) and hexane, to thereby obtain 0.60 g of Compound 1 (yield: 30 %). The synthesized material was identified by high resolution mass spectrometry (HRMS) and high performance liquid chromatography (HPLC) analysis.

HRMS(MALDI) calculated (calcd) for C₅₂H₅₀IrN₃OSi₂: mass divided by charge number (m/z) 981.3122 Found: 981.3123

### Synthesis Example 2 (Compound 838 or Compound 2-201)

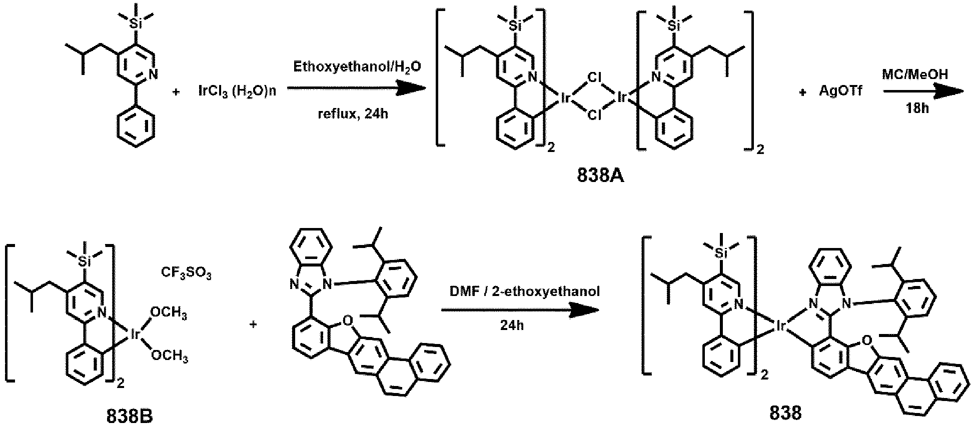

### Synthesis of Compound 838A

An amount of 3.4 g of Compound 838A (yield: 74 %) was obtained in the same manner as in Synthesis of Compound 1A in Synthesis Example 1, except that 4-isobutyl-2-phenyl-5-(trimethylsilyl)pyridine was used instead of 2-phenyl-5-(trimethylsilyl)pyridine.

### Synthesis of Compound 838B

Compound 838B was obtained in the same manner as in Synthesis of Compound 1B in Synthesis Example 1, except that Compound 838A was used instead of Compound 1A. The resulting Compound 838B was used in the following reaction without any further purification.

### Synthesis of Compound 838

An amount of 2.97 g (3.06 mmol) of Compound 838B and 1.66 g (3.06 mmol) of 1-(2,6-diisopropylphenyl)-2-(phenanthro[3,2-b]benzofuran-11-yl)-1H-benzo[d]imidazole were mixed with 40 mL of 2-ethoxyethanol and 40 mL of dimethyl formamide (DMF), followed by stirring under reflux at a temperature of 130 °C for 24 hours. Then, the temperature was lowered. The resulting mixture was placed under reduced pressure to obtain a solid, followed by performing column chromatography using ethyl acetate (EA) and hexane, to thereby obtain 1.1 g of Compound 838 (yield: 37 %). The synthesized material was identified by HRMS and HPLC analysis.

HRMS(MALDI) calcd for C₇₅H₇₉IrN₄OSi₂: m/z 1300.5422 Found: 1300.5420

### Synthesis Example 3 (Compound 855 or Compound 11-366)

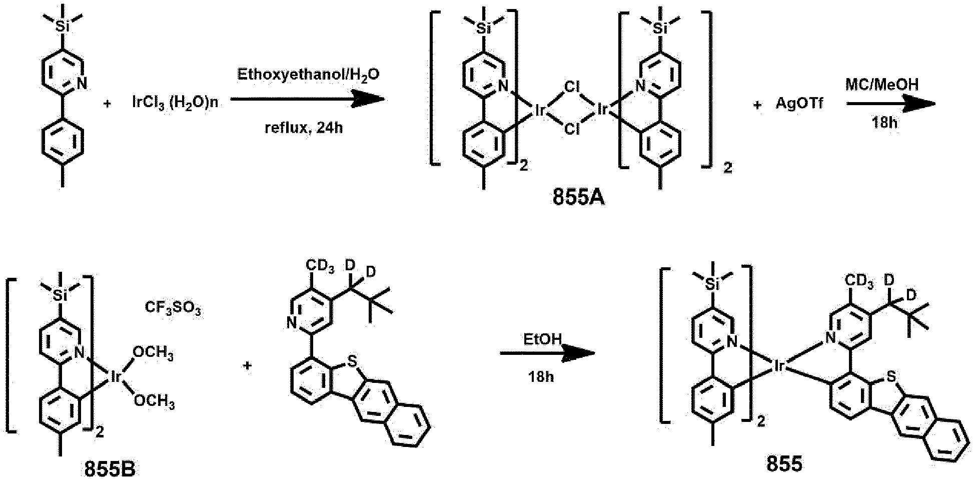

### Synthesis of Compound 855A

An amount of 5.0 g of Compound 855A (yield: 83 %) was obtained in the same manner as in Synthesis of Compound 1A in Synthesis Example 1, except that 2-(p-tolyl)-5-(trimethylsilyl)pyridine was used instead of 2-phenyl-5-(trimethylsilyl)pyridine.

### Synthesis of Compound 855B

Compound 855B was obtained in the same manner as in Synthesis of Compound 1B in Synthesis Example 1, except that Compound 855A was used instead of Compound 1A. The resulting Compound 855B was used in the following reaction without any further purification.

### Synthesis of Compound 855

An amount of 2.48 g (2.80 mmol) of Compound 855B and 1.12 g (2.80 mmol) of 2-(benzo[b]naphtho[2,3-d]thiophen-4-yl)-4-(2,2-dimethylpropyl-1,1-d2)-5-(methyl-d3)pyridine were mixed with 30 mL of ethanol and stirred under reflux for 18 hours at a temperature of 90 °C, followed by lowering the temperature. The resulting solid product was filtered and separated, followed by performing column chromatography using methylene chloride (MC) and hexane, to thereby obtain 1.16 g of Compound 855 (yield: 39 %). The synthesized material was identified by HRMS and HPLC analysis.

HRMS(MALDI) calcd for C₅₇H₅₅D₅IrN₃OSSi₂: m/z 1072.3990 Found: 1072.3988

### Synthesis Example 4 (Compound 960 or Compound 116-48)

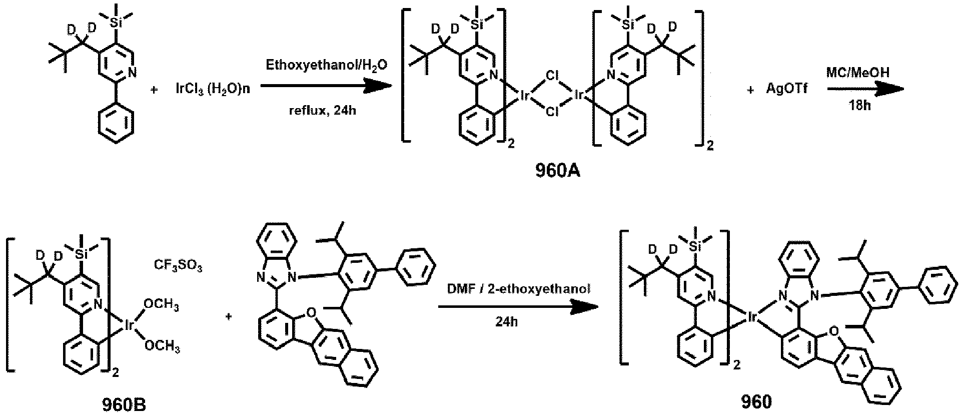

### Synthesis of Compound 960A

An amount of 3.8 g of Compound 960A (yield: 76 %) was obtained in the same manner as in Synthesis of Compound 1A in Synthesis Example 1, except that 4-(2,2-dimethylpropyl-1,1-d2)-2-phenyl-5-(trimethylsilyl)pyridine was used instead of 2-phenyl-5-(trimethylsilyl)pyridine.

### Synthesis of Compound 960B

Compound 960B was obtained in the same manner as in Synthesis of Compound 1B in Synthesis Example 1, except that Compound 960A was used instead of Compound 1A. The resulting Compound 960B was used in the following reaction without any further purification.

### Synthesis of Compound 960

An amount of 3.17 g (3.16 mmol) of Compound 960B and 1.81 g (3.16 mmol) of 1-(3,5-diisopropyl-[1,1'-biphenyl]-4-yl)-2-(naphtho[2,3-b]benzofuran-4-yl)-1H-benzo[d]imidazole were mixed with 40 mL of 2-ethoxyethanol and 40 mL of dimethyl formamide, followed by stirring under reflux at a temperature of 130 °C for 24 hours. Then, the temperature of lowered. The resulting mixture was placed under reduced pressure to obtain a solid, followed by performing column chromatography using EA and hexane, to thereby obtain 0.98 g of Compound 960 (yield: 23 %). The synthesized material was identified by HRMS and HPLC analysis.

HRMS(MALDI) calcd for C₇₉H₈₁IrN₄OSi₂: m/z 1358.9874 Found: 1358.9872

### Synthesis Example 5 (Compound 962 or Compound 118-24)

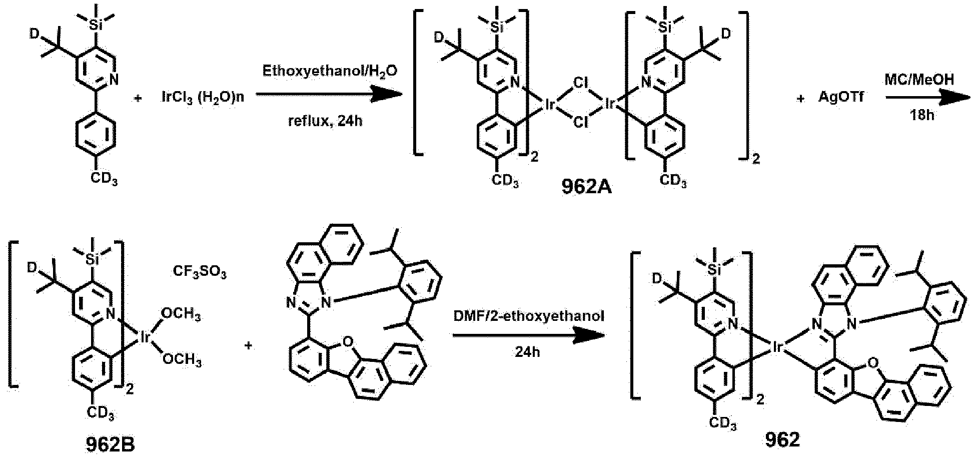

### Synthesis of Compound 962A

An amount of 3.5 g of Compound 962A (yield: 88 %) was obtained in the same manner as in Synthesis of Compound 1A in Synthesis Example 1, except that 2-(4-(methyl-d3)phenyl)-4-(propan-2-yl-2-d)-5-(trimethylsilyl)pyridine was used instead of 2-phenyl-5-(trimethylsilyl)pyridine.

### Synthesis of Compound 962B

Compound 962B was obtained in the same manner as in Synthesis of Compound 1B in Synthesis Example 1, except that Compound 962A was used instead of Compound 1A. The resulting Compound 962B was used in the following reaction without any further purification.

### Synthesis of Compound 962

An amount of 3.21 g (3.29 mmol) of Compound 962B and 1.37 g (3.29 mmol) of 1-(2,6-diisopropylphenyl)-2-(naphtho[1,2-b]benzofuran-10-yl)-1H-naphtho[1,2-d]imidazole) were mixed with 80 mL of 2-ethoxyethanol and 80 mL of dimethyl formamide, followed by stirring under reflux at a temperature of 130 °C for 24 hours. Then, the temperature was lowered. The resulting mixture was placed under reduced pressure to obtain a solid, followed by performing column chromatography using EA and hexane, to thereby obtain 1.62 g of Compound 962 (yield: 38 %). The synthesized material was identified by HRMS and HPLC analysis.

HRMS(MALDI) calcd for C₇₅H₇₁IrN₄OSi₂: m/z 1308.9198 Found: 1308.9198.

### Synthesis Example 6 (Compound 980 or Compound 136-309)

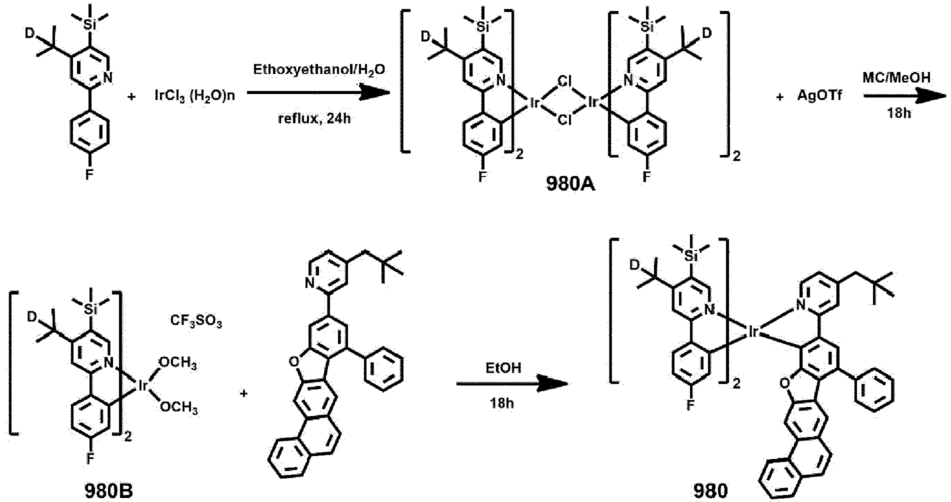

### Synthesis of Compound 980A

An amount of 3.5 g of Compound 980A (yield: 88 %) was obtained in the same manner as in Synthesis of Compound 1A in Synthesis Example 1, except that 2-(4-fluorophenyl)-4-(propan-2-yl-2-d)-5-(trimethylsilyl)pyridine was used instead of 2-phenyl-5-(trimethylsilyl)pyridine.

### Synthesis of Compound 980B

Compound 980B was obtained in the same manner as in Synthesis of Compound 1B in Synthesis Example 1, except that Compound 980A was used instead of Compound 1A. The resulting Compound 980B was used in the following reaction without any further purification.

### Synthesis of Compound 980

An amount of 2.73 g (2.79 mmol) of Compound 980B and 1.37 g (2.79 mmol) of 4-neopentyl-2-(8-phenylphenanthro[3,2-b]benzofuran-10-yl)pyridine were mixed with 60 mL of ethanol and stirred under reflux for 18 hours at a temperature of 90 °C, followed by lowering the temperature. The resulting solid product was filtered and separated, followed by performing column chromatography using MC and hexane, to thereby obtain 1.62 g of Compound 980 (yield: 46 %). The synthesized material was identified by HRMS and HPLC analysis.

HRMS(MALDI) calcd for C₇₂H₅₈D₈IrN₃OSi₂: m/z 1255.8558 Found: 1255.8555.

### Synthesis Example 7 (Compound 1279 or Compound 151-137)

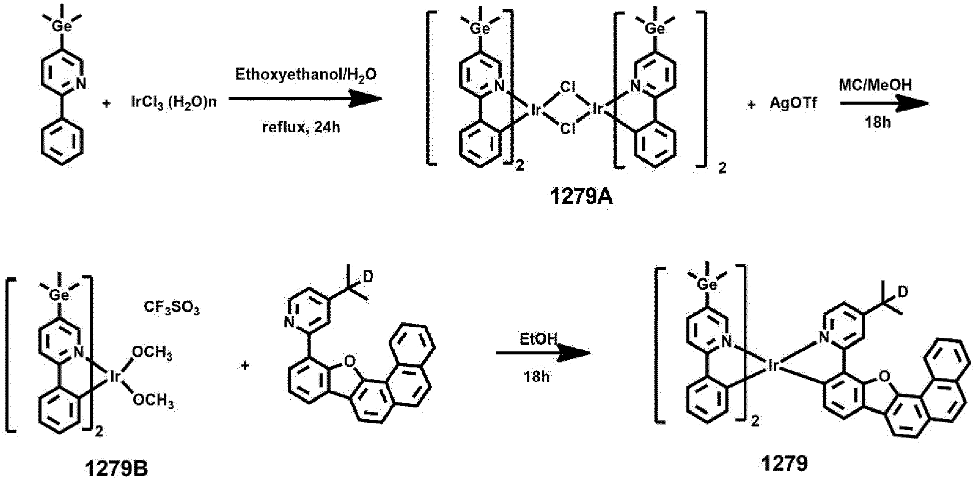

### Synthesis of Compound 1279A

An amount of 4.5 g of Compound 1279A (yield: 87 %) was obtained in the same manner as in Synthesis of Compound 1A in Synthesis Example 1, except that 2-phenyl-5-(trimethylgermyl)pyridine was used instead of 2-phenyl-5-(trimethylsilyl)pyridine.

### Synthesis of Compound 1279B

Compound 1279B was obtained in the same manner as in Synthesis of Compound 1B in Synthesis Example 1, except that Compound 1279A was used instead of Compound 1A. The resulting Compound 1279B was used in the following reaction without any further purification.

### Synthesis of Compound 1279

2.96 g (3.12 mmol) of Compound 1279B and 1.21 g (3.12 mmol) of 2-(phenanthro[4,3-b]benzofuran-12-yl)-4-(propan-2-yl-2-d)pyridine were mixed with 60 mL of ethanol and stirred under reflux for 18 hours at a temperature of 90 °C, followed by lowering the temperature. The resulting solid product was filtered and separated, followed by performing column chromatography using EA and hexane, to thereby obtain 1.80 g of Compound 1279 (yield: 50 %). The synthesized material was identified by HRMS and HPLC analysis.

HRMS(MALDI) calcd for C₅₆H₅₁DGe₂IrN₃O: m/z 1121.5351 Found: 1121.5350.

### Synthesis Example 8 (Compound 2206 or Compound 273-162)

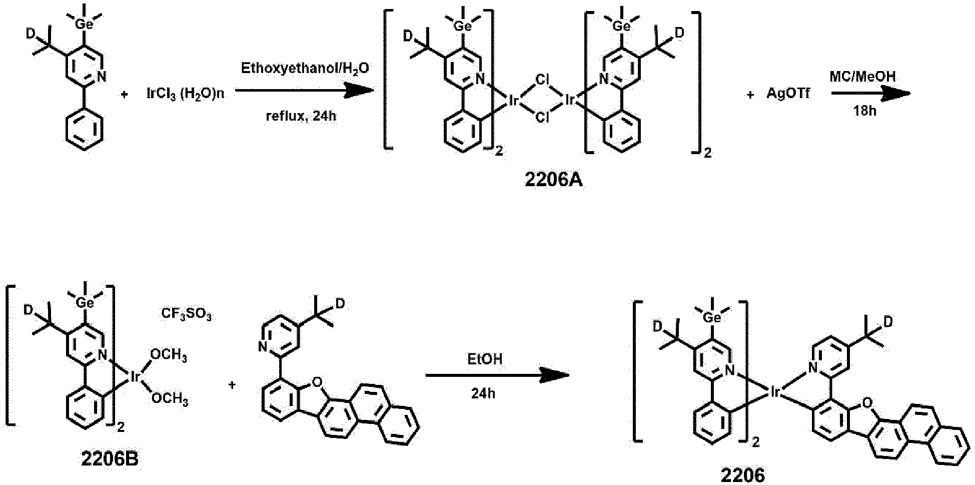

### Synthesis of Compound 2206A

An amount of 4.4 g of Compound 2206A (yield: 88 %) was obtained in the same manner as in Synthesis of Compound 1A in Synthesis Example 1, except that 2-phenyl-4-(propan-2-yl-2-d)-5-(trimethylgermyl)pyridine was used instead of 2-phenyl-5-(trimethylsilyl)pyridine.

### Synthesis of Compound 2206B

Compound 2206B was obtained in the same manner as in Synthesis of Compound 1B in Synthesis Example 1, except that Compound 2206A was used instead of Compound 1A. The resulting Compound 2206B was used in the following reaction without any further purification.

### Synthesis of Compound 2206

An amount of 2.57 g (2.48 mmol) of Compound 2206B and 0.97 g (2.48 mmol) of 2-(phenanthro[1,2-b]benzofuran-12-yl)-4-(propan-2-yl-2-d)pyridine were mixed with 60 mL of ethanol and stirred under reflux for 24 hours at a temperature of 90 °C, followed by lowering the temperature. The resulting solid product was filtered and separated, followed by performing column chromatography using EA and hexane, to thereby obtain 1.10 g of Compound 2206 (yield: 37 %). The synthesized material was identified by HRMS and HPLC analysis.

HRMS(MALDI) calcd for C₆₂H₆₁D₃Ge₂IrN₃O: m/z 1210.3290 Found: 1210.3292.

### Synthesis Example 9 (Compound 2543 or Compound 306-183)

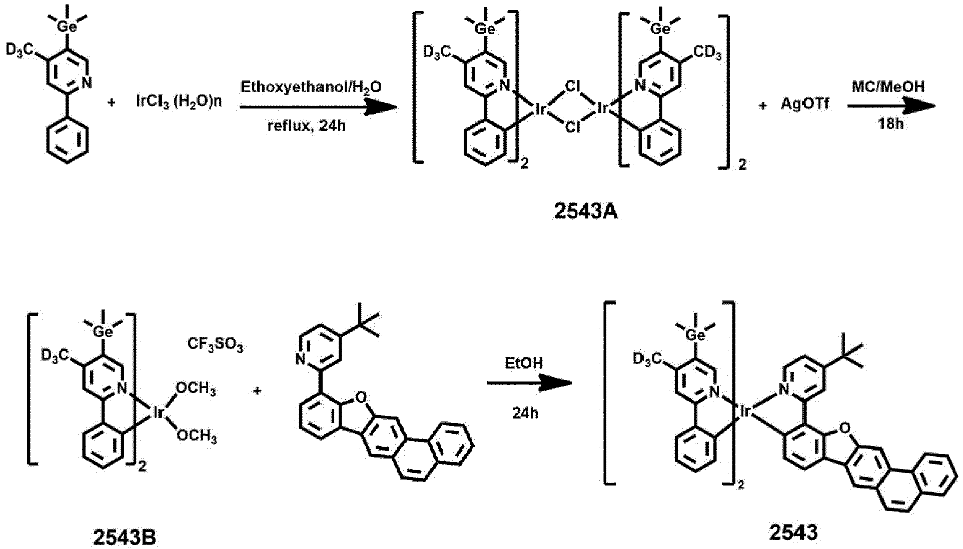

### Synthesis of Compound 2543A

An amount of 5.4 g of Compound 2543A (yield: 90 %) was obtained in the same manner as in Synthesis of Compound 1A in Synthesis Example 1, except that 4-(methyl-d3)-2-phenyl-5-(trimethylgermyl)pyridine was used instead of 2-phenyl-5-(trimethylsilyl)pyridine.

### Synthesis of Compound 2543B

Compound 2543B was obtained in the same manner as in Synthesis of Compound 1B in Synthesis Example 1, except that Compound 2543A was used instead of Compound 1A. The resulting Compound 2543B was used in the following reaction without any further purification.

### Synthesis of Compound 2543

An amount of 2.77 g (2.82 mmol) of Compound 2543B and 1.13 g (2.82 mmol) of 4-(tert-butyl)-2-(phenanthro[3,2-b]benzofuran-11-yl)pyridine were mixed with 60 mL of ethanol and stirred under reflux for 24 hours at a temperature of 90 °C, followed by lowering the temperature. The resulting solid product was filtered and separated, followed by performing column chromatography using EA and hexane, to thereby obtain 1.05 g of Compound 2543 (yield: 32 %). The synthesized material was identified by HRMS and HPLC analysis.

HRMS(MALDI) calcd for C₅₉H₅₂D₅Ge₂IrN₃O: m/z 1171.3009 Found: 1171.3008.

### Synthesis Example 10 (Compound 2588 or Compound 1-184N)

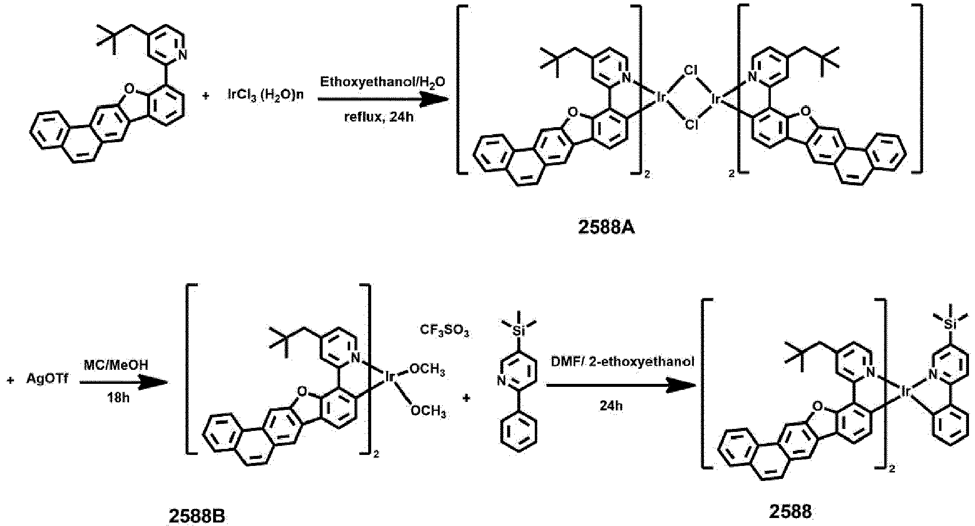

### Synthesis of Compound 2588A

An amount of 4.6 g of Compound 2588A (yield: 77 %) was obtained in the same manner as in Synthesis of Compound 1A in Synthesis Example 1, except that 4-neopentyl-2-(phenanthro[3,2-b]benzofuran-11-yl)pyridine was used instead of 2-phenyl-5-(trimethylsilyl)pyridine.

### Synthesis of Compound 2588B

Compound 2588B was obtained in the same manner as in Synthesis of Compound 1B in Synthesis Example 1, except that Compound 2588A was used instead of Compound 1A. The resulting Compound 2588B was used in the following reaction without any further purification.

### Synthesis of Compound 2588

An amount of 3.261 g (2.64 mmol) of Compound 2588B and 0.60 g (2.64 mmol) of 2-phenyl-5-(trimethylsilyl)pyridine were mixed with 40 mL of 2-ethoxyethanol and 40 mL of dimethylformamide and stirred under reflux for 24 hours at a temperature of 130 °C, followed by lowering the temperature. The resulting solid product was filtered and separated, followed by performing column chromatography using EA and hexane, to thereby obtain 0.94 g of Compound 2588 (yield: 28 %). The synthesized material was identified by HRMS and HPLC analysis.

HRMS(MALDI) calcd for C₇₄H₆₄IrN₃O₂Si: m/z 1247.6470 Found: 1247.6470.

### Comparative Example A (Compound A)

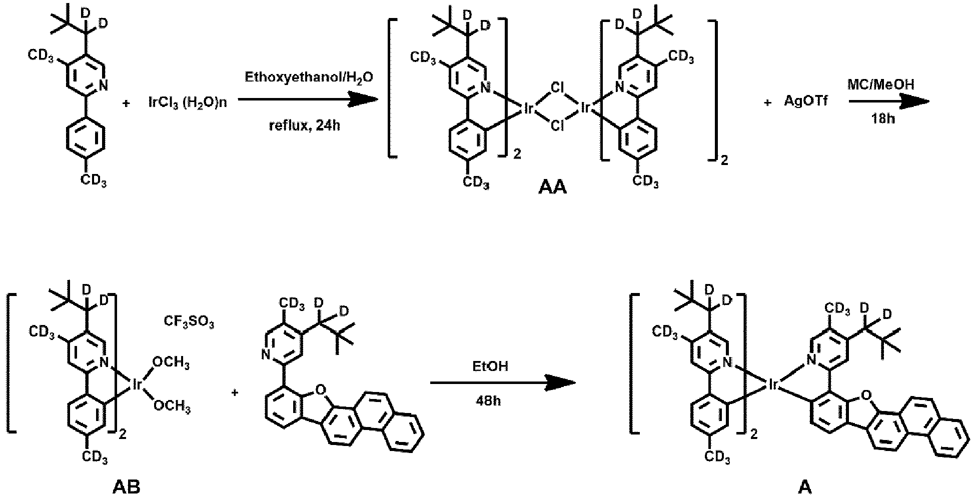

### Synthesis of Compound AA

An amount of 4.6 g of Compound AA (yield: 77 %). was obtained in the same manner as in Synthesis of Compound 1A in Synthesis Example 1, except that 5-(2,2-dimethylpropyl-1,1-d2)-4-(methyl-d3)-2-(4-(methyl-d3)phenyl)pyridine was used instead of 2-phenyl-5-(trimethylsilyl)pyridine.

### Synthesis of Compound AB

Compound AB was obtained in the same manner as in Synthesis of Compound 1B in Synthesis Example 1, except that Compound AA was used instead of Compound 1A. The resulting Compound AB was used in the following reaction without any further purification.

### Synthesis of Compound A

An amount of 2.83 g (3.05 mmol) of Compound AB and 1.33 g (3.05 mmol) of 4-(2,2-dimethylpropyl-1,1-d2)-5-(methyl-d3)-2-(phenanthro[1,2-b]benzofuran-12-yl)pyridine were mixed with 70 mL of ethanol and stirred under reflux for 48 hours at a temperature of 90 °C, followed by lowering the temperature. The resulting solid product was filtered and separated, followed by performing column chromatography using EA and hexane, to thereby obtain 0.80 g of Compound A (yield: 23 %). The synthesized material was identified by HRMS and HPLC analysis.

HRMS(MALDI) calcd for C₆₇H₄₉D₂₁IrN₃O: m/z 1146.6466 Found: 1146.6465.

### Comparative Example B (Compound B)

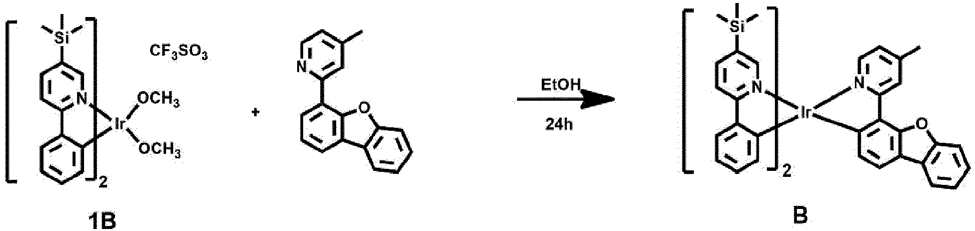

An amount of 2.85 g (3.32 mmol) of Compound 1B and 0.86 g (3.32 mmol) of 2-(dibenzo[b,d]furan-4-yl)-4-methylpyridine were mixed with 70 mL of ethanol and stirred at a temperature of 90 °C under reflux for 24 hours, followed by lowering the temperature. The resulting solid product was filtered and separated, followed by performing column chromatography using EA and hexane, to thereby obtain 1.12 g of Compound B (yield: 37 %). The synthesized material was identified by HRMS and HPLC analysis.

HRMS(MALDI) calcd for C₄₆H₄₄IrN₃OSi₂: m/z 903.2652 Found: 903.2653.

### Example 1

A glass substrate, on which ITO is patterned as an anode, was cut to a size of 50 millimeters (mm) × 50 mm × 0.5 mm, sonicated in isopropyl alcohol and water for 5 minutes each, and cleaned by exposure to ultraviolet rays and ozone for 30 minutes. Subsequently, the glass substrate was mounted on a vacuum-deposition device.

Compound HT3 and F6-TCNNQ were vacuum-co-deposited at a weight ratio of 98:2 on the anode to form a hole injection layer having a thickness of 100 Å. Compound HT3 was vacuum-deposited on the hole injection layer to form a hole transport layer having a thickness of 1,350 Å. Then, Compound H-H1 was deposited on the hole transport layer to form an electron blocking layer having a thickness of 300 Å.

Subsequently, Compound H-H1, Compound H-E43, and Compound 1 (as a dopant) were co-deposited on the electron blocking layer at a weight ratio of 57:38:5 to form an emission layer having a thickness of 400 Å.

Compound ET3 and Compound ET-D1 were co-deposited at a volume ratio of 50:50 on the emission layer to form an electron transport layer having a thickness of 350 Å, Compound ET-D1 was vacuum-deposited on the electron transport layer to form an electron injection layer having a thickness of 10 Å, and Al was vacuum-deposited on the electron injection layer to form a cathode having a thickness of 1,000 Å, thereby completing the manufacture of an organic light-emitting device.

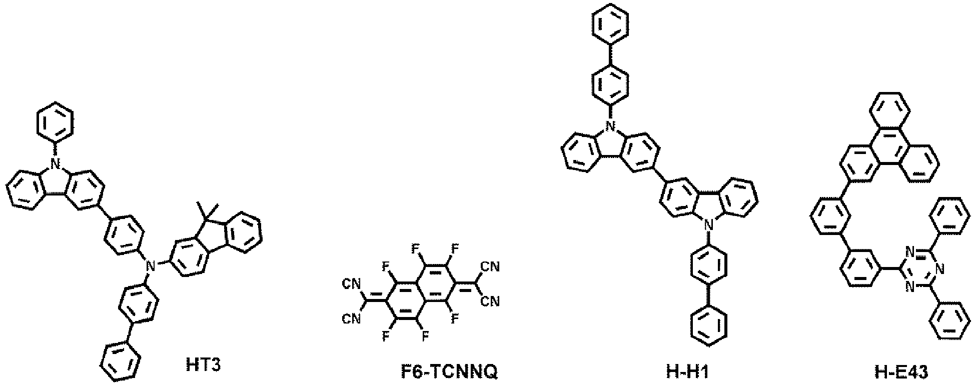

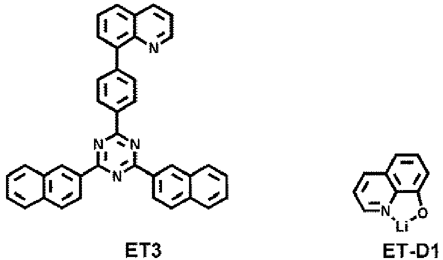

### Examples 2 to 10 and Comparative Examples A and B

Organic light-emitting devices were manufactured in the same manner as in Example 1, except that the compounds shown in Table 98 were used instead of Compound 1 as a dopant in the formation of an emission layer.

### Evaluation Example 1: Evaluation of characteristics of organic light-emitting device

The maximum value of external quantum efficiency (Max EQE, %), lifespan (LT₉₇, hours (hr)) and maximum emission wavelength of each of the organic light-emitting devices manufactured in Examples 1 to 10 and Comparative Examples A and B were evaluated. The results thereof are shown in Table 98. A Keithley 2400 current voltmeter and a luminance meter (Minolta Cs-1000A) were used in the evaluation. The lifespan (LT₉₇ at 6,000 nit (candela per square meter)) refers to time (hr) required for the initial luminance of the organic light-emitting device to reduce to 97 %. The Max EQE and the lifespan are indicated in a relative value (%) compared to Comparative Example B.

**Table 98**

| | Dopant in emission layer Compound No. | Max EQE (relative value, %) | LT₉₇ (at 6,000 nit) (relative value, %) | Maximum emission wavelength (nm) |
|---|---|---|---|---|
| Example 1 | 1 | 110% | 257 % | 530 |
| Example 2 | 1279 | 114 % | 286 % | 532 |
| Example 3 | 2206 | 118 % | 443 % | 526 |
| Example 4 | 960 | 117 % | 215 % | 538 |
| Example 5 | 855 | 115 % | 171 % | 534 |
| Example 6 | 962 | 120 % | 193 % | 526 |
| Example 7 | 838 | 121 % | 357 % | 530 |
| Example 8 | 980 | 113 % | 186 % | 522 |
| Example 9 | 2543 | 119% | 516% | 526 |
| Example 10 | 2588 | 125% | 292% | 525 |
| Comparative Example A | A | 108 % | 143 % | 527 |
| Comparative Example B | B | 100 % | 100 % | 525 |

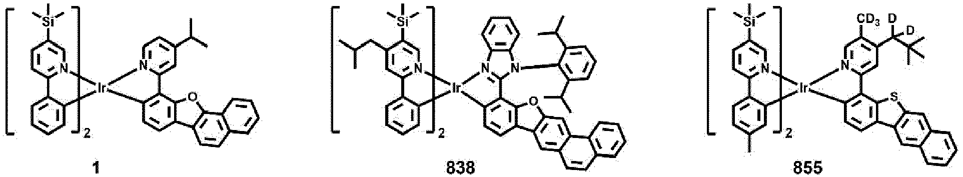

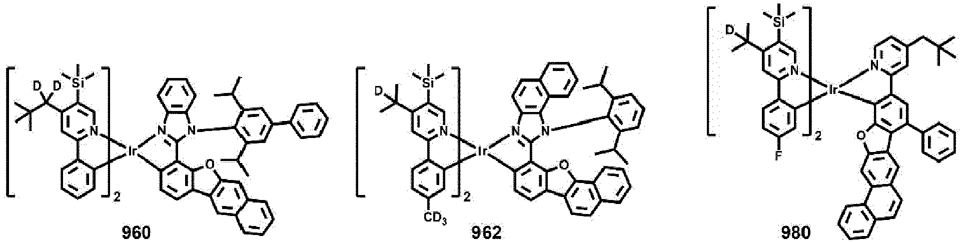

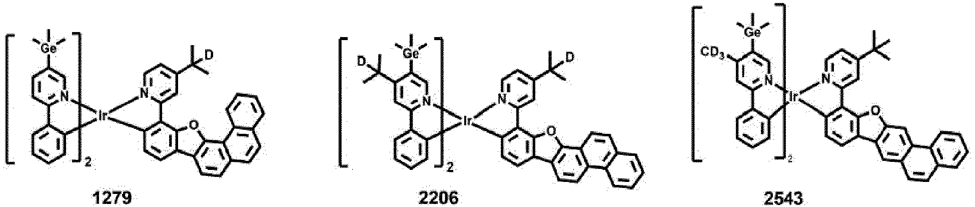

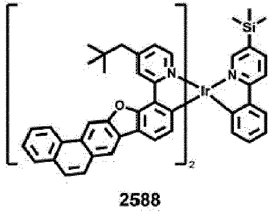

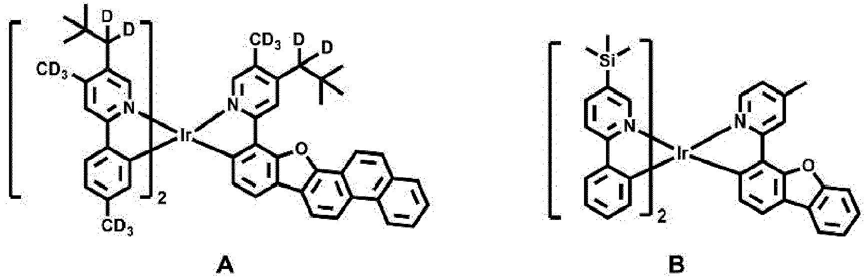

Referring to the results of Table 98, the organic light-emitting devices of Examples 1 to 10 were found to have improved external quantum yield and lifespan, as compared with the organic light-emitting devices of Comparative Examples A and B and to emit a green light.

As apparent from the foregoing description, the organometallic compound may have excellent thermal stability and/or electrical characteristics, and thus, an electronic device, e.g., an organic light-emitting device, including the organometallic compound may have an improved external quantum yield and improved lifespan characteristics. Therefore, a high-quality electronic apparatus may be manufactured by using the organic light-emitting device.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An organometallic compound represented by Formula 1:
Formula 1 M(L₁)ₙ₁(L₂)ₙ₂
wherein, in Formula 1,
M is a transition metal,
L₁ is a ligand represented by Formula 2-1,
L₂ is a ligand represented by Formula 2-2,
n1 and n2 are each independently 1 or 2, with the proviso that when n1 is 2, the L₁ ligands are identical to or different from each other, and when n2 is 2, the L₂ ligands are identical to or different from each other, and
L₁ is different from L₂: 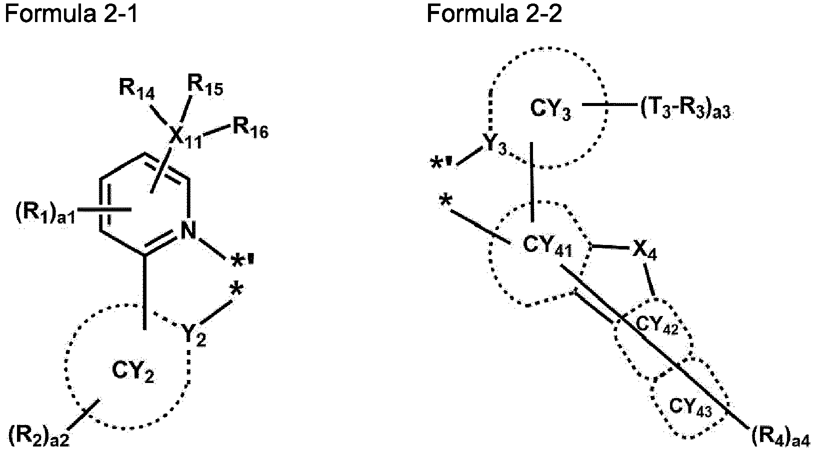
wherein, in Formulae 2-1 and 2-2,
Y₂ and Y₃ are each independently C or N,
ring CY₂, ring CY₃, and ring CY₄₁ to ring CY₄₃ are each independently a C₅-C₃₀ carbocyclic group or a C₁-C₃₀ heterocyclic group,
X₁₁ is Si or Ge,
T₃ is a single bond, a C₁-C₂₀ alkylene group unsubstituted or substituted with at least one R₁₀ₐ, a C₅-C₃₀ carbocyclic group unsubstituted or substituted with at least one R₁₀ₐ, or a C₁-C₃₀ heterocyclic group unsubstituted or substituted with at least one R₁₀ₐ,
X4 is O, S, Se, N(R48), C(R48)(R49), or Si(R₄₈)(R₄₉),
R₁ to R₄, R₁₄ to R₁₆, R₄₈, and R₄₉ are each independently hydrogen, deuterium, - F, -Cl, -Br, -I, -SF₅, a hydroxyl group, a cyano group, a nitro group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), - P(=O)(Q₈)(Q₉), or -P(Q₈)(Q₉),
a1 is an integer from 0 to 3,
a2 to a4 are each independently an integer from 0 to 20,
when a1 is 2 or greater, at least two of the R₁ moieties are optionally bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
when a2 is 2 or greater, at least two of the R₂ moieties are optionally bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
when a3 is 2 or greater, at least two of the R₃ moieties are optionally bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
when a3 is 2 or greater, at least two of the R₄ moieties are optionally bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
at least two of R₁ to R₄ are optionally bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ has a same definition as R₂,
* and *' each indicate a binding site to M in Formula 1, and
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, or the substituted monovalent non-aromatic condensed heteropolycyclic group is:
deuterium, -F, -Cl, -Br, -I, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, - I, -CD₃, -CD₂H, -CDH₂, -CF₃, -CF₂H, -CFH₂, a hydroxyl group, a cyano group, a nitro group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), - P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, - CF₂H, -CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), P(Q₂₈)(Q₂₉), or any combination thereof;
-N(Q31)(Q32), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q38)(Q39); or
any combination thereof,
wherein Q₁ to Q₉, Q₁₁ to Q₁₉, Q₂₁ to Q₂₉, and Q₃₁ to Q₃₉ are each independently: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, a C₁-C₆₀ alkyl group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

2. The organometallic compound of claim 1, wherein ring CY₂ is a benzene group, a naphthalene group, an anthracene group, a phenanthrene group, a 1,2,3,4-tetrahydronaphthalene group, a benzene group condensed with a norbornane group, a carbazole group, a fluorene group, a dibenzosilole group, a dibenzothiophene group, a dibenzofuran group, a dibenzoselenophene group, a pyridine group, a benzoxazole group, or a benzothiazole group; and/or
wherein ring CY₃ is a pyridine group, a pyrimidine group, a triazine group, a quinoline group, an isoquinoline group, a quinoxaline group, a benzoquinoline group, a benzoisoquinoline group, a benzoquinoxaline group, a naphthoquinoline group, a naphthoisoquinoline group, a naphthoquinoxaline group, a pyridoquinoline group, a pyridoisoquinoline group, a pyridoquinoxaline group, a pyridine group condensed with a cyclohexane group, a pyridine group condensed with a norbornane group, an imidazole group, a benzimidazole group, a naphthoimidazole group, a phenanthrenoimidazole group, a pyridoimidazole group, an oxazole group, a benzoxazole group, a naphthooxazole group, a phenanthrenooxazole group, a pyridooxazole group, a thiazole group, a benzothiazole group, a naphthothiazole group, a phenanthrenothiazole group, or a pyridothiazole group.

3. The organometallic compound of claims 1 or 2, wherein ring CY₄₁ and ring CY₄₂ are each independently a benzene group, a naphthalene group, a benzene group condensed with a cyclohexane group, or a benzene group condensed with a norbornane group, and
ring CY₄₃ is:
a benzene group, a naphthalene group, a phenanthrene group, an anthracene group, or a chrysene group; or
a benzene group, a naphthalene group, a phenanthrene group, an anthracene group, or a chrysene group, each condensed with a cyclohexane group, a norbornane group, or any combination thereof.

4. The organometallic compound of any of claims 1-3, wherein a carbon atom in ring CY₄₁ in Formula 2-2 is bound to M in Formula 1 via a covalent bond.

5. The organometallic compound of any of claims 1-4, wherein T₃ is:
a single bond; or
a C₁-C₂₀ alkylene group, a benzene group, a naphthalene group, a dibenzofuran group, or a dibenzothiophene group, each unsubstituted or substituted with deuterium, - F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated a phenyl group, a fluorinated phenyl group, (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

6. The organometallic compound of any of claims 1-5, wherein R₁ to R₄, R₄₈, and R₄₉ are each independently:
hydrogen, deuterium, -F, or a cyano group; or
a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated a phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, -Si(Q₃₃)(Q₃₄)(Q₃₅), -Ge(Q₃₃)(Q₃₄)(Q₃₅), or any combination thereof, and
R₁₄ to R₁₆ are each independently a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated a phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

7. The organometallic compound of any of claims 1-6, wherein the organometallic compound comprises deuterium, a fluoro group, or any combination thereof; and/or wherein a group represented by 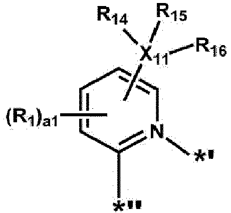 in Formula 2-1 is represented by one of Formulae CY1-1 to CY1-3: 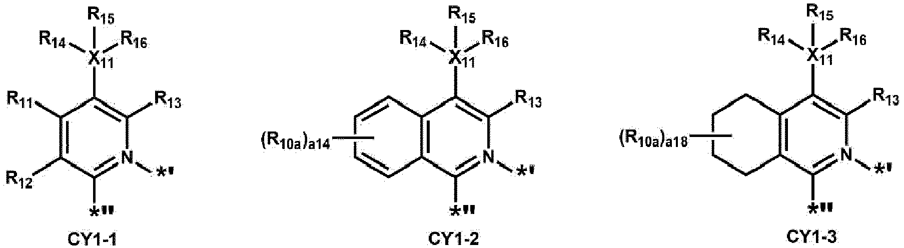 wherein, in Formulae CY1-1 to CY1-3,
X₁₁, R₁₄ to R₁₆, and R₁₀ₐ are respectively understood by referring to the descriptions of X₁₁, R₁₄ to R₁₆, and R₁₀ₐ in claim 1,
R₁₁ to R₁₃ each has a same definition as R₁,
a14 is an integer from 0 to 4,
a18 is an integer from 0 to 8,
*' indicates a binding site to M in Formula 1, and
*" indicates a binding site to an adjacent atom in Formula 2-1; and/or
wherein a group represented by 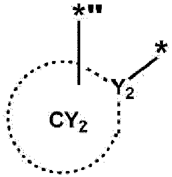 in Formula 2-1 is represented by one of Formulae CY2-1 to CY2-33: 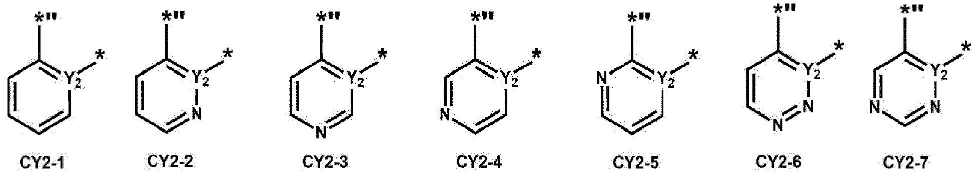 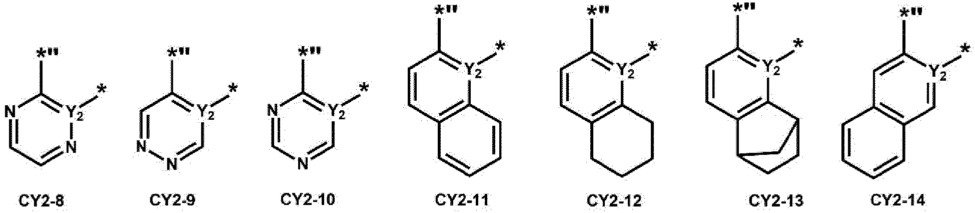 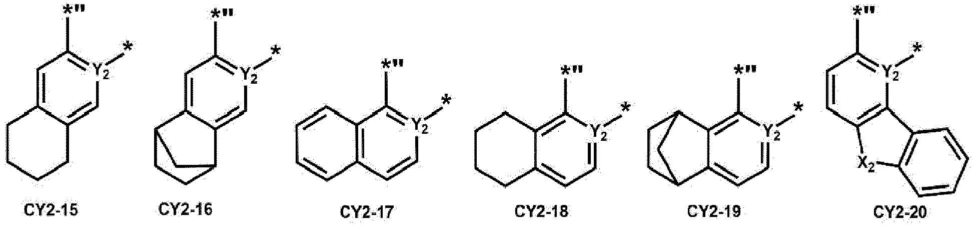 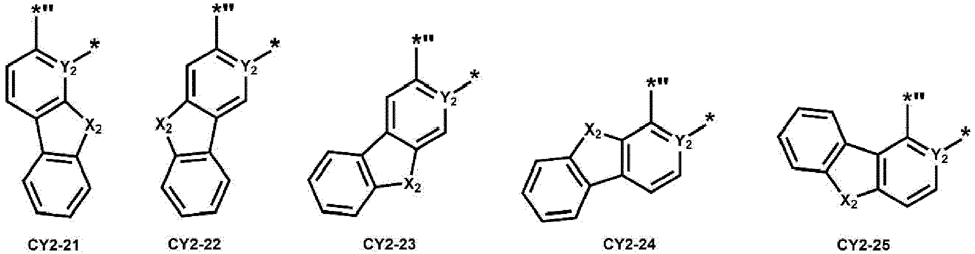 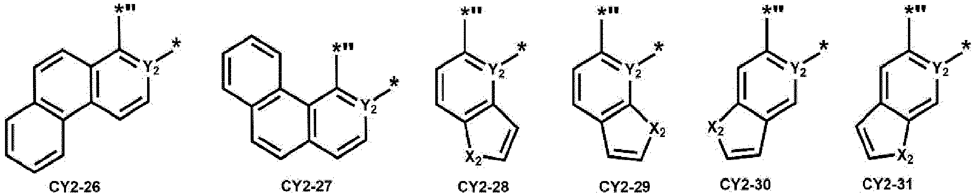 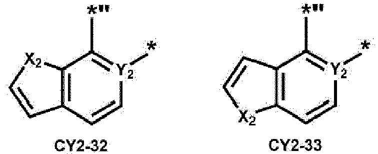 wherein, in Formulae CY2-1 to CY2-33,
Y₂ is understood by referring to the description of Y₂ in claim 1,
X₂ is O, S, Se, N(R₂₈), C(R₂₈)(R₂₉), or Si(R28)(R29),
R₂₈ and R₂₉ are each understood by referring to the description of R₂ claim 1,
*" indicates a binding site to an adjacent atom in Formula 2-1, and
* indicates a binding site to M in Formula 1.

8. The organometallic compound of any of claims 1-7, wherein a group represented by 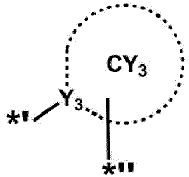 in Formula 2-2 is represented by one of Formulae CY3-1 to CY3-48: 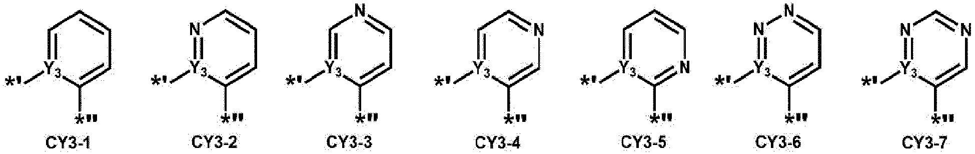 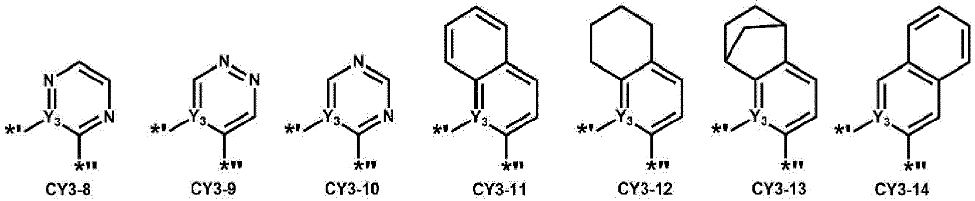 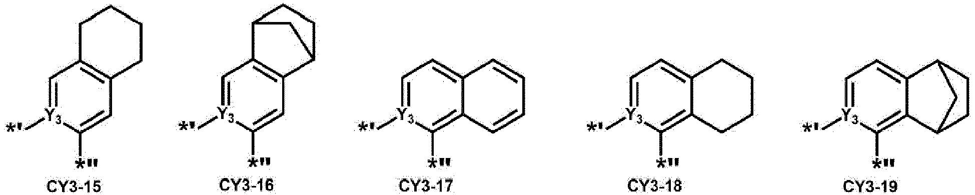 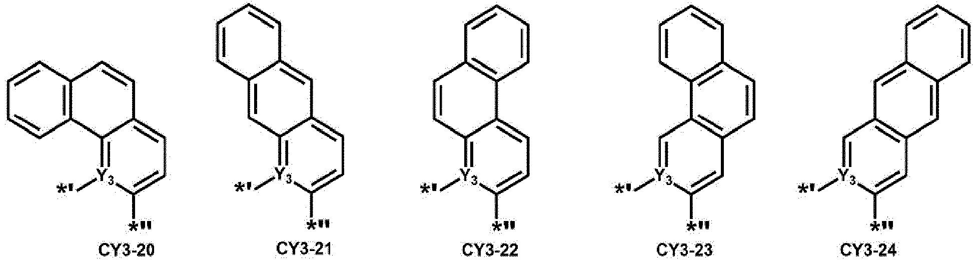 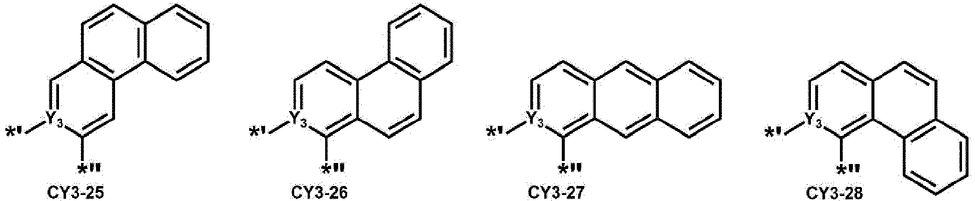 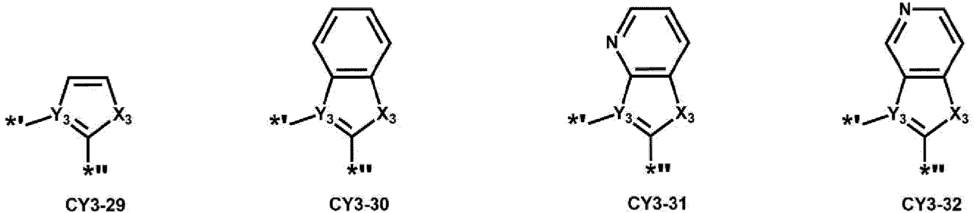 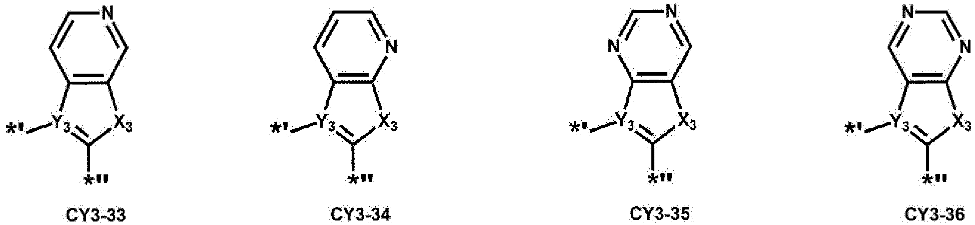 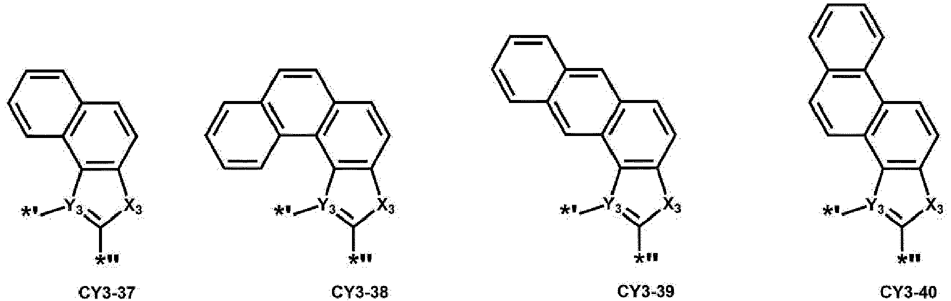 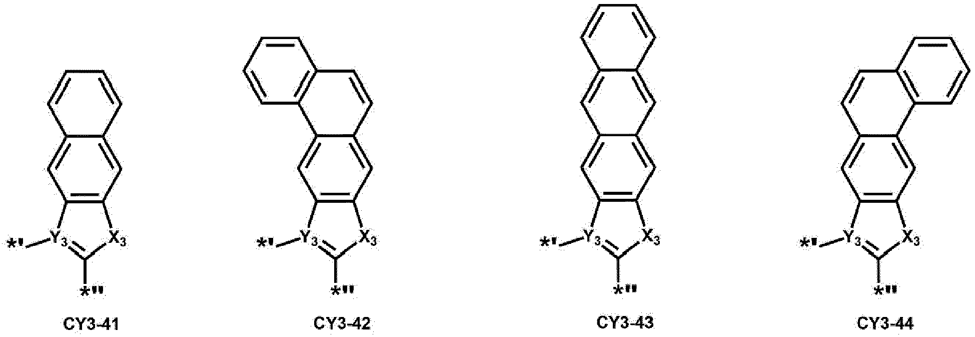 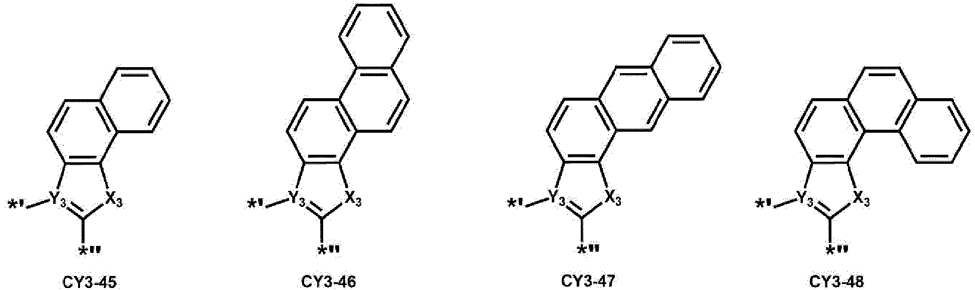 wherein, in Formulae CY3-1 to CY3-48,
X3 is O, S, or N(T₃-R₃),
Y₃, T₃, and R₃ are respectively understood by referring to the descriptions of Y₃, T₃, and R₃ in claim 1,
*' indicates a binding site to M in Formula 1, and
*" indicates a binding site to an adjacent atom in Formula 2-2.

9. The organometallic compound of any of claims 1-8, wherein a group represented by 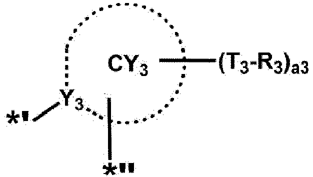 in Formula 2-2 is represented by one of Formulae CY3(1) to CY3(16): 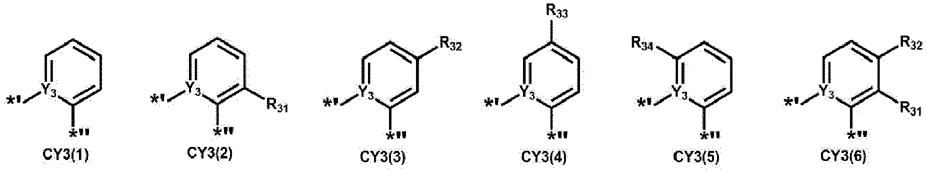 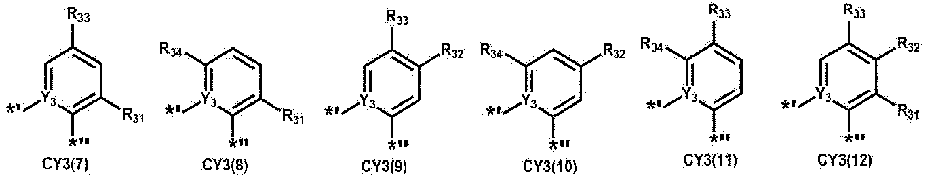 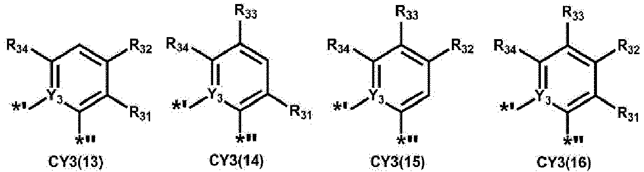 wherein, in Formulae CY3(1) to CY3(16),
Y₃ is understood by referring to the description of Y₃ in claim 1,
R₃₁ to R₃₄ each has a same definition as R₃, with the proviso that R₃₁ to R₃₄ are each not hydrogen,
*' indicates a binding site to M in Formula 1, and
*" indicates a binding site to an adjacent atom in Formula 2-2.

10. The organometallic compound of any of claims 1-9, wherein a group represented by 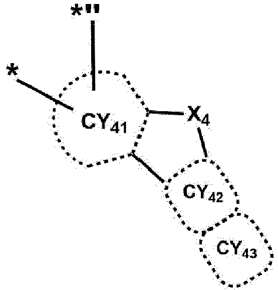 in Formula 2-2 is represented by one of Formulae CY4-1 to CY4-6: 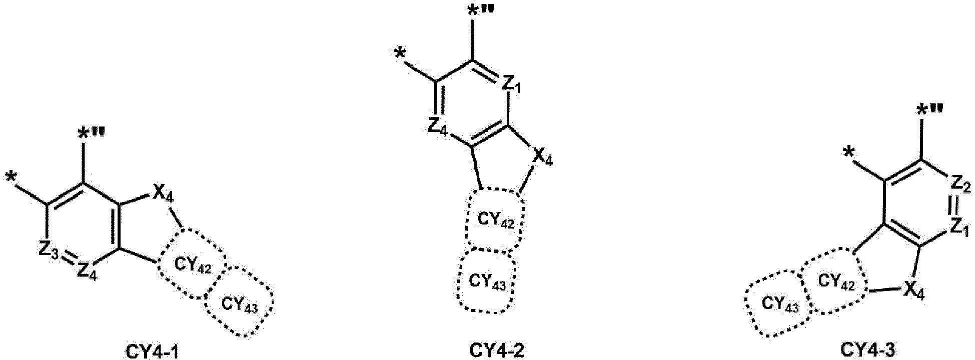 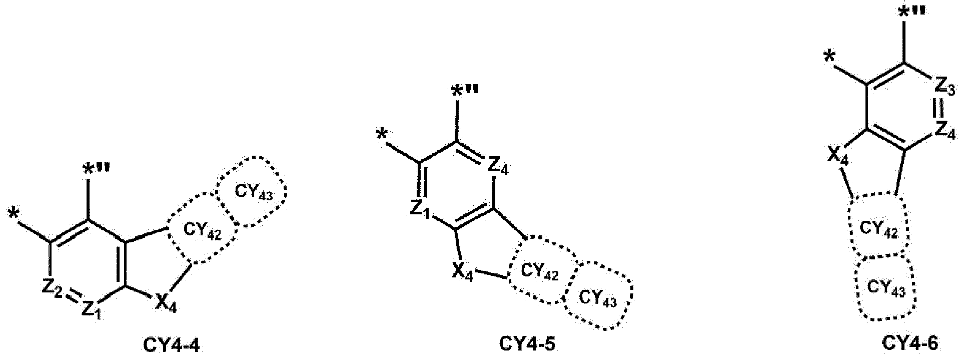 wherein, in Formulae CY4-1 to CY4-6,
X₄, ring CY₄₂, and ring CY₄₃ are respectively understood by referring to the descriptions of X₄, ring CY₄₂, and ring CY₄₃ in claim 1,
Z₁ to Z₄ are each independently N or C,
* indicates a binding site to M in Formula 1, and
*" indicates a binding site to ring CY₃ in Formula 2-2.

11. The organometallic compound of any of claims 1-10, wherein a group represented by 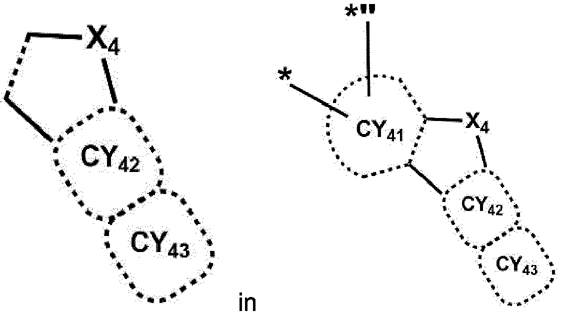 in Formula 2-2 is represented by one of Formulae CY401 to CY412: 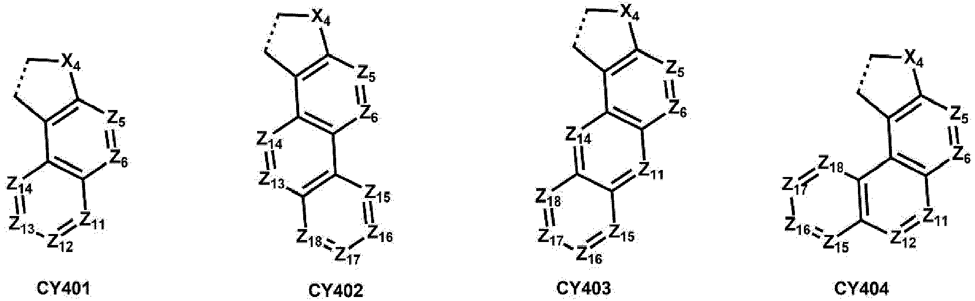 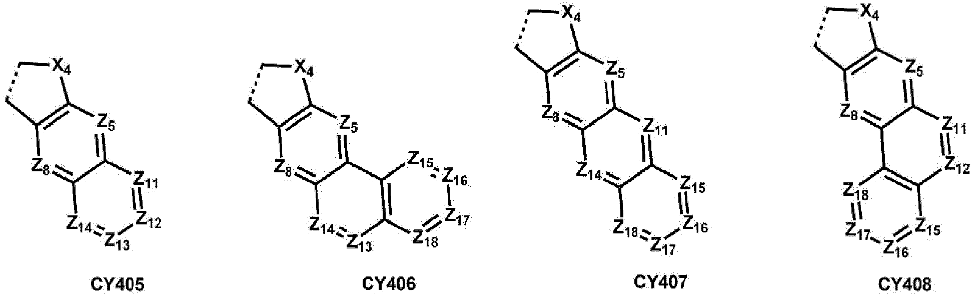 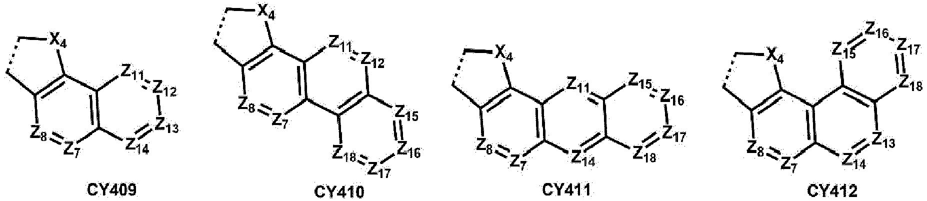 wherein, in Formulae CY401 to CY412,
X₄ is understood by referring to the description of X₄ in claim 1,
Z₅ to Z₈ and Z₁₁ to Z₁₈ are each independently N or C, and
an X₄-containing 5-membered ring is condensed to an adjacent ring CY₄₁.

12. An organic light-emitting device comprising:
a first electrode;
a second electrode; and
an organic layer disposed between the first electrode and the second electrode and comprising an emission layer,
wherein the organic layer comprises the organometallic compound of any of claims 1-11;
preferably wherein
the first electrode is an anode,
the second electrode is a cathode,
the organic layer further comprises
a hole transport region between the first electrode and the emission layer, and an electron transport region between the emission layer and the second
electrode,
the hole transport region comprises a hole injection layer, a hole transport layer, an electron blocking layer, a buffer layer, or any combination thereof, and
the electron transport region comprises a hole blocking layer, an electron transport layer, an electron injection layer, or any combination thereof.

13. The organic light-emitting device of claim 12, wherein the emission layer comprises the organometallic compound.

14. The organic light-emitting device of claim 13, wherein the emission layer is configured to emit green light; and/or
wherein the emission layer further comprises a host in an amount greater than an amount of the organometallic compound.

15. An electronic apparatus comprising the organic light-emitting device of any of claims 12-14.
